# EUROPEAN PATENT SPECIFICATION

(11) **EP 3 431 482 B1**
(45) Date of publication and mention of the grant of the patent: **02.09.2020**
(21) Application number: 18184583.5
(22) Date of filing: 19.07.2018
(51) Int. Cl.: C07F 15/00, C09K 11/06, H01L 51/00

(54) **ORGANOMETALLIC COMPOUND AND ORGANIC LIGHT-EMITTING DEVICE INCLUDING THE SAME**
ORGANOMETALLISCHE VERBINDUNG UND ORGANISCHE LICHTEMITTIERENDE VORRICHTUNG DAMIT
COMPOSÉ ORGANOMÉTALLIQUE ET DISPOSITIF ÉLECTROLUMINESCENT ORGANIQUE L'INCLUANT

(30) Priority: 21.07.2017 KR 20170092947
(43) Date of publication of application: 23.01.2019
(73) Proprietor: Samsung Display Co., Ltd., Yongin-si Gyeonggi-do (KR)
(72) Inventor: KO, Soobyung, Gyeonggi-do (KR); KIM, Sungbum, Gyeonggi-do (KR); JEON, Mina, Gyeonggi-do (KR); AHN, Heechoon, Gyeonggi-do (KR); JUN, Mieun, Gyeonggi-do (KR); KIM, Youngkook, Gyeonggi-do (KR); HWANG, Seokhwan, Gyeonggi-do (KR)
(74) Representative: Mounteney, Simon James

(56) References cited:
- EP-A1- 2 574 613
- WO-A2-2012/116231

## Description

### BACKGROUND

### 1. Field

One or more embodiments relate to an organometallic compound and an organic light-emitting device including the same.

### 2. Description of the Related Art

Organic light-emitting devices are self-emission devices that produce full-color images, and also have wide viewing angles, high contrast ratios, short response times, as well as excellent characteristics in terms of brightness, driving voltage, and response speed.

An example of such organic light-emitting devices may include a first electrode disposed on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transit from an excited state to a ground state, thereby generating light.
EP 2 574 613 A1 relates to cyclometallated tetradentate Pt(II) compounds.
WO 2012/116231 A2 relates to phosphorescent tetradentate platinum (II) compounds comprising a twisted aryl group.

### SUMMARY

Aspects of the present disclosure provide an organometallic compound and an organic light-emitting device including the same.

Additional aspects will be set forth in part in the description which follows and, in part, will be apparent from the description, or may be learned by practice of the presented embodiments.

An aspect provides an organometallic compound represented by Formula 1 below: 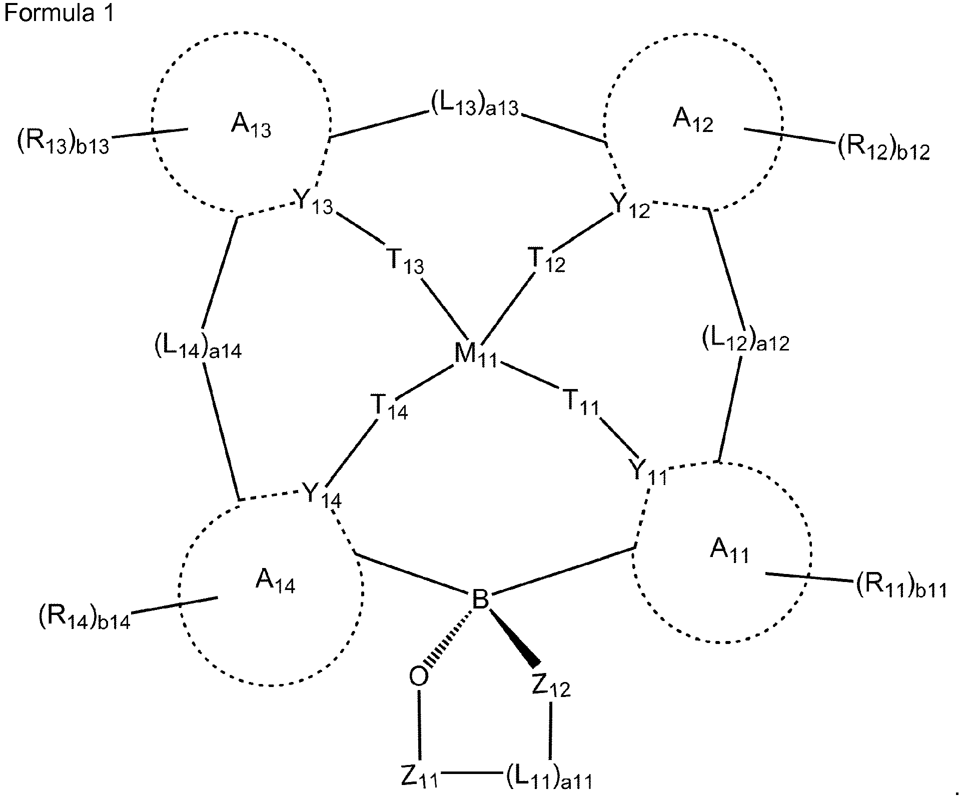 In Formula 1,
M₁₁ is selected from platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), and thulium (Tm),
A₁₁ to A₁₄ are each independently a C₅-C₆₀ carbocyclic group or a C₁-C₆₀ heterocyclic group,
Y₁₁ to Y₁₄ are each independently N or C,
Z₁₁ and Z₁₂ are each independently selected from N, C, O, S, a single bond, a substituted or unsubstituted C₅-C₆₀ carbocyclic group, and a substituted or unsubstituted C₁-C₆₀ heterocyclic group,
T₁₁ to T₁₄ are each independently selected from a single bond, O, and S,
L₁₁ to L₁₄ are each independently selected from a single bond, *-O-*', *-S-*', *-C(R₁₇)(R₁₈)-*', *-C(R₁₇)=*', *=C(R₁₇)-*', *-C(R₁₇)=C(R₁₈)-*', *-C(=O)-*', *-C(=S)-*', *-C=C-*', *-B(R₁₇)-*', *-N(R₁₇)-*', *-P(R₁₇)-*', *-Si(R₁₇)(R₁₈)-*', *-P(R₁₇)(R₁₈)-*', and *-Ge(R₁₇)(R₁₈)-*',
a11 to a14 are each independently selected from 0, 1, 2, and 3,
at least two of a12, a13, and a14 are each independently selected from 1, 2, and 3,
when a11 is zero, (L₁₁)ₐ₁₁ is a single bond, when a12 is zero, A₁₁ and A₁₂ are not linked to each other, when a13 is zero, A₁₂ and A₁₃ are not linked to each other, and when a14 is zero, A₁₃ and A₁₄ are not linked to each other,
R₁₁ to R₁₄, R₁₇, and R₁₈ are each independently selected from hydrogen, deuterium, -F, -CI, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), - B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), and -P(=S)(Q₁)(Q₂),
R₁₇ and R₁₁, R₁₇ and R₁₂, R₁₇ and R₁₃, and/or R₁₇ and R₁₄ are optionally linked to form a substituted or unsubstituted C₅-C₆₀ carbocyclic group or a substituted or unsubstituted C₁-C₆₀ heterocyclic group,
R₁₇ and R₁₈ are optionally linked to form a substituted or unsubstituted C₅-C₆₀ carbocyclic group or a substituted or unsubstituted C₁-C₆₀ heterocyclic group,
b11 to b14 are each independently selected from 1, 2, 3, 4, 5, 6, 7, and 8,
Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one selected from deuterium, -F, and a cyano group, a C₆-C₆₀ aryl group substituted with at least one selected from deuterium, -F, and a cyano group, a biphenyl group, and a terphenyl group, wherein at least one substituent of the substituted C₅-C₆₀ carbocyclic group, the substituted C₁-C₆₀ heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C1-C₆₀ alkoxy group, the substituted C₃-C₁₀ cycloalkyl group, the substituted C1-C10 heterocycloalkyl group, the substituted C3-C10 cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be selected from: deuterium (-D), -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group; a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁ )(Q₁₂), - C(=O)(Q₁₁), -S(=O)₂(Q₁₁), and -P(=O)(Q₁₁)(Q₁₂); a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group; a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂), and Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁ -C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one selected from deuterium, -F, and a cyano group, a C₆-C₆₀ aryl group substituted with at least one selected from deuterium, -F, and a cyano group, a biphenyl group, and a terphenyl group; and
* and *' each indicate a binding site to a neighboring atom.

Another aspect provides an organic light-emitting device including: a first electrode; a second electrode; an organic layer disposed between the first electrode and the second electrode,
wherein the organic layer includes an emission layer and the organometallic compound represented by Formula 1.

At least some of the above and other features of the invention are set out in the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 is a schematic cross-sectional view of an organic light-emitting device according to an embodiment;
FIG. 2 is a schematic cross-sectional view of an organic light-emitting device according to an embodiment;
FIG. 3 is a schematic cross-sectional view of an organic light-emitting device according to an embodiment; and
FIG. 4 is a schematic cross-sectional view of an organic light-emitting device according to an embodiment.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain certain aspects. As used herein, the term "and/or" includes any and all combinations of one or more of the associated listed items. Expressions such as "at least one of," when preceding a list of elements, modify the entire list of elements and do not modify the individual elements of the list.

The present disclosure will now be described more fully with reference to embodiments. The disclosure may, however, be embodied in many different forms and should not be construed as being limited to the embodiments set forth herein; rather, these embodiments are provided so that this disclosure will be thorough and complete, and will fully convey the concept of the disclosure to those skilled in the art. Features of embodiments of the present disclosure, and how to achieve them, will become apparent by reference to the embodiment that will be described later in more detail, together with the accompanying drawings. The subject matter of the present disclosure may, however, be embodied in many different forms and should not be limited to the embodiments.

Hereinafter, embodiments are described in more detail by referring to the attached drawings, and in the drawings, like reference numerals denote like elements, and a redundant explanation thereof will not be provided herein.

As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "on" or "onto" another layer, region, or component, it may be directly or indirectly formed on the other layer, region, or component. For example, intervening layers, regions, or components may be present.

In the drawings, components may be exaggerated or reduced in size for convenience of explanation. In other words, since sizes and thicknesses of components in the drawings may be arbitrarily illustrated for convenience of explanation, the following embodiments of the present disclosure are not limited thereto. For the avoidance of doubt, solid and broken wedged bonds are used herein merely to denote the relative stereochemical arrangement of functional groups in the organometallic compounds of the present invention.

An organometallic compound according to an embodiment is represented by Formula 1 below:

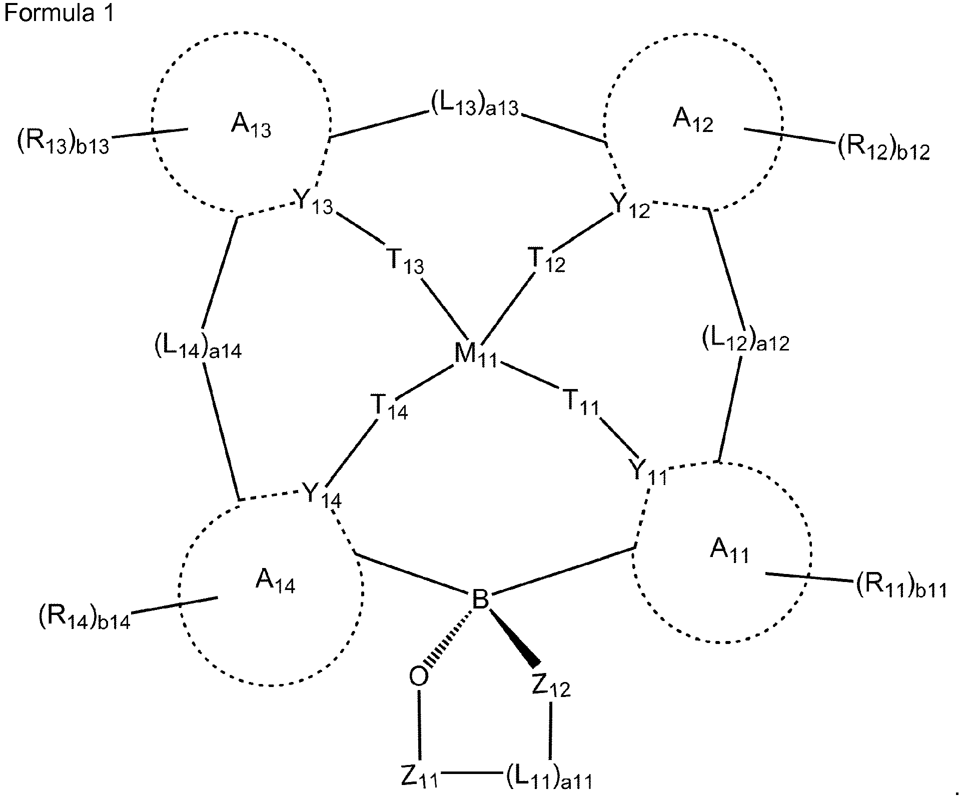

M₁₁ in Formula 1 is selected from platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), and thulium (Tm).

For example, M₁₁ in Formula 1 may be selected from Pt, Pd, Cu, Ag, Au, Rh, Ir, Ru, and Os, but embodiments of the present disclosure are not limited thereto.

In one embodiment, M₁₁ in Formula 1 may be selected from Pt, Pd, Cu, Ag, and Au, but embodiments of the present disclosure are not limited thereto.

A₁₁ to A₁₄ in Formula 1 are each independently a C₅-C₆₀ carbocyclic group or a C₁-C₆₀ heterocyclic group, but embodiments of the present disclosure are not limited thereto.

For example, A₁₁ to A₁₄ in Formula 1 may each independently be a C₅-C₂₀ carbocyclic group or a C₁-C₂₀ heterocyclic group, but embodiments of the present disclosure are not limited thereto. For example, A₁₁ to A₁₄ in Formula 1 may each independently be a C₅-C₁₀ carbocyclic group or a C₁-C₁₂ heterocyclic group, but embodiments of the present disclosure are not limited thereto. For example, A₁₁ to A₁₄ in Formula 1 may each independently be a C₅-C₁₀ carbocyclic group or a C₂-C₁₂ heterocyclic group, but embodiments of the present disclosure are not limited thereto. For example, A₁₁ to A₁₄ in Formula 1 may each independently be a C₅-C₆ carbocyclic group or a C₂-C₁₂ heterocyclic group, but embodiments of the present disclosure are not limited thereto. For example, A₁₁ to A₁₄ in Formula 1 may each independently be a C₆ carbocyclic group or a C₂-C₁₂ heterocyclic group, but embodiments of the present disclosure are not limited thereto.

For example, A₁₁ to A₁₄ in Formula 1 may each independently be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indeno pyridine group, an indolopyridine group, a benzofuropyridine group, a benzothienopyridine group, a benzosilolopyridine group, an indeno pyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline, but embodiments of the present disclosure are not limited thereto.

In one embodiment, A₁₁ to A₁₄ in Formula 1 may each independently be selected from a benzene group, a naphthalene group, a cyclopentadiene group, a 1,2,3,4-tetrahydronaphthalene group, a furan group, a thiophene group, an indene group, a fluorene group, an indole group, a carbazole group, a benzofuran group, a dibenzofuran group, a benzothiophene group, a dibenzothiophene group, an indeno pyridine group, an indolopyridine group, a benzofuropyridine group, a benzothienopyridine group, an indeno pyrimidine group, an indolopyrimidine group, a benzofuropyrimidine group, a benzothienopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline, but embodiments of the present disclosure are not limited thereto.

In one embodiment, A₁₁ to A₁₄ in Formula 1 may each independently be selected from a benzene group, a naphthalene group, an indene group, a fluorene group, an indole group, a carbazole group, a benzofuran group, a dibenzofuran group, a benzothiophene group, a dibenzothiophene group, a pyridine group, a pyrimidine group, a pyrazine group, a triazine group, a quinoline group, an isoquinoline group, a quinoxaline group, a quinazoline group, a pyrazole group, an imidazole group, a 2,3-dihydroimidazole group, a triazole group, a 2,3-dihydrotriazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, and a 2,3-dihydroimidazopyrazine group, but embodiments of the present disclosure are not limited thereto.

In one embodiment, A₁₁ to A₁₄ in Formula 1 may each independently be represented by one of Formulae 2-1 to 2-43, but embodiments of the present disclosure are not limited thereto: 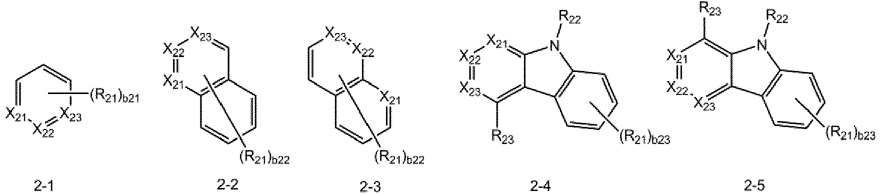 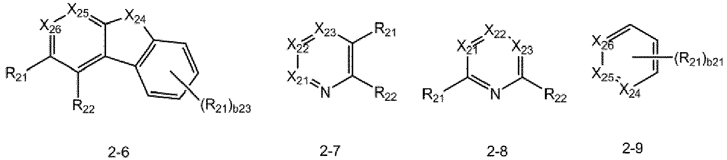 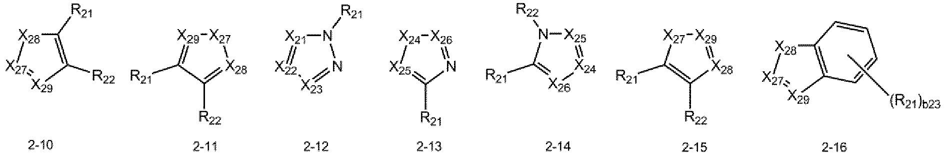 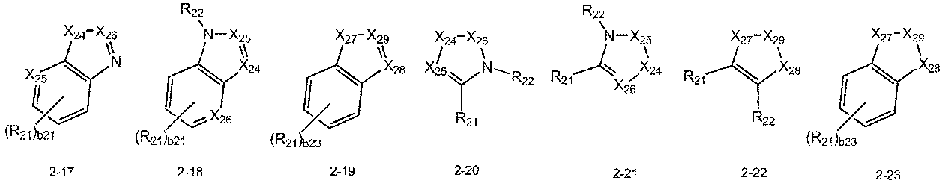 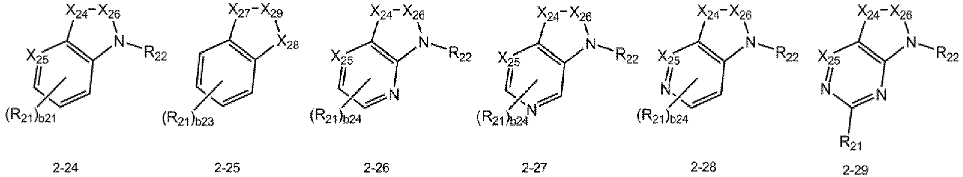 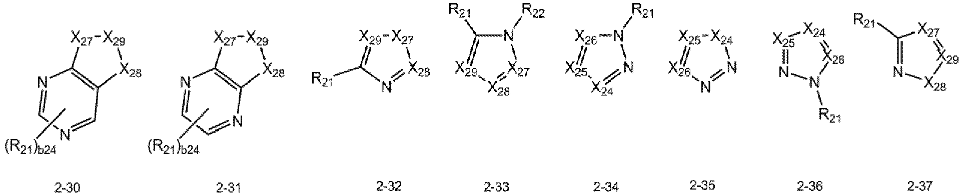 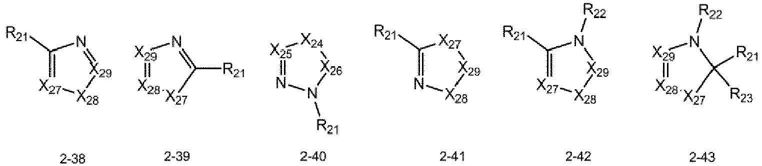 In Formulae 2-1 to 2-43,
X₂₁ to X₂₃ are each independently C(R₂₄) or C-*, provided that at least two of X₂₁ to X₂₃ are each C-*,
X₂₄ is N-*, and X₂₅ and X₂₆ are each independently C(R₂₄) or C-*, provided that at least one of X₂₅ and X₂₆ is C-*,
X₂₇ and X₂₈ are each independently selected from N, N(R₂₅), and N-*, and X₂₉ is C(R₂₄) or C-*, provided that i) at least one of X₂₇ and X₂₈ is N-*, and X₂₉ is C-*, or ii) X₂₇ and X₂₈ are each N-*, and X₂₉ is C(R₂₄),
R₂₁ to R₂₄ are each independently the same as described in connection with R₁₁ in Formula 1,
b21 is selected from 1, 2, and 3,
b22 is selected from 1, 2, 3, 4, and 5,
b23 is selected from 1, 2, 3, and 4,
b24 is 1 or 2, and
* indicates a binding site to a neighboring atom.
Y₁₁ to Y₁₄ in Formula 1 are each independently N or C.

For example, in Formula 1, Y₁₁, Y₁₂, and Y₁₃ may each be C, and Y₁₄ may be N;
Y₁₁, Y₁₂, and Y₁₄ may each be C, and Y₁₃ may be N;
Y₁₁, Y₁₃, and Y₁₄ may each be C, and Y₁₂ may be N;
Y₁₂, Y₁₃, and Y₁₄ may each be C, and Y₁₁ may be N;
Y₁₁ and Y₁₄ may each be C, and Y₁₂ and Y₁₃ may each be N;
Y₁₁ and Y₁₄ may each be N, and Y₁₂ and Y₁₃ may each be C;
Y₁₁ and Y₁₂ may each be C, and Y₁₃ and Y₁₄ may each be N;
Y₁₁ and Y₁₂ may each be N, and Y₁₃ and Y₁₄ may each be C;
Y₁₁ and Y₁₃ may each be C, and Y₁₂ and Y₁₄ may each be N; or
Y₁₁ and Y₁₃ may each be N, and Y₁₂ and Y₁₄ may each be C, but embodiments of the present disclosure are not limited thereto.

In one embodiment, in Formula 1, Y₁₁, Y₁₃, and Y₁₄ may each be C, and Y₁₂ may be N;
Y₁₁ and Y₁₄ may each be C, and Y₁₂ and Y₁₃ may each be N; or
Y₁₁ and Y₁₃ may each be C, and Y₁₂ and Y₁₄ may each be N, but embodiments of the present disclosure are not limited thereto.
Z₁₁ and Z₁₂ in Formula 1 are each independently selected from N, C, O, S, a single bond, a substituted or unsubstituted C₅-C₆₀ carbocyclic group, and a substituted or unsubstituted C₁-C₆₀ heterocyclic group, but embodiments of the present disclosure are not limited thereto.

For example, Z₁₁ and Z₁₂ in Formula 1 may each independently be selected from N, C, O, S, a single bond, a substituted or unsubstituted C₅-C₂₀ carbocyclic group, and a substituted or unsubstituted C₁-C₂₀ heterocyclic group, but embodiments of the present disclosure are not limited thereto. For example, Z₁₁ and Z₁₂ in Formula 1 may each independently be selected from N, C, O, S, a single bond, a substituted or unsubstituted C₅-C₁₀ carbocyclic group, and a substituted or unsubstituted C₁-C₁₂ heterocyclic group, but embodiments of the present disclosure are not limited thereto. For example, Z₁₁ and Z₁₂ in Formula 1 may each independently be selected from N, C, O, S, a single bond, a substituted or unsubstituted C₅-C₁₀ carbocyclic group, and a substituted or unsubstituted C₂-C₁₂ heterocyclic group, but embodiments of the present disclosure are not limited thereto. For example, Z₁₁ and Z₁₂ in Formula 1 may each independently be selected from N, C, O, S, a single bond, a substituted or unsubstituted C₅-C₆ carbocyclic group, and a substituted or unsubstituted C₂-C₁₂ heterocyclic group, but embodiments of the present disclosure are not limited thereto. For example, Z₁₁ and Z₁₂ in Formula 1 may each independently be selected from N, C, O, S, a single bond, a substituted or unsubstituted C₆ carbocyclic group, and a substituted or unsubstituted C₂-C₅ heterocyclic group, but embodiments of the present disclosure are not limited thereto. For example, Z₁₁ and Z₁₂ in Formula 1 may each independently be selected from a substituted or unsubstituted C₅-C₂₀ carbocyclic group, and a substituted or unsubstituted C₁-C₂₀ heterocyclic group, but embodiments of the present disclosure are not limited thereto. For example, Z₁₁ and Z₁₂ in Formula 1 may each independently be selected from a substituted or unsubstituted C₅-C₁₀ carbocyclic group, and a substituted or unsubstituted C₁-C₁₂ heterocyclic group, but embodiments of the present disclosure are not limited thereto. For example, Z₁₁ and Z₁₂ in Formula 1 may each independently be selected from a substituted or unsubstituted C₅-C₁₀ carbocyclic group, and a substituted or unsubstituted C₂-C₁₂ heterocyclic group, but embodiments of the present disclosure are not limited thereto. For example, Z₁₁ and Z₁₂ in Formula 1 may each independently be selected from a substituted or unsubstituted C₅-C₆ carbocyclic group, and a substituted or unsubstituted C₂-C₁₂ heterocyclic group, but embodiments of the present disclosure are not limited thereto. For example, Z₁₁ and Z₁₂ in Formula 1 may each independently be selected from a substituted or unsubstituted C₆ carbocyclic group, and a substituted or unsubstituted C₂-C₅ heterocyclic group, but embodiments of the present disclosure are not limited thereto.

For example, Z₁₁ and Z₁₂ in Formula 1 may each independently be selected from:
N, C, O, S, a single bond, a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indeno pyridine group, an indolopyridine group, a benzofuropyridine group, a benzothienopyridine group, a benzosilolopyridine group, an indeno pyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline;
a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indeno pyridine group, an indolopyridine group, a benzofuropyridine group, a benzothienopyridine group, a benzosilolopyridine group, an indeno pyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline, each substituted with at least one selected from deuterium, -F, -CI, -Br, -I, a hydroxyl group, a cyano group, a nitro group, an amidino group, a hydrazino group, a hydrazono group, -CD₃, -CD₂H, - CDH₂, -CF₃, -CF₂H, -CFH₂, C₁-C₆₀ *(e.g.* C₁-C₂₀) alkyl group, a C₂-C₆₀ *(e.g.* C₂-C₂₀) alkenyl group, a C₂-C₆₀ (*e.g.* C₂-C₂₀) alkynyl group, and a C₁-C₆₀ *(e.g.* C₁-C₂₀) alkoxy group; and
a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indeno pyridine group, an indolopyridine group, a benzofuropyridine group, a benzothienopyridine group, a benzosilolopyridine group, an indeno pyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline, each substituted with at least one selected from deuterium, -F, -CI, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ *(e.g.* C₆-C₃₀) aryloxy group, a C₆-C₆₀ (*e.g.* C₆-C₃₀) arylthio group, a C₁-C₆₀ *(e.g.* C₁-C₂₀) heteroaryl group, a monovalent non-aromatic condensed polycyclic group, a monovalent non-aromatic condensed heteropolycyclic group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
Q₃₁ to Q₃₃ may each independently be selected from hydrogen, deuterium, - F, -CI, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₁-C₆₀ (*e.g*. C₁-C₂₀) heteroaryl group, a monovalent non-aromatic condensed polycyclic group, a monovalent non-aromatic condensed heteropolycyclic group, a C₁-C₆₀ (*e.g*. C₁-C₂₀) alkyl group substituted with at least one selected from deuterium, -F, and a cyano group, a C₆-C₆₀ (*e.g*. C₆-C₃₀) aryl group substituted with at least one selected from deuterium, -F, and a cyano group, a biphenyl group, and a terphenyl group, but embodiments of the present disclosure are not limited thereto.

In one embodiment, Z₁₁ and Z₁₂ in Formula 1 may each independently be selected from:
N, C, O, S, a single bond, a benzene group, a cyclopentadiene group, a furan group, a thiophene group, a silole group, a dihydropyridine group, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group;
a benzene group, a cyclopentadiene group, a furan group, a thiophene group, a silole group, a dihydropyridine group, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, each substituted with at least one selected from deuterium, -F, -CI, -Br, -I, a hydroxyl group, a cyano group, a nitro group, an amidino group, a hydrazino group, a hydrazono group, -CD₃, -CD₂H, -CDH₂, -CF₃, -CF₂H, -CFH₂, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, a methoxy group, an ethoxy group, a propoxy group, a butoxy group, and a pentoxy group; and
a benzene group, a cyclopentadiene group, a furan group, a thiophene group, a silole group, a dihydropyridine group, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, each substituted with at least one selected from deuterium, -F, -Cl, -Br, -I, a hydroxyl group, a cyano group, a nitro group, an amidino group, a hydrazino group, a hydrazono group, a cyclopentyl group, a cyclohexyl group, a cycloheptyl group, a phenyl group, a biphenyl group, a terphenyl group, a naphthyl group, - Si(Q₃₁)(Q₃₂)(Q₃₃), -N(Q₃₁)(Q₃₂), and -C(=O)(Q₃₁), and
Q₃₁ to Q₃₃ may each independently be selected from hydrogen, deuterium, - F, -Cl, -Br, -I, a hydroxyl group, a cyano group, a nitro group, an amidino group, a hydrazino group, a hydrazono group, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, a methoxy group, an ethoxy group, a propoxy group, a butoxy group, a pentoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a cyclopentyl group, a cyclohexyl group, a cycloheptyl group, a phenyl group, a biphenyl group, a terphenyl group, and a naphthyl group, but embodiments of the present disclosure are not limited thereto.

In one embodiment, in Formula 1, Z₁₁ may be selected from:
N, C, O, S, a single bond, a benzene group, a cyclopentadiene group, a furan group, a thiophene group, a silole group, a dihydropyridine group, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group;
a benzene group, a cyclopentadiene group, a furan group, a thiophene group, a silole group, a dihydropyridine group, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, each substituted with at least one selected from deuterium, -F, -Cl, -Br, -I, a hydroxyl group, a cyano group, a nitro group, an amidino group, a hydrazino group, a hydrazono group, -CD₃, -CD₂H, -CDH₂, -CF₃, -CF₂H, -CFH₂, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, a methoxy group, an ethoxy group, a propoxy group, a butoxy group, and a pentoxy group; and
a benzene group, a cyclopentadiene group, a furan group, a thiophene group, a silole group, a dihydropyridine group, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, each substituted with at least one selected from deuterium, -F, -Cl, -Br, -I, a hydroxyl group, a cyano group, a nitro group, an amidino group, a hydrazino group, a hydrazono group, a cyclopentyl group, a cyclohexyl group, a cycloheptyl group, a phenyl group, a biphenyl group, a terphenyl group, a naphthyl group, - Si(Q₃₁)(Q₃₂)(Q₃₃), -N(Q₃₁)(Q₃₂), and -C(=O)(Q₃₁), and
Z₁₂ may be selected from:
   N, C, O, S, a single bond, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group;
   a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, each substituted with at least one selected from deuterium, -F, -Cl, -Br, -I, a hydroxyl group, a cyano group, a nitro group, an amidino group, a hydrazino group, a hydrazono group, -CD₃, -CD₂H, - CDH₂, -CF₃, -CF₂H, -CFH₂, a methyl group, an ethyl group, an n-propyl group, an iso-propyl group, an n-butyl group, an isobutyl group, a sec-butyl group, a tert-butyl group, an n-pentyl group, an isopentyl group, a sec-pentyl group, a tert-pentyl group, a methoxy group, an ethoxy group, a propoxy group, a butoxy group, and a pentoxy group; and
   a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, each substituted with at least one selected from deuterium, -F, -Cl, -Br, -I, a hydroxyl group, a cyano group, a nitro group, an amidino group, a hydrazino group, a hydrazono group, a cyclopentyl group, a cyclohexyl group, a cycloheptyl group, a phenyl group, a biphenyl group, a terphenyl group, a naphthyl group, -Si(Q₃₁)(Q₃₂)(Q₃₃), -N(Q₃₁)(Q₃₂), and -C(=O)(Q₃₁), but embodiments of the present disclosure are not limited thereto.

In one embodiment, a substructure represented by 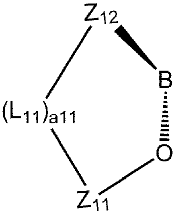 in Formula 1 may be represented by Formula 9, but embodiments of the present disclosure are not limited thereto: 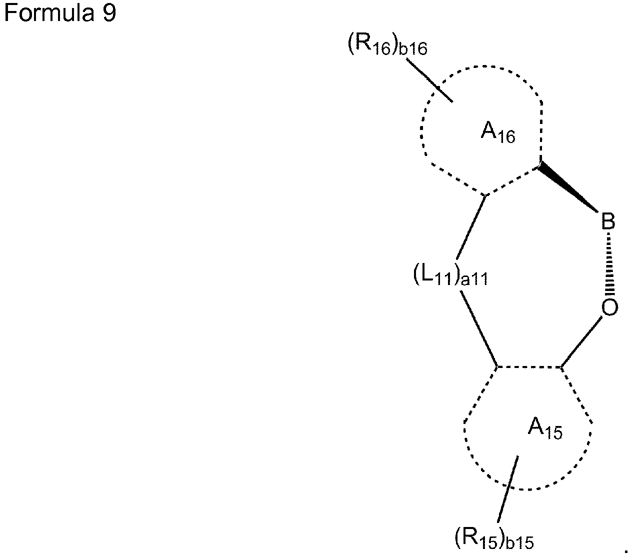 In Formula 9,
A₁₅ and A₁₆ are each independently be a C₅-C₆₀ carbocyclic group or a C₁-C₆₀ heterocyclic group,
R₁₅ and R₁₆ are each independently the same as described in connection with R₁₁ in Formula 1,
b15 and b16 are each independently the same as described in connection with b11 in Formula 1.

For example, A₁₅ and A₁₆ in Formula 9 may each independently be a C₅-C₂₀ carbocyclic group or a C₁-C₂₀ heterocyclic group, but embodiments of the present disclosure are not limited thereto. For example, A₁₅ and A₁₆ in Formula 9 may each independently be a C₅-C₁₀ carbocyclic group or a C₁-C₁₂ heterocyclic group, but embodiments of the present disclosure are not limited thereto. For example, A₁₅ and A₁₆ in Formula 9 may each independently be a C₅-C₁₀ carbocyclic group or a C₂-C₁₂ heterocyclic group, but embodiments of the present disclosure are not limited thereto. For example, A₁₅ and A₁₆ in Formula 9 may each independently be a C₅-C₆ carbocyclic group or a C₂-C₁₂ heterocyclic group, but embodiments of the present disclosure are not limited thereto. For example, A₁₅ and A₁₆ in Formula 9 may each independently be a C₆ carbocyclic group or a C₂-C₁₂ heterocyclic group, but embodiments of the present disclosure are not limited thereto. For example, A₁₅ and A₁₆ in Formula 9 may each independently be a C₆ carbocyclic group or a C₂-C₅ heterocyclic group, but embodiments of the present disclosure are not limited thereto.

For example, A₁₅ and A₁₆ in Formula 9 may each independently be selected from a benzene group, a cyclopentadiene group, a furan group, a thiophene group, a silole group, a dihydropyridine group, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, but embodiments of the present disclosure are not limited thereto.

In one embodiment, in Formula 9, A₁₅ may be selected from a benzene group, a pyridine group, a pyrimidine group, a pyrazine group, a pyridazine group, and a triazine group, and A₁₆ may be selected from a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group;
A₁₅ may be selected from a benzene group, a pyridine group, a pyrimidine group, a pyrazine group, a pyridazine group, and a triazine group, and A₁₆ may be selected from a benzene group, a pyridine group, a pyrimidine group, a pyrazine group, a pyridazine group, and a triazine group;
A₁₅ may be selected from a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, and A₁₆ may be selected from a benzene group, a pyridine group, a pyrimidine group, a pyrazine group, a pyridazine group, and a triazine group; or
A₁₅ may be selected from a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, and A₁₆ may be selected from a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, but embodiments of the present disclosure are not limited thereto.

In one embodiment, a substructure represented by 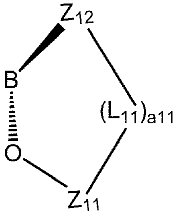 in Formula 1 may be represented by one of Formulae 9-1 to 9-112, but embodiments of the present disclosure are not limited thereto: 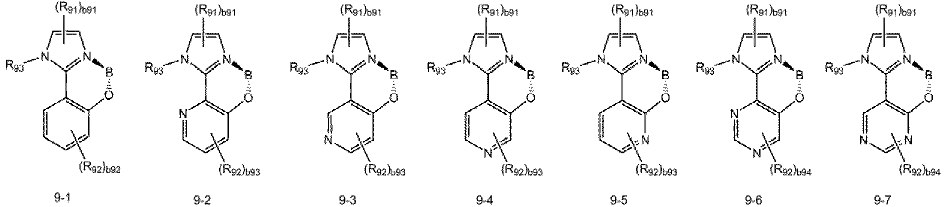 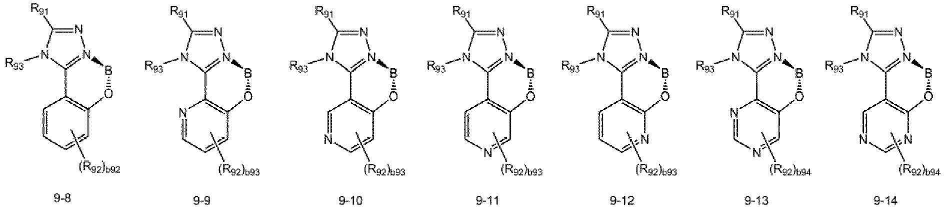 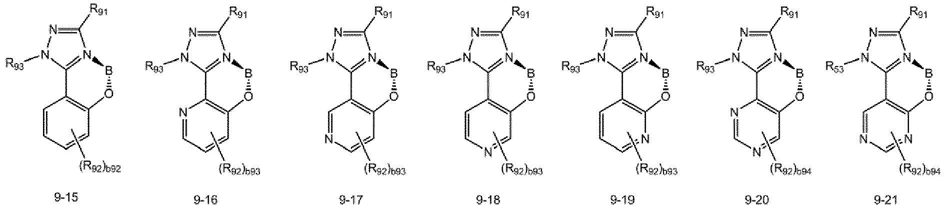 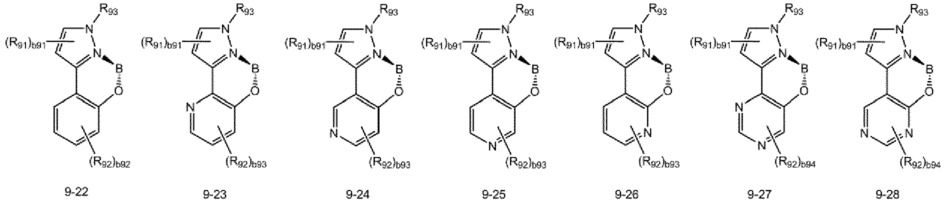 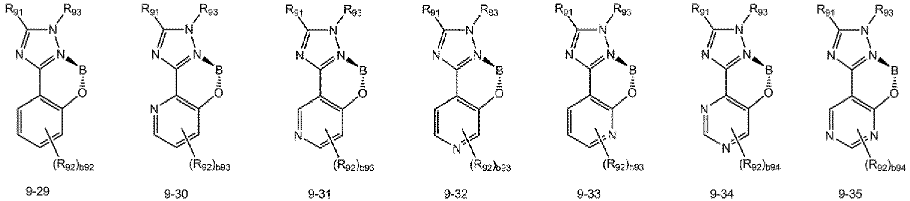 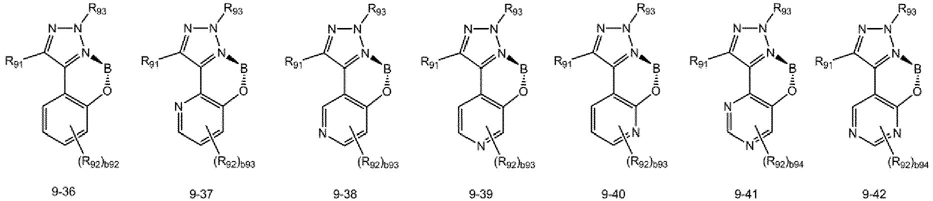 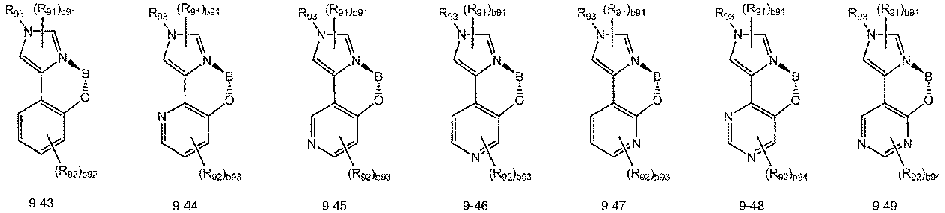 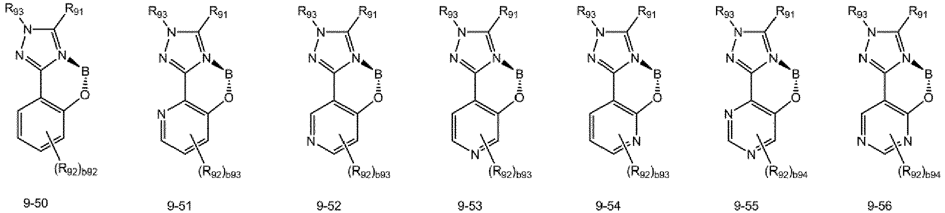 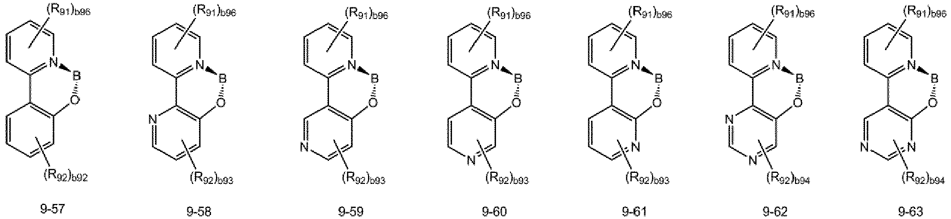 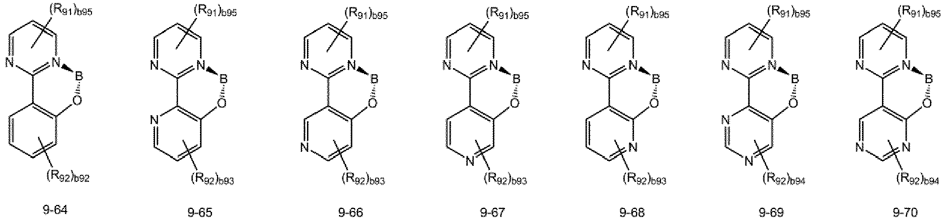 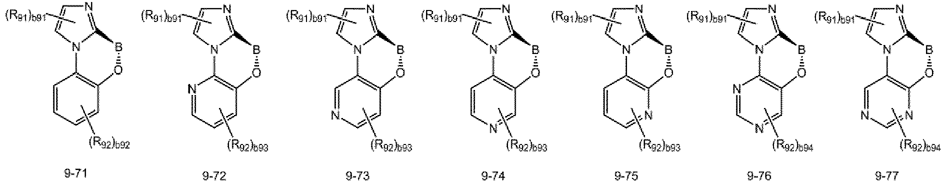 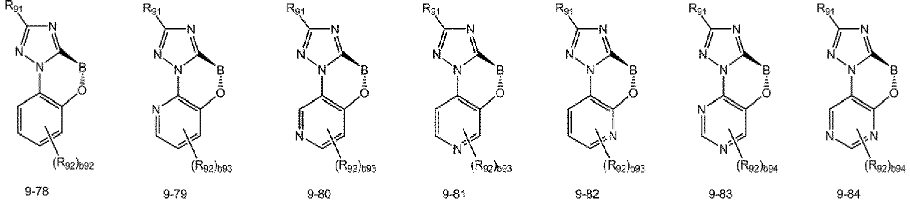 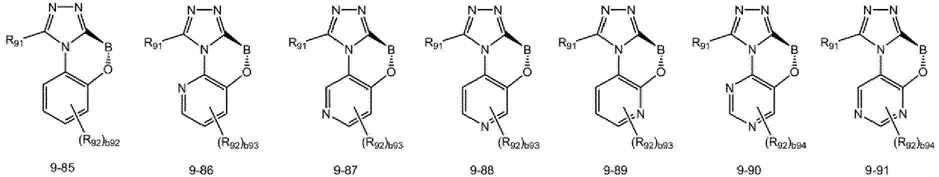 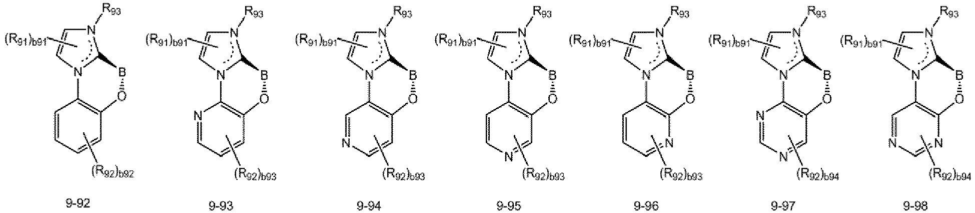 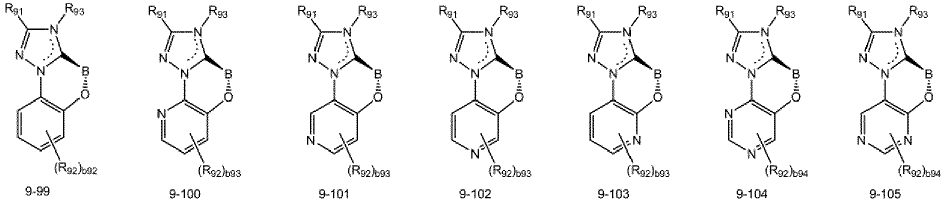 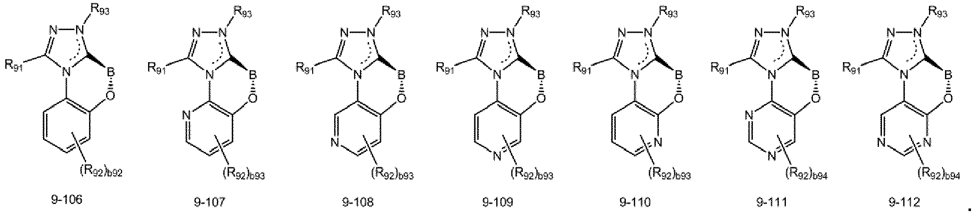 In Formulae 9-1 to 9-112,
R₉₁ to R₉₃ are each independently selected from hydrogen, -F, a cyano group, a nitro group, a methyl group, an ethyl group, a propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decanyl group, an iso-decanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, and a dibenzothiophenyl group; and
a methyl group, an ethyl group, a propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decanyl group, an iso-decanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, and a dibenzothiophenyl group, each substituted with at least one selected from -F, a cyano group, and a nitro group,
b91 and b94 are each independently 1 or 2,
b93 and b95 are each independently selected from 1, 2, and 3, and
b92 and b96 are each independently selected from 1, 2, 3, and 4.

In one embodiment, in Formula 1, a ring formed by B, O, Z₁₁, Z₁₂, and (L₁₁)ₐ₁₁ may be selected from a 5-membered ring, a 6-membered ring, a 7-membered ring, an 8-membered ring, and a 9-membered ring, but embodiments of the present disclosure are not limited thereto. For example, a ring formed by B, O, Z₁₁, Z₁₂, and (L₁₁)ₐ₁₁ may be a 6-membered ring.

T₁₁ to T₁₄ in Formula 1 are each independently selected from a single bond, O, and S.

For example, in Formula 1, T₁₁ to T₁₄ may each be a single bond;
T₁₁ may be O or S, and T₁₂ to T₁₄ may each be a single bond;
T₁₂ may be O or S, and T₁₁, T₁₃, and T₁₄ may each be a single bond;
T₁₃ may be O or S, and T₁₁, T₁₂, and T₁₄ may each be a single bond; or
T₁₄ may be O or S, and T₁₁, T₁₂, and T₁₃ may each be a single bond, but embodiments of the present disclosure are not limited thereto.

In one embodiment, T₁₁ to T₁₄ in Formula 1 may each be a single bond, but embodiments of the present disclosure are not limited thereto.

In Formula 1, L₁₁ to L₁₄ are each independently selected from a single bond, *-O-*' *-S-*', *-C(R₁₇)(R₁₈)-*', *-C(R₁₇)=*', *=C(R₁₇)-*', *-C(R₁₇)=C(R₁₈)-*', *-C(=O)-*', *-C(=S)-*', *-C=C-*', *-B(R₁₇)-*', *-N(R₁₇)-*', *-P(R₁₇)-*', *-Si(R₁₇)(R₁₈)-*', *-P(R₁₇)(R₁₈)-*', and *-Ge(Rᵢ₇)(Rᵢ₈)-*', * and *' each indicate a binding site to a neighboring atom, and R₁₇ and R₁₈ are the same as described below.

For example, L₁₁ to L₁₄ in Formula 1 may each independently be selected from a single bond, *-O-*', *-S-*', *-C(R₁₅)(R₁₆)-*', *-C(R₁₅)=*', *=C(R₁₅)-*', *-B(R₁₅)-*', *-N(R₁₅)-*', *-Si(R₁₅)(R₁₆)-*', and *-P(R₁₅)(R₁₆)-*', but embodiments of the present disclosure are not limited thereto. * and *' each indicate a binding site to a neighboring atom, and R₁₇ and R₁₈ are the same as described below.

In one embodiment, L₁₁ to L₁₄ in Formula 1 may each be a single bond, but embodiments of the present disclosure are not limited thereto.

In Formula 1, a11 to a14 are each independently selected from 0, 1, 2 and 3.

a11 in Formula 1 indicates the repeating number of L₁₁(s) and may be selected from 0, 1, 2, and 3. When a11 in Formula 1 is zero, (L₁₁)ₐ₁₁ may be a single bond. When a11 in Formula 1 is two or more, a plurality of L₁₁(s) may be identical to or different from each other.

For example, a11 in Formula 1 may be 0 or 1, but embodiments of the present disclosure are not limited thereto. For example, a11 in Formula 1 may be 0. In one or more embodiments, (L₁₁)ₐ₁₁ is a single bond.

a12, a13, and a14 in Formula 1 respectively indicate the repeating number of L₁₂(s), the repeating number of L₁₃(s), and the repeating number of L₁₄(s), and may be selected from 0, 1, 2, and 3, provided that at least two of a12, a13, and a14 are each independently selected from 1, 2, and 3. In Formula 1, when a12 is zero, A₁₁ and A₁₂ are not linked to each other, when a13 is zero, A₁₂ and A₁₃ are not linked to each other, and when a14 is zero, A₁₃ and A₁₄ are not linked to each other. When a12 in Formula 1 is two or more, a plurality of L₁₂(s) may be identical to or different from each other. When a13 in Formula 1 is two or more, a plurality of L₁₃(s) may be identical to or different from each other. When a14 in Formula 1 is two or more, a plurality of L₁₄(s) may be identical to or different from each other.

For example, the sum of a12, a13, and a14 in Formula 1 may be selected from 2, 3, 4, 5, 6, 7, and 8, but embodiments of the present disclosure are not limited thereto.

In one embodiment, in Formula 1, a12, a13, and a14 may each independently be selected from 1, 2, and 3;
a12 may be 0, and a13 and a14 may each independently be selected from 1, 2, and 3;
a13 may be 0, and a12 and a14 may each independently be selected from 1, 2, and 3; or
a14 may be 0, and a12 and a13 may each independently be selected from 1, 2, and 3, but embodiments of the present disclosure are not limited thereto.

In one embodiment, in Formula 1, a12, a13, and a14 may each be 1;
a12 may be 0, and a13 and a14 may each be 1;
a13 may be 0, and a12 and a14 may each be 1; or
a14 may be 0, and a12 and a13 may each be 1, but embodiments of the present disclosure are not limited thereto.

In Formula 1, R₁₁ to R₁₄, R₁₇, and R₁₈ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), - B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), and -P(=S)(Q₁)(Q₂),
R₁₇ and R₁₁, R₁₇ and R₁₂, R₁₇ and R₁₃, and/or R₁₇ and R₁₄ may optionally be linked to form a substituted or unsubstituted C₅-C₆₀ (*e.g.* C₅-C₂₀) carbocyclic group or a substituted or unsubstituted C₁-C₆₀ (*e.g*. C₁-C₂₀) heterocyclic group,
R₁₇ and R₁₈ may optionally be linked to form a substituted or unsubstituted C₅-C₆₀ (*e.g.* C₅-C₂₀) carbocyclic group or a substituted or unsubstituted C₁-C₆₀ (*e.g.* C₁-C₂₀) heterocyclic group, and
Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ (*e.g.* C₁-C₂₀) alkyl group, a C₂-C₆₀ (*e.g.* C₂-C₂₀) alkenyl group, a C₂-C₆₀ *(e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a C₁-C₆₀ (*e.g.* C₁-C₂₀) heteroaryloxy group, a C₁-C₆₀ (*e.g.* C₁-C₂₀) heteroarylthio group, a monovalent non-aromatic condensed polycyclic group, a monovalent non-aromatic condensed heteropolycyclic group, a C₁-C₆₀ (*e.g*. C₁-C₂₀) alkyl group substituted with at least one selected from deuterium, -F, and a cyano group, a C₆-C₆₀ (*e.g*. C₆-C₃₀) aryl group substituted with at least one selected from deuterium, -F, and a cyano group, a biphenyl group, and a terphenyl group.

For example, R₁₁ to R₁₄, R₁₇, and R₁₈ in Formula 1 may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₂-C₂₀ alkenyl group, a substituted or unsubstituted C₂-C₂₀ alkynyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted C₁-C₂₀ heteroaryloxy group, a substituted or unsubstituted C₁-C₂₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), and -P(=S)(Q₁)(Q₂).

For example, R₁₁ to R₁₄, R₁₇, and R₁₈ in Formula 1 may each independently be selected from hydrogen, deuterium, -F, -Cl, -Br, -I, a cyano group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a cyano group, a phenyl group, and a biphenyl group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, an isoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, and an indolocarbazolyl group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, an isoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, and an indolocarbazolyl group, each substituted with at least one selected from deuterium, -F, -Cl, -Br, -I, a cyano group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, an isoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, an indolocarbazolyl group, - Si(Q₃₁)(Q₃₂)(Q₃₃), -N(Q₃₁)(Q₃₂), -B(Q₃₁)(Q₃₂), -C(=O)(Q₃₁), -S(=O)(Q₃₁), -S(=O)₂(Q₃₁), - P(=O)(Q₃₁)(Q₃₂), and -P(=S)(Q₃₁)(Q₃₂); and
-Si(Q₁)(Q₂)(Q₃), -B(Q₁)(Q₂), -N(Q₁)(Q₂), -P(Q₁)(Q₂), -C(=O)(O₁), -S(=O)(Q₁), - S(=O)₂(Q₁), -P(=O)(Q₁)(Q₂), and -P(=S)(Q₁)(Q₂), and
Q₁ to Q₃ and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ (*e.g*. C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a C₁-C₆₀ (*e.g.* C₁-C₂₀) heteroaryloxy group, a C₁-C₆₀ (*e.g*. C₁-C₂₀) heteroarylthio group, a monovalent non-aromatic condensed polycyclic group, a monovalent non-aromatic condensed heteropolycyclic group, a C₁-C₆₀ (*e.g*. C₁-C₂₀) alkyl group substituted with at least one selected from deuterium, -F, and a cyano group, a C₆-C₆₀ (*e.g*. C₆-C₃₀) aryl group substituted with at least one selected from deuterium, -F, and a cyano group, a biphenyl group, and a terphenyl group, but embodiments of the present disclosure are not limited thereto.

In one embodiment, R₁₁ to R₁₄, R₁₇, and R₁₈ in Formula 1 may each independently be selected from:
hydrogen, deuterium, -F, -Cl, -Br, -I, a cyano group, and a C₁-C₂₀ alkyl group;
a C₁-C₂₀ alkyl group, substituted with at least one selected from deuterium, - F, -Cl, -Br, -I, and a cyano group;
groups represented by Formulae 5-1 to 5-138; and
-Si(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), and -P(=S)(Q₁)(Q₂), but embodiments of the present disclosure are not limited thereto: 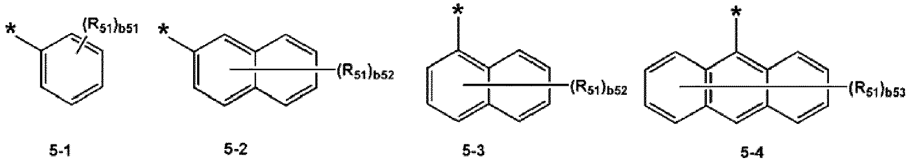 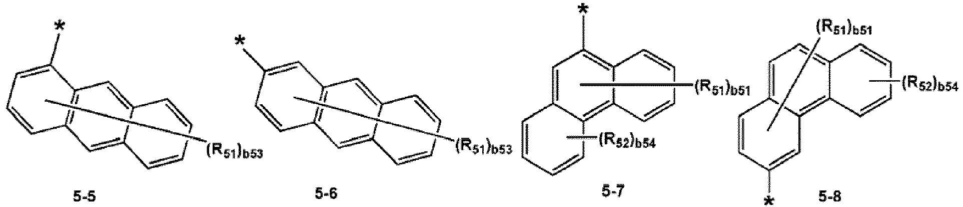 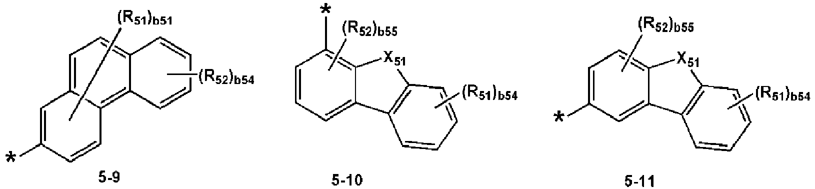 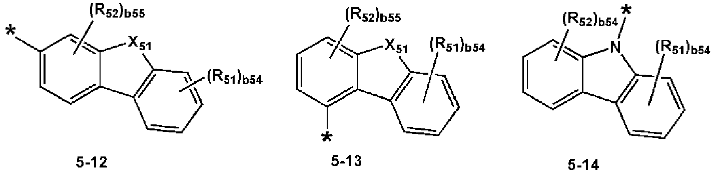 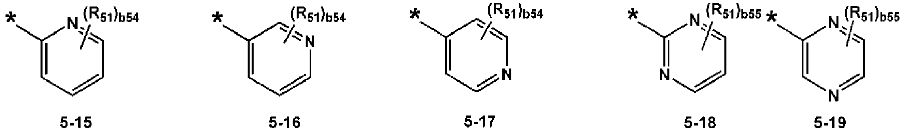 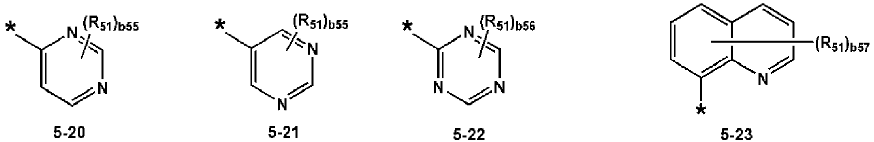 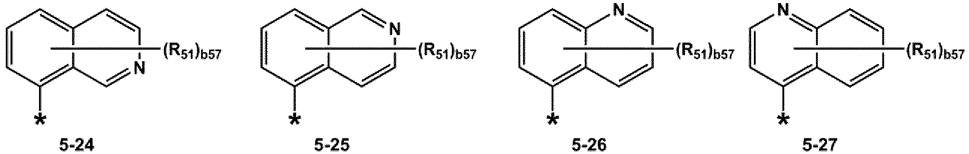 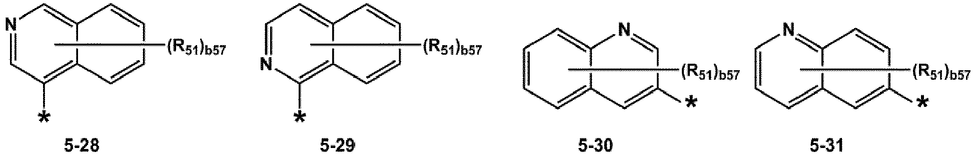 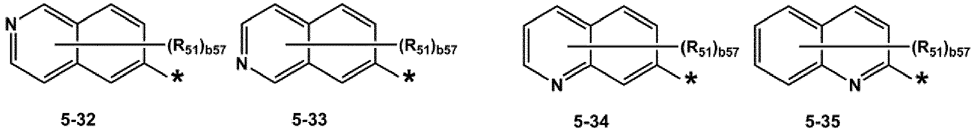 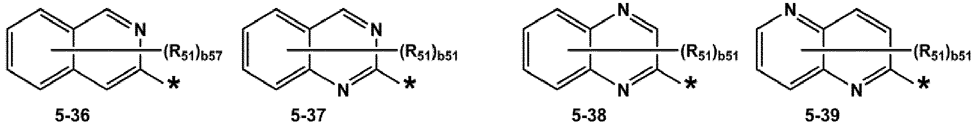 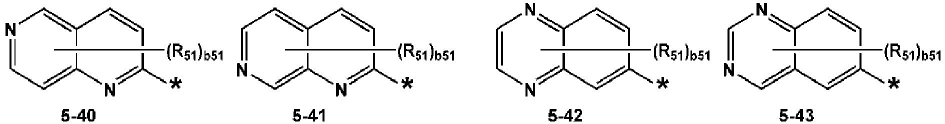 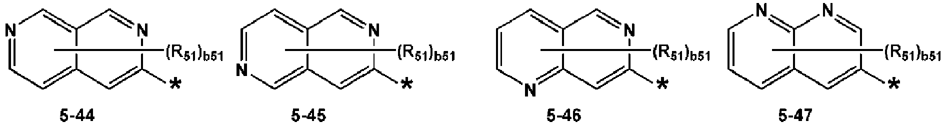 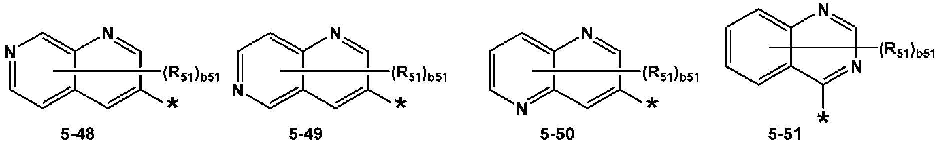 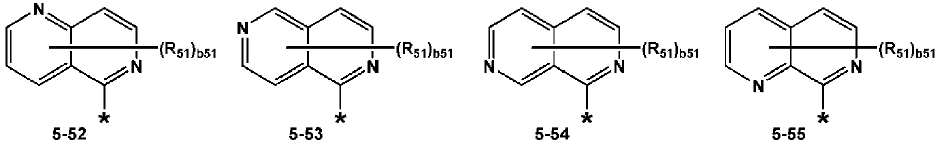 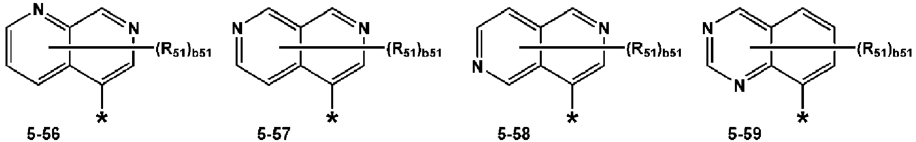 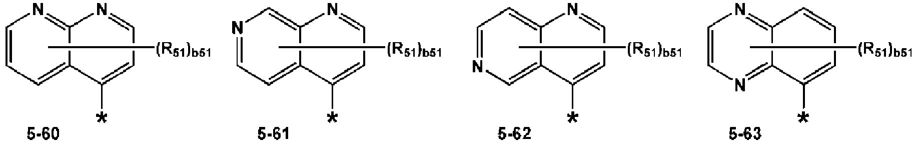 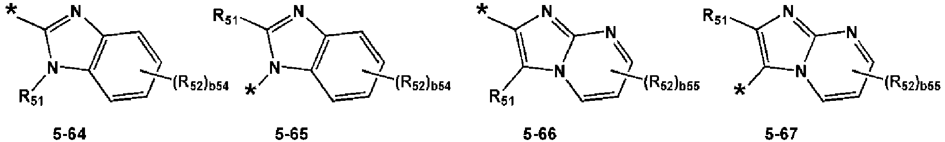 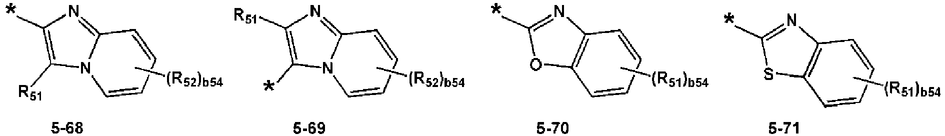 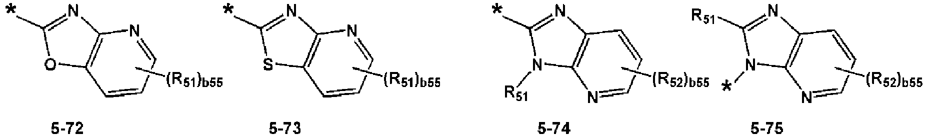 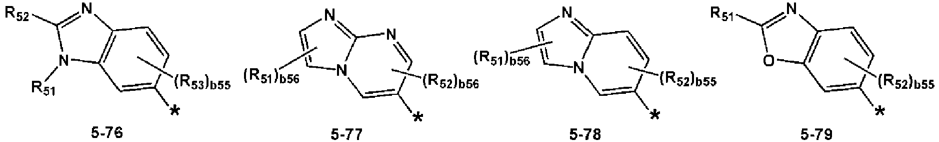 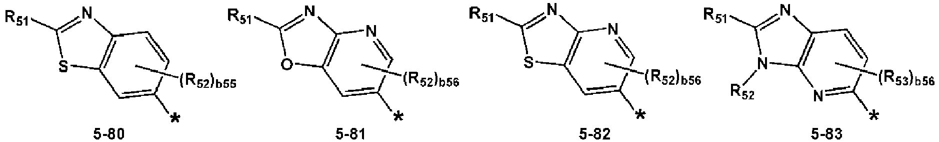 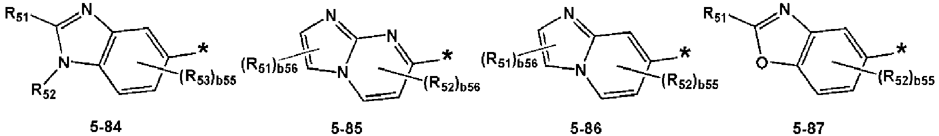 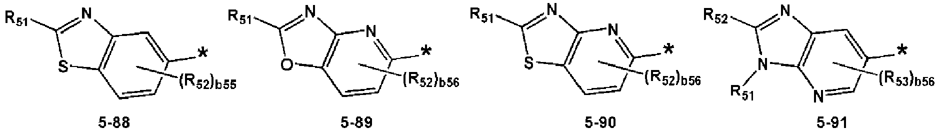 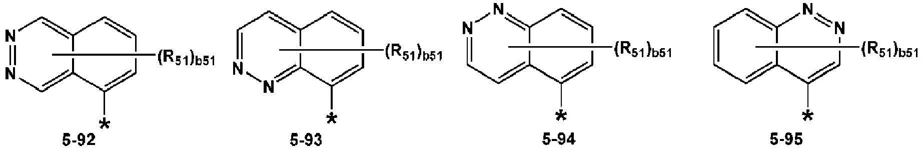 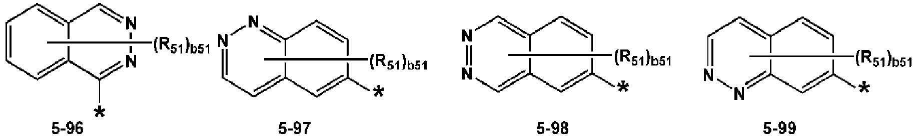 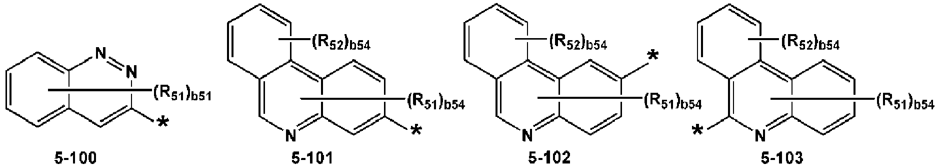 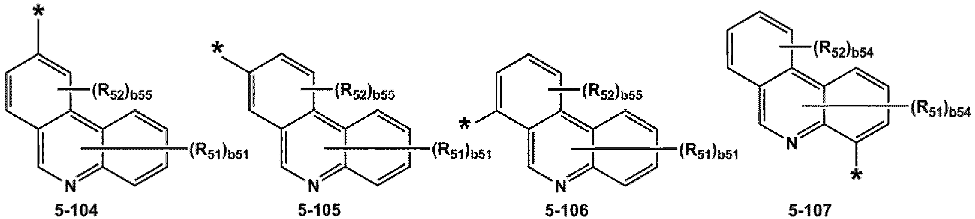 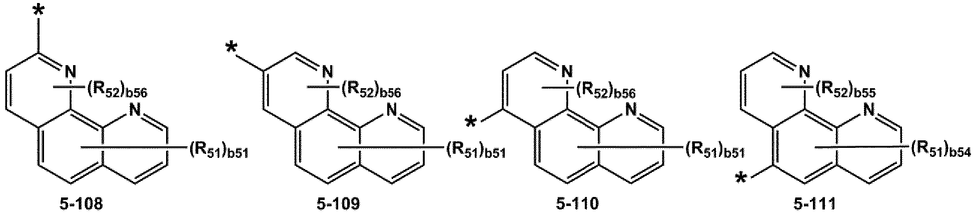 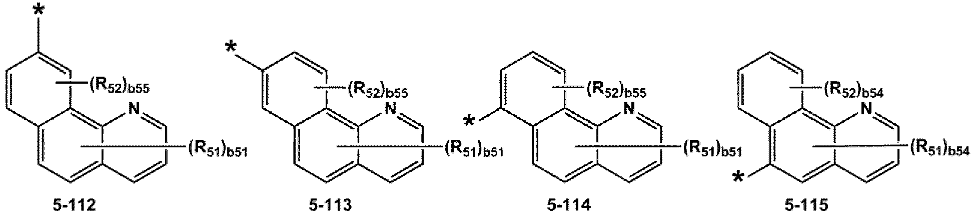 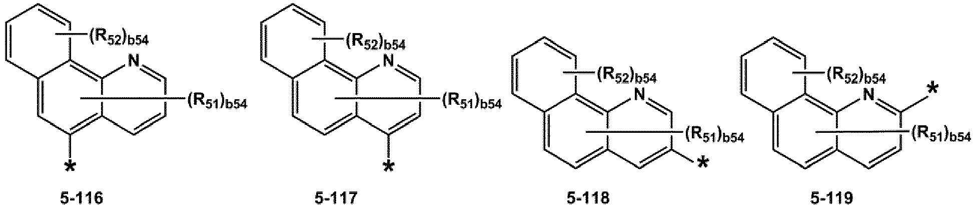 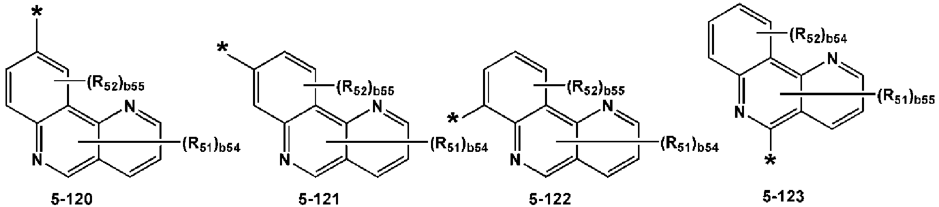 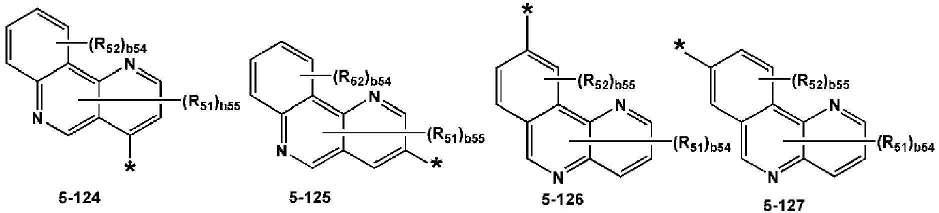 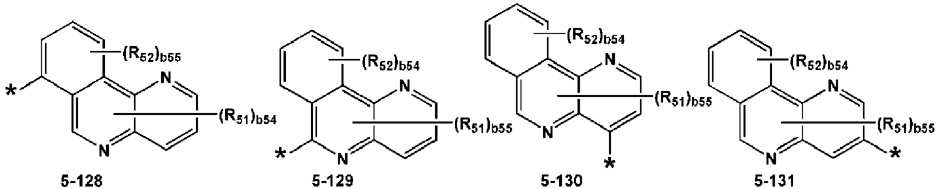 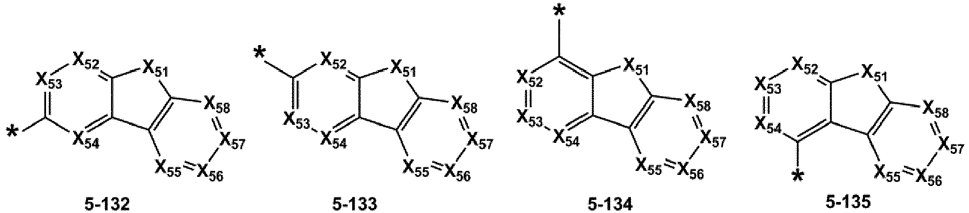 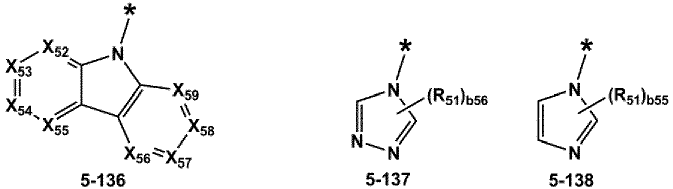 In Formulae 5-1 to 5-138,
   X₅₁ is selected from O, S, N(R₅₁), and C(R₅₁)(R₆₀),
   X₅₂ is N or C(R₅₂), X₅₃ is N or C(R₅₃), X₅₄ is N or C(R₅₄), X₅₅ is N or C(R₅₅), X₅₆ is N or C(R₅₆), X₅₇ is N or C(R₅₇), X₅₈ is N or C(R₅₈), and X₅₉ is N or C(R₅₉),
   R₅₁ to R₆₀ are each independently selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a thiophenyl group, a furanyl group, a silolyl group, a carbazolyl group, an indolyl group, an isoindolyl group, a benzofuranyl group, a benzothiophenyl group, a benzosilolyl group, a dibenzofuranyl group, a dibenzothiophenyl group, a benzocarbazolyl group, a dibenzocarbazolyl group, a dibenzosilolyl group, -Si(Q₃₁)(Q₃₂)(Q₃₃), -B(Q₃₁)(Q₃₂), -N(Q₃₁)(Q₃₂), - P(Q₃₁)(Q₃₂), -C(=O)(Q₃₁), -S(=O)(Q₃₁), -S(=O)₂(Q₃₁), -P(=O)(Q₃₁)(Q₃₂), and - P(=S)(Q₃₁)(Q₃₂);
   Q₁ to Q₃ and Q₃₁ to Q₃₃ are each independently be selected from a C₁-C₆₀ (*e.g*. C₁-C₂₀) alkyl group, a phenyl group, a biphenyl group, and a terphenyl group,
   b51 is selected from 1, 2, 3, 4, and 5,
   b52 is selected from 1, 2, 3, 4, 5, 6, and 7,
   b53 is selected from 1, 2, 3, 4, 5, 6, 7, and 9,
   b54 is selected from 1, 2, 3, and 4,
   b55 is selected from 1, 2, and 3,
   b56 is 1 or 2,
   b57 is selected from 1, 2, 3, 4, 5, and 6, and
   * indicates a binding site to a neighboring atom.

In one embodiment, R₁₁ to R₁₄, R₁₇, and R₁₈ in Formula 1 may each independently be selected from:
hydrogen, deuterium, -F, -Cl, -Br, -I, a cyano group, a methyl group, an ethyl group, an n-propyl group, an iso-propyl group, an n-butyl group, an iso-butyl group, a sec-butyl group, and a tert-butyl group;
a methyl group, an ethyl group, an n-propyl group, an iso-propyl group, an n-butyl group, an iso-butyl group, a sec-butyl group, and a tert-butyl group, each substituted with at least one selected from deuterium, -F, -CI, -Br, -I, and a cyano group; and
a phenyl group, a naphthyl group, and a pyridinyl group,
but embodiments of the present disclosure are not limited thereto.
b11, b12, b13, and b14 in Formula 1 respectively indicate the number of R₁₁(s), the number of R₁₂(s), the number of R₁₃(s), and the number of R₁₄(s), and b11 to b14 are each independently selected from 1, 2, 3, 4, 5, 6, 7, and 8. When b11 is two or more, a plurality of R₁₁(s) may be identical to or different from each other. When b12 is two or more, a plurality of R₁₂(s) may be identical to or different from each other. When b13 is two or more, a plurality of R₁₃(s) may be identical to or different from each other. When b14 is two or more, a plurality of R₁₄(s) may be identical to or different from each other.

For example, the organometallic compound represented by Formula 1 may be represented by one of Formulae 1-1 to 1-4 below, but embodiments of the present disclosure are not limited thereto: 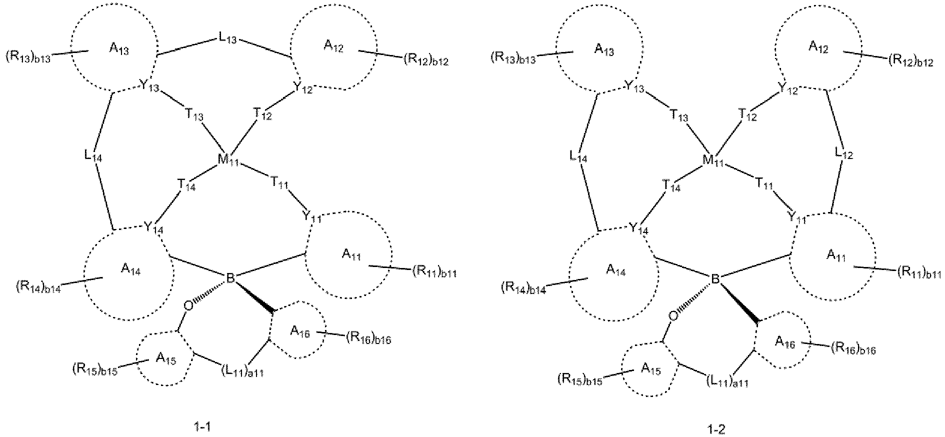 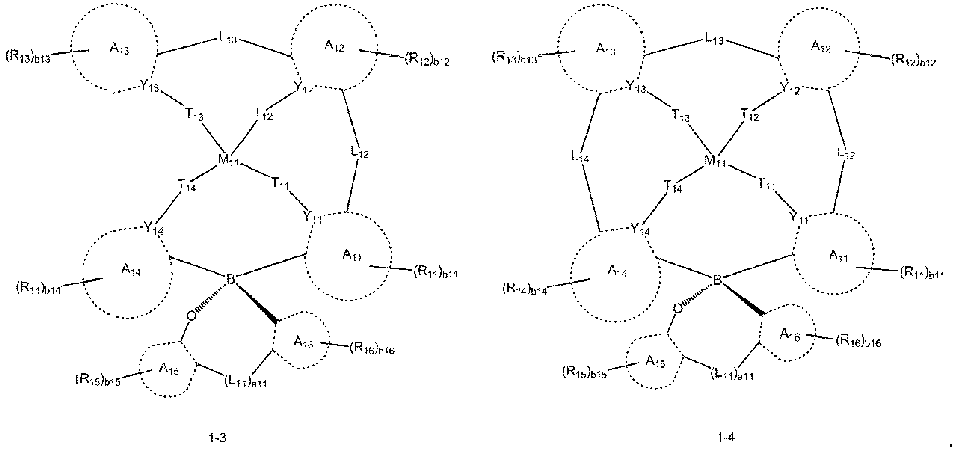 In Formulae 1-1 to 1-4,
M₁₁, A₁₁ to A₁₄, Y₁₁ to Y₁₄, T₁₁ to T₁₄, L₁₁ to L₁₄, a11 to a14, R₁₁ to R₁₄, and b11 to b14 are each independently the same as described in Formula 1,
A₁₅ and A₁₆ are each independently a C₅-C₆₀ carbocyclic group or a C₁-C₆₀ heterocyclic group,
R₁₅ and R₁₆ are each independently the same as described in connection with R₁₁ in Formula 1, and
b15 and b16 are each independently the same as described in connection with b11 in Formula 1.

For example, A₁₅ and A₁₆ in Formulae 1-1 to 1-4 may each independently be a C₅-C₂₀ carbocyclic group or a C₁-C₂₀ heterocyclic group, but embodiments of the present disclosure are not limited thereto. For example, A₁₅ and A₁₆ in Formulae 1-1 to 1-4 may each independently be a C₅-C₁₀ carbocyclic group or a C₁-C₁₂ heterocyclic group, but embodiments of the present disclosure are not limited thereto. For example, A₁₅ and A₁₆ in Formulae 1-1 to 1-4 may each independently be a C₅-C₁₀ carbocyclic group or a C₂-C₁₂ heterocyclic group, but embodiments of the present disclosure are not limited thereto. For example, A₁₅ and A₁₆ in Formulae 1-1 to 1-4 may each independently be a C₅-C₆ carbocyclic group or a C₂-C₁₂ heterocyclic group, but embodiments of the present disclosure are not limited thereto. For example, A₁₅ and A₁₆ in Formulae 1-1 to 1-4 may each independently be a C₆ carbocyclic group or a C₂-C₁₂ heterocyclic group, but embodiments of the present disclosure are not limited thereto. For example, A₁₅ and A₁₆ in Formulae 1-1 to 1-4 may each independently be a C₆ carbocyclic group or a C₂-C₅ heterocyclic group, but embodiments of the present disclosure are not limited thereto.

In one embodiment, the organometallic compound represented by Formula 1 may be represented by one of Formulae 1-11 to 1-14, but embodiments of the present disclosure are not limited thereto: 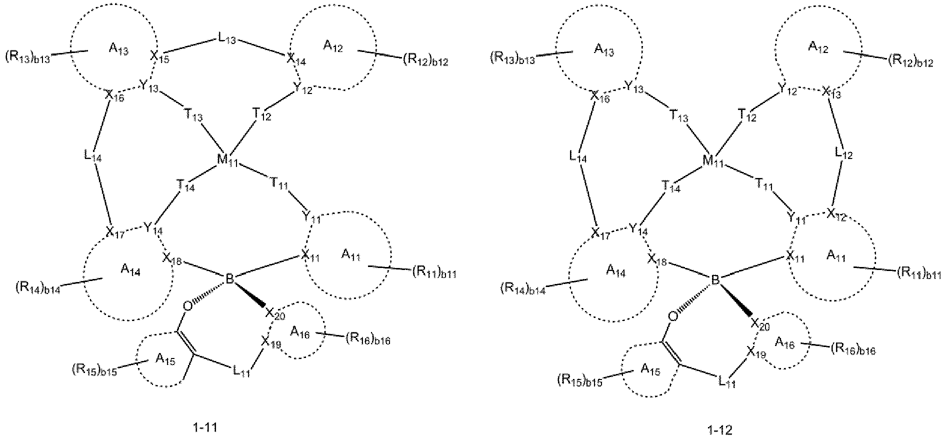 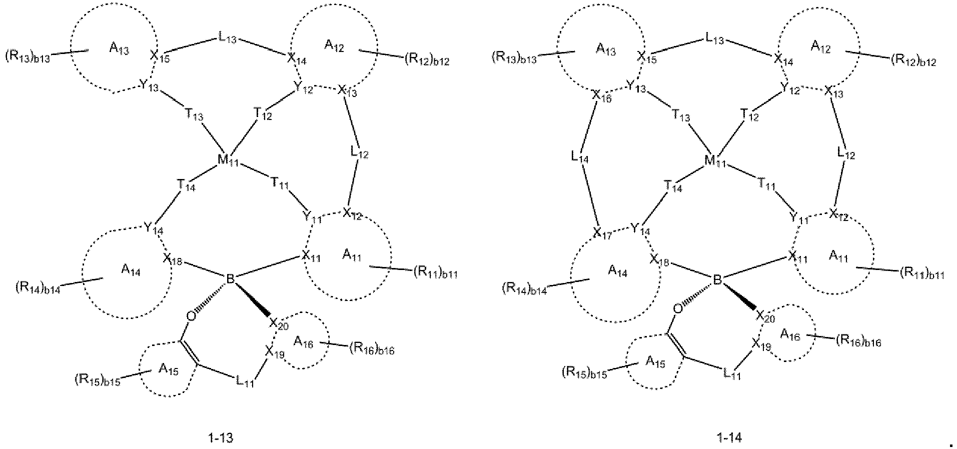 In Formulae 1-11 to 1-14,
M₁₁ is selected from Pt, Pd, Cu, Ag, Au, Rh, Ir, Ru, and Os,
X₁₁ to X₂₀ are each independently N or C,
Y₁₁, Y₁₂, and Y₁₃ may each be C, and Y₁₄ may be N;
Y₁₁, Y₁₂, and Y₁₄ may each be C, and Y₁₃ may be N;
Y₁₁, Y₁₃, and Y₁₄ may each be C, and Y₁₂ may be N;
Y₁₂, Y₁₃, and Y₁₄ may each be C, and Y₁₁ may be N;
Y₁₁ and Y₁₄ may each be C, and Y₁₂ and Y₁₃ may each be N;
Y₁₁ and Y₁₄ may each be N, and Y₁₂ and Y₁₃ may each be C;
Y₁₁ and Y₁₂ may be C, and Y₁₃ and Y₁₄ may each be N;
Y₁₁ and Y₁₂ may each be N, and Y₁₃ and Y₁₄ may each be C;
Y₁₁ and Y₁₃ may each be C, and Y₁₂ and Y₁₄ may each be N; or
Y₁₁ and Y₁₃ may each be N, and Y₁₂ and Y₁₄ may each be C,
T₁₁ to T₁₄ may each be a single bond;
T₁₁ may be O or S, and T₁₂ to T₁₄ may each be a single bond;
T₁₂ may be O or S, and T₁₁, T₁₃, and T₁₄ may each be a single bond;
T₁₃ may be O or S, and T₁₁, T₁₂, and T₁₄ may each be a single bond; or
T₁₄ may be O or S, and T₁₁, T₁₂, and T₁₃ may each be a single bond,
A₁₁ to A₁₄, L₁₁ to L₁₄, R₁₁ to R₁₄, and b11 to b14 are each independently the same as described in Formula 1,
A₁₅ and A₁₆ are each independently a C₅-C₆₀ carbocyclic group or a C₁-C₆₀ heterocyclic group,
R₁₅ and R₁₆ are each independently the same as described in connection with R₁₁ in Formula 1, and
b15 and b16 are each independently the same as described in connection with b11 in Formula 1.

For example, M₁₁ in Formulae 1-11 to 1-14 may be selected from Pt, Pd, Cu, Ag, and Au, but embodiments of the present disclosure are not limited thereto.

For example, A₁₅ and A₁₆ in Formulae 1-11 to 1-14 may each independently be a C₅-C₂₀ carbocyclic group or a C₁-C₂₀ heterocyclic group, but embodiments of the present disclosure are not limited thereto. For example, A₁₅ and A₁₆ in Formulae 1-11 to 1-14 may each independently be a C₅-C₁₀ carbocyclic group or a C₁-C₁₂ heterocyclic group, but embodiments of the present disclosure are not limited thereto. For example, A₁₅ and A₁₆ in Formulae 1-11 to 1-14 may each independently be a C₅-C₁₀carbocyclic group or a C₂-C₁₂ heterocyclic group, but embodiments of the present disclosure are not limited thereto. For example, A₁₅ and A₁₆ in Formulae 1-11 to 1-14 may each independently be a C₅-C₆ carbocyclic group or a C₂-C₁₂ heterocyclic group, but embodiments of the present disclosure are not limited thereto. For example, A₁₅ and A₁₆ in Formulae 1-11 to 1-14 may each independently be a C₆ carbocyclic group or a C₂-C₁₂ heterocyclic group, but embodiments of the present disclosure are not limited thereto. For example, A₁₅ and A₁₆ in Formulae 1-11 to 1-14 may each independently be a C₆ carbocyclic group or a C₂-C₅ heterocyclic group, but embodiments of the present disclosure are not limited thereto.

For example, in Formula 1-11 to 1-14, A₁₁ to A₁₄ may each independently be selected from a benzene group, a naphthalene group, an indene group, a fluorene group, an indole group, a carbazole group, a benzofuran group, a dibenzofuran group, a benzothiophene group, a dibenzothiophene group, a pyridine group, a pyrimidine group, a pyrazine group, a triazine group, a quinoline group, an isoquinoline group, a quinoxaline group, a quinazoline group, a pyrazole group, an imidazole group, a 2,3-dihydroimidazole group, a triazole group, a 2,3-dihydrotriazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, and a 2,3-dihydroimidazopyrazine group, and

A₁₅ and A₁₆ may each independently be selected from a benzene group, a cyclopentadiene group, a furan group, a thiophene group, a silole group, a dihydropyridine group, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, but embodiments of the present disclosure are not limited thereto.

In one embodiment, the organometallic compound represented by Formula 1 may be represented by one of Formulae 1-21 to 1-24, but embodiments of the present disclosure are not limited thereto: 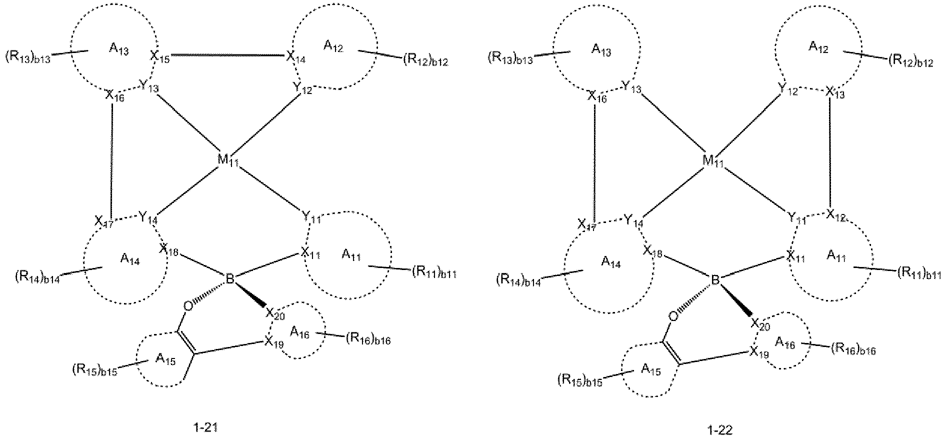 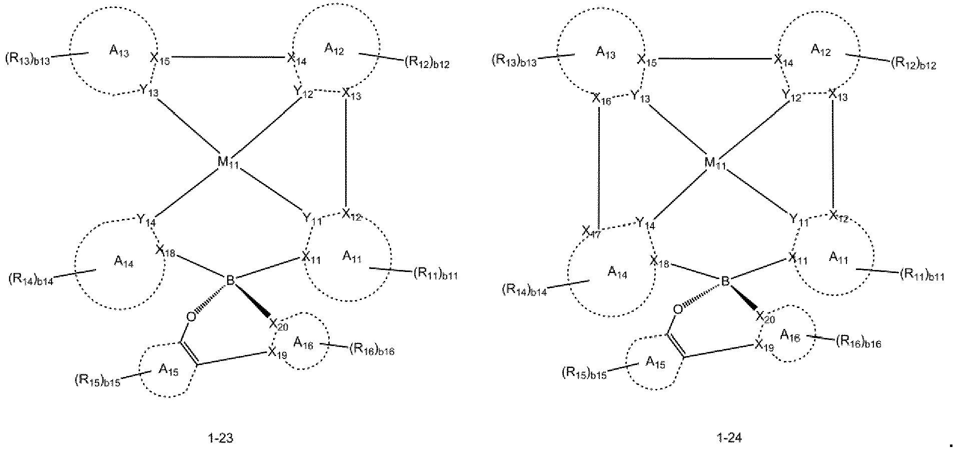 In Formulae 1-21 to 1-24,
M₁₁ is selected from Pt, Pd, Cu, Ag, Au, Rh, Ir, Ru, and Os,
X₁₁ to X₂₀ are each independently N or C,
Y₁₁, Y₁₂, and Y₁₃ may each be C, and Y₁₄ may be N;
Y₁₁, Y₁₂, and Y₁₄ may each be C, and Y₁₃ may be N;
Y₁₁, Y₁₃, and Y₁₄ may each be C, and Y₁₂ may be N;
Y₁₂, Y₁₃, and Y₁₄ may each be C, and Y₁₁ may be N;
Y₁₁ and Y₁₄ may each be C, and Y₁₂ and Y₁₃ may each be N;
Y₁₁ and Y₁₄ may each be N, and Y₁₂ and Y₁₃ may each be C;
Y₁₁ and Y₁₂ may each be C, and Y₁₃ and Y₁₄ may each be N;
Y₁₁ and Y₁₂ may each be N, and Y₁₃ and Y₁₄ may each be C;
Y₁₁ and Y₁₃ may each be C, and Y₁₂ and Y₁₄ may each be N; or
Y₁₁ and Y₁₃ may each be N, and Y₁₂ and Y₁₄ may each be C,
A₁₁ to A₁₄ are each independently selected from a benzene group, a naphthalene group, an indene group, a fluorene group, an indole group, a carbazole group, a benzofuran group, a dibenzofuran group, a benzothiophene group, a dibenzothiophene group, a pyridine group, a pyrimidine group, a pyrazine group, a triazine group, a quinoline group, an isoquinoline group, a quinoxaline group, a quinazoline group, a pyrazole group, an imidazole group, a 2,3-dihydroimidazole group, a triazole group, a 2,3-dihydrotriazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, and a 2,3-dihydroimidazopyrazine group,
A₁₅ and A₁₆ are each independently selected from a benzene group, a cyclopentadiene group, a furan group, a thiophene group, a silole group, a dihydropyridine group, a pyridine group, a pyrimidine group, a pyrazine group, a pyridazine group, a triazine group, a quinoline group, an isoquinoline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group,
R₁₁ to R₁₄ and b11 to b14 are each independently the same as described in Formula 1,
R₁₅ and R₁₆ are each independently the same as described in connection with R₁₁ in Formula 1, and
b15 and b16 are each independently the same as described in connection with b11 in Formula 1.

For example, M₁₁ in Formulae 1-21 to 1-24 may be selected from Pt, Pd, Cu, Ag, and Au, but embodiments of the present disclosure are not limited thereto.

For example, R₁₁ to R₁₈ in Formulae 1-21 to 1-24 may each independently be selected from:
hydrogen, deuterium, -F, -Cl, -Br, -I, a cyano group, a methyl group, an ethyl group, an n-propyl group, an iso-propyl group, an n-butyl group, an iso-butyl group, a sec-butyl group, and a tert-butyl group;
a methyl group, an ethyl group, an n-propyl group, an iso-propyl group, an n-butyl group, an iso-butyl group, a sec-butyl group, and a tert-butyl group, each substituted with at least one selected from deuterium, -F, -Cl, -Br, -I, and a cyano group; and
a phenyl group, a naphthyl group, and a pyridinyl group,
but embodiments of the present disclosure are not limited thereto.

In one embodiment, the organometallic compound represented by Formula 1 may be selected from Compounds 1 to 250, but embodiments of the present disclosure are not limited thereto:

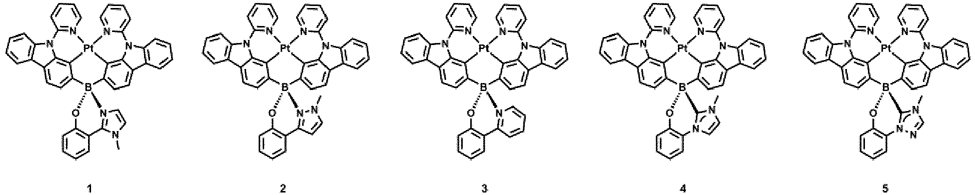

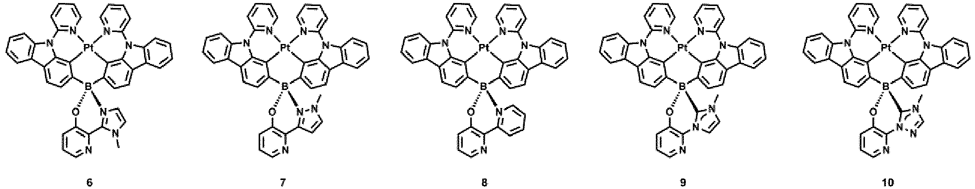

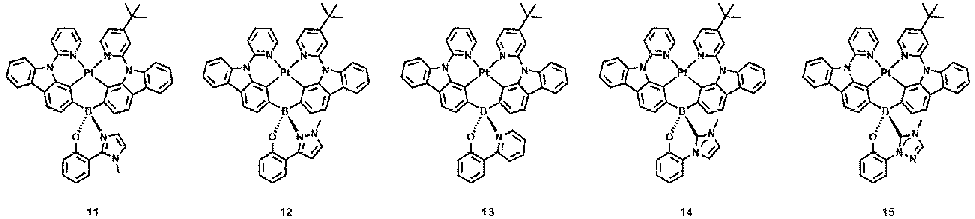

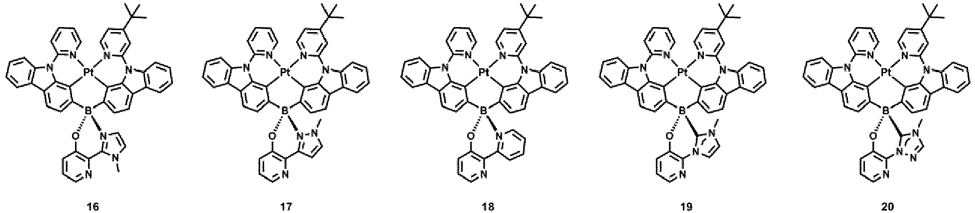

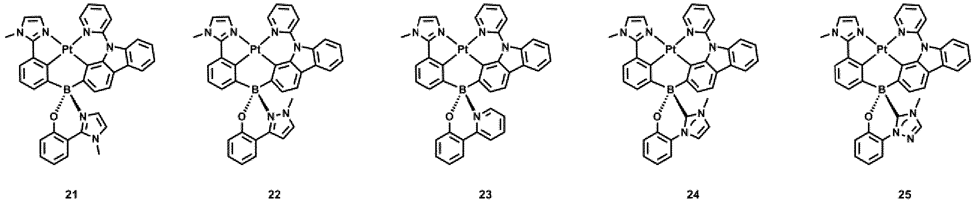

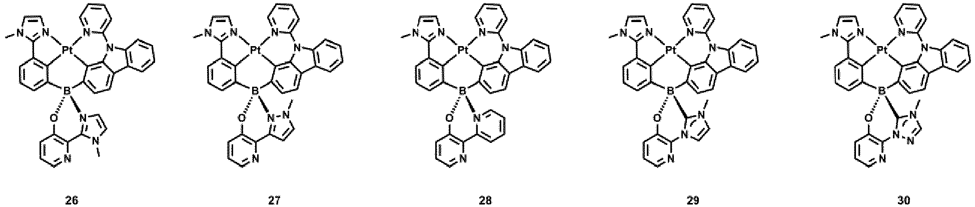

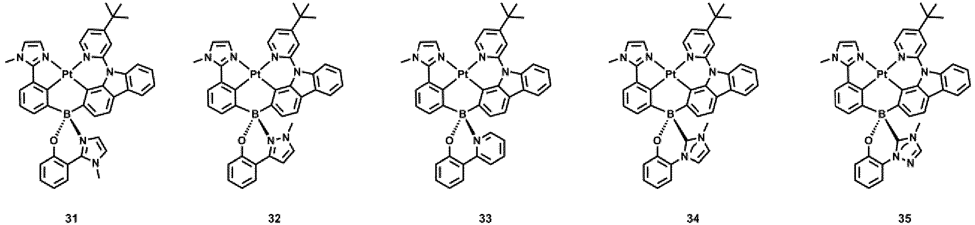

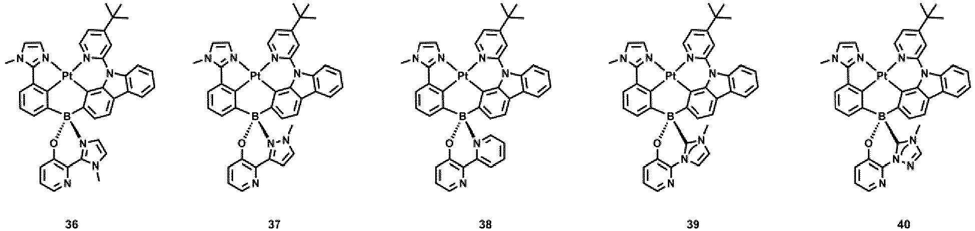

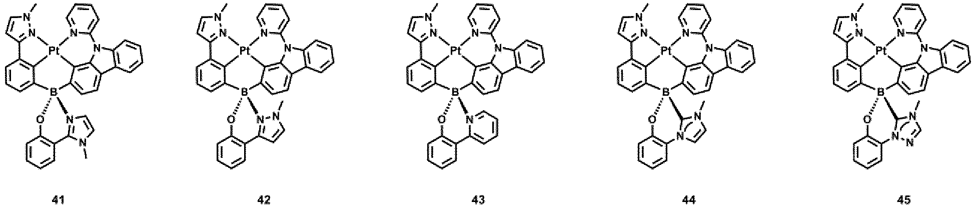

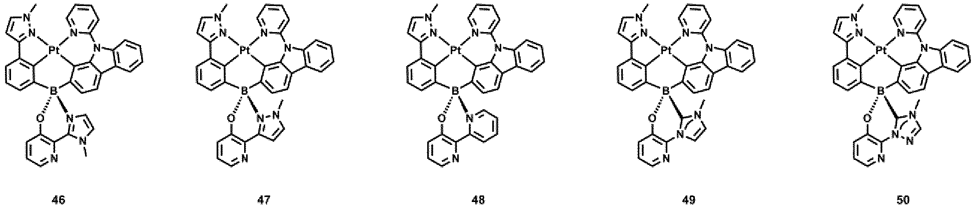

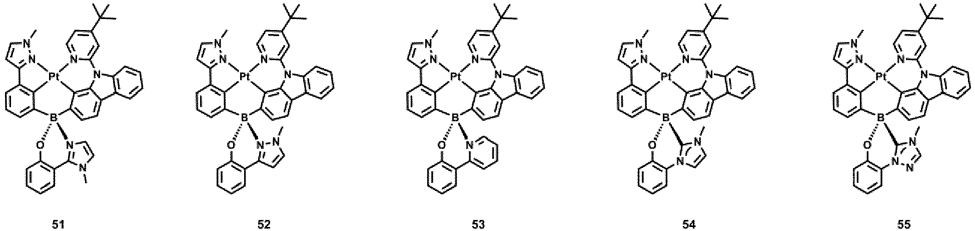

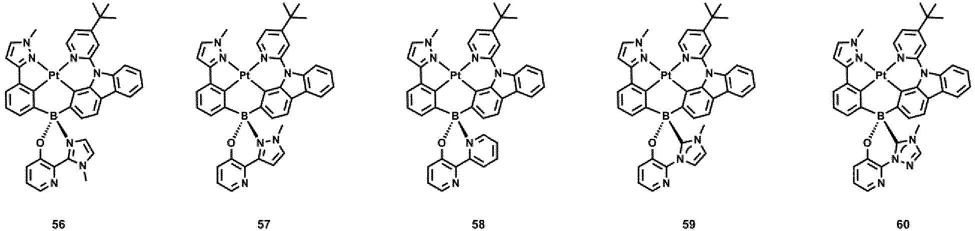

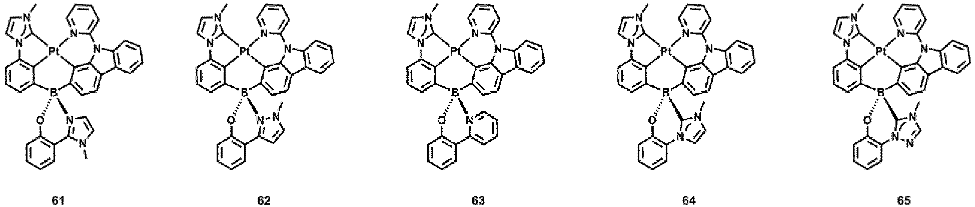

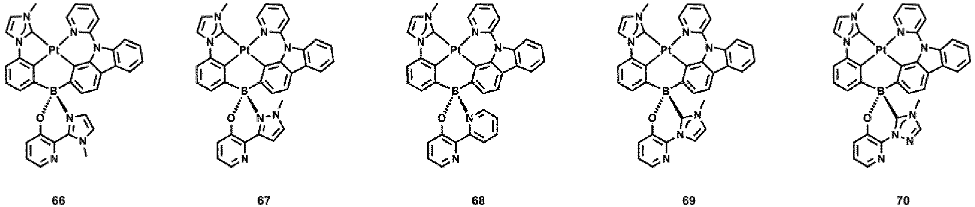

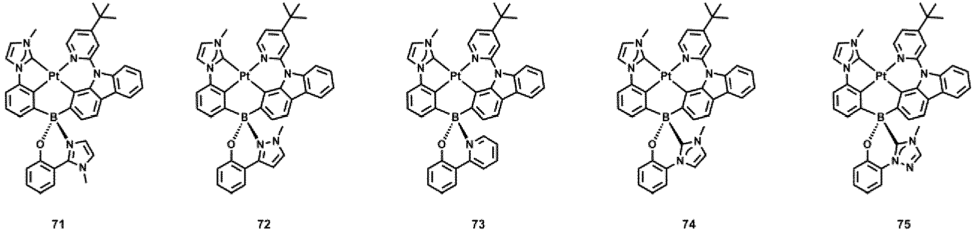

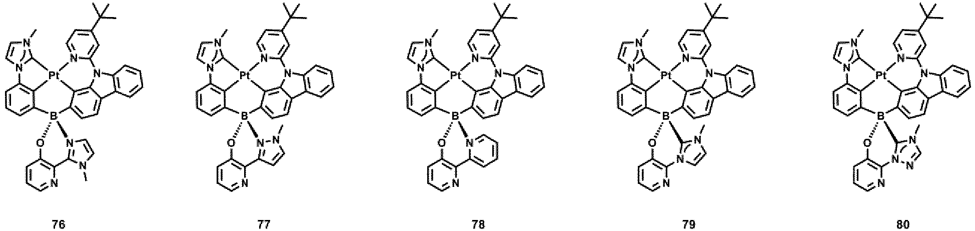

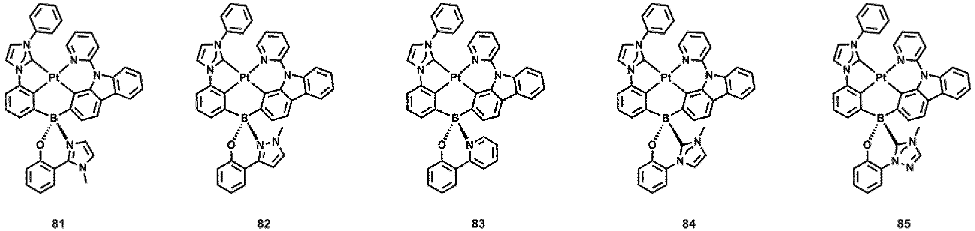

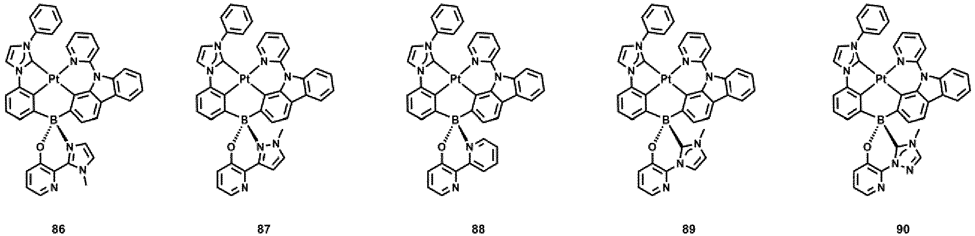

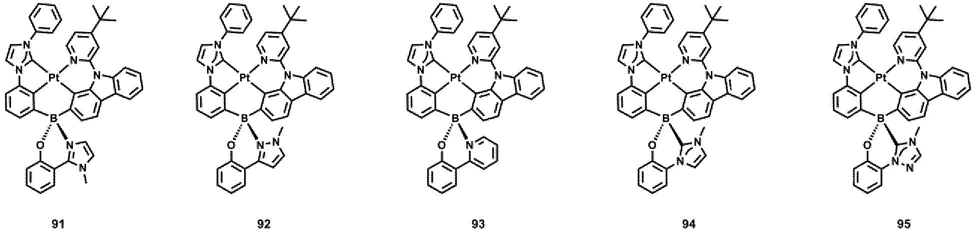

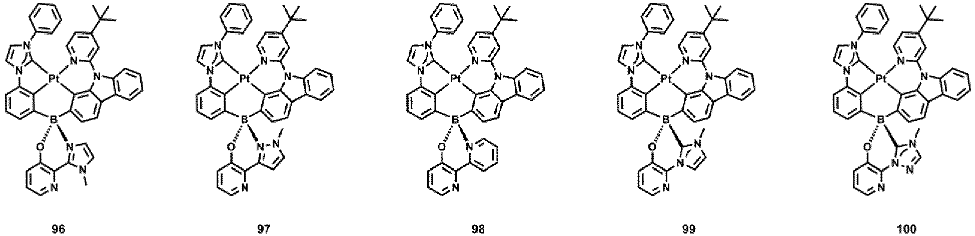

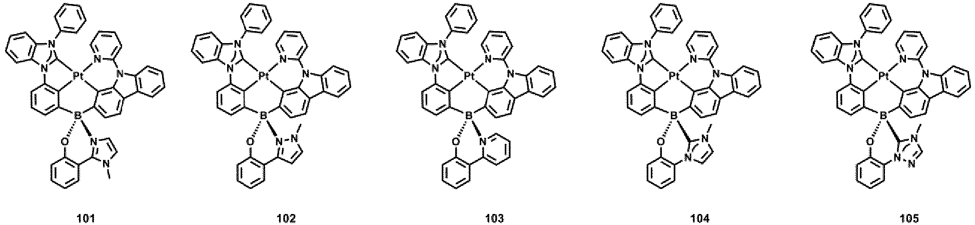

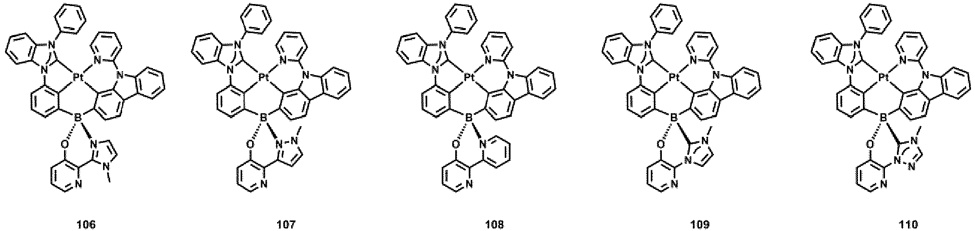

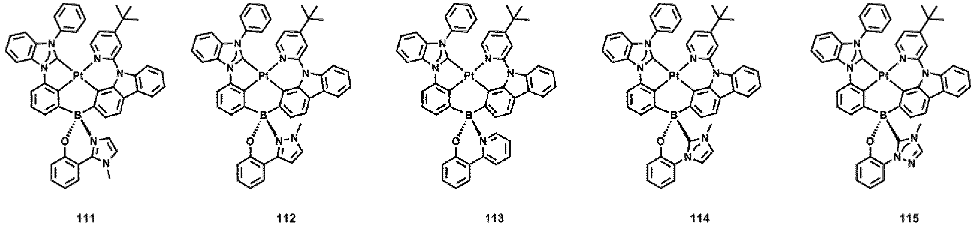

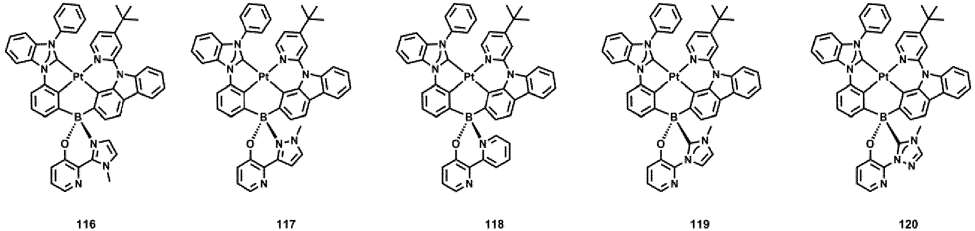

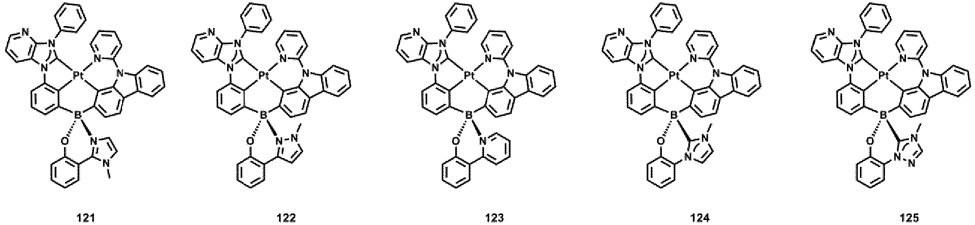

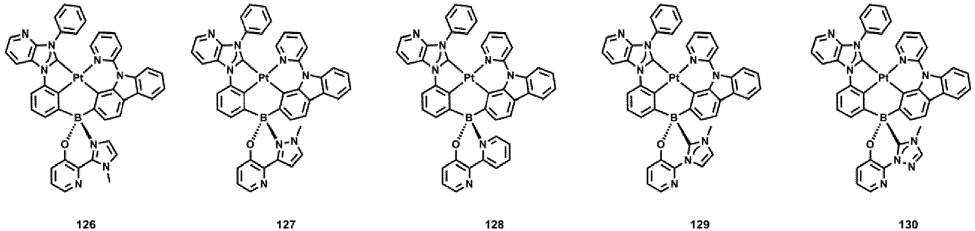

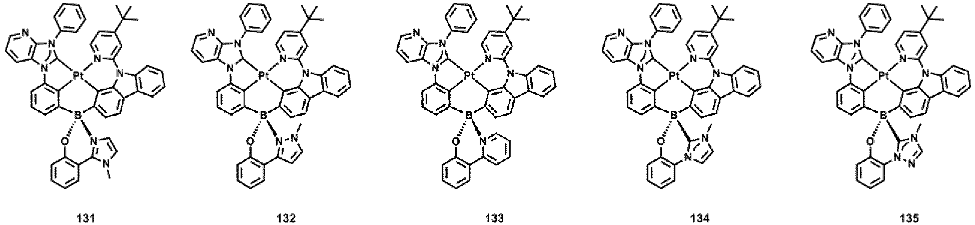

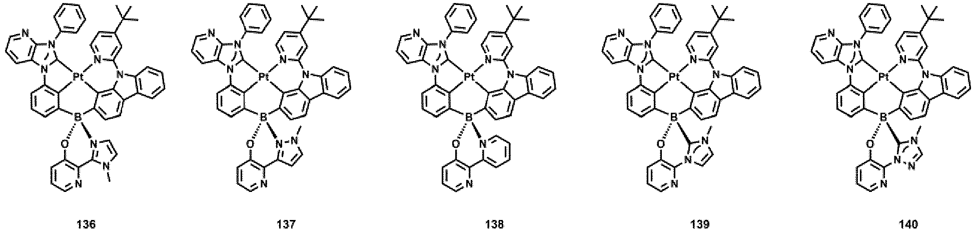

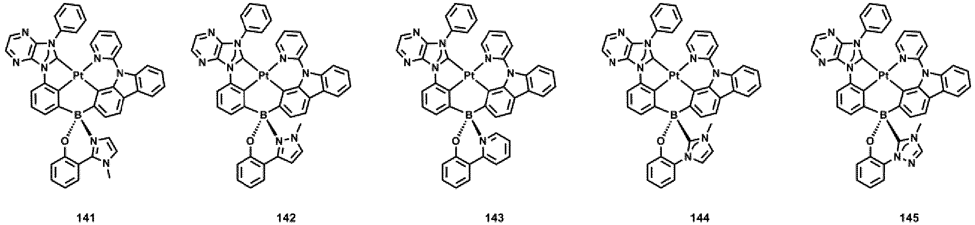

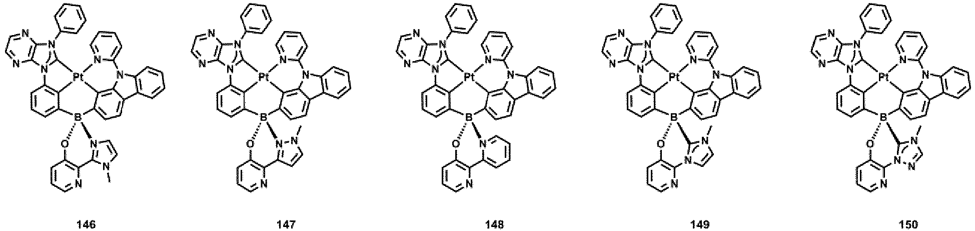

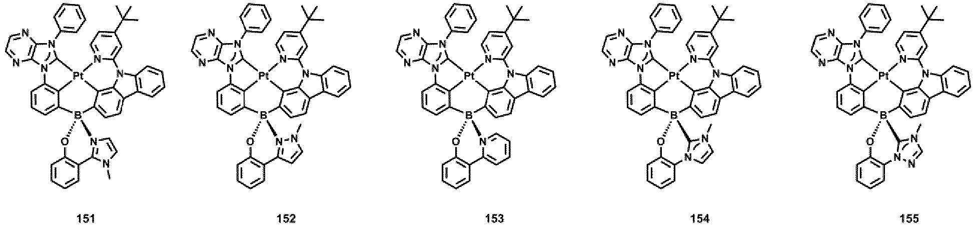

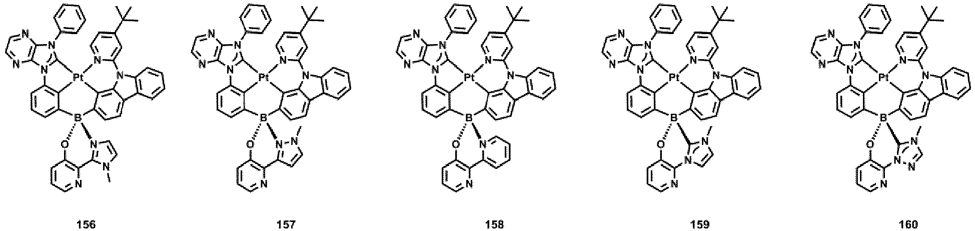

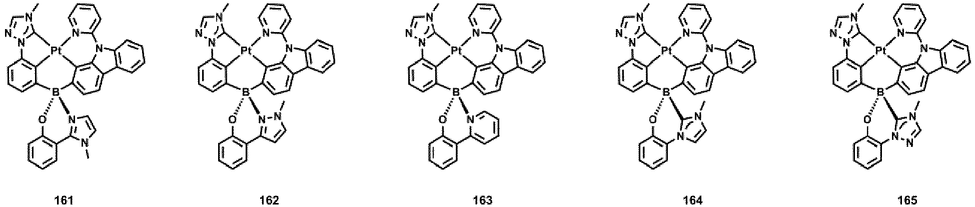

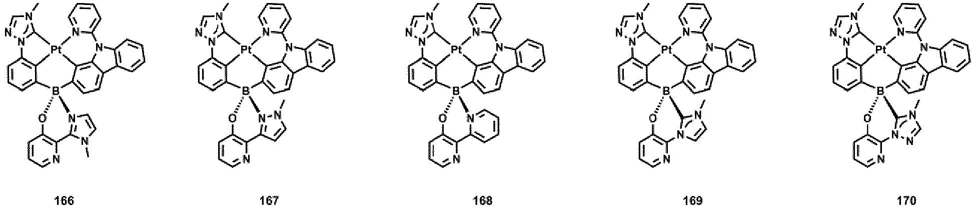

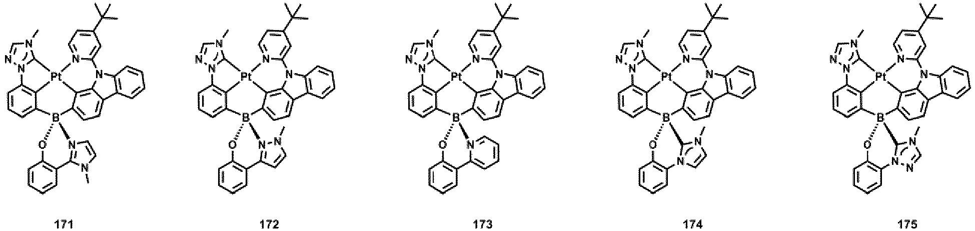

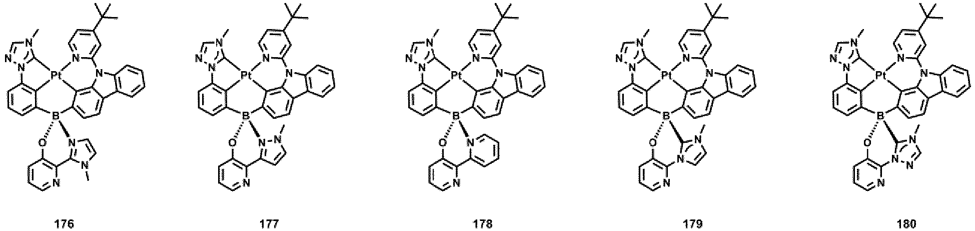

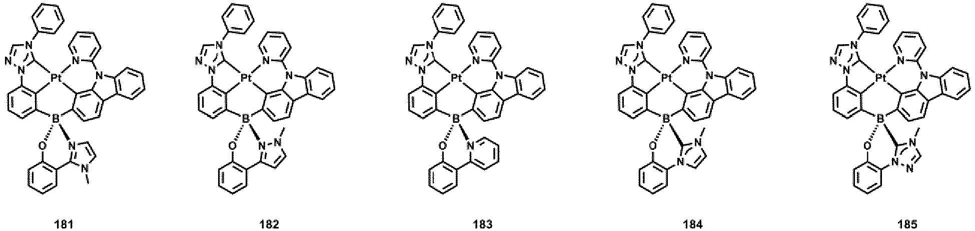

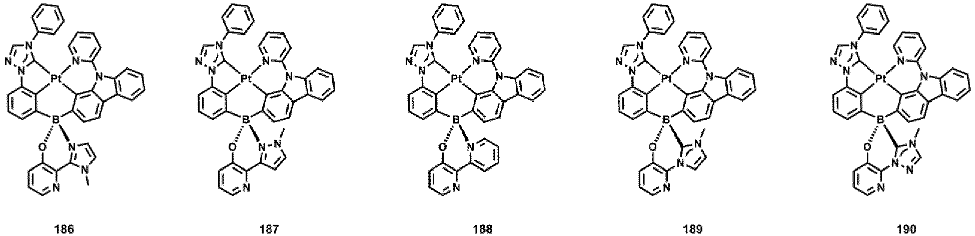

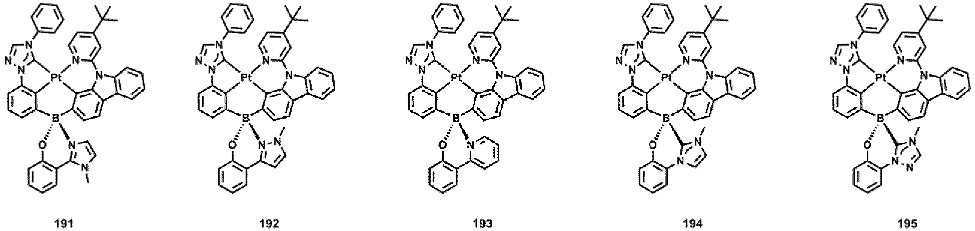

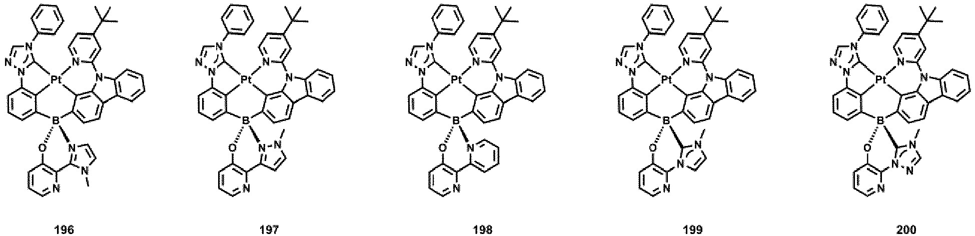

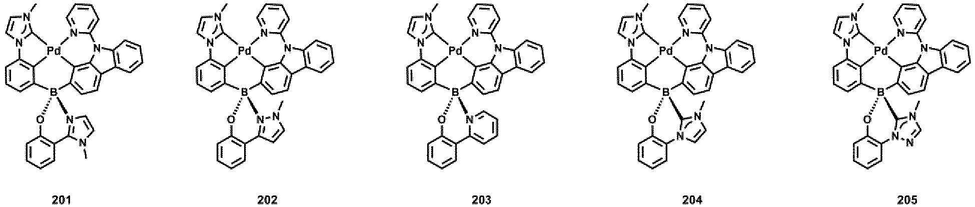

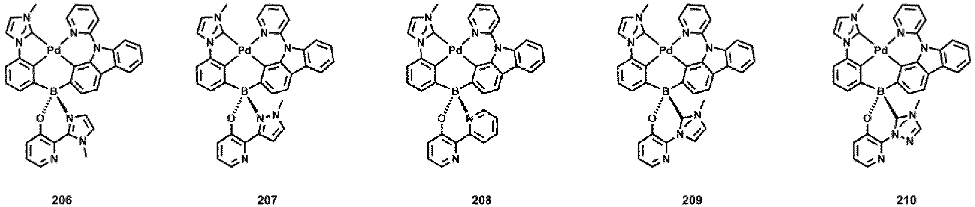

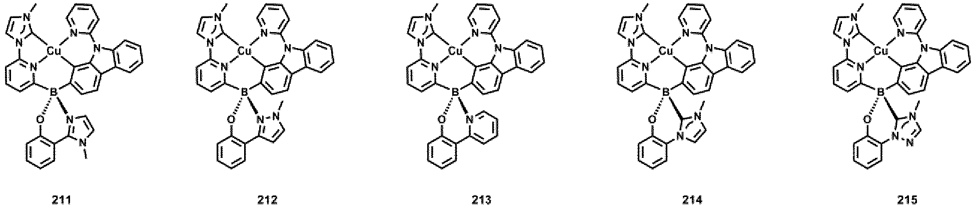

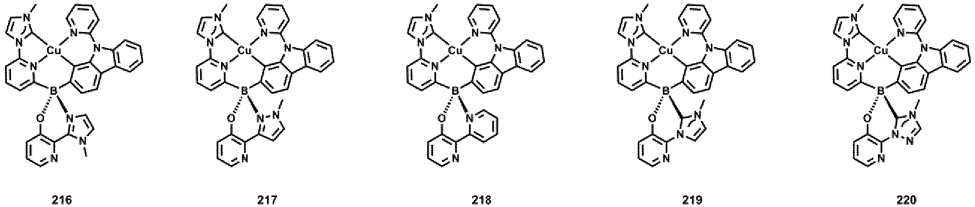

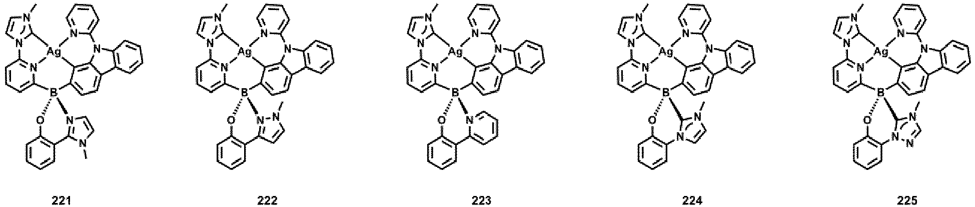

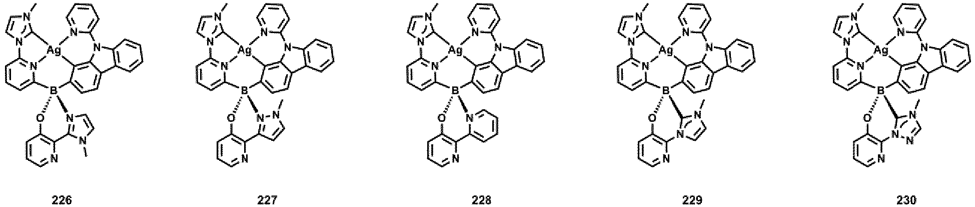

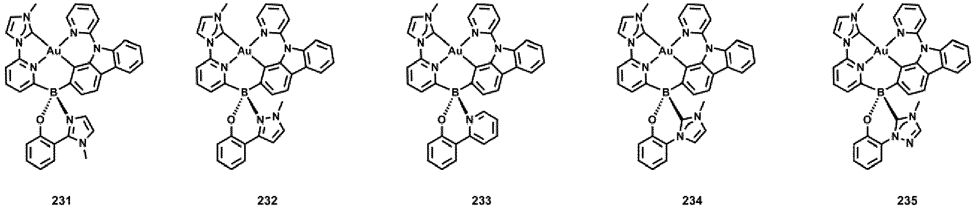

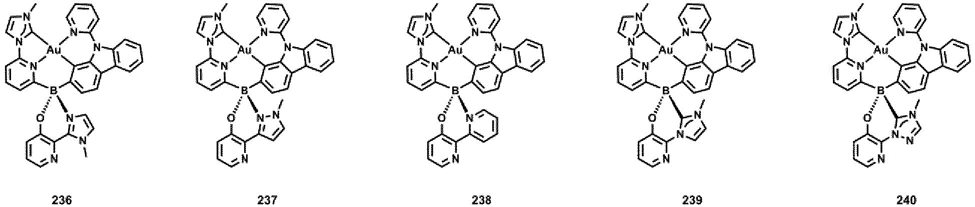

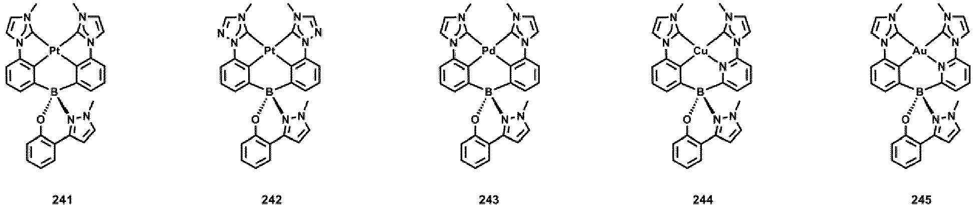

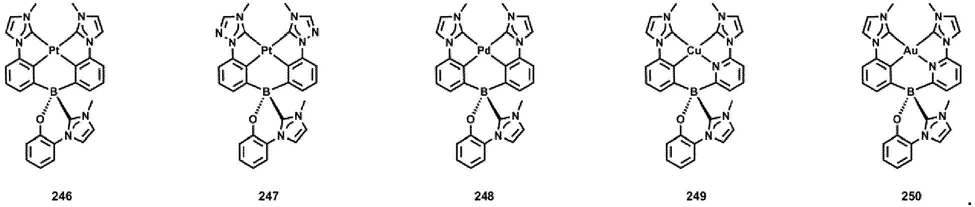

The organometallic compound represented by Formula 1 may emit visible light having an upper (e.g., a maximum) emission wavelength of greater than or equal to 380 nm to less than 800 nm. For example, the organometallic compound represented by Formula 1 may emit blue light having an upper (e.g., a maximum) emission wavelength of greater than or equal to 450 nm to less than 490 nm, green light having an upper (e.g., a maximum) emission wavelength of greater than or equal to 500 nm to less than 550 nm, or red light having an upper (e.g., a maximum) emission wavelength of greater than or equal to 620 nm to less than 790 nm, but embodiments of the present disclosure are not limited thereto.

The organometallic compound represented by Formula 1 essentially includes a substructure represented by 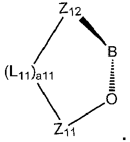 While the present disclosure is not limited to any particular mechanism or theory, it is believed that due to the presence of the foregoing substructure, in the organometallic compound represented by Formula 1, a first plane including A₁₁ to A₁₄ and a second plane including O, Z₁₁, Z₁₂, and (L₁₁)ₐ₁₁ are disposed to be not in parallel. Thus, it is possible to reduce an electron density of boron and also satisfy chemical and/or physical stability to the extent that an organometallic compound can exist. Due to a low electron density of boron, the organometallic compound represented by Formula 1 may emit deep blue light.

Also, since the organometallic compound represented by Formula 1 has a relatively great structural steric hindrance (e.g., a relatively large structural steric hindrance compared to similar compounds that do not include the foregoing substructure), it is possible to suppress or reduce interaction between the organometallic compounds represented by Formula 1 and/or between the organometallic compound represented by Formula 1 and the host. Therefore, since the formation of excimer and/or exciplex therebetween is reduced, an organic light-emitting device including the organometallic compound represented by Formula 1 may have high optical characteristics such as improved luminescent efficiency.

Also, since the organometallic compound represented by Formula 1 is chemically and/or physically stable, the lifespan of an organic light-emitting device including the organometallic compound may be improved.

In addition, the organometallic compound represented by the Formula 1 may have a lowest excited triplet energy level (T₁) and a lowest excited singlet energy level (S₁) suitable or appropriate for metal-assisted delayed fluorescence (MADF), that is, suitably or sufficiently close T₁ and S₁ (e.g., T₁ and S₁ are suitably close to one another in terms of energy), depending on a type or kind of a metal element. Therefore, the organometallic compound represented by Formula 1 may emit both phosphorescence and fluorescence. Accordingly, the efficiency of an organic light-emitting device including the organometallic compound represented by Formula 1 may be improved.

The organometallic compound represented by Formula 1 may be synthesized by using any suitable organic synthetic method available in the art. A synthesis method of the organometallic compound may be recognizable by one of ordinary skill in the art in view of the following embodiments.

The organometallic compound represented by Formula 1 may be used between a pair of electrodes of an organic light-emitting device.

Accordingly, another aspect of embodiments provides an organic light-emitting device that includes: a first electrode; a second electrode; and an organic layer that is disposed between the first electrode and the second electrode and includes an organic layer including an emission layer, and the organic layer includes at least one of the organometallic compound represented by Formula 1.

In an embodiment, the emission layer may include the organometallic compound, but embodiments of the present disclosure are not limited thereto.

In one or more embodiments, the emission layer may include a host and the organometallic compound, and an amount of the host in the emission layer may be greater than that of the organometallic compound in the emission layer, but embodiments of the present disclosure are not limited thereto.

In one or more embodiments, the emission layer may further include at least one of a phosphorescent dopant and a fluorescent dopant.

The expression "(an organic layer) includes at least one of organometallic compounds," as used herein, may include a case in which "(an organic layer) includes identical organometallic compounds represented by Formula 1" and a case in which "(an organic layer) includes two or more different organometallic compounds represented by Formula 1."

For example, the organic layer may include, as the organometallic compound, only Compound 1. In this regard, Compound 1 may exist in an emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 may all exist in an emission layer), or different layers (for example, Compound 1 may exist in an emission layer and Compound 2 may exist in an electron transport layer).

The organic layer includes i) a hole transport region that is disposed between the first electrode (anode) and the emission layer and includes at least one of a hole injection layer, a hole transport layer, a buffer layer, and an electron blocking layer, and ii) an electron transport region that is disposed between the emission layer and the second electrode (cathode) and includes at least one selected from a hole blocking layer, an electron transport layer, and an electron injection layer. The emission layer may include at least one of the organometallic compounds represented by Formula 1.

The term "organic layer," as used herein, refers to a single layer and/or a plurality of layers disposed between the first electrode and the second electrode of the organic light-emitting device. A material included in the "organic layer" is not limited to an organic material.

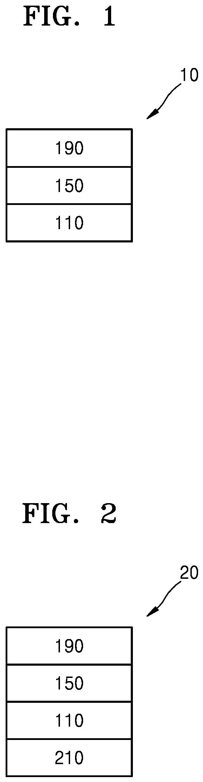

### [Description of the FIG. 1]

FIG. 1 is a schematic view of an organic light-emitting device 10 according to an embodiment. The organic light-emitting device 10 includes a first electrode 110, an organic layer 150, and a second electrode 190.

Hereinafter, the structure of the organic light-emitting device 10 according to an embodiment and a method of manufacturing the organic light-emitting device 10 will be described in connection with the FIG. 1.

### [First electrode 110]

In FIG. 1, a substrate may be additionally disposed under the first electrode 110 or above the second electrode 190. The substrate may be a glass substrate or a plastic substrate, each having excellent mechanical strength, thermal stability, transparency, surface smoothness, ease of handling, and water resistance.

The first electrode 110 may be formed by depositing or sputtering a material for forming the first electrode 110 on the substrate. When the first electrode 110 is an anode, the material for a first electrode may be selected from materials with a high work function to facilitate hole injection.

The first electrode 110 may be a reflective electrode, a semi-transmissive electrode, or a transmissive electrode. When the first electrode 110 is a transmissive electrode, a material for forming a first electrode may be selected from indium tin oxide (ITO), indium zinc oxide (IZO), tin oxide (SnO₂), zinc oxide (ZnO), and any combinations thereof, but embodiments of the present disclosure are not limited thereto. In one or more embodiments, when the first electrode 110 is a semi-transmissive electrode or a reflexive electrode, a material for forming a first electrode may be selected from magnesium (Mg), silver (Ag), aluminium (Al), aluminium-lithium (Al-Li), calcium (Ca), magnesium-indium (Mg-In), magnesium-silver (Mg-Ag), and any combinations thereof, but embodiments of the present disclosure are not limited thereto.

The first electrode 110 may have a single-layered structure, or a multi-layered structure including two or more layers. For example, the first electrode 110 may have a three-layered structure of ITO/Ag/ITO, but the structure of the first electrode 110 is not limited thereto.

### [Organic layer 150]

The organic layer 150 is disposed on the first electrode 110. The organic layer 150 may include an emission layer.

The organic layer 150 may further include a hole transport region between the first electrode 110 and the emission layer, and an electron transport region between the emission layer and the second electrode 190.

### [Hole transport region in organic layer 150]

The hole transport region may have i) a single-layered structure including a single layer including a single material, ii) a single-layered structure including a single layer including a plurality of different materials, or iii) a multi-layered structure having a plurality of layers including a plurality of different materials.

The hole transport region may include at least one layer selected from a hole injection layer, a hole transport layer, an emission auxiliary layer, and an electron blocking layer.

For example, the hole transport region may have a single-layered structure including a single layer including a plurality of different materials, or a multi-layered structure having a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein for each structure, constituting layers are sequentially stacked from the first electrode 110 in this stated order, but the structure of the hole transport region is not limited thereto.

The hole transport region may include at least one selected from m-MTDATA, TDATA, 2-TNATA, NPB(NPD), β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, and a compound represented by Formula 202: 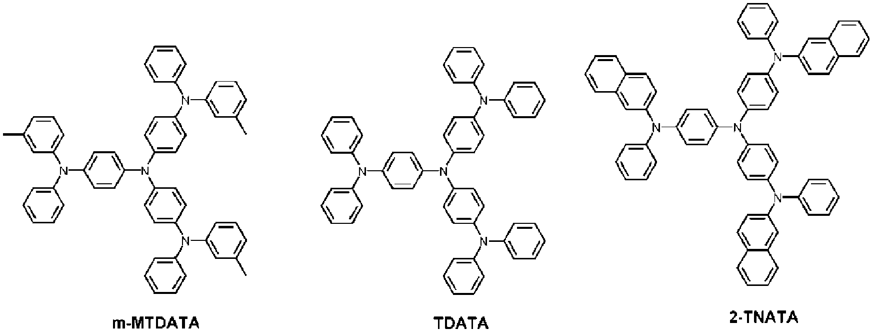 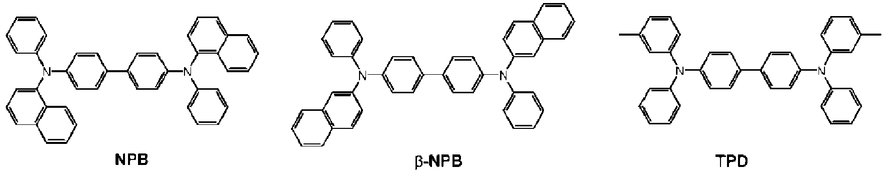 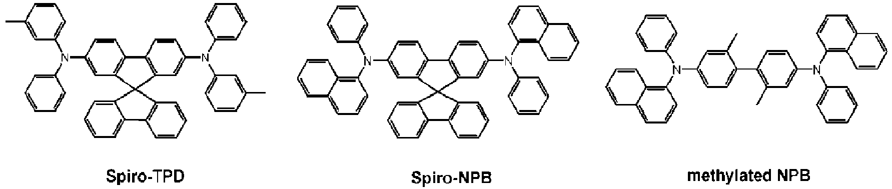 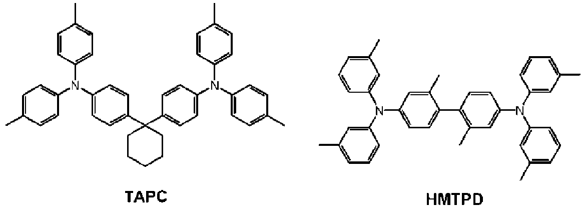 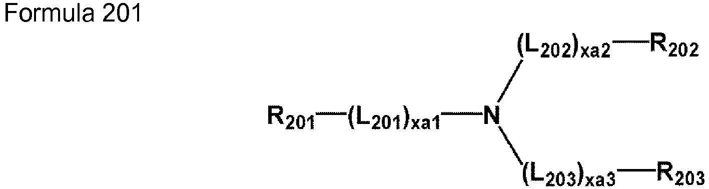 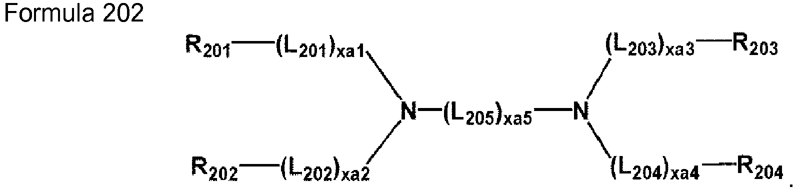 In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₂) arylene group, a substituted or unsubstituted C₁-C₆₀ (*e.g*. C₁-C₂₀) heteroarylene group, a substituted or unsubstituted divalent non-aromatic condensed polycyclic group, and a substituted or unsubstituted divalent non-aromatic condensed heteropolycyclic group;
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₂) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 may each independently be an integer from 0 to 3,
xa5 may be an integer from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₂) aryl group, a substituted or unsubstituted C₆-C₆₀ (*e.g.* C₆-C₃₂) aryloxy group, a substituted or unsubstituted C₆-C₆₀ (*e.g.* C₆-C₃₂) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group.

In one embodiment, in Formula 202, R₂₀₁ and R₂₀₂ may optionally be linked via a single bond, a dimethyl-methylene group, or a diphenyl-methylene group, and R₂₀₃ and R₂₀₄ may optionally be linked via a single bond, a dimethyl-methylene group, or a diphenyl-methylene group.

In one or more embodiments, in Formulae 201 and 202,

L₂₀₁ to L₂₀₅ may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one embodiment, xa1 to xa4 may each independently be 0, 1, or 2.

In one embodiment, xa5 may be 1, 2, 3, or 4.

In one embodiment, R₂₀₁ to R₂₀₄ and Q₂₀₁ may each independently be selected from:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ are each independently the same as described herein.

In one embodiment, at least one of R₂₀₁ to R₂₀₃ in Formula 201 may be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one embodiment, in Formula 202, i) R₂₀₁ and R₂₀₂ may be linked via a single bond, and/or ii) R₂₀₃ and R₂₀₄ may be linked via a single bond.

In one embodiment, at least one of R₂₀₁ to R₂₀₄ in Formula 202 may be selected from:
a carbazolyl group; and
a carbazolyl group, substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

The compound represented by Formula 201 may be represented by Formula 201A:

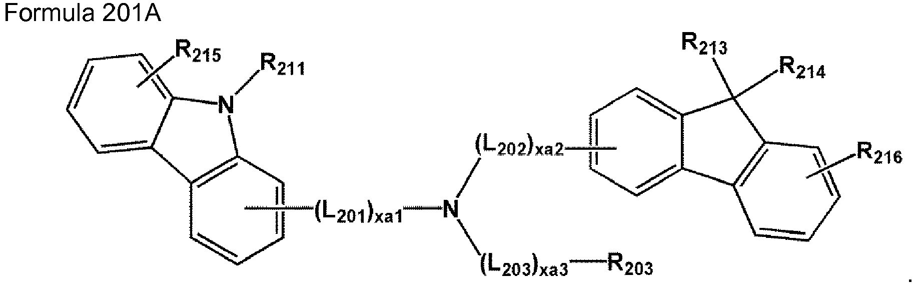

In one embodiment, the compound represented by Formula 201 may be represented by Formula 201A(1) below, but embodiments of the present disclosure are not limited thereto:

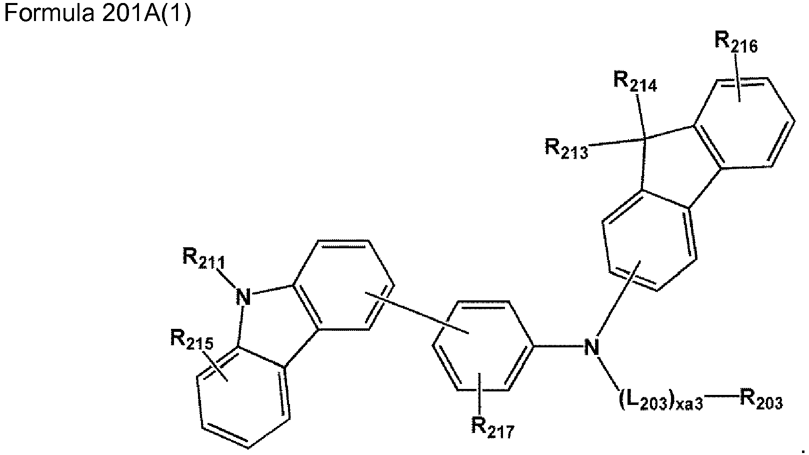

In one embodiment, the compound represented by Formula 201 may be represented by Formula 201A-1 below, but embodiments of the present disclosure are not limited thereto:

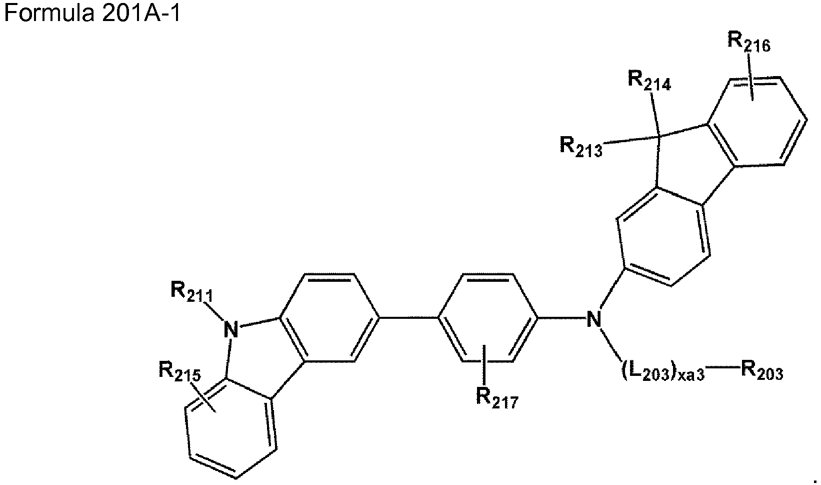

In one embodiment, the compound represented by Formula 202 may be represented by Formula 202A:

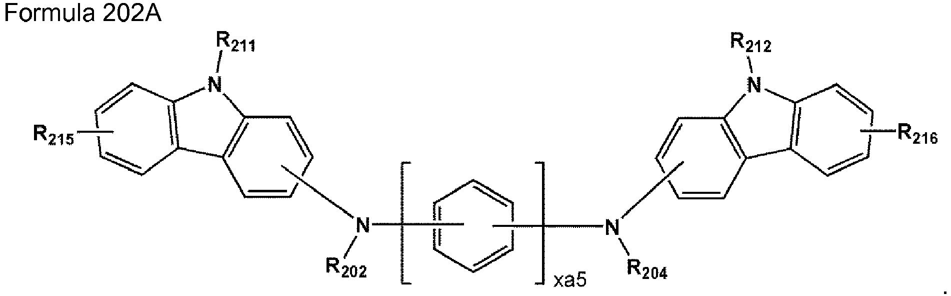

In one embodiment, the compound represented by Formula 202 may be represented by Formula 202A-1: 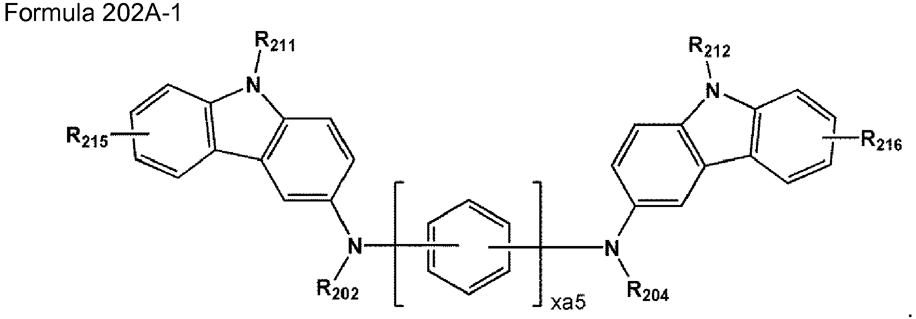 In Formulae 201A, 201A(1), 201A-1, 202A, and 202A-1,
L₂₀₁ to L₂₀₃, xa1 to xa3, xa5, and R₂₀₂ to R₂₀₄ are the same as described above,
R₂₁₁ and R₂₁₂ are the same as described above in connection with R₂₀₃, and
R₂₁₃ to R₂₁₇ are each independently selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39, but embodiments of the present disclosure are not limited thereto:

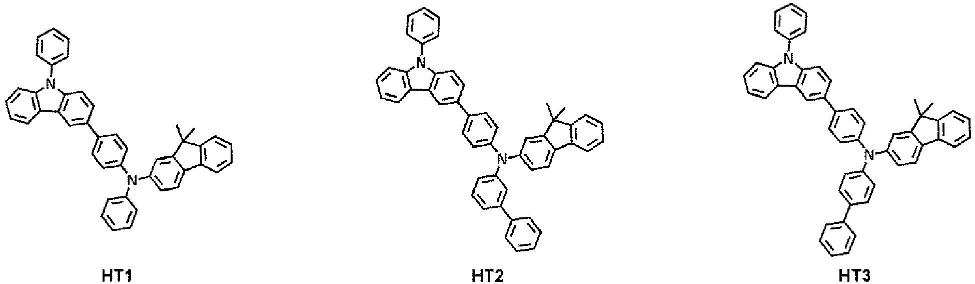

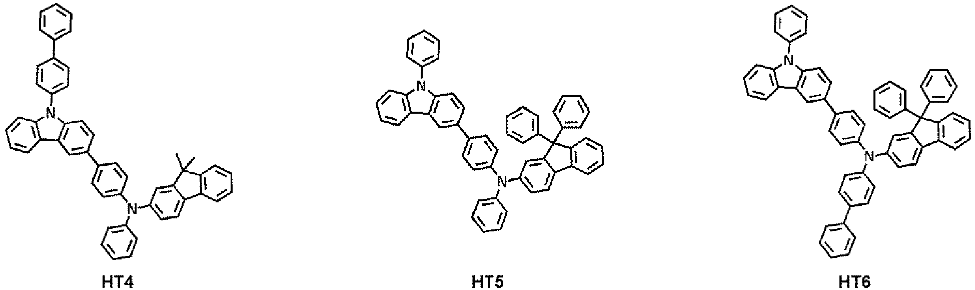

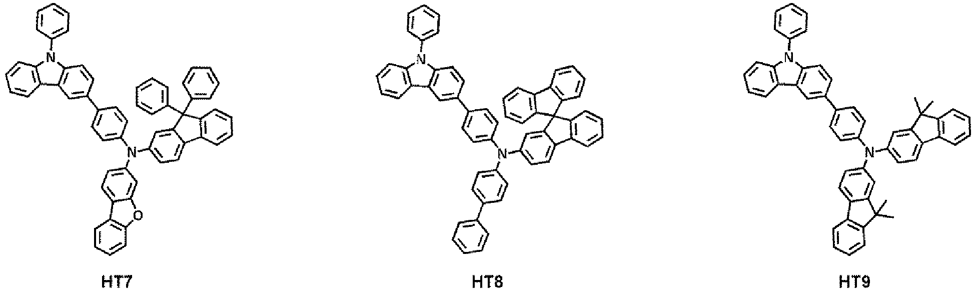

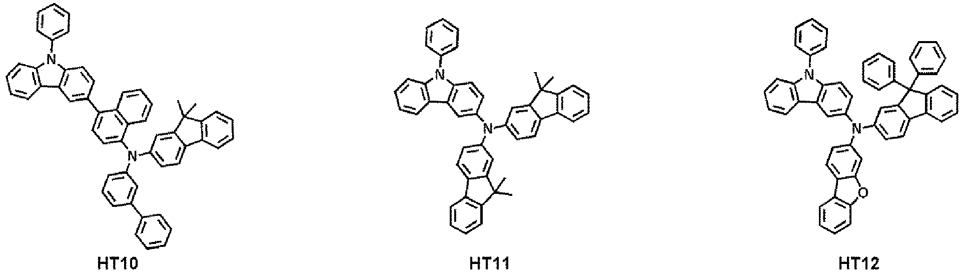

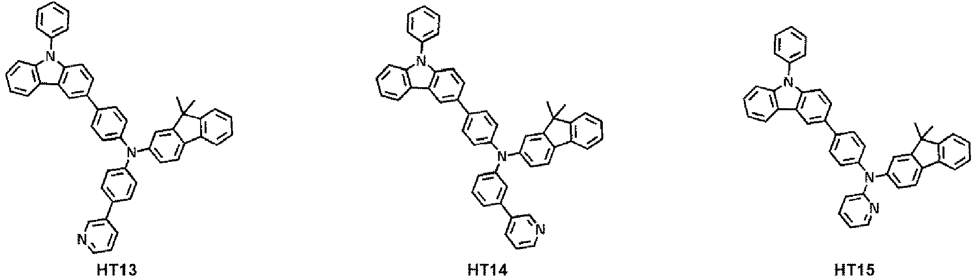

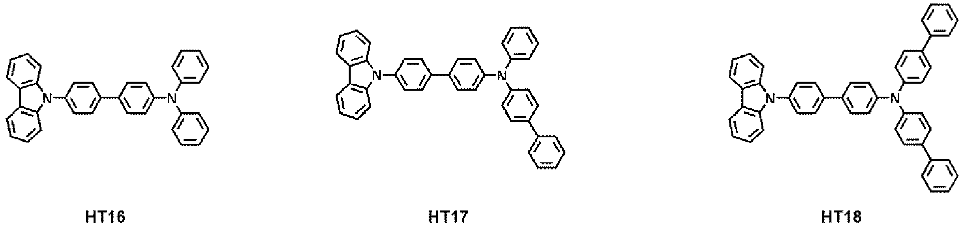

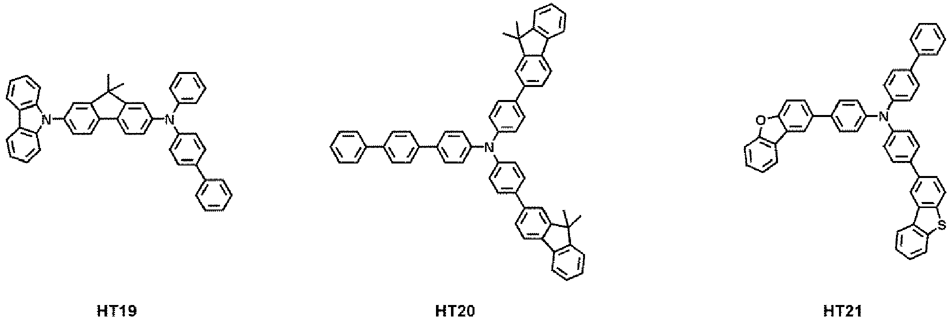

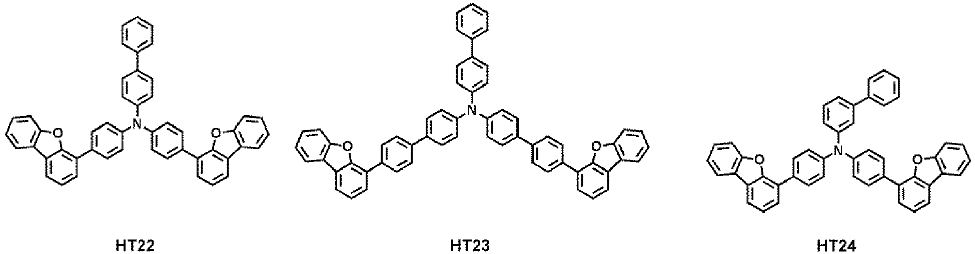

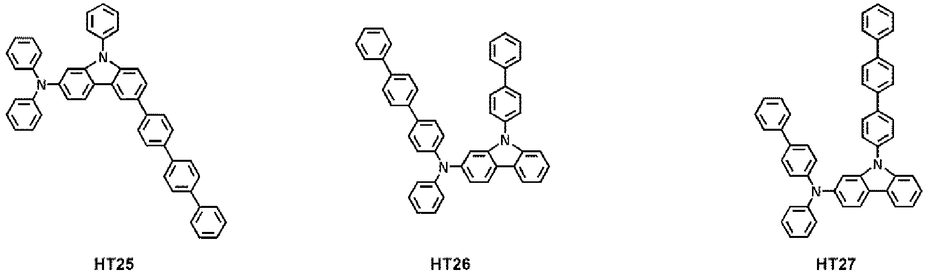

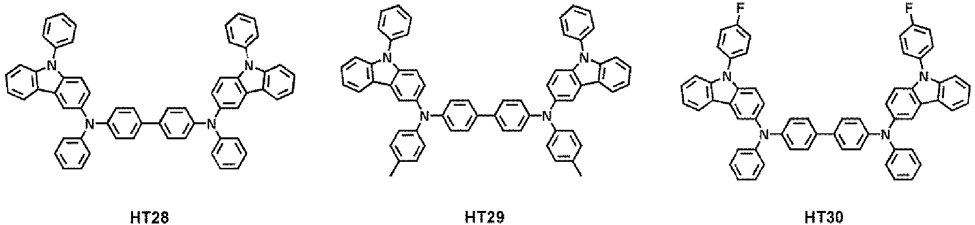

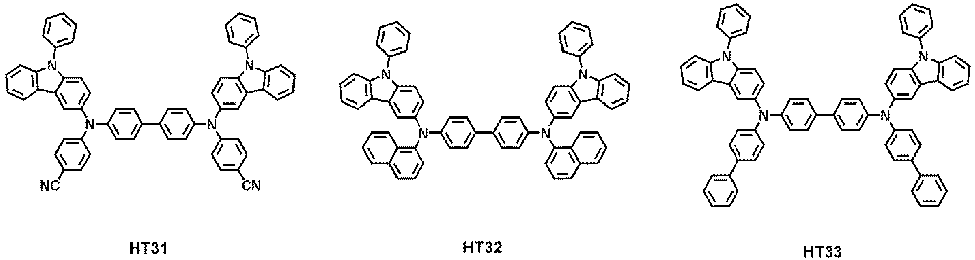

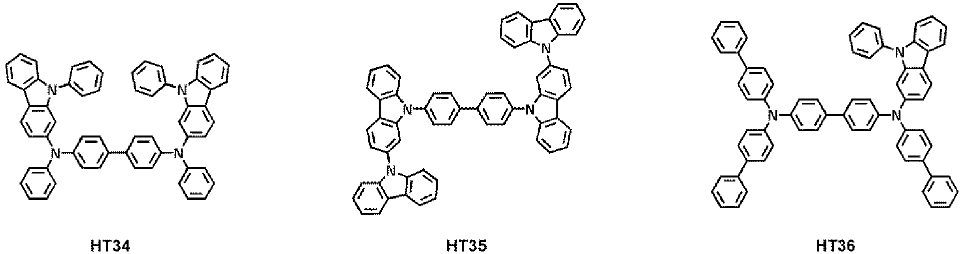

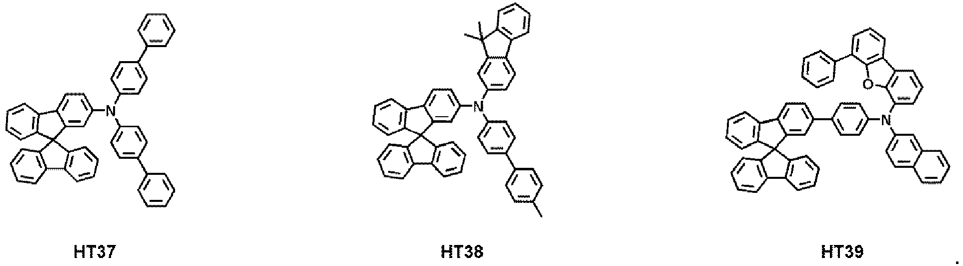

A thickness of the hole transport region may be in a range of about 100 Å to about 10,000 Å, or, for example, about 100 Å to about 7000 Å, about 100 Å to about 5000 Å, about 100 Å to about 3000 Å, or about 100 Å to about 1,000 Å. When the hole transport region includes at least one of a hole injection layer and a hole transport layer, a thickness of the hole injection layer may be in a range of about 100 Å to about 9,000 Å, or, for example, about 100 Å to about 7,000 Å, about 100 Å to about 5,000 Å, about 100 Å to about 3,000 Å, about 100 Å to about 1,000 Å, and a thickness of the hole transport layer may be in a range of about 50 Å to about 2,000 Å, or, for example about 100 Å to about 1,500 Å or about 200 Å to about 400 Å. When the thicknesses of the hole transport region, the hole injection layer, and the hole transport layer are within these ranges, suitable or satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block or reduce the flow of electrons from an electron transport region. The emission auxiliary layer and the electron blocking layer may include the materials as described above.

### [P-dopant]

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant.

In an embodiment, the p-dopant may have a lowest unoccupied molecular orbital (LUMO) energy level of about -3.5 eV or less.

The p-dopant may include at least one selected from a quinone derivative, a metal oxide, and a cyano group-containing compound, but embodiments of the present disclosure are not limited thereto. Examples of the p-dopant include:
a quinone derivative, such as tetracyanoquinodimethane (TCNQ) or 2,3,5,6-tetrafluoro-7,7,8,8-tetracyanoquinodimethane (F4-TCNQ);
a metal oxide, such as tungsten oxide or molybdenum oxide;
1,4,5,8,9,11-hexaazatriphenylene-hexacarbonitrile (HAT-CN); and
a compound represented by Formula 221 below, but embodiments of the present disclosure are not limited thereto: 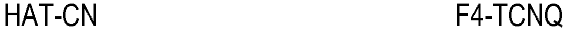 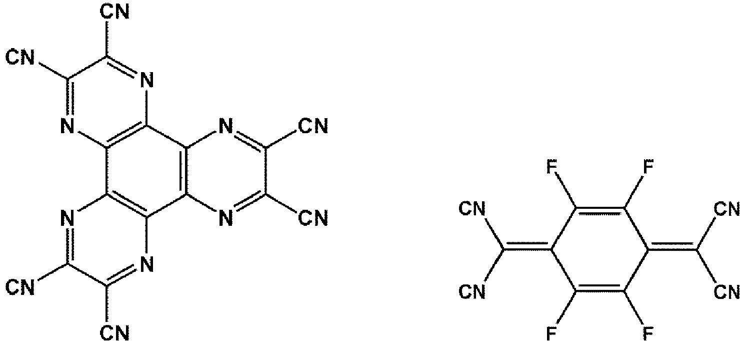 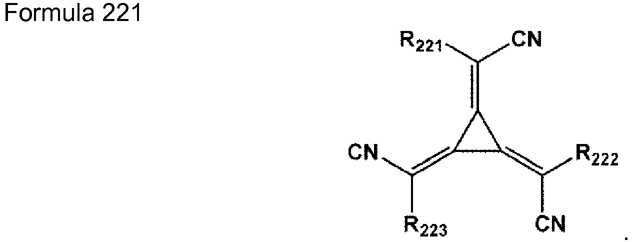 In Formula 221,
   R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₂) aryl group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, wherein at least one selected from R₂₂₁ to R₂₂₃ may have at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### [Emission layer in organic layer 150]

When the organic light-emitting device 10 is a full-color organic light-emitting device, the emission layer may be patterned into a red emission layer, a green emission layer, or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other. In one or more embodiments, the emission layer may include two or more materials selected from a red light-emitting material, a green light-emitting material, and a blue light-emitting material, in which the two or more materials are mixed with each other in a single layer to emit white light.

The emission layer may include a host and a dopant. The dopant may include the organometallic compound represented by Formula 1. In one or more embodiments, the dopant may further include, in addition to the organometallic compound represented by Formula 1, at least one of a phosphorescent dopant and a fluorescent dopant.

An amount of the dopant in the emission layer may be in a range of about 0.01 parts by weight to about 15 parts by weight based on 100 parts by weight of the host, but embodiments of the present disclosure are not limited thereto.

A thickness of the emission layer may be in a range of about 100 A to about 1,000 Å, for example, about 100 Å to about 800 Å, about 150 Å to about 800 Å, about 150 Å to about 700 Å, about 150 Å to about 650 Å, about 200 Å to about 600 Å or about 200 Å to about 400 Å. When the thickness of the emission layer is within this range, excellent light-emission characteristics may be obtained without a substantial increase in driving voltage.

### [Host in emission layer]

In one or more embodiments, the host may include a compound represented by Formula 301 below.

Formula 301 [Ar₃₀₁]_{xb11}-[(L₃₀₁)_{xb1}-R₃₀₁]_{xb21}.

In Formula 301,
Ar₃₀₁ may be a substituted or unsubstituted C₅-C₆₀ carbocyclic group or a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xb1 may be an integer from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and - P(=O)(Q₃₀₁)(Q₃₀₂),
xb21 may be an integer from 1 to 5, and
Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

For example, Ar₃₀₁ may be a substituted or unsubstituted C₆-C₃₂ carbocyclic group or a substituted or unsubstituted C₁-C₁₂ heterocyclic group, but embodiments are not limited thereto.

In one or more embodiments, Ar₃₀₁ in Formula 301 may be selected from:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

When xb11 in Formula 301 is two or more, two or more Ar₃₀₁(s) may be linked via a single bond.

In one or more embodiments, the compound represented by Formula 301 may be represented by Formula 301-1 or 301-2: 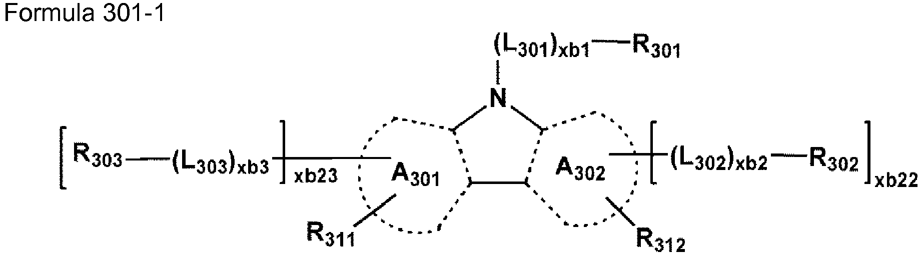 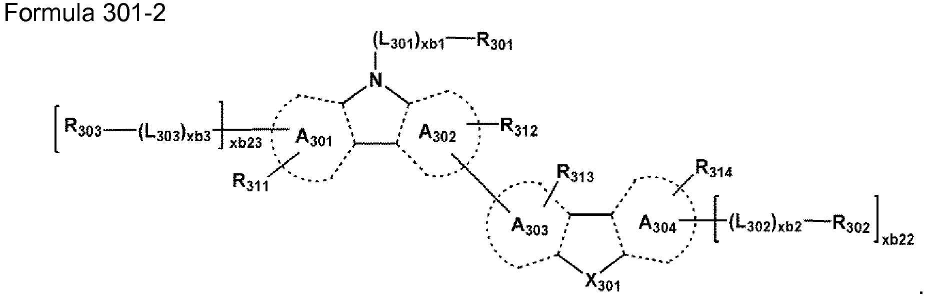 In Formulae 301-1 and 301-2,
A₃₀₁ to A₃₀₄ may each independently be selected from a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, and dinaphthothiophene group,
X₃₀₁ may be O, S, or N-[(L₃₀₄)_{xb4}-R₃₀₄],
R₃₁₁ to R₃₁₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂),
xb22 and xb23 may each independently be 0, 1, or 2,
L₃₀₁, xb1, R₃₀₁, and Q₃₁ to Q₃₃ are the same as described above,
L₃₀₂ to L₃₀₄ may each independently be the same as described in connection with L₃₀₁,
xb2 to xb4 may each independently be the same as described in connection with xb1, and
R₃₀₂ to R₃₀₄ may each independently be the same as described in connection with R₃₀₁.

For example, L₃₀₁ to L₃₀₄ in Formulae 301, 301-1, and 301-2 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

For example, L₃₀₁ to L₃₀₄ in Formulae 301, 301-1, and 301-2 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
Q₃₁ to Q₃₃ are the same as described above.

As another example, R₃₀₁ to R₃₀₄ in Formulae 301, 301-1, and 301-2 may each independently be selected from: deuterium, -F, -Cl, -Br, -I, a hydroxyl group, a cyano group, a nitro group, an amidino group, a hydrazino group, a hydrazono group, a substituted or unsubstituted C₁-C₆₀ (e.g. C₁-C₁₀) alkyl group, a substituted or unsubstituted C₂-C₆₀ (e.g. C₂-C₁₀) alkenyl group, a substituted or unsubstituted C₂-C₆₀ (*e.g.* C₂-C₁₀) alkynyl group, a substituted or unsubstituted C₁-C₆₀ (*e.g.* C₁-C₁₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂),-B(Q₃₀₁)(Q₃₀₂), -C(=O)(Q₃₀₁), -S(=O)₂(Q₃₀₁), and -P(=O)(Q₃₀₁)(Q₃₀₂), but embodiments are not limited thereto.

In one embodiment, R₃₀₁ to R₃₀₄ in Formulae 301, 301-1, and 301-2 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
Q₃₁ to Q₃₃ are the same as described above.

In one embodiment, the host may include an alkaline earth metal complex. For example, the host may include a complex selected from a Be complex (for example, Compound H55), a Mg complex, and a Zn complex. For example, the host may be selected from a Be complex (for example, Compound H55), a Mg complex, and a Zn complex.

The host may include at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), bis(4-(9H-carbazol-9-yl)phenyl)diphenylsilane (BCPDS), 4-(1-(4-(diphenylamino)phenyl)cyclohexyl)phenyl)diphenyl-phosphine oxide (POPCPA), and Compounds H1 to H55, but embodiments of the present disclosure are not limited thereto:

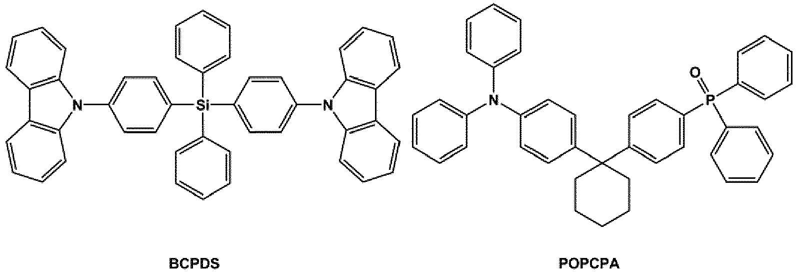

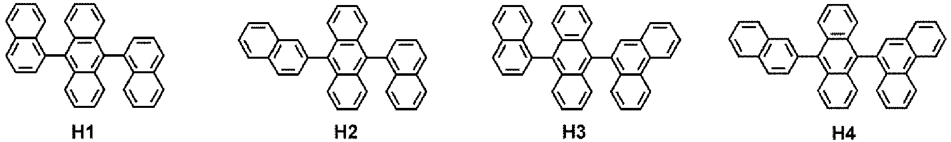

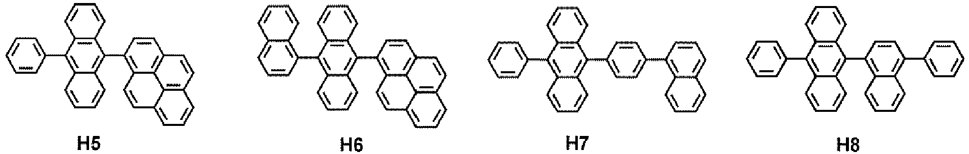

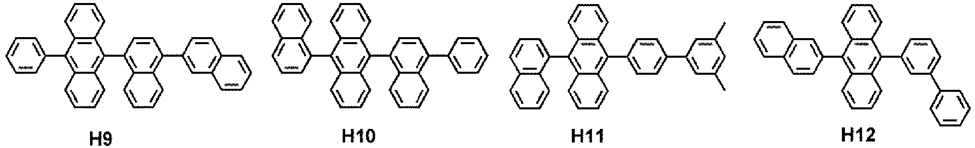

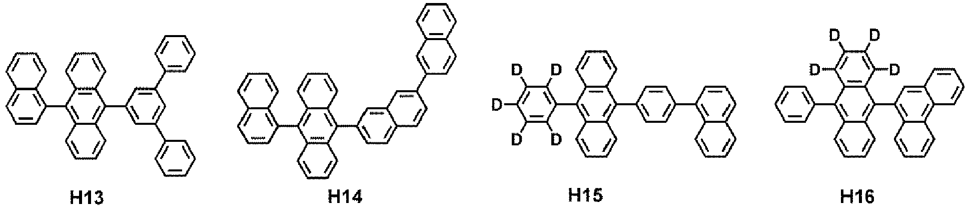

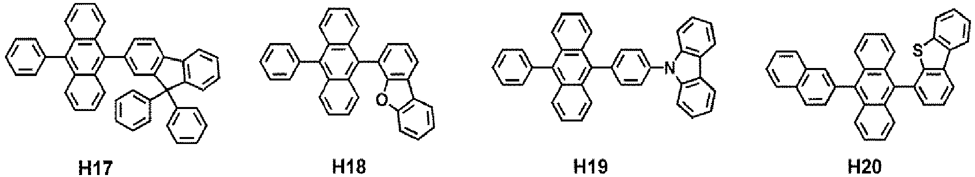

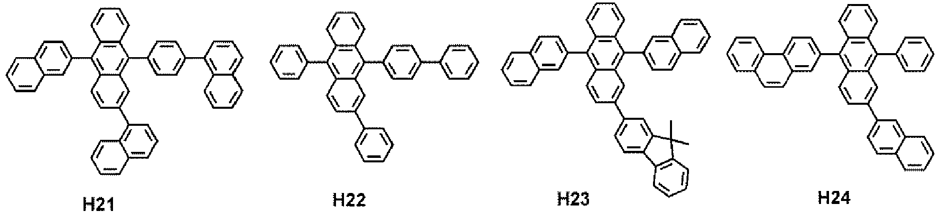

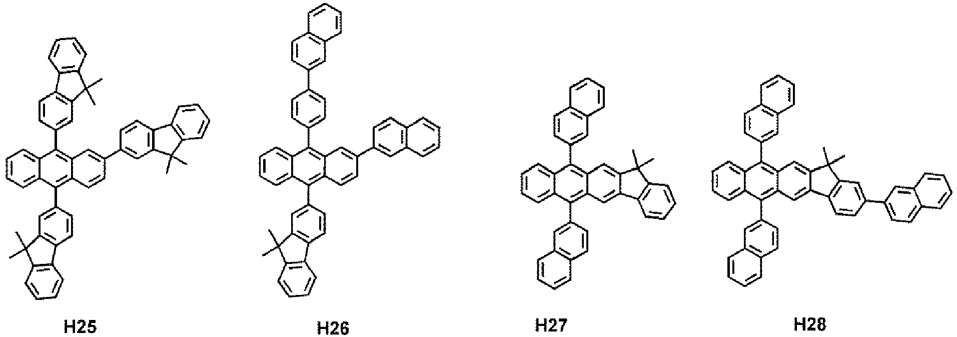

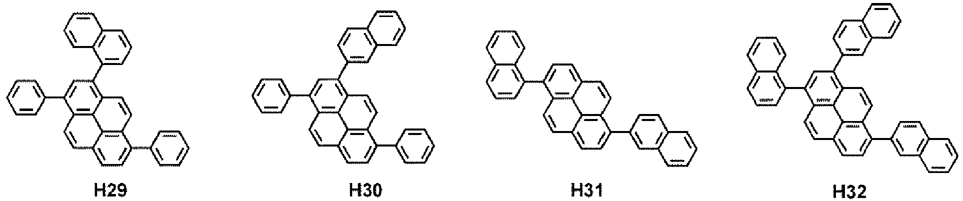

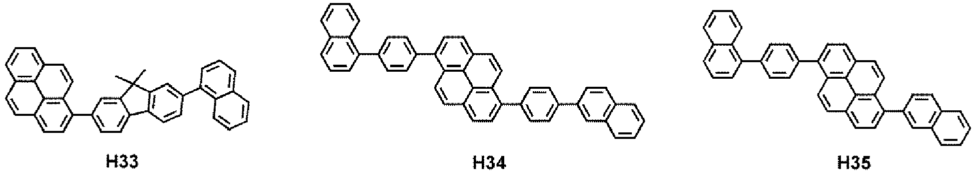

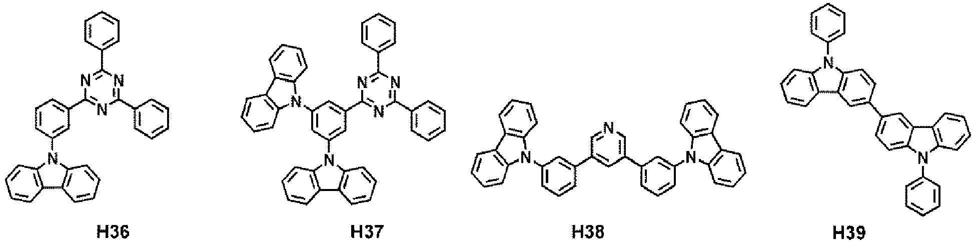

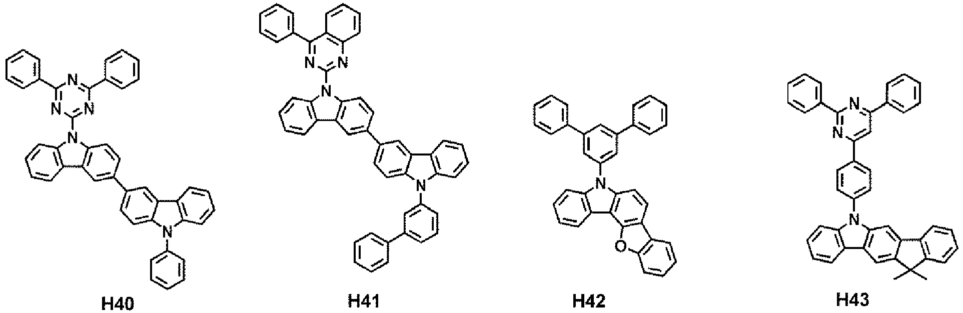

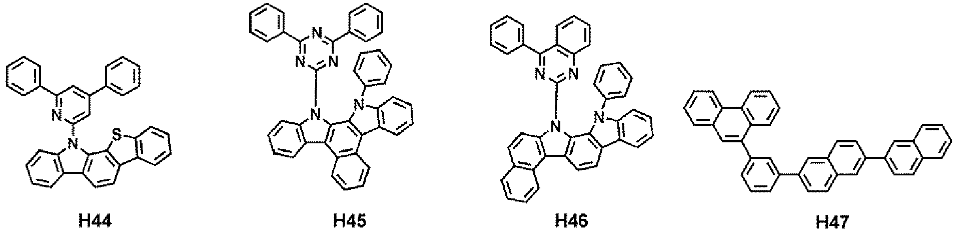

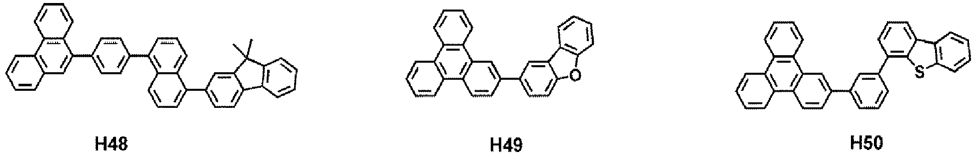

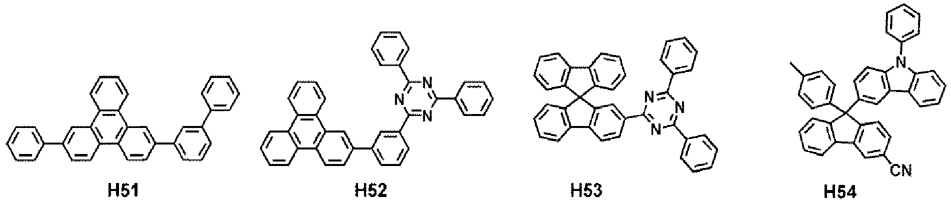

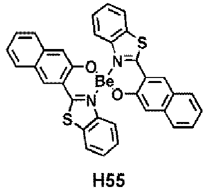

In one embodiment, the host may include at least one selected from a silicon-containing compound (for example, BCPDS used in the following examples or the like) and a phosphine oxide-containing compound (for example, POPCPA used in the following examples or the like).

However, embodiments of the present disclosure are not limited thereto. In one embodiment, the host may include only one compound, or two or more different compounds (for example, a host used in the following examples includes BCPDS and POPCPA).

### [Phosphorescent dopant included in emission layer in organic layer 150]

The phosphorescent dopant may include the organometallic compound represented by Formula 1.

In one or more embodiments, the phosphorescent dopant may further include, in addition to the organometallic compound represented by Formula 1, an organometallic complex represented by Formula 401 below:

Formula 401 M(L₄₀₁)_{xc1}(L₄₀₂)_{xc2}

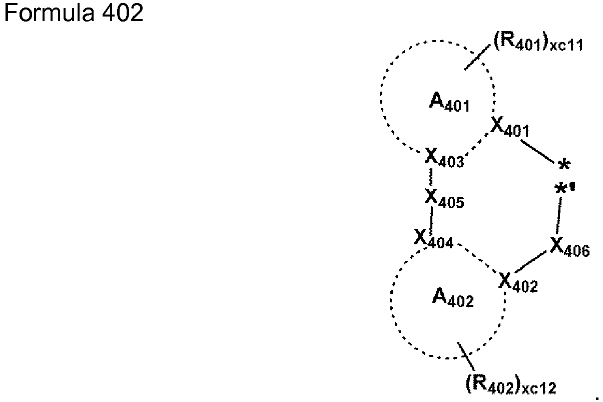

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
L₄₀₁ may be selected from ligands represented by Formula 402, and xc1 may be 1, 2, or 3, wherein, when xc1 is two or more, two or more L₄₀₁(s) may be identical to or different from each other,
L₄₀₂ may be an organic ligand, and xc2 may be an integer from 0 to 4, wherein, when xc2 is two or more, two or more L₄₀₂(s) may be identical to or different from each other,
X₄₀₁ to X₄₀₄ may each independently be nitrogen or carbon,
X₄₀₁ and X₄₀₃ may be linked via a single bond or a double bond, and X₄₀₂ and X₄₀₄ may be linked via a single bond or a double bond,
A₄₀₁ and A₄₀₂ may each independently be a C₅-C₆₀ (*e.g.* C₅-C₃₀) carbocyclic group or a C₁-C₆₀ (*e.g.* C₁-C₂₀) heterocyclic group,
X₄₀₅ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)=*', wherein Q₄₁₁ and Q₄₁₂ may be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted (*e.g.* C₆-C₃₀) C₆-C₆₀ aryloxy group, a substituted or unsubstituted C₆-C₆₀ (*e.g.* C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁) and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer from 0 to 10, and
* and *' in Formula 402 each indicate a binding site to M in Formula 401.

In one embodiment, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen, and X₄₀₂ may be carbon, or ii) X₄₀₁ may X₄₀₂ may each be nitrogen at the same time.

In one or more embodiments, R₄₀₁ and R₄₀₂ in Formula 402 may each independently be selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantanyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁),-S(=O)₂(Q₄₀₁), and -P(=O)(Q₄₀₁)(Q₄₀₂), and
Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, when xc1 in Formula 401 is two or more, two A₄₀₁(s) in two or more L₄₀₁(s) may optionally be linked via X₄₀₇, which is a linking group, or two A₄₀₂(s) in two or more L₄₀₁(s) may optionally be linked via X₄₀₈, which is a linking group (see Compounds PD1 to PD4 and PD7). X₄₀₇ and X₄₀₈ may each independently be a single bond, *-O-*', *-S-*', *-C(=O)-*', *-N(Q₄₁₃)-*', *-C(Q₄₁₃)(Q₄₁₄)-*', or *-C(Q₄₁₃)=C(Q₄₁₄)-*' (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but embodiments of the present disclosure are not limited thereto.

L₄₀₂ in Formula 401 may be a monovalent, divalent, or trivalent organic ligand. For example, L₄₀₂ may be selected from halogen, diketone (for example, acetylacetonate), carboxylic acid (for example, picolinate), -C(=O), isonitrile, -CN, and phosphorus (for example, phosphine or phosphite), but embodiments of the present disclosure are not limited thereto.

In one or more embodiments, the phosphorescent dopant may be selected from, for example, Compounds PD1 to PD25, but embodiments of the present disclosure are not limited thereto:

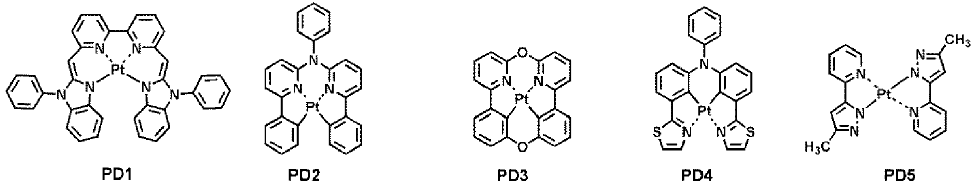

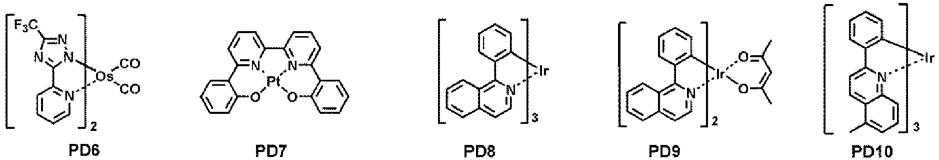

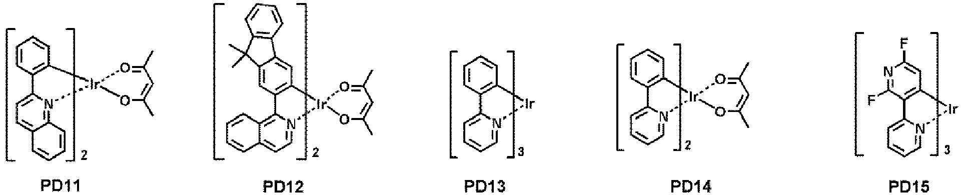

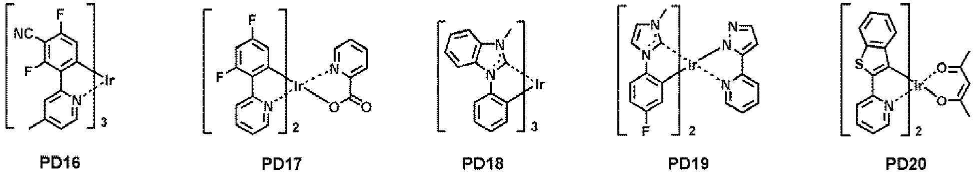

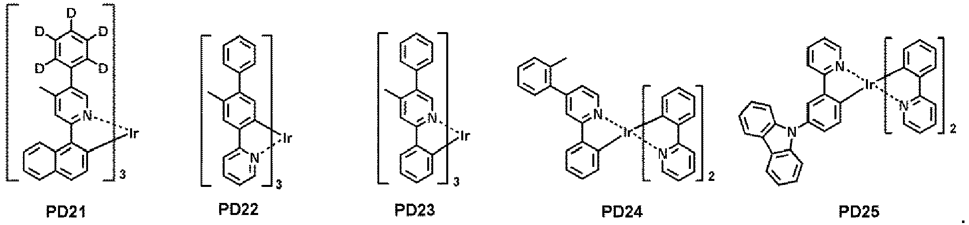

### [Fluorescent dopant in emission layer]

The fluorescent dopant may include an arylamine compound or a styrylamine compound.

The fluorescent dopant may include a compound represented by Formula 501 below. 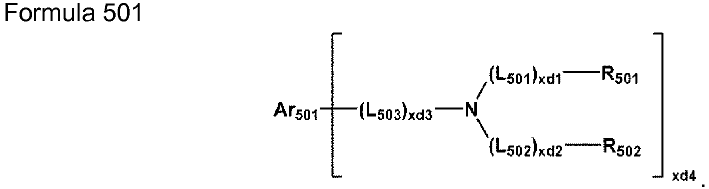 In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₀) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer of 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, and
xd4 may be an integer of 1 to 6.

For example, Ar₅₀₁ may be a substituted or unsubstituted C₅-C₃₀ carbocyclic group or a substituted or unsubstituted C₁-C₂₀ heterocyclic group, but embodiments are not limited thereto.

In one embodiment, Ar₅₀₁ in Formula 501 may be selected from:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, L₅₀₁ to L₅₀₃ in Formula 501 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R₅₀₁ and R₅₀₂ in Formula 501 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃), and
Q₃₁ to Q₃₃ may be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

For example, the fluorescent dopant may be selected from Compounds FD1 to FD22:

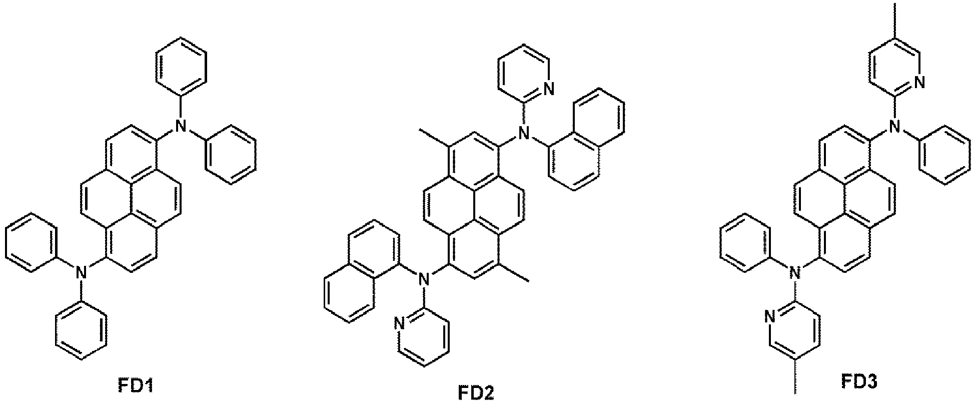

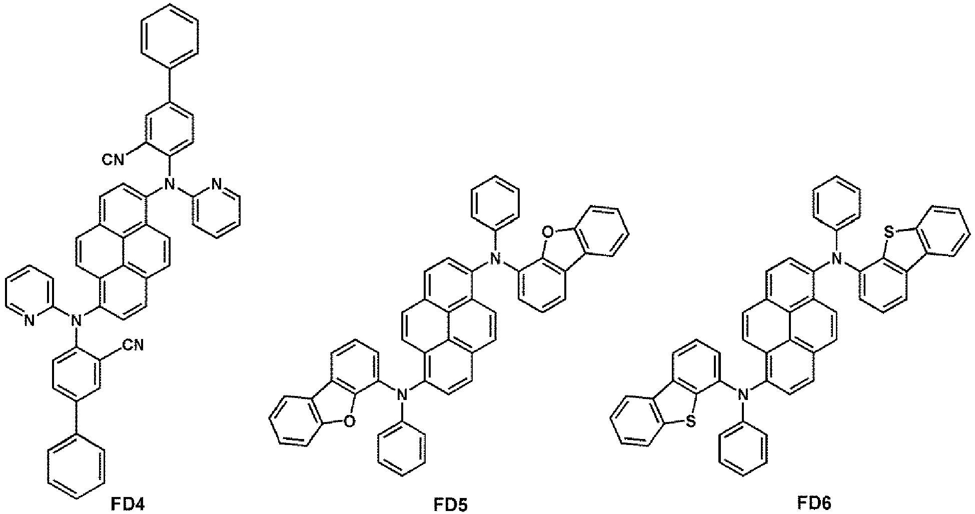

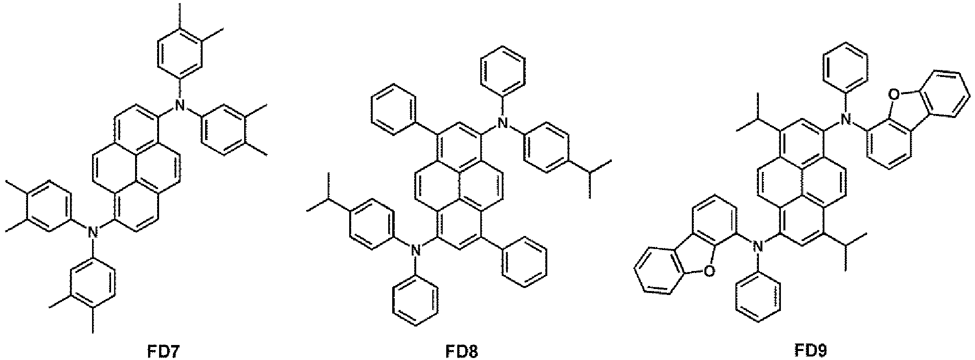

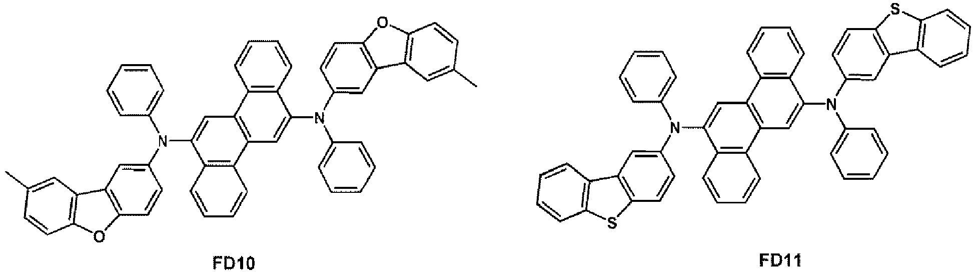

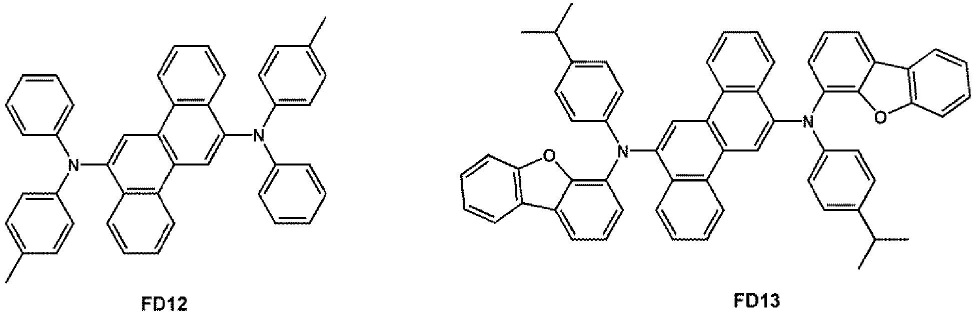

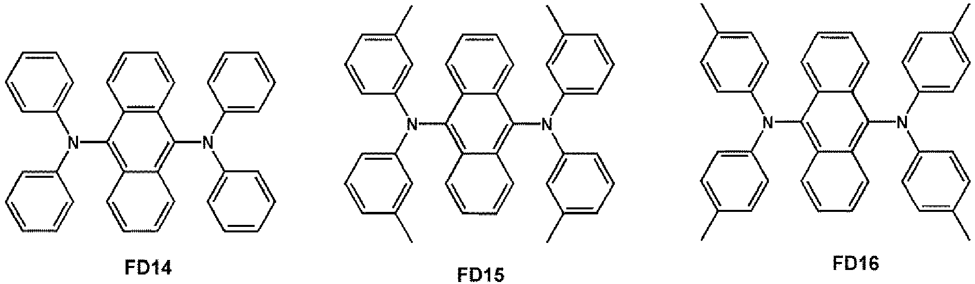

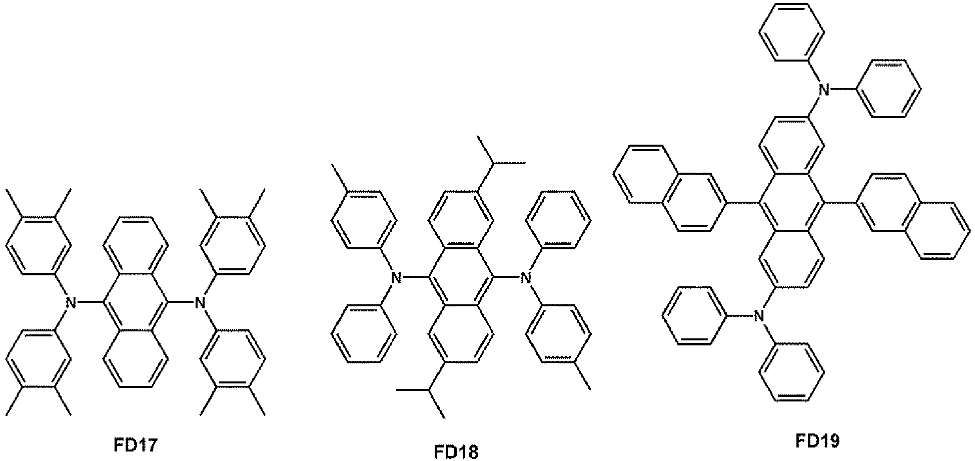

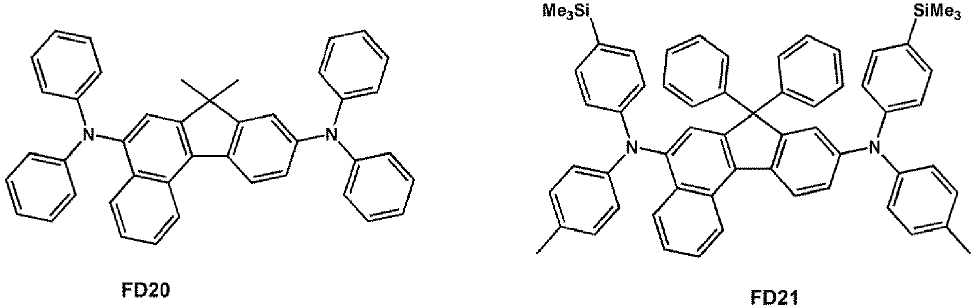

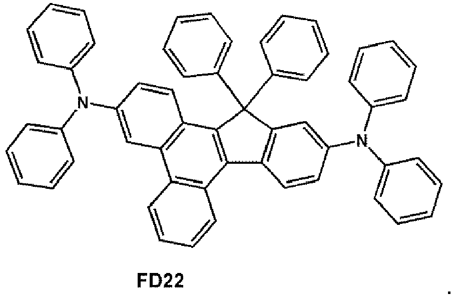

In one or more embodiments, the fluorescent dopant may be selected from the following compounds, but embodiments of the present disclosure are not limited thereto:

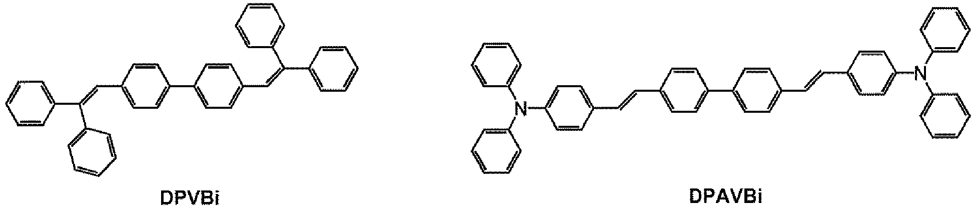

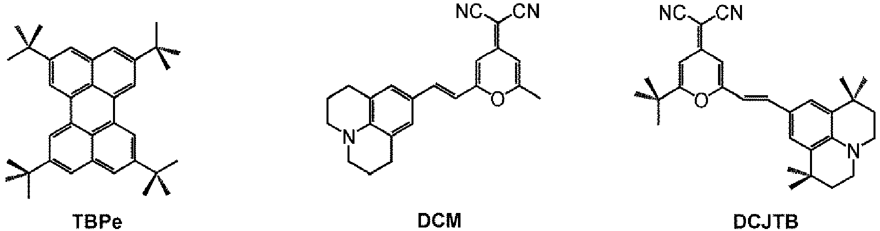

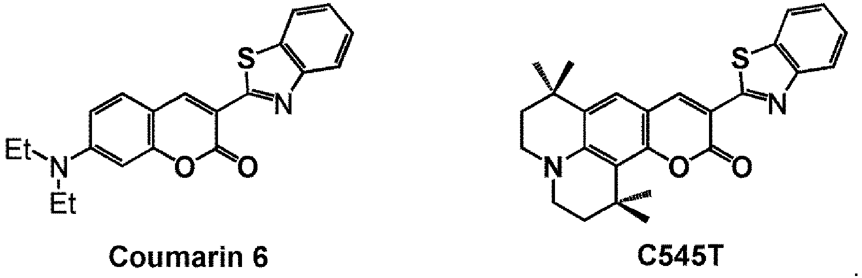

### [Electron transport region in organic layer 150]

The electron transport region may have i) a single-layered structure including a single layer including a single material, ii) a single-layered structure including a single layer including a plurality of different materials, or iii) a multi-layered structure having a plurality of layers including a plurality of different materials.

The electron transport region may include at least one selected from a buffer layer, a hole blocking layer, an electron control layer, an electron transport layer, and an electron injection layer, but embodiments of the present disclosure are not limited thereto.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein for each structure, constituting layers are sequentially stacked from an emission layer. However, embodiments of the structure of the electron transport region are not limited thereto.

The electron transport region (for example, a buffer layer, a hole blocking layer, an electron control layer, or an electron transport layer in the electron transport region) may include a metal-free compound containing at least one π electron-depleted nitrogen-containing ring.

As used herein, the term "π electron-depleted nitrogen-containing ring" indicates a C₁-C₆₀ (*e.g.* a C₁-C₃₀) heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed with each other (e.g., combined together), or iii) a heteropolycyclic group in which at least one of 5-membered to 7-membered heteromonocyclic groups, each having at least one *-N=*' moiety, is condensed with (e.g., combined with) at least one C₅-C₆₀ (*e.g.* a C₅-C₃₀) carbocyclic group.

Examples of the π electron-depleted nitrogen-containing ring include an imidazole group, a pyrazole group, a thiazole group, an isothiazole group, an oxazole group, an isoxazole group, a pyridine group, a pyrazine group, a pyrimidine group, a pyridazine group, indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, but embodiments of the present disclosure are not limited thereto.

For example, the electron transport region may include a compound represented by Formula 601:

Formula 601 [Ar₆₀₁]ₓₑ₁₁-[(L₆₀₁)ₓₑ₁-R₆₀₁]ₓₑ₂₁.

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 may be an integer from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), - -C(=O)(Q₆₀₁), -S(=O)₂(Q₆₀₁), and -P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer from 1 to 5.

In one embodiment, at least one of Ar₆₀₁(s) in the number of xe11 and R₆₀₁(s) in the number of xe21 may include the π electron-depleted nitrogen-containing ring.

For example, Ar₆₀₁ may be a substituted or unsubstituted C₅-C₃₀ carbocyclic group or a substituted or unsubstituted C₁-C₂₀ heterocyclic group, but embodiments are not limited thereto.

In one embodiment, ring Ar₆₀₁ in Formula 601 may be selected from:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁) and -P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is two or more, two or more Ar601(s) may be linked via a single bond.

In one or more embodiments, Ar₆₀₁ in Formula 601 may be an anthracene group.

In one or more embodiments, a compound represented by Formula 601 may be represented by Formula 601-1: 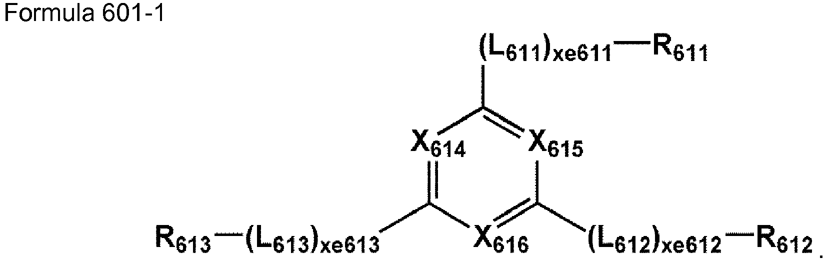 In Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁,
R₆₁₄ to R₆₁₆ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For example, L₆₀₁ and L₆₁₁ to L₆₁₃ in Formulae 601 and 601-1 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

In one embodiment, in Formulae 601 and 601-1, L₆₀₁ and L₆₁₁ to L₆₁₃ may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,
but embodiments of the present disclosure are not limited thereto.

In one or more embodimetns, in Formulae 601 and 601-1, xe1 and xe611 to xe613 may each independently be 0, 1, or 2.

For example, R₆₀₁ and R₆₁₁ to R₆₁₃ in Formulae 601 and 601-1 may each independently be selected from: a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂)·

In one or more embodiments, in Formulae 601 and 601-1, R₆₀₁ and R₆₁₁ to R₆₁₃ may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂), and
Q₆₀₁ and Q₆₀₂ are the same as described above.

The electron transport region may include at least one compound selected from Compounds ET1 to ET36, but embodiments of the present disclosure are not limited thereto:

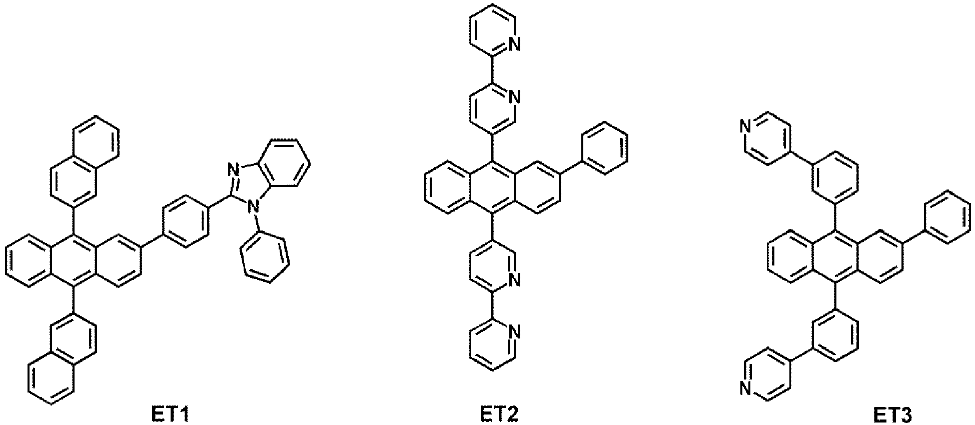

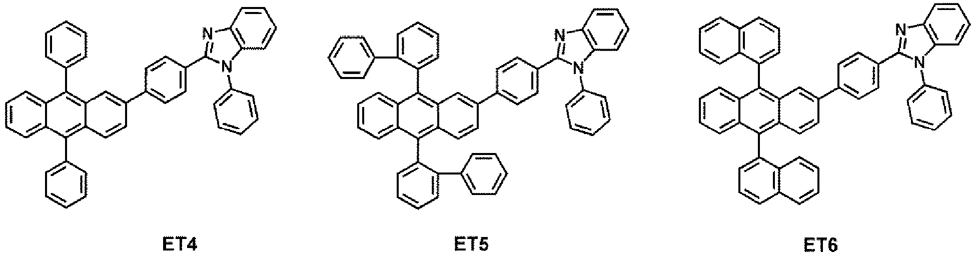

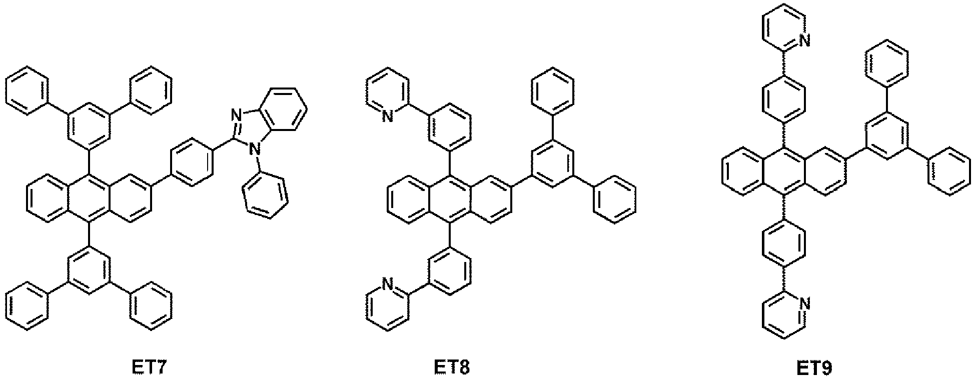

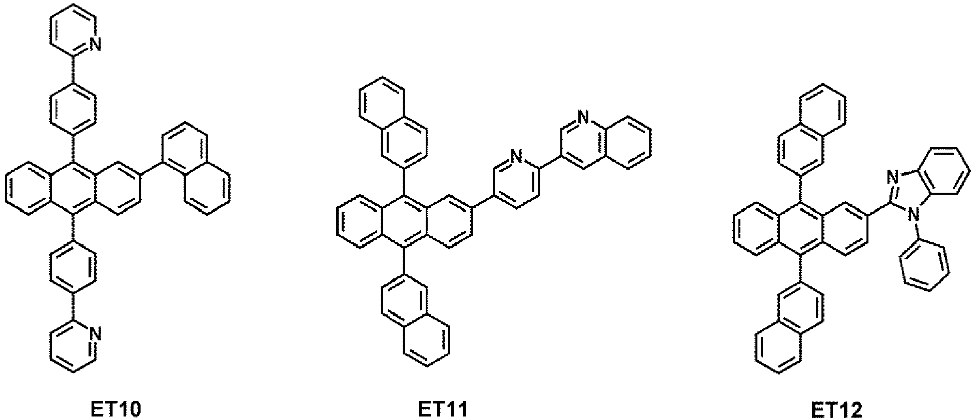

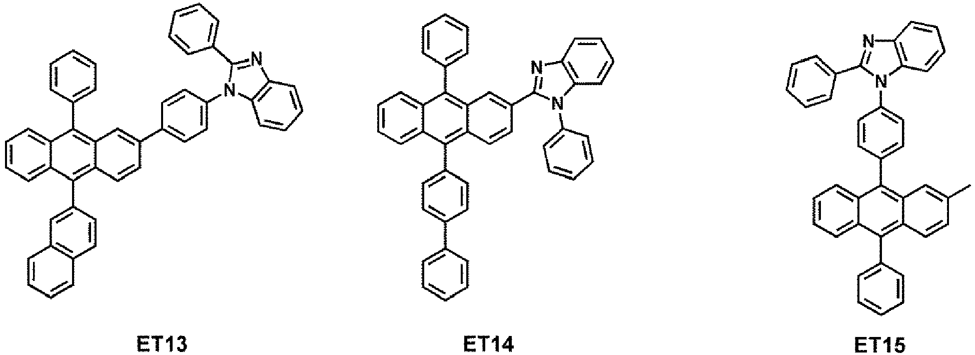

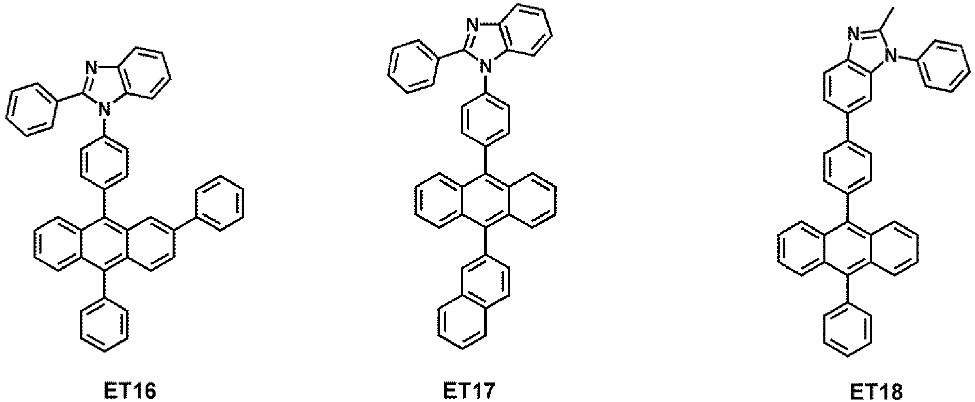

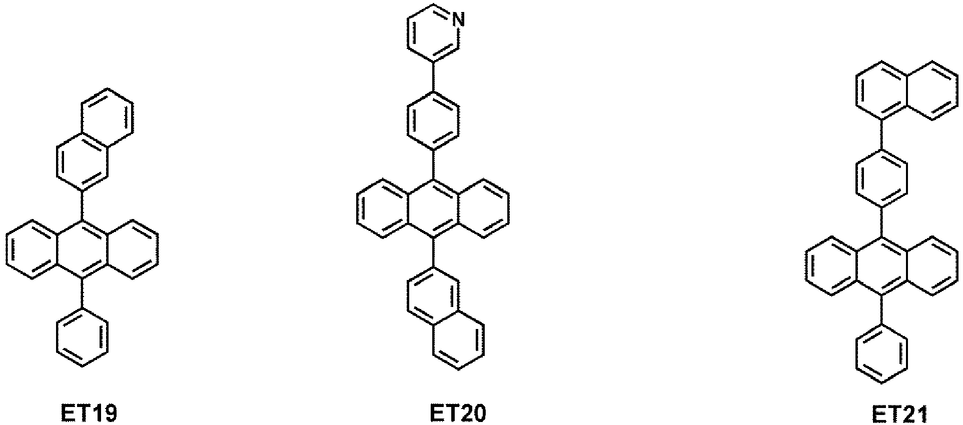

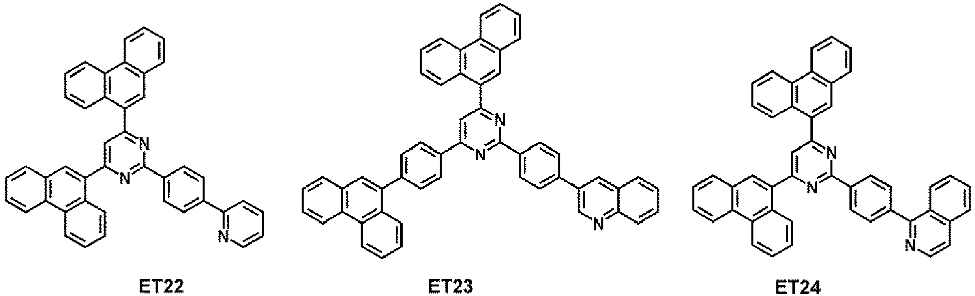

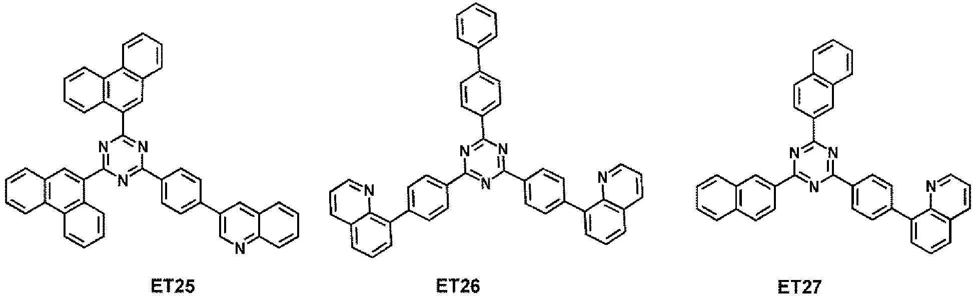

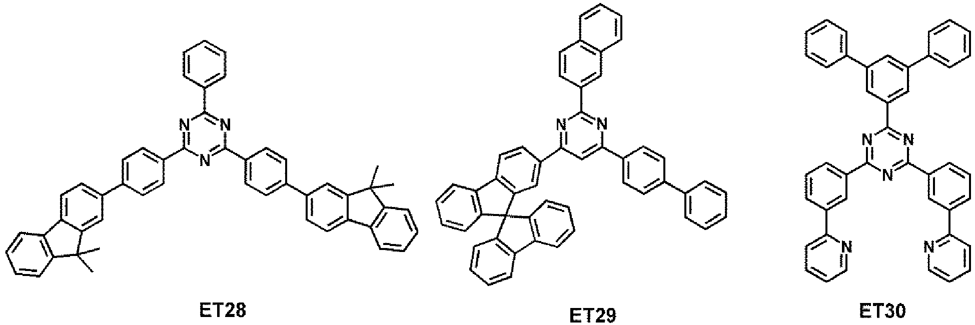

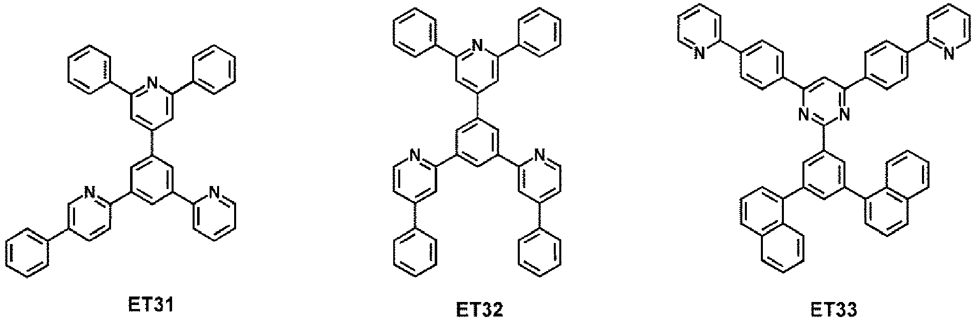

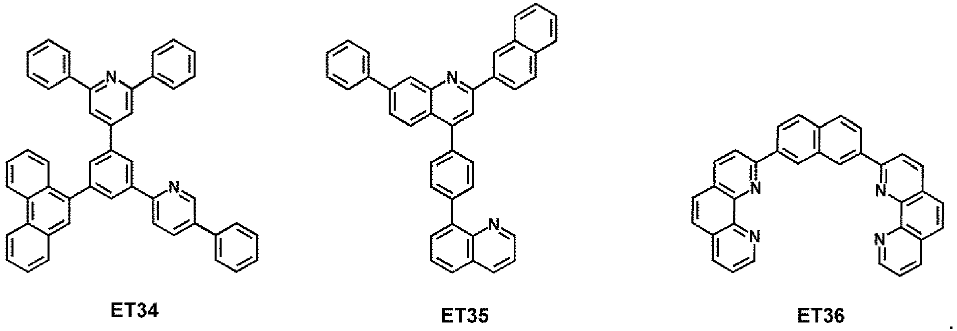

In one or more embodiments, the electron transport region may include at least one selected from dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-*tert-*butylphenyl)-4-phenyl-4*H*-1,2,4-triazole (TAZ), NTAZ, and diphenyl(4-(triphenylsilyl)phenyl)-phosphine oxide (TSPO1):

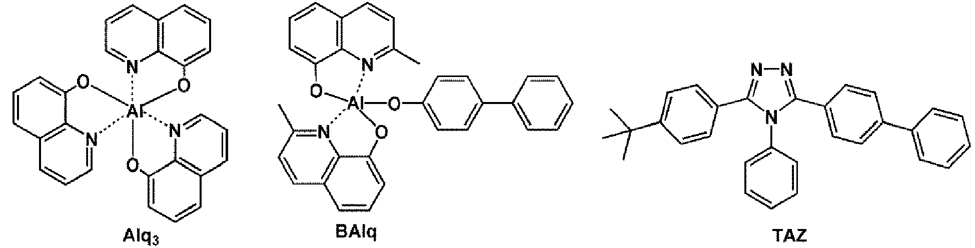

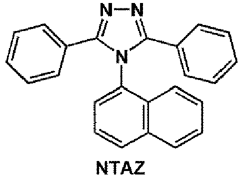

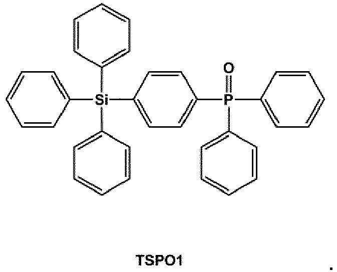

A thickness of the buffer layer, the hole blocking layer, and/or the electron control layer may be in a range of about 20 Å to about 1,000 Å, for example, about 20 Å to about 700 Å, about 20 Å to about 500 Å, about 20 Å to about 400, about 30 Å to about 400 Å or about 30 Å to about 300 Å. When the thicknesses of the buffer layer, the hole blocking layer, and the electron control layer are within these ranges, the electron blocking layer may have excellent electron blocking characteristics or electron control characteristics without a substantial increase in driving voltage.

A thickness of the electron transport layer may be in a range of about 100 Å to about 1,000 Å, or, for example, about 100 Å to about 700 Å, about 100 Å to about 600 Å. about 150 Å to about 600 Å, about 150 Å to about 500 Å or about 250 Å to about 350 Å. When the thickness of the electron transport layer is within the range described above, the electron transport layer may have suitable or satisfactory electron transport characteristics without a substantial increase in driving voltage.

The electron transport region (for example, the electron transport layer in the electron transport region) may further include, in addition to the materials described above, a metal-containing material.

The metal-containing material may include at least one selected from alkali metal complex and alkaline earth-metal complex. The alkali metal complex may include a metal ion selected from a Li ion, a Na ion, a K ion, a Rb ion, and a Cs ion, and the alkaline earth-metal complex may include a metal ion selected from a Be ion, a Mg ion, a Ca ion, a Sr ion, and a Ba ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may include a Li complex. The Li complex may include, for example, Compound ET-D1 (lithium quinolate, LiQ) or ET-D2:

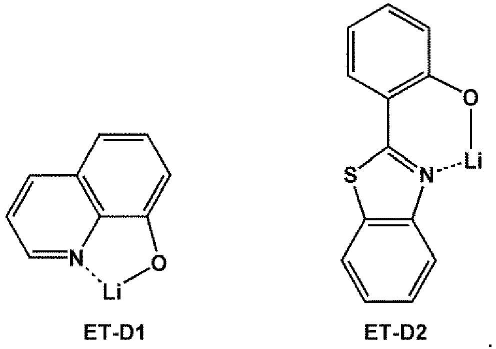

The electron transport region may include an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof.

The alkali metal may be selected from Li, a Na, K, Rb, and Cs. In one embodiment, the alkali metal may be Li, a Na, or Cs. In one or more embodiments, the alkali metal may be Li or Cs, but embodiments of the present disclosure are not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth-metal compound, and the rare earth metal compound may be selected from oxides and halides (for example, fluorides, chlorides, bromides, or iodides) of the alkali metal, the alkaline earth-metal, and the rare earth metal.

The alkali metal compound may be selected from alkali metal oxides, such as Li₂O, Cs₂O, or K₂O, and alkali metal halides, such as LiF, NaF, CsF, KF, Lil, Nal, Csl, Kl, or Rbl. In one embodiment, the alkali metal compound may be selected from LiF, Li₂O, NaF, Lil, Nal, Csl, and Kl, but embodiments of the present disclosure are not limited thereto.

The alkaline earth-metal compound may be selected from alkaline earth-metal oxides, such as BaO, SrO, CaO, BaₓSr₁₋ₓO (0<x<1), BaₓCa₁₋ₓO (0<x<1). In one embodiment, the alkaline earth-metal compound may be selected from BaO, SrO, and CaO, but embodiments of the present disclosure are not limited thereto.

The rare earth metal compound may be selected from YbF₃, ScF₃, ScO₃, Y₂O₃, Ce₂O₃, GdF₃, and TbF₃. In one embodiment, the rare earth metal compound may be selected from YbF₃, ScF₃, TbF₃, Ybl₃, Scl₃, and Tbl₃, but embodiments of the present disclosure are not limited thereto.

The alkali metal complex, the alkaline earth-metal complex, and the rare earth metal complex may include an ion of alkali metal, alkaline earth-metal, and rare earth metal as described above, and a ligand coordinated with a metal ion of the alkali metal complex, the alkaline earth-metal complex, or the rare earth metal complex may be selected from hydroxy quinoline, hydroxy isoquinoline, hydroxy benzoquinoline, hydroxy acridine, hydroxy phenanthridine, hydroxy phenylan oxazole, hydroxy phenylthiazole, hydroxy diphenylan oxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but embodiments of the present disclosure are not limited thereto.

The electron injection layer may include or consist of an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof, as described above. In one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof may be homogeneously or non-homogeneously dispersed in a matrix including the organic material.

A thickness of the electron injection layer may be in a range of about 1 Å to about 100 Å, or, for example, about 1 Å to about 95 Å, about 2 Å to about 95 Å or about 3 Å to about 90 Å. When the thickness of the electron injection layer is within the range described above, the electron injection layer may have suitable or satisfactory electron injection characteristics without a substantial increase in driving voltage.

### [Second electrode 190]

The second electrode 190 may be disposed on the organic layer 150 having such a structure. The second electrode 190 may be a cathode which is an electron injection electrode, and in this regard, a material for forming the second electrode 190 may be selected from metal, an alloy, an electrically conductive compound, and a combination thereof, which have a relatively low work function.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layered structure, or a multi-layered structure including two or more layers.

### [Description of FIGS. 2 to 4]

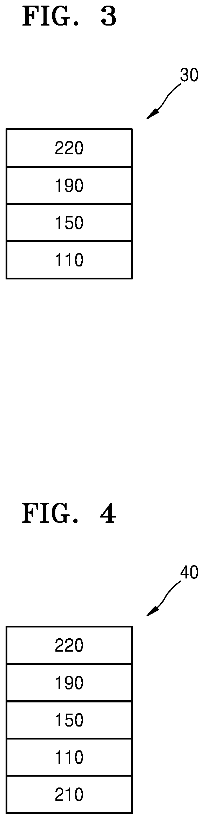

An organic light-emitting device 20 of FIG. 2 includes a first capping layer 210, a first electrode 110, an organic layer 150, and a second electrode 190 which are sequentially stacked in this stated order. An organic light-emitting device 30 of FIG. 3 includes a first electrode 110, an organic layer 150, a second electrode 190, and a second capping layer 220 which are sequentially stacked in this stated order. An organic light-emitting device 40 of FIG. 4 includes a first capping layer 210, a first electrode 110, an organic layer 150, a second electrode 190, and a second capping layer 220.

Regarding FIGS. 2 to 4, the first electrode 110, the organic layer 150, and the second electrode 190 may be understood by referring to the description presented in connection with FIG. 1.

In the organic layer 150 of each of the organic light-emitting devices 20 and 40, light generated in an emission layer may pass through the first electrode 110, which is a semi-transmissive electrode or a transmissive electrode, and the first capping layer 210 toward the outside, and in the organic layer 150 of each of the organic light-emitting devices 30 and 40, light generated in an emission layer may pass through the second electrode 190, which is a semi-transmissive electrode or a transmissive electrode, and the second capping layer 220 toward the outside.

The first capping layer 210 and the second capping layer 220 may increase external luminescent efficiency according to the principle of constructive interference.

The first capping layer 210 and the second capping layer 220 may each independently be an organic capping layer including an organic material, an inorganic capping layer including an inorganic material, or a composite capping layer including an organic material and an inorganic material.

At least one selected from the first capping layer 210 and the second capping layer 220 may each independently include at least one material selected from carbocyclic compounds, heterocyclic compounds, amine-based compounds, porphyrine derivatives, phthalocyanine derivatives, a naphthalocyanine derivatives, alkali metal complexes, and alkaline earth-based complexes. The carbocyclic compound, the heterocyclic compound, and the amine-based compound may be optionally substituted with a substituent containing at least one element selected from O, N, S, Se, Si, F, CI, Br, and I. In one embodiment, at least one selected from the first capping layer 210 and the second capping layer 220 may each independently include an amine-based compound.

In one embodiment, at least one selected from the first capping layer 210 and the second capping layer 220 may each independently include the compound represented by Formula 201 or the compound represented by Formula 202.

In one or more embodiments, at least one selected from the first capping layer 210 and the second capping layer 220 may each independently include a compound selected from Compounds HT28 to HT33 and Compounds CP1 to CP5, but embodiments of the present disclosure are not limited thereto:

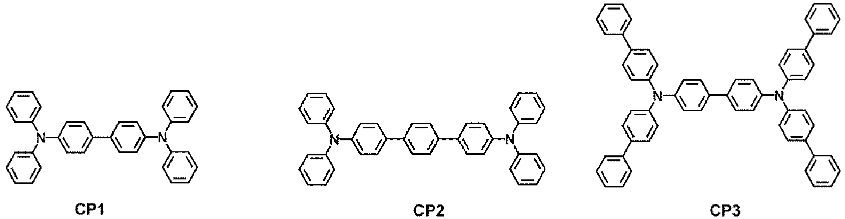

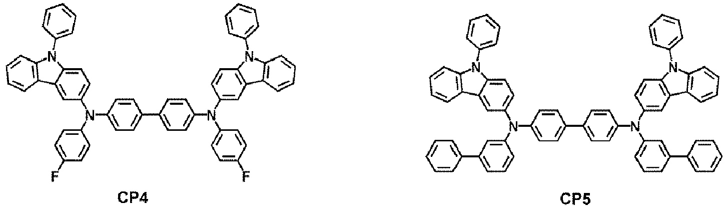

Hereinbefore, the organic light-emitting device according to an embodiment has been described in connection with FIGS. 1 to 4. However, embodiments of the present disclosure are not limited thereto.

Layers constituting the hole transport region, an emission layer, and layers constituting the electron transport region may be formed in a certain region by using one or more suitable methods selected from vacuum deposition, spin coating, casting, Langmuir-Blodgett (LB) deposition, ink-jet printing, laser-printing, and laser-induced thermal imaging.

When layers constituting the hole transport region, an emission layer, and layers constituting the electron transport region are formed by vacuum deposition, for example, the vacuum deposition may be performed at a deposition temperature of about 100 °C to about 500 °C, at a vacuum degree of about 1.33322368 x 10⁻⁶ Pa (10⁻⁸ torr) to about 0.133322368 Pa (10⁻³ torr), and at a deposition rate of about 0.01 Å/sec to about 100 Å/sec by taking into account a material to be included in a layer to be formed, and the structure of a layer to be formed.

When layers constituting the hole transport region, an emission layer, and layers constituting the electron transport region are formed by spin coating, the spin coating may be performed at a coating speed of about 33.33 Hz (2,000 rpm) to about 83.33 Hz (5,000 rpm) and at a heat treatment temperature of about 80 °C to about 200 °C by taking into account a material to be included in a layer to be formed, and the structure of a layer to be formed.

### [General definition of some of the substituents]

The term "C₁-C₆₀ alkyl group," as used herein, refers to a linear or branched saturated aliphatic hydrocarbon monovalent group having 1 to 60 carbon atoms, and examples thereof include a methyl group, an ethyl group, a propyl group, an isobutyl group, a sec-butyl group, a tert-butyl group, a pentyl group, an iso-amyl group, and a hexyl group. The term "C₁-C₆₀ alkylene group," as used herein, refers to a divalent group having substantially the same structure as the C₁-C₆₀ alkyl group, except that the C₁-C₆₀ alkylene group is divalent instead of monovalent. Corresponding definitions apply to other ranges given for the number of carbon atoms in an alkyl/alkylene group.

The term "C₂-C₆₀ alkenyl group," as used herein, refers to a hydrocarbon group having at least one carbon-carbon double bond at a main chain (e.g., in the middle) or at an end (e.g., the terminus) of the C₂-C₆₀ alkyl group, and examples thereof include an ethenyl group, a propenyl group, and a butenyl group. The term "C₂-C₆₀ alkenylene group," as used herein, refers to a divalent group having substantially the same structure as the C₂-C₆₀ alkenyl group, except that the C₂-C₆₀ alkenylene group is divalent instead of monovalent. Corresponding definitions apply to other ranges given for the number of carbon atoms in an alkenyl/alkenylene group.

The term "C₂-C₆₀ alkynyl group," as used herein, refers to a hydrocarbon group having at least one carbon-carbon triple bond at a main chain (e.g., in the middle) or at an end (e.g., the terminus) of the C₂-C₆₀ alkyl group, and examples thereof include an ethynyl group, and a propynyl group. The term "C₂-C₆₀ alkynylene group," as used herein, refers to a divalent group having substantially the same structure as the C₂-C₆₀ alkynyl group, except that the C₂-C₆₀ alkynylene group is divalent instead of monovalent. Corresponding definitions apply to other ranges given for the number of carbon atoms in an alkynyl/alkynylene group.

The term "C₁-C₆₀ alkoxy group," as used herein, refers to a monovalent group represented by -OA₁₀₁ (wherein A₁₀₁ is the C₁-C₆₀ alkyl group), and examples thereof include a methoxy group, an ethoxy group, and an isopropyloxy group. Corresponding definitions apply to other ranges given for the number of carbon atoms in an alkoxy group.

The term "C₃-C₁₀ cycloalkyl group," as used herein, refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "C₃-C₁₀ cycloalkylene group," as used herein, refers to a divalent group having substantially the same structure as the C₃-C₁₀ cycloalkyl group, except that the C₃-C₁₀ cycloalkylene group is divalent instead of monovalent.

The term "C₁-C₁₀ heterocycloalkyl group," as used herein, refers to a monovalent monocyclic group having at least one heteroatom selected from N, O, Si, P, and S as a ring-forming atom and 1 to 10 carbon atoms, and examples thereof include a 1,2,3,4-oxatriazolidinyl group, a tetrahydrofuranyl group, and a tetrahydrothiophenyl group. The term "C₁-C₁₀ heterocycloalkylene group," as used herein, refers to a divalent group having substantially the same structure as the C₁-C₁₀ heterocycloalkyl group, except that the C₁-C₁₀ heterocycloalkylene group is divalent instead of monovalent.

The term "C₃-C₁₀ cycloalkenyl group," as used herein, refers to a monovalent monocyclic group that has 3 to 10 carbon atoms and at least one carbon-carbon double bond in the ring thereof and no aromaticity (e.g., the ring is not aromatic), and examples thereof include a cyclopentenyl group, a cyclohexenyl group, and a cycloheptenyl group. The term "C₃-C₁₀ cycloalkenylene group," as used herein, refers to a divalent group having substantially the same structure as the C₃-C₁₀ cycloalkenyl group, except that the C₃-C₁₀ cycloalkenylene group is divalent instead of monovalent.

The term "C₁-C₁₀ heterocycloalkenyl group," as used herein, refers to a monovalent monocyclic group that has at least one heteroatom selected from N, O, Si, P, and S as a ring-forming atom, 1 to 10 carbon atoms, and at least one carbon-carbon double bond in its ring. Non-limiting examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group," as used herein, refers to a divalent group having substantially the same structure as the C₁-C₁₀ heterocycloalkenyl group, except that the C₁-C₁₀ heterocycloalkenylene group is divalent instead of monovalent.

The term "C₆-C₆₀ aryl group," as used herein, refers to a monovalent group having a carbocyclic aromatic system having 6 to 60 carbon atoms, and a C₆-C₆₀ arylene group used herein refers to a divalent group having a carbocyclic aromatic system having 6 to 60 carbon atoms. Examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other (e.g., combined together). Corresponding definitions apply to other ranges given for the number of carbon atoms in an aryl/arylene group.

The term "C₁-C₆₀ heteroaryl group," as used herein, refers to a monovalent group having a carbocyclic aromatic system that has at least one heteroatom selected from N, O, Si, P, and S as a ring-forming atom, in addition to 1 to 1 carbon atoms. The term "C₁-C₆₀ heteroarylene group," as used herein refers to a divalent group having a carbocyclic aromatic system that has at least one heteroatom selected from N, O, Si, P, and S as a ring-forming atom, in addition to 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other (e.g., combined together). Corresponding definitions apply to other ranges given for the number of carbon atoms in an heteroaryl/heteroarylene group.

The term "C₆-C₆₀ aryloxy group," used herein, indicates -OA₁₀₂ (wherein A₁₀₂ is the C₆-C₆₀ aryl group), and a C₆-C₆₀ arylthio group indicates -SA₁₀₃ (wherein A₁₀₃ is the C₆-C₆₀ aryl group). Corresponding definitions apply to other ranges given for the number of carbon atoms in an aryloxy group and an arylthio group.

The term "C₁-C₆₀ heteroaryloxy group," as used herein, indicates -OA₁₀₄ (wherein A₁₀₄ is the C₁-C₆₀ heteroaryl group), and the term " C₆-C₆₀ heteroarylthio group," as used herein, indicates -SA₁₀₅ (wherein A₁₀₅ is the C₁-C₆₀ heteroaryl group). Corresponding definitions apply to other ranges given for the number of carbon atoms in a heteroaryloxy group and a heteroarylthio group.

The term "monovalent non-aromatic condensed polycyclic group," as used herein, refers to a monovalent group (for example, having 8 to 60 carbon atoms) having two or more rings condensed with each other (e.g., combined together), only carbon atoms as ring-forming atoms, and no aromaticity in its entire molecular structure (e.g., the entire compound or group is not aromatic). A non-limiting example of the monovalent non-aromatic condensed polycyclic group is a fluorenyl group. The term "divalent non-aromatic condensed polycyclic group," as used herein, refers to a divalent group having substantially the same structure as the monovalent non-aromatic condensed polycyclic group, except that the divalent non-aromatic condensed polycyclic group is divalent instead of monovalent.

The term "monovalent non-aromatic condensed heteropolycyclic group," as used herein, refers to a monovalent group (for example, having 1 to 60 carbon atoms) having two or more rings condensed to each other, at least one heteroatom selected from N, O, Si, P, and S, other than carbon atoms, as a ring-forming atom, and no aromaticity in its entire molecular structure (e.g., the entire compound or group is not aromatic). A non-limiting example of the monovalent non-aromatic condensed heteropolycyclic group is a carbazolyl group. The term "divalent non-aromatic condensed heteropolycyclic group," as used herein, refers to a divalent group having substantially the same structure as the monovalent non-aromatic condensed heteropolycyclic group, except that the divalent non-aromatic condensed heteropolycyclic group is divalent instead of monovalent.

The term "C₅-C₆₀ carbocyclic group," as used herein, refers to a monocyclic or polycyclic group having 5 to 60 carbon atoms in which a ring-forming atom is a carbon atom only (e.g., the atoms forming the ring only include carbon atoms). The C₅-C₆₀ carbocyclic group may be an aromatic carbocyclic group or a non-aromatic carbocyclic group. The C₅-C₆₀ carbocyclic group may be a ring, such as benzene, a monovalent group, such as a phenyl group, or a divalent group, such as a phenylene group. In one or more embodiments, depending on the number of substituents coupled or connected to the C₅-C₆₀ carbocyclic group, the C₅-C₆₀ carbocyclic group may be a trivalent group or a quadrivalent group. Corresponding definitions apply to other ranges given for the number of carbon atoms in a carbocyclic group.

The term "C₁-C₆₀ heterocyclic group," as used herein, refers to a group having substantially the same structure as the C₅-C₆₀ carbocyclic group, except that as a ring-forming atom, at least one heteroatom selected from N, O, Si, P, and S is used in addition to carbon (the number of carbon atoms may be in a range of 1 to 60). Corresponding definitions apply to other ranges given for the number of carbon atoms in a heterocyclic group.

At least one substituent of the substituted C₅-C₆₀ carbocyclic group, the substituted C₁-C₆₀ heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be selected from:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - CI, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂), and
Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one selected from deuterium, -F, and a cyano group, a C₆-C₆₀ aryl group substituted with at least one selected from deuterium, -F, and a cyano group, a biphenyl group, and a terphenyl group.

The term "Ph," as used herein, represents a phenyl group, the term "Me," as used herein, represents a methyl group, the term "Et," as used herein, represents an ethyl group, the term "ter-Bu" or "Bu^{t}," as used herein, represents a tert-butyl group, and the term "OMe," as used herein, represents a methoxy group.

The term "biphenyl group," as used herein, refers to "a phenyl group substituted with a phenyl group." In other words, the "biphenyl group" is a substituted phenyl group having a C₆-C₆₀ aryl group as a substituent.

The term "terphenyl group," as used herein, refers to "a phenyl group substituted with a biphenyl group." In other words, the "terphenyl group" is a phenyl group having, as a substituent, a C₆-C₆₀ aryl group substituted with a C₆-C₆₀ aryl group.

* and *', as used herein, unless defined otherwise, each refer to a binding site to a neighboring atom in a corresponding formula.

Hereinafter, a compound according to embodiments and an organic light-emitting device according to embodiments will be described in more detail with reference to Synthesis Examples and Examples. The wording "B was used instead of A" used in describing Synthesis Examples refers to that an identical molar equivalent of B was used in place of A.

### [Examples]

### Synthesis Example 1: Synthesis of Compound 4

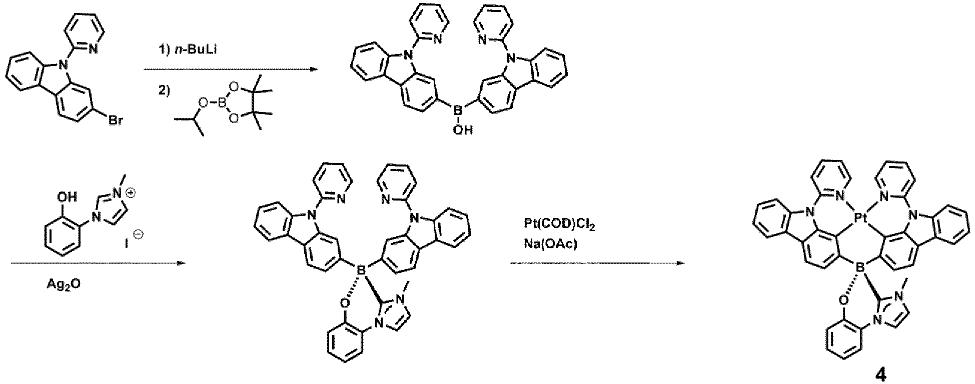

10.64 mL (17.08 mmol) of n-BuLi (1.6 M sol. in hexane) was slowly added dropwise to a solution, in which 5.00 g (15.47 mmol) of 2-bromo-9-(pyridin-2-yl)-9*H-*carbazole was dissolved in 50 mL of tetrahydrofuran (THF), at a temperature of -78 °C. The reaction mixture was stirred at a temperature of -78 °C for 1 hour, and 2-isopropoxy-4,4,5,5-tetramethyl-1,3,2-dioxaborolane (1.2 equiv.) was slowly added dropwise thereto. The reaction mixture was heated to room temperature and stirred for 24 hours. A solvent was removed from the reaction mixture, and an organic layer was extracted therefrom three times by using dichloromethane and water. 3.04 g (10.06 mmol) of 1-(2-hydroxyphenyl)-3-methyl-1*H*-imidazol-3-ium iodine, 3.50 g (15.09 mmol) of Ag₂O, and 50 mL of THF were added to 2,2'-(hydroxyborandiyl)bis(9-(pyridin-2-yl)-9H-carbazole) obtained by drying an organic layer filtrate, and the reaction mixture was heated to a temperature of 50 °C and stirred for 24 hours. Then, the reaction mixture was cooled to room temperature, and 3.74 g (10.00 mmol) of dichloro(1,5-cyclooctadiene)platinum(II) and 2.46 g (30 mmol) of NaOAc were added thereto. Then, the reaction mixture was stirred at a temperature of 70 °C for 60 hours. The reaction mixture was cooled to room temperature, and an organic layer was extracted therefrom three times by using dichloromethane and water. The extracted organic layer was dried by using magnesium sulfate and filtered by using celite. Then, column chromatography was performed thereon to synthesize 2.14 g (2.48 mmol, yield=16%) of Compound 4.

### Synthesis Example 2: Synthesis of Compound 14

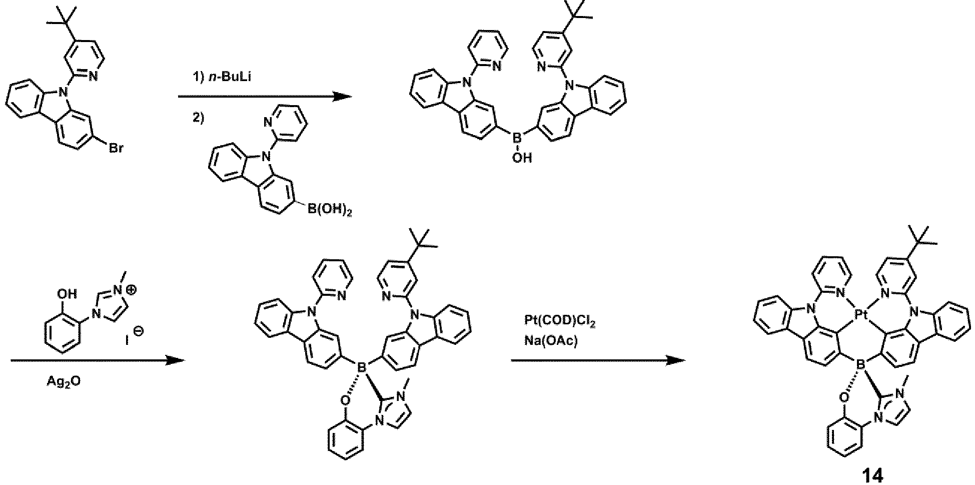

10.64 mL (17.08 mmol) of n-BuLi (1.6 M sol. in hexane) was added dropwise to a solution, in which 5.87 g (15.47 mmol) of 2-bromo-9-(4-(tert-butyl)pyridin-2-yl)-9*H-*carbazole was dissolved in 50 mL of THF, at a temperature of -78 °C. The reaction mixture was stirred at a temperature of -78 °C for 1 hour, and (9-(pyridin-2-yl)-9H-carbazol-2-yl)boronic acid (1.2 equivalent) was slowly added dropwise thereto. A solvent was removed from the reaction mixture, and an organic layer was extracted therefrom three times by using dichloromethane and water. 3.04 g (10.06 mmol) of 1-(2-hydroxyphenyl)-3-methyl-1*H*-imidazol-3-ium iodine, 3.50 g (15.09 mmol) of Ag₂O, and 50 mL of THF were added to 9-(4-(tert-butyl)pyridin-2-yl)-2-(hydroxy(9-(pyridin-2-yl)-9H-carbazol-2-yl)boranyl)-9H-carbazole obtained by drying an organic layer filtrate, and the reaction mixture was heated to a temperature of 50 °C and stirred for 24 hours. Then, the reaction mixture was cooled to room temperature, and 3.74 g (10.00 mmol) of dichloro(1,5-cyclooctadiene)platinum(II) and 2.46 g (30 mmol) of NaOAc were added thereto and stirred at a temperature of 70 °C for 60 hours. The reaction mixture was cooled to room temperature, and an organic layer was extracted therefrom three times by using dichloromethane and water. The extracted organic layer was dried by using magnesium sulfate and filtered by using celite. Then, column chromatography was performed thereon to synthesize 2.56 g (2.78 mmol, yield=18%) of Compound 14.

### Synthesis Example 3: Synthesis of Compound 24

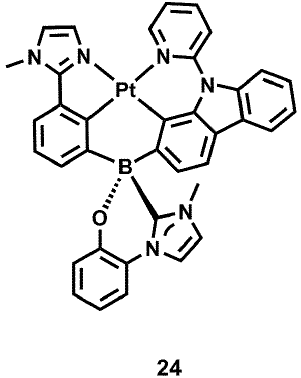

1.80 g (2.32 mmol, yield=15%) of Compound 24 was synthesized in substantially the same manner as in Synthesis Example 2, except that 2-(3-bromophenyl)-1-methyl-1H-imidazole was used instead of 2-bromo-9-(4-(tert-butyl)pyridin-2-yl)-9*H*-carbazole.

### Synthesis Example 4: Synthesis of Compound 44

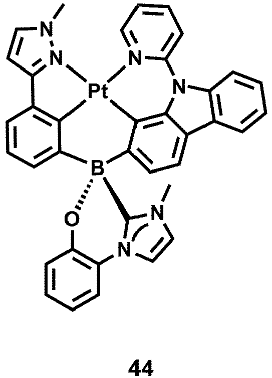

2.16 g (2.78 mmol, yield=18%) of Compound 44 was synthesized in substantially the same manner as in Synthesis Example 2, except that 1-methyl-3-phenyl-1H-pyrazole was used instead of 2-bromo-9-(4-(tert-butyl)pyridin-2-yl)-9*H-*carbazole.

### Synthesis Example 5: Synthesis of Compound 64

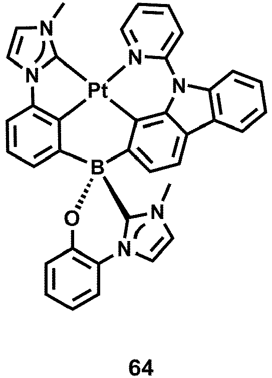

1.92 g (2.78 mmol, yield=16%) of Compound 64 was synthesized in substantially the same manner as in Synthesis Example 2, except that 1-(3-bromophenyl)-3-methyl-1H-imidazol-3-ium bromine was used instead of 2-bromo-9-(4-(tert-butyl)pyridin-2-yl)-9*H*-carbazole.

### Synthesis Example 6: Synthesis of Compound 84

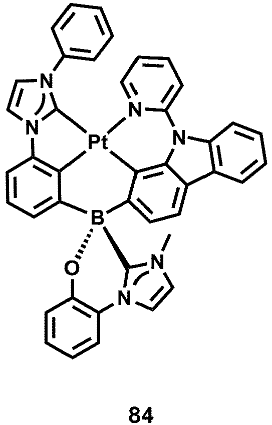

2.21 g (2.63 mmol, yield=17%) of Compound 84 was synthesized in substantially the same manner as in Synthesis Example 2, except that 1-(3-bromophenyl)-3-phenyl-1H-imidazol-3-ium bromine was used instead of 2-bromo-9-(4-(tert-butyl)pyridin-2-yl)-9*H*-carbazole.

### Synthesis Example 7: Synthesis of Compound 104

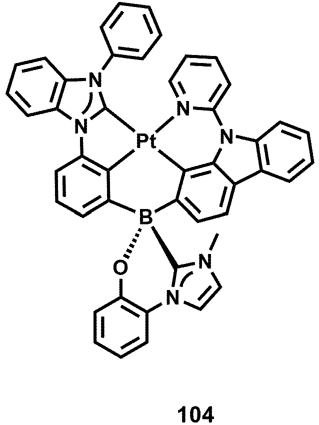

1.79 g (2.01 mmol, yield=13%) of Compound 104 was synthesized in substantially the same manner as in Synthesis Example 2, except that 1-(3-bromophenyl)-3-phenyl-1H-benzo[d]imidazol-3-ium bromine was used instead of 2-bromo-9-(4-(tert-butyl)pyridin-2-yl)-9*H*-carbazole.

### Synthesis Example 8: Synthesis of Compound 124

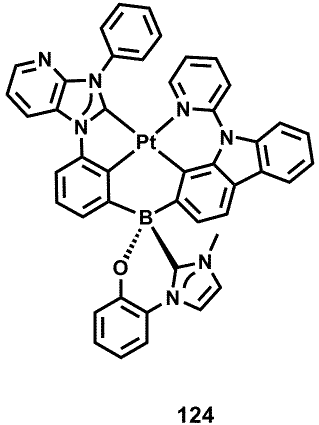

0.96 g (1.08 mmol, yield=7%) of Compound 124 was synthesized in substantially the same manner as in Synthesis Example 2, except that 1-(3-bromophenyl)-3-phenyl-1H-imidazo[4,5-b]pyridin-3-ium bromine was used instead of 2-bromo-9-(4-(tert-butyl)pyridin-2-yl)-9*H*-carbazole.

### Synthesis Example 9: Synthesis of Compound 144

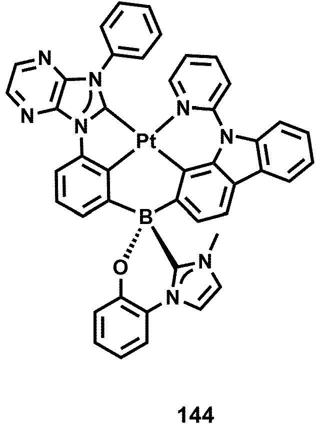

0.96 g (0.70 mmol, yield=5%) of Compound 144 was synthesized in substantially the same manner as in Synthesis Example 2, except that 1-(3-bromophenyl)-3-phenyl-1H-imidazo[4,5-b]pyrazin-3-ium bromine was used instead of 2-bromo-9-(4-(tert-butyl)pyridin-2-yl)-9*H*-carbazole.

### Synthesis Example 10 : Synthesis of Compound 164

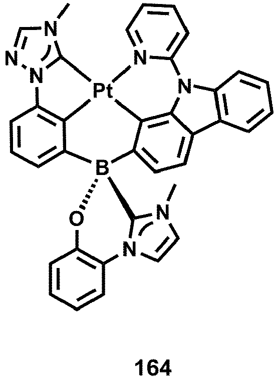

0.78 g (0.93 mmol, yield=6%) of Compound 164 was synthesized in substantially the same manner as in Synthesis Example 2, except that 1-(3-bromophenyl)-4-methyl-1H-1,2,4-triazol-4-ium bromine was used instead of 2-bromo-9-(4-(tert-butyl)pyridin-2-yl)-9*H*-carbazole.

### Synthesis Example 11 : Synthesis of Compound 184

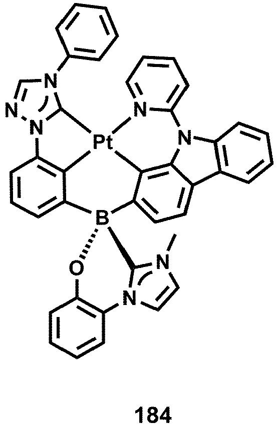

0.65 g (0.77 mmol, yield=5%) of Compound 184 was synthesized in substantially the same manner as in Synthesis Example 2, except that 1-(3-bromophenyl)-4-phenyl-1H-1,2,4-triazol-4-ium bromine was used instead of 2-bromo-9-(4-(tert-butyl)pyridin-2-yl)-9*H*-carbazole.

### Synthesis Example 12: Synthesis of Compound 204

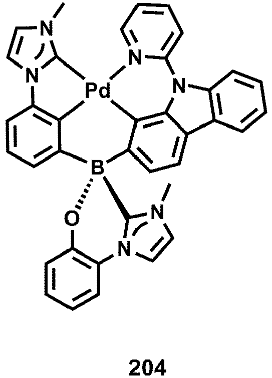

1.49 g (2.17 mmol, yield=14%) of Compound 204 was synthesized in substantially the same manner as in Synthesis Example 5, except that palladium acetate was used instead of dichloro(1,5-cyclooctadiene)platinum(II).

### Synthesis Example 13: Compound 214

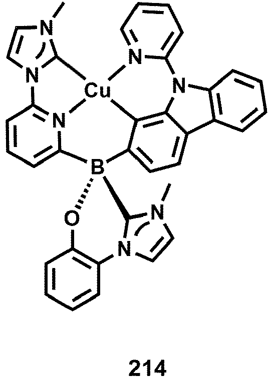

1.49 g (2.17 mmol, yield=14%) of Compound 214 was synthesized in substantially the same manner as in Synthesis Example 5, except that Cul was used instead of dichloro(1,5-cyclooctadiene) platinum(II).

### Synthesis Example 14: Synthesis of Compound 224

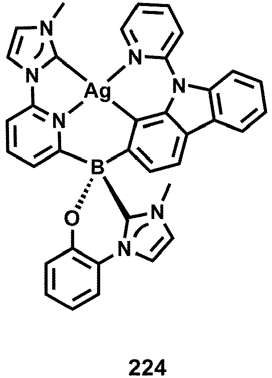

1.29 g (1.86 mmol, yield=12%) of Compound 224 was synthesized in substantially the same manner as in Synthesis Example 5, except that AgOTf was used instead of dichloro(1,5-cyclooctadiene)-platinum(II).

### Synthesis Example 15: Synthesis of Compound 234

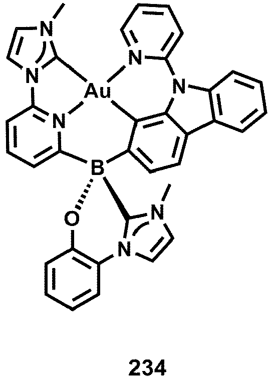

1.69 g (2.17 mmol, yield=14%) of Compound 234 was synthesized in substantially the same manner as in Synthesis Example 5, except that (PPh)₃AuCl was used instead of dichloro(1,5-cyclooctadiene)-platinum(II).

### Synthesis Example 16: Synthesis of Compound 241

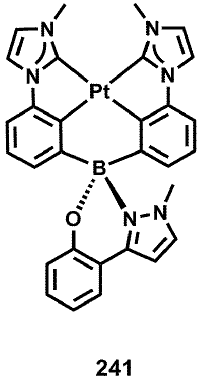

3.74 g (5.42 mmol, yield=35%) of Compound 241 was synthesized in substantially the same manner as in Synthesis Example 1, except that 1-(3-bromophenyl)-3-methyl-1H-imidazol-3-ium bromine was used instead of 2-bromo-9-(pyridin-2-yl)-9*H*-carbazole, and 2-(1-methyl-1H-pyrazol-3-yl)phenol was used instead of 1-(3-hydroxyphenyl)-3-methyl-1H-imidazol-3-ium iodine.

¹H NMR and FAB-MS of Compounds synthesized according to Synthesis Examples 1 to 16 are shown in Table 1.

Methods of synthesizing compounds other than the compound shown in Table 1 are recognizable by those of ordinary skill in the art by referring to the synthesis mechanisms and source materials described above.

**Table 1**

| Compound | ¹H NMR (CDCl₃, 500 MHz) | FAB-MS [M⁺] | |
|---|---|---|---|
| | | Found | Calc. |
| 4 | δ = 8.73 (d, 1H), 8.43 (d, 2H), 8.19-8.15 (m, 4H), 8.02 (d, 2H), 7.88-7.27 (m, 16H), 6.80 (d, 1H), 3.62 (s, 3H). | 868.26 | 863.21 |
| 14 | δ = 8.74 (d, 1H), 8.42 (d, 2H), 8.18-8.14 (m, 4H), 8.01 (d, 2H), 7.86-7.24 (m, 15H), 6.81 (d, 1H), 3.61 (s, 3H), 1.28 (s, 9H). | 919.33 | 919.28 |
| 24 | δ = 8.73 (d, 1H), 8.44 (d, 2H), 8.15-8.13 (m, 2H), 8.02 (d, 2H), 7.88 (d, 1H), 7.77 (d, 1H), 7.55-7.24 (m, 11H), 6.80 (d, 1H), 3.71 (s, 3H), 3.69 (s, 3H). | 777.24 | 777.20 |
| 44 | δ = 8.72 (d, 1H), 8.43 (d, 2H), 8.19-8.15 (m, 2H), 8.02 (d, 1H), 7.85 (d, 1H), 7.77-7.75 (m, 2H), 7.55-7.40 (m, 5H), 7.26-7.10 (m, 5H), 6.93 (d, 1H), 6.81 (d, 1H), 3.95 (s, 3H), 3.72 (s, 3H). | 777.26 | 777.20 |
| 64 | δ = 8.73 (d, 1H), 8.41 (d, 2H), 8.20-8.16 (m, 2H), 8.08 (d, 1H), 7.84 (d, 1H), 7.76-7.70 (m, 2H), 7.54-7.44 (m, 5H), 7.20-7.05 (m, 5H), 6.92 (d, 1H), 6.83 (d, 1H), 3.74 (s, 3H), 3.72 (s, 3H). | 777.27 | 777.20 |
| 84 | δ = 8.74 (d, 1H), 8.43 (d, 1H), 8.19-8.15 (m, 2H), 8.02 (d, 1H), 7.75-7.73 (m, 3H), 7.62-7.30 (m, 17H), 6.82 (d, 1H), 3.73 (s, 3H). | 839.25 | 839.21 |
| 104 | δ = 8.76 (d, 1H), 8.56-8.54 (m, 2H), 8.43 (d, 1H), 8.19-8.15 (m, 2H), 8.02 (d, 1H), 7.75 (d, 1H), 7.54-7.00 (m, 19H), 6.92 (d, 1H), 3.72 (s, 3H). | 889.28 | 889.23 |
| 124 | δ = 8.77 (d, 1H), 8.42-8.39 (m, 2H), 8.20-8.16 (m, 2H), 8.01-7.99 (m, 1H), 7.76 (d, 1H), 7.60-7.02 (m, 19H), 6.81 (d, 1H), 3.71 (s, 3H). | 890.26 | 890.23 |
| 144 | δ = 8.76 (d, 1H), 8.60-8.58 (m, 2H), 8.43 (d, 1H), 8.19-8.15 (m, 2H), 8.02 (d, 1H), 7.74 (d, 1H), 7.58-7.02 (m, 17H), 6.80 (d, 1H), 3.71 (s, 3H). | 891.25 | 891.22 |
| 164 | δ = 8.79 (s, 1H), 8.73 (d, 1H), 8.19-8.15 (m, 2H), 7.75 (d, 1H), 7.65-7.00 (m, 19H), 6.82 (d, 1H), 3.71 (s, 3H). | 778.30 | 778.19 |
| 184 | δ = 9.28 (s, 1H), 8.75 (d, 1H), 8.43 (d, 1H), 8.18-8.16 (m, 2H), 8.02 (m, 1H), 7.75 (d, 1H), 7.61-7.00 (m, 17H), 6.80 (d, 1H), 3.71 (s, 3H). | 840.23 | 840.21 |
| 204 | δ = 8.70 (d, 1H), 8.41 (d, 1H), 8.17-8.10 (m, 2H), 8.01 (d, 1H), 7.88 (d, 1H), 7.62-7.45 (m, 8H), 7.20-7.02 (m, 10H), 6.82 (d, 1H), 3.72 (3H), 3.72 (s, 3H). | 688.17 | 688.14 |
| 214 | δ = 8.70 (d, 1H), 8.41 (d, 1H), 8.17-8.10 (m, 2H), 8.01 (d, 1H), 7.88 (d, 1H), 7.62-7.45 (m, 8H), 7.20-7.02 (m, 10H), 6.82 (d, 1H), 3.72 (3H), 3.72 (s, 3H). | 647.19 | 647.17 |
| 224 | δ = 8.71 (d, 1H), 8.40 (d, 1H), 8.18-8.13 (m, 2H), 8.00 (d, 1H), 7.87 (d, 1H), 7.65-7.42 (m, 8H), 7.24-7.10 (m, 10H), 6.85 (d, 1H), 3.74 (3H), 3.73 (s, 3H). | 691.16 | 691.14 |
| 234 | δ = 8.73 (d, 1H), 8.43 (d, 1H), 8.19-8.15 (m, 2H), 8.02 (d, 1H), 7.90 (d, 1H), 7.66-7.44 (m, 8H), 7.28-7.12 (m, 10H), 6.81 (d, 1H), 3.75 (3H), 3.72 (s, 3H). | 797.29 | 797.23 |
| 241 | δ = 8.36 (d, 1H), 7.77-7.75 (m, 3H), 7.61-7.58 (m, 2H), 7.44-7.25 (m, 8H), 7.05 (d, 1H), 6.95 (d, 1H), 3.95 (s, 3H), 3.74 (s, 3H), 3.72 (s, 3H) | 691.22 | 691.18 |

### Example 1

As an anode, an ITO (thickness = 1,200 Å) substrate was cut to a size of 50 mm x 50 mm x 0.7 mm, sonicated with isopropyl alcohol and pure water each for 5 minutes, and then cleaned by exposure to ultraviolet rays and ozone for 30 minutes. Then, the resultant ITO substrate was provided to a vacuum deposition apparatus.

2-TNATA was vacuum-deposited on the ITO substrate to form a hole injection layer having a thickness of 600 Å, and NPB was vacuum-deposited on the hole injection layer to form a hole transport layer having a thickness of 300 Å.

BCPDS, POPCPA, and Compound 4 were co-deposited on the hole transport layer at a weight ratio of 45:45:10 to form an emission layer having a thickness of 300 Å.

Then, TSPO1 was vacuum-deposited on the emission layer to form a hole blocking layer having a thickness of 50 Å, Alq₃ was vacuum-deposited on the hole blocking layer to form an electron transport layer having a thickness of 300 Å, LiF was deposited on the electron transport layer to form an electron injection layer having a thickness of 10 Å, and Al was vacuum-deposited on the electron injection layer to form a cathode electrode having a thickness of 3,000 Å, thereby completing the manufacture of an organic light-emitting device.

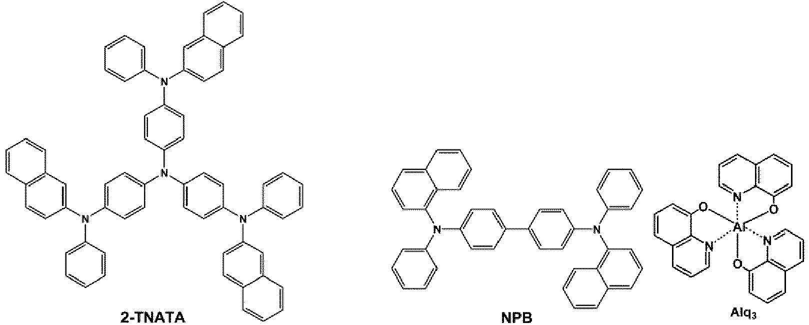

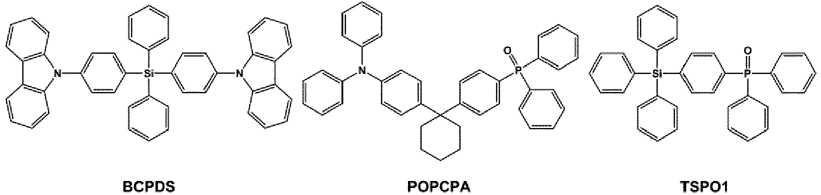

### Examples 2 to 16 and Comparative Examples 1 to 3

Organic light-emitting devices were manufactured in substantially the same manner as in Example 1, except that Compounds shown in Table 2 were each used instead of Compound 4 in forming an emission layer.

### Evaluation Example

The driving voltage, luminance, efficiency, lifespan, emission color, and emission wavelength of the organic light-emitting devices manufactured according to Examples 1 to 16 and Comparative Examples 1 to 3 were measured at a current density 50 mA/cm² by using Keithley SMU 236 and a luminance meter PR650, and results thereof are shown in Table 1. The lifespan indicates an amount of time that lapsed when luminance was 70% of initial luminance after the organic light-emitting devices was driven at a current density 5.0 mA/cm².

**Table 2**

| | Emission layer | Driving voltage (V) | Current density (mA/cm²) | Luminance (cd/m²) | Efficiency (cd/A) | lifespan (T₇₀) (@5.0 mA/cm²) | Emissio n color | Emission wavelength (nm) |
|---|---|---|---|---|---|---|---|---|
| Example 1 | 4 | 5.02 | 50 | 4425 | 25.45 | 350 | Blue | 485 |
| Example 2 | 14 | 5.02 | 50 | 4525 | 26.05 | 360 | Blue | 483 |
| Example 3 | 24 | 5.08 | 50 | 4433 | 18.60 | 150 | Blue | 463 |
| Example 4 | 44 | 5.06 | 50 | 4424 | 18.65 | 190 | Blue | 458 |
| Example 5 | 64 | 5.02 | 50 | 4855 | 19.05 | 160 | Blue | 460 |
| Example 6 | 84 | 5.00 | 50 | 4752 | 19.65 | 170 | Blue | 462 |
| Example 7 | 104 | 5.08 | 50 | 4732 | 18.74 | 165 | Blue | 465 |
| Example 8 | 124 | 5.18 | 50 | 4710 | 18.73 | 160 | Blue | 458 |
| Example 9 | 144 | 5.04 | 50 | 4768 | 19.74 | 165 | Blue | 463 |
| Example 10 | 164 | 5.18 | 50 | 4790 | 19.74 | 170 | Blue | 462 |
| Example 11 | 184 | 5.22 | 50 | 4435 | 18.85 | 175 | Blue | 466 |
| Example 12 | 204 | 5.06 | 50 | 4049 | 10.36 | 120 | Blue | 462 |
| Example 13 | 214 | 5.18 | 50 | 3953 | 7.35 | 125 | Blue | 455 |
| Example 14 | 224 | 5.06 | 50 | 3632 | 6.55 | 125 | Blue | 458 |
| Example 15 | 234 | 5.16 | 50 | 4432 | 14.28 | 175 | Blue | 458 |
| Example 16 | 241 | 5.20 | 50 | 4432 | 13.65 | 170 | Blue | 455 |
| Comparative Example 1 | Flrpic | 6.56 | 50 | 3870 | 10.65 | 1 | Blue | 478 |
| Comparative Example 2 | A | 6.20 | 50 | 2950 | 7.05 | 10 | Blue | 485 |
| Comparative Example 3 | B | 6.05 | 50 | 3235 | 9.53 | 20 | Blue | 495 |

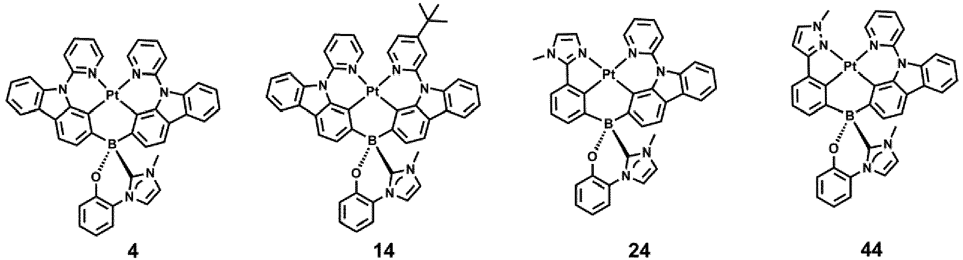

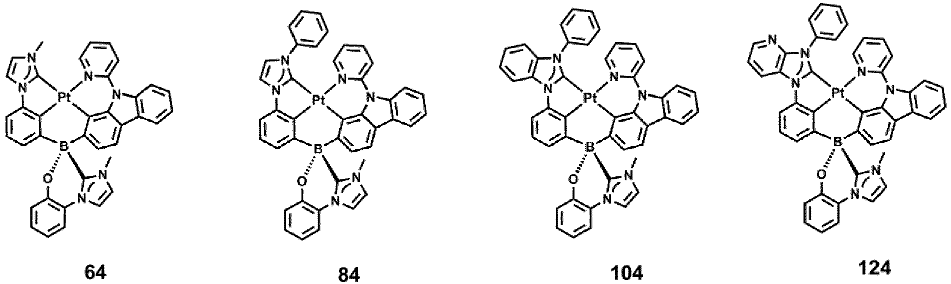

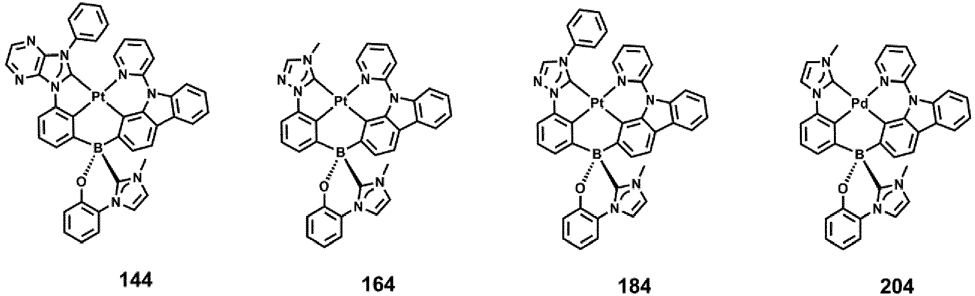

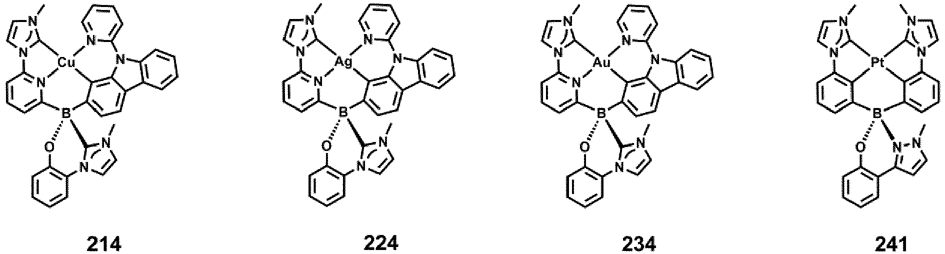

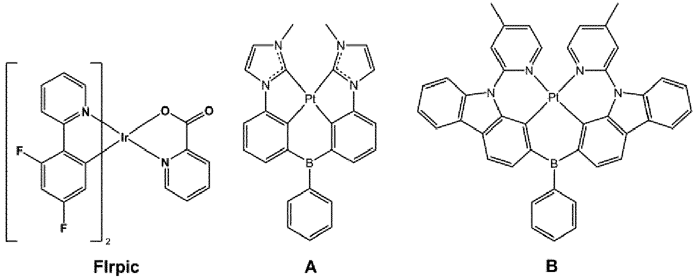

Referring to Table 1, it is confirmed that the organic light-emitting devices of Examples 1 to 16 are excellent in terms of the driving voltage, luminance, efficiency, lifespan, and emission color, as compared with those of the organic light-emitting devices of Comparative Examples 1 to 3.

An organic light-emitting device including the organometallic compound may have a low driving voltage, high efficiency, high luminance, high color purity, and a long lifespan.

It should be understood that embodiments described herein should be considered in a descriptive sense only and not for purposes of limitation. Descriptions of features or aspects within each embodiment should typically be considered as available for other similar features or aspects in other embodiments.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

As used herein, the terms "substantially," "about," and similar terms are used as terms of approximation and not as terms of degree, and are intended to account for the inherent deviations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Also, any numerical range recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

While one or more embodiments have been described with reference to the figures, it will be understood by those of ordinary skill in the art that various changes in form and details may be made therein without departing from the scope as defined by the following claims.

## Claims

1. An organometallic compound represented by Formula 1: 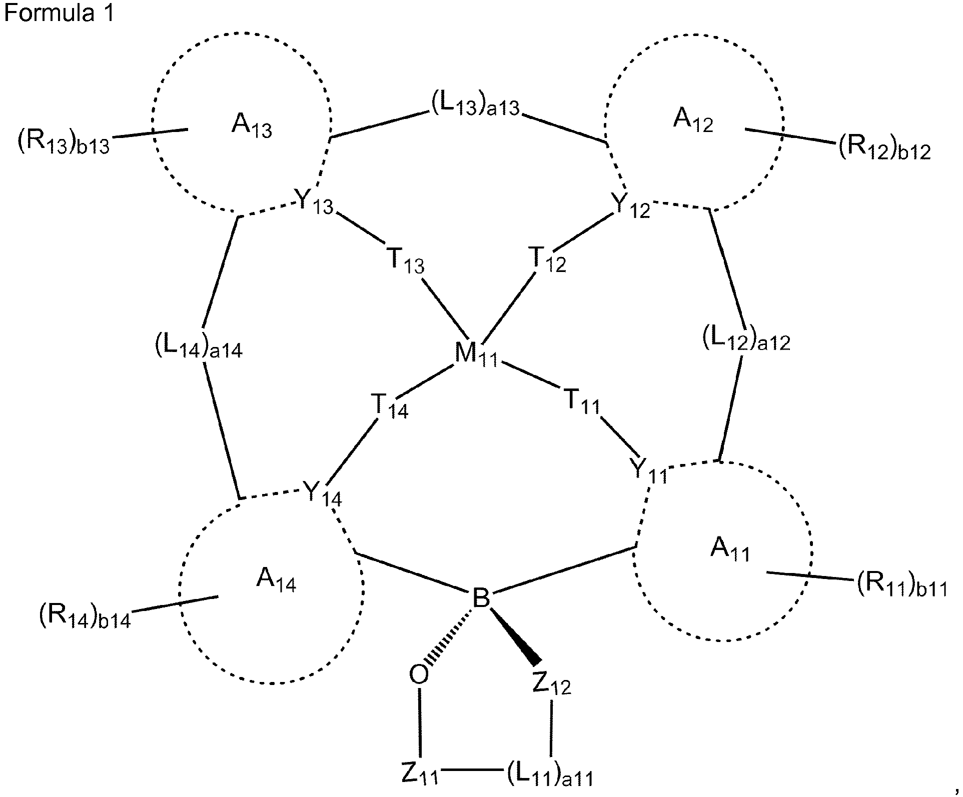 wherein, in Formula 1,
M₁₁ is selected from platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), and thulium (Tm),
A₁₁ to A₁₄ are each independently a C₅-C₆₀ carbocyclic group or a C₁-C₆₀ heterocyclic group,
Y₁₁ to Y₁₄ are each independently N or C,
Z₁₁ and Z₁₂ are each independently selected from N, C, O, S, a single bond, a substituted or unsubstituted C₅-C₆₀ carbocyclic group, and a substituted or unsubstituted C₁-C₆₀ heterocyclic group,
T₁₁ to T₁₄ are each independently selected from a single bond, O, and S,
L₁₁ to L₁₄ are each independently selected from a single bond, *-O-*', *-S-*', *-C(R₁₇)(R₁₈)-*', *-C(R₁₇)=*', *=C(R₁₇)-*', *-C(R₁₇)=C(R₁₈)-*', *-C(=O)-*', *-C(=S)-*', *-C≡C-*', *-B(R₁₇)-*', *-N(R₁₇)-*', *-P(R₁₇)-*', *-Si(R₁₇)(R₁₈)-*', *-P(R₁₇)(R₁₈)-*', and *-Ge(R₁₇)(R₁₈)-*',
a11 to a14 are each independently selected from 0, 1, 2, and 3,
at least two of a12, a13, and a14 are each independently selected from 1, 2, and 3,
when a11 is zero, (L₁₁)ₐ₁₁ is a single bond, when a12 is zero, A₁₁ and A₁₂ are not linked to each other, when a13 is zero, A₁₂ and A₁₃ are not linked to each other, and when a14 is zero, A₁₃ and A₁₄ are not linked to each other,
R₁₁ to R₁₄, R₁₇, and R₁₈ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), - B(Q₁)(Q₂), -N(Q₁)(Q₂), -P(Q₁)(Q₂), -C(=O)(Q₁), -S(=O)(Q₁), -S(=O)₂(Q₁), - P(=O)(Q₁)(Q₂), and -P(=S)(Q₁)(Q₂),
R₁₇ and R₁₁, R₁₇ and R₁₂, R₁₇ and R₁₃, and/or R₁₇ and R₁₄ are optionally linked to form a substituted or unsubstituted C₅-C₆₀ carbocyclic group or a substituted or unsubstituted C₁-C₆₀ heterocyclic group,
R₁₇ and R₁₈ are optionally linked to form a substituted or unsubstituted C₅-C₆₀ carbocyclic group or a substituted or unsubstituted C₁-C₆₀ heterocyclic group,
b11 to b14 are each independently selected from 1, 2, 3, 4, 5, 6, 7, and 8,
Q₁ to Q₃ are each independently selected from hydrogen, deuterium, -F, -Cl, - Br, -I, a hydroxyl group, a cyano group, a nitro group, an amidino group, a hydrazino group, a hydrazono group, a C₁-C₆₀ alkyl group, a C2-C60 alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one selected from deuterium, -F, and a cyano group, a C₆-C₆₀ aryl group substituted with at least one selected from deuterium, -F, and a cyano group, a biphenyl group, and a terphenyl group,
wherein at least one substituent of the substituted C₅-C₆₀ carbocyclic group, the substituted C₁-C₆₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is selected from:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C2-C60 alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), and -P(=O)(Q₂₁)(Q₂₂); and
Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂), and
Q11 to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one selected from deuterium, -F, and a cyano group, a C₆-C₆₀ aryl group substituted with at least one selected from deuterium, -F, and a cyano group, a biphenyl group, and a terphenyl group; and
* and *' each indicate a binding site to a neighboring atom.

2. An organometallic compound according to claim 1, wherein:
A₁₁ to A₁₄ are each independently selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indeno pyridine group, an indolopyridine group, a benzofuropyridine group, a benzothienopyridine group, a benzosilolopyridine group, an indeno pyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline.

3. An organometallic compound according to claim 1 or claim 2, wherein:
A₁₁ to A₁₄ are each independently represented by one of Formulae 2-1 to 2-43: 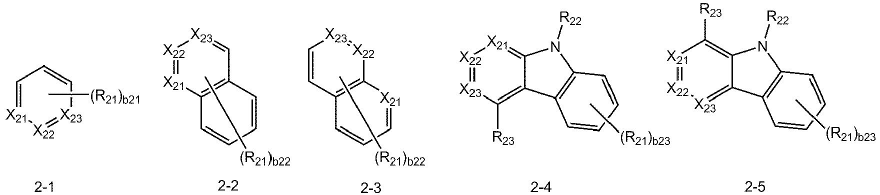 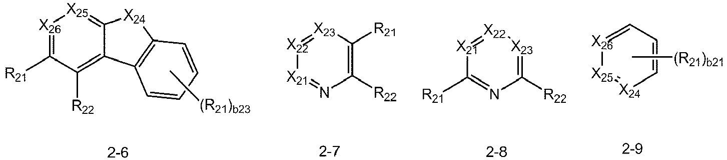 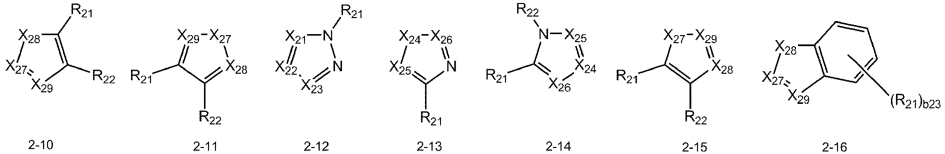 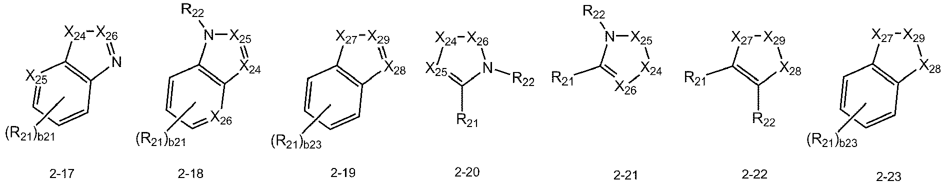 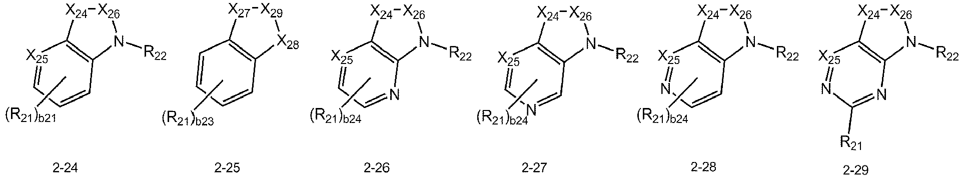 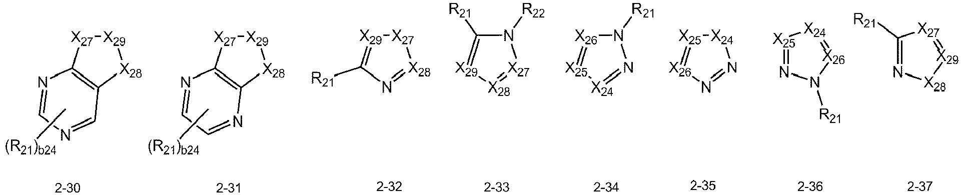 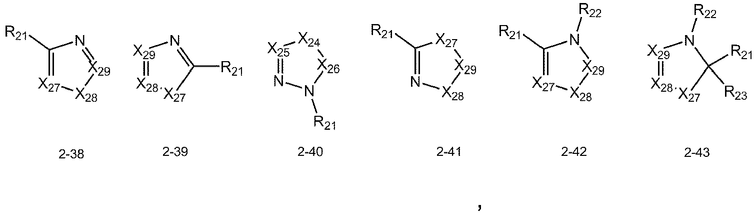 wherein, in Formulae 2-1 to 2-43,
X₂₁ to X₂₃ are each independently C(R₂₄) or C-*, provided that at least two of X₂₁ to X₂₃ are each C-*,
X₂₄ is N-*, and X₂₅ and X₂₆ are each independently C(R₂₄) or C-*, provided that at least one of X₂₅ and X₂₆ is C-*,
X₂₇ and X₂₈ are each independently selected from N, N(R₂₅), and N-*, and X₂₉ is C(R₂₄) or C-*, provided that i) at least one of X₂₇ and X₂₈ is N-*, and X₂₉ is C-*, or ii) X₂₇ and X₂₈ are each N-*, and X₂₉ is C(R₂₄),
R₂₁ to R₂₄ are each independently the same as described in connection with R₁₁ in Formula 1,
b21 is selected from 1, 2, and 3,
b22 is selected from 1, 2, 3, 4, and 5,
b23 is selected from 1, 2, 3, and 4,
b24 is 1 or 2, and
* indicates a binding site to a neighboring atom.

4. An organometallic compound according to any one of claims 1 to 3, wherein:
Y₁₁, Y₁₂, and Y₁₃ are each C, and Y₁₄ is N;
Y₁₁, Y₁₂, and Y₁₄ are each C, and Y₁₃ is N,
Y₁₁, Y₁₃, and Y₁₄ are each C, and Y₁₂ is N;
Y₁₂, Y₁₃, and Y₁₄ are each C, and Y₁₁ is N;
Y₁₁ and Y₁₄ are each C, and Y₁₂ and Y₁₃ are each N;
Y₁₁ and Y₁₄ are each N, and Y₁₂ and Y₁₃ are each C;
Y₁₁ and Y₁₂ are each C, and Y₁₃ and Y₁₄ are each N;
Y₁₁ and Y₁₂ are each N, and Y₁₃ and Y₁₄ are each C;
Y₁₁ and Y₁₃ are each C, and Y₁₂ and Y₁₄ are each N; or
Y₁₁ and Y₁₃ are each N, and Y₁₂ and Y₁₄ are each C.

5. An organometallic compound according to any one of claims 1 to 4, wherein:
Z₁₁ and Z₁₂ are each independently selected from:
N, C, O, S, a single bond, a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indeno pyridine group, an indolopyridine group, a benzofuropyridine group, a benzothienopyridine group, a benzosilolopyridine group, an indeno pyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline;
a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indeno pyridine group, an indolopyridine group, a benzofuropyridine group, a benzothienopyridine group, a benzosilolopyridine group, an indeno pyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline, each substituted with at least one selected from deuterium, -F, -Cl, -Br, -I, a hydroxyl group, a cyano group, a nitro group, an amidino group, a hydrazino group, a hydrazono group, -CD₃, -CD₂H, -CDH₂, -CF₃, - CF₂H, -CFH₂, C₁-C₆₀ alkyl group, a C₂-C₆₀ alkenyl group, a C₂-C₆₀ alkynyl group, and a C₁-C₆₀ alkoxy group; and
a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indeno pyridine group, an indolopyridine group, a benzofuropyridine group, a benzothienopyridine group, a benzosilolopyridine group, an indeno pyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzoxadiazole group, a benzothiadiazole group, a 5,6,7,8-tetrahydroisoquinoline group, and a 5,6,7,8-tetrahydroquinoline, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), and -P(=O)(Q₃₁)(Q₃₂), and
Q₃₁ to Q₃₃ are each independently selected from hydrogen, deuterium, - F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a C₁-C₆₀ alkyl group substituted with at least one selected from deuterium, -F, and a cyano group, a C₆-C₆₀ aryl group substituted with at least one selected from deuterium, -F, and a cyano group, a biphenyl group, and a terphenyl group.

6. An organometallic compound according to any one of claims 1 to 5, wherein:
a substructure represented by 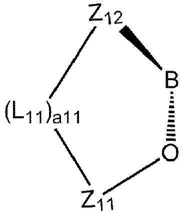 is represented by Formula 9: 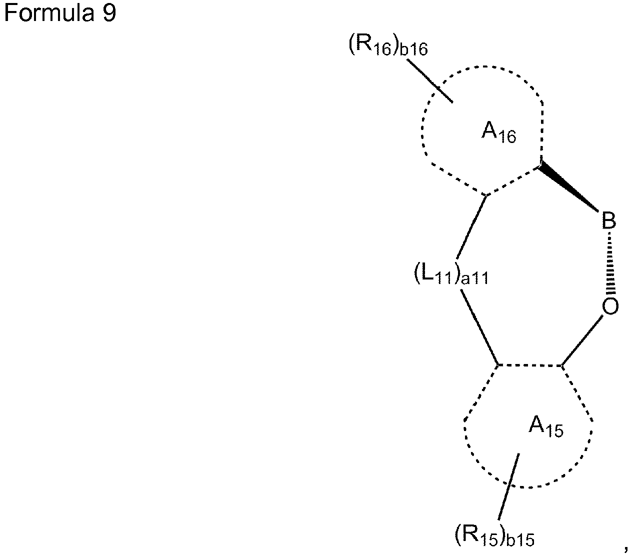 wherein, in Formula 9,
A₁₅ and A₁₆ are each independently a C₅-C₆₀ carbocyclic group or a C₁-C₆₀ heterocyclic group,
R₁₅ and R₁₆ are each independently the same as described in connection with R₁₁ in Formula 1, and
b15 and b16 are each independently the same as described in connection with b11 in Formula 1.

7. An organometallic compound according to claim 6, wherein:
A₁₅ is selected from a benzene group, a pyridine group, a pyrimidine group, a pyrazine group, a pyridazine group, and a triazine group, and A₁₆ is selected from a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group;
A₁₅ is selected from a benzene group, a pyridine group, a pyrimidine group, a pyrazine group, a pyridazine group, and a triazine group, and A₁₆ is selected from a benzene group, a pyridine group, a pyrimidine group, a pyrazine group, a pyridazine group, and a triazine group;
A₁₅ is selected from a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, and A₁₆ is selected from a benzene group, a pyridine group, a pyrimidine group, a pyrazine group, a pyridazine group, and a triazine group; or
A₁₅ is selected from a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group, and A₁₆ is selected from a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, and a thiadiazole group.

8. An organometallic compound according to any one of claims 1 to 7, wherein:
a substructure represented by 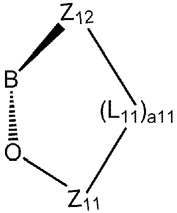 is represented by one of Formulae 9-1 to 9-112: 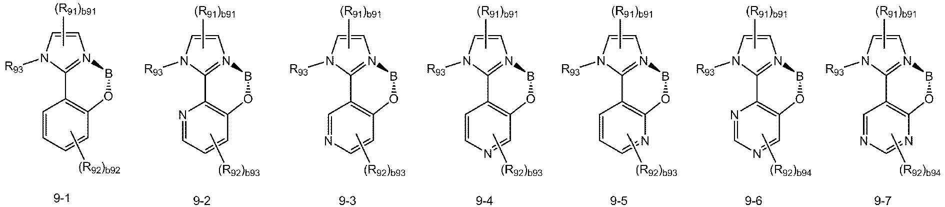 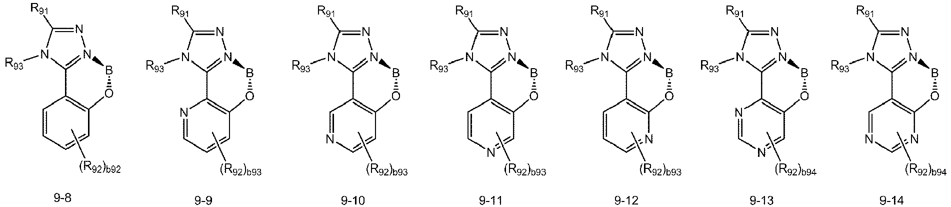 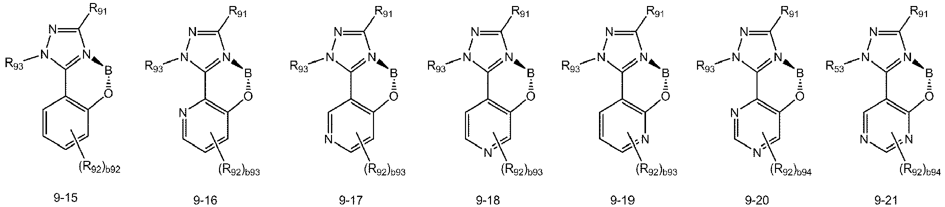 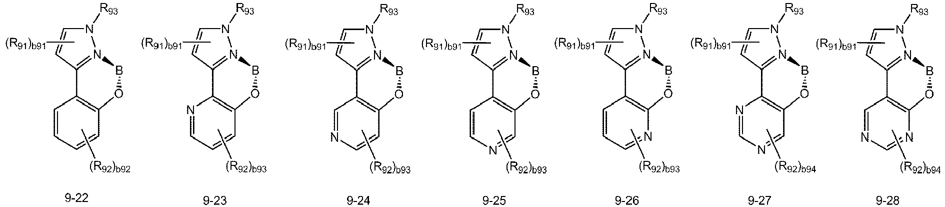 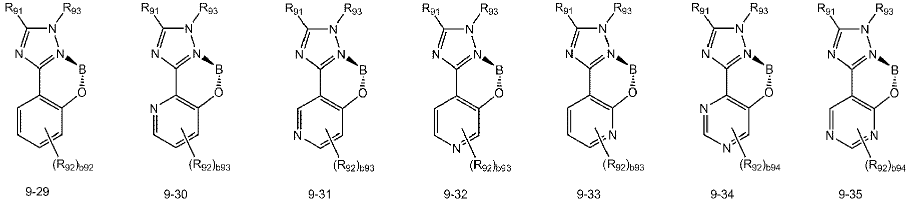 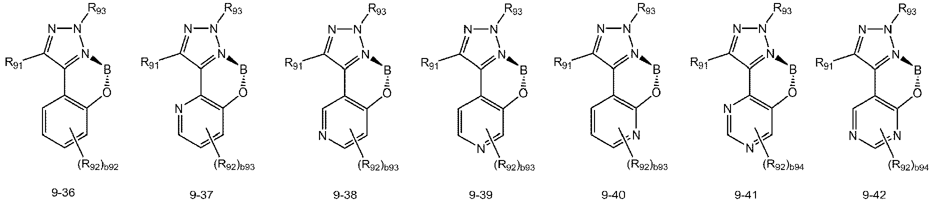 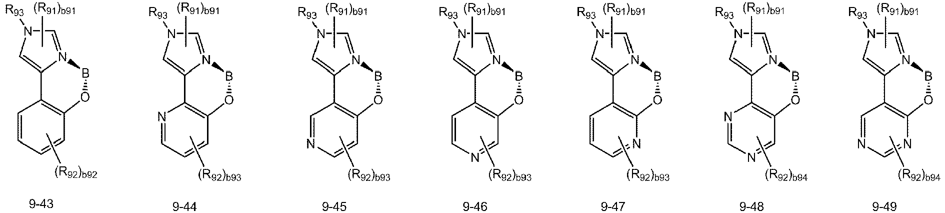 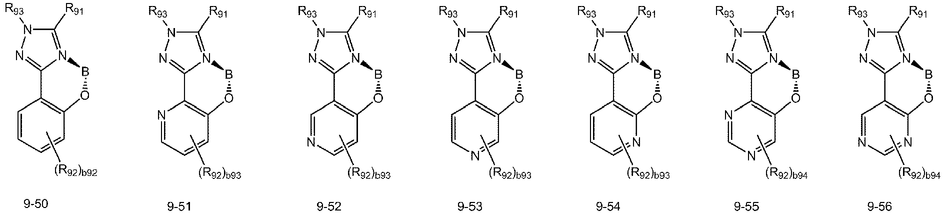 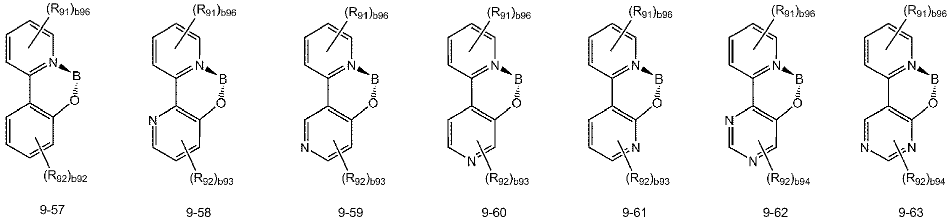 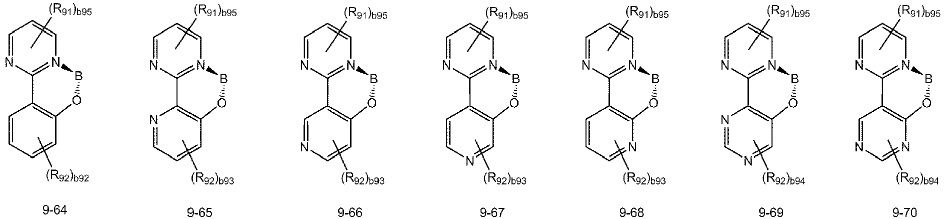 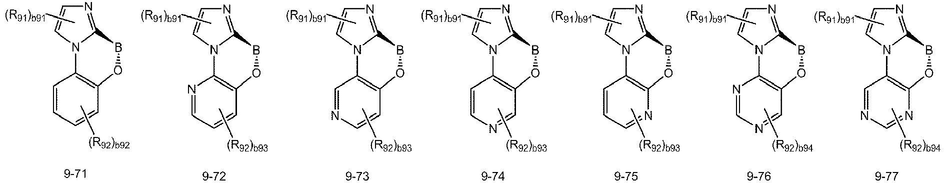 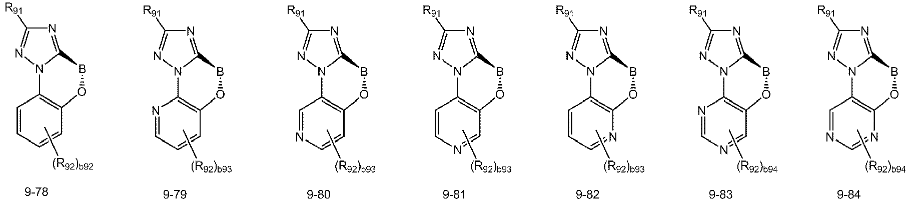 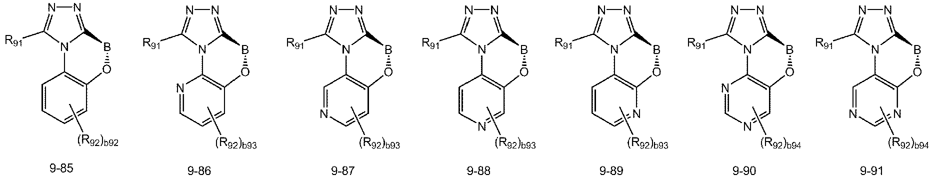 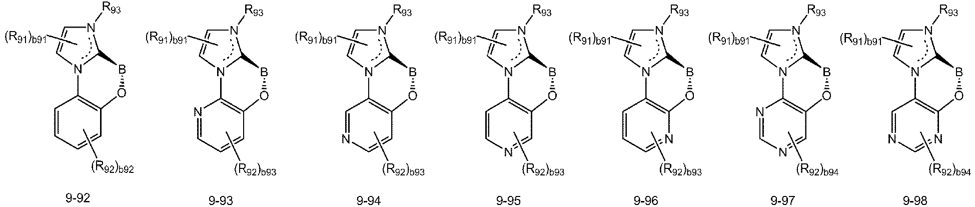 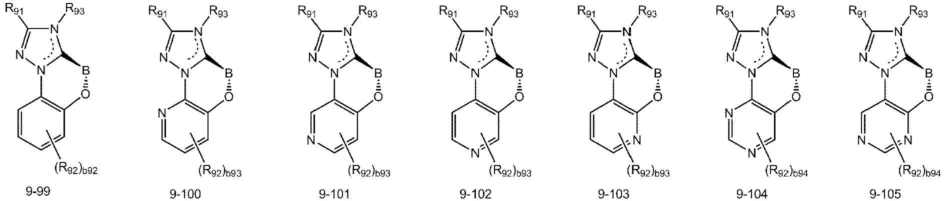 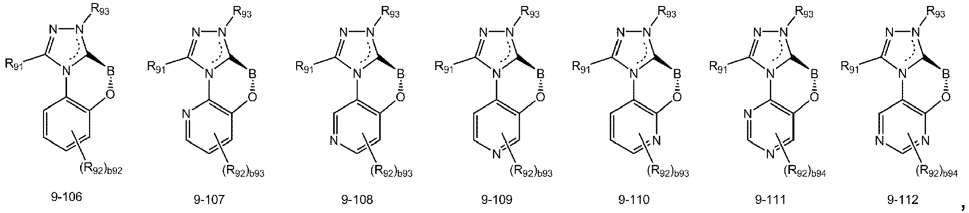 wherein, in Formulae 9-1 to 9-112,
R₉₁ to R₉₃ are each independently selected from:
hydrogen, -F, a cyano group, a nitro group, a methyl group, an ethyl group, a propyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decanyl group, an iso-decanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, and a dibenzothiophenyl group; and
a methyl group, an ethyl group, a propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decanyl group, an iso-decanyl group, a sec-decanyl group, a tert-decanyl group, a methoxy group, an ethoxy group, a propoxy group, a butoxy group, a pentoxy group, a phenyl group, a naphthyl group, a pyridinyl group, a pyrimidinyl group, a triazinyl group, a dibenzofuranyl group, and a dibenzothiophenyl group, each substituted with at least one selected from -F, a cyano group, and a nitro group,
b91 and b94 are each independently 1 or 2,
b93 and b95 are each independently selected from 1, 2, and 3,
b92 and b96 are each independently selected from 1, 2, 3, and 4.

9. An organometallic compound according to any one of claims 1 to 8, wherein:
a ring formed by B, O, Z₁₁, Z₁₂, and (L₁₁)ₐ₁₁ is selected from a 5-membered ring, a 6-membered ring, a 7-membered ring, an 8-membered ring, and a 9-membered ring.

10. An organometallic compound according to any one of claims 1 to 9, wherein:
T₁₁ to T₁₄ are each a single bond;
T₁₁ is O or S, and T₁₂ to T₁₄ are each a single bond;
T₁₂ is O or S, and T₁₁, T₁₃, and T₁₄ are each a single bond;
T₁₃ is O or S, and T₁₁, T₁₂, and T₁₄ are each a single bond; or
T₁₄ is O or S, and T₁₁, T₁₂, and T₁₃ are each a single bond.

11. An organometallic compound according to any one of claims 1 to 10, wherein:
L₁₁ to L₁₄ are each independently selected from a single bond, *-O-*', *-S-*', *-C(R₁₅)(R₁₆)-*', *-C(R₁₅)=*', *=C(R₁₅)-*', *-B(R₁₅)-*', *-N(R₁₅)-*', *-Si(R₁₅)(R₁₆)-*', and *-P(R₁₅)(R₁₆)-*'.

12. An organometallic compound according to any one of claims 1 to 11, wherein:
a11 is 0 or 1.

13. An organometallic compound according to any one of claims 1 to 12, wherein:
a12, a13, and a14 are each independently selected from 1, 2, and 3;
a12 is 0, and a13 and a14 are each independently selected from 1, 2, and 3;
a13 is 0, and a12 and a14 are each independently selected from 1, 2, and 3; or
a14 is 0, and a12 and a13 are each independently selected from 1, 2, and 3.

14. An organometallic compound according to any one of claims 1 to 13, wherein:
R₁₁ to R₁₄, R₁₇, and R₁₈ are each independently selected from:
hydrogen, deuterium, -F, -Cl, -Br, -I, a cyano group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -CI, -Br, -I, a cyano group, a phenyl group, and a biphenyl group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, an isoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, and an indolocarbazolyl group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, an isoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, and an indolocarbazolyl group, each substituted with at least one selected from deuterium, -F, -CI, -Br, -I, a cyano group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, an isoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, an indolocarbazolyl group, - Si(Q₃₁)(Q₃₂)(Q₃₃), -N(Q₃₁)(Q₃₂), -B(Q₃₁)(Q₃₂), -C(=O)(Q₃₁), -S(=O)(Q₃₁), -S(=O)₂(Q₃₁), - P(=O)(Q₃₁)(Q₃₂), and -P(=S)(Q₃₁)(Q₃₂); and
-Si(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), and -P(=S)(Q₁)(Q₂), and
Q₁ to Q₃ and Q₃₁ to Q₃₃ are each independently selected from hydrogen, deuterium, -F, -CI, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, a C₁-C₆₀ alkyl group substituted with at least one selected from deuterium, -F, and a cyano group, a C₆-C₆₀ aryl group substituted with at least one selected from deuterium, -F, and a cyano group, a biphenyl group, and a terphenyl group.

15. An organometallic compound according to any one of claims 1 to 14, wherein:
R₁₁ to R₁₄, R₁₇, and R₁₈ are each independently selected from:
hydrogen, deuterium, -F, -CI, -Br, -I, a cyano group, a methyl group, an ethyl group, an n-propyl group, an iso-propyl group, an n-butyl group, an iso-butyl group, a sec-butyl group, and a tert-butyl group;
a methyl group, an ethyl group, an n-propyl group, an iso-propyl group, an n-butyl group, an iso-butyl group, a sec-butyl group, and a tert-butyl group, each substituted with at least one selected from deuterium, -F, -CI, -Br, -I and a cyano group; and
a phenyl group, a naphthyl group, and a pyridinyl group.

16. An organometallic compound according to any one of claims 1 to 15, wherein:
the organometallic compound represented by Formula 1 is represented by one of Formulae 1-1 to 1-4: 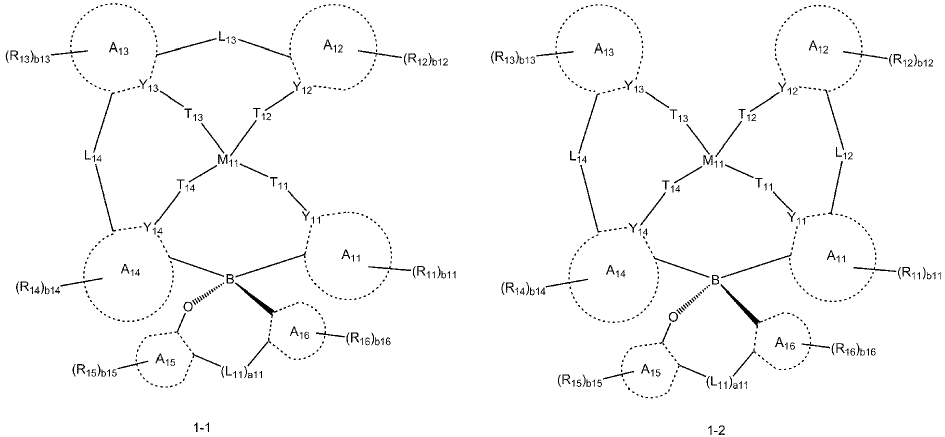 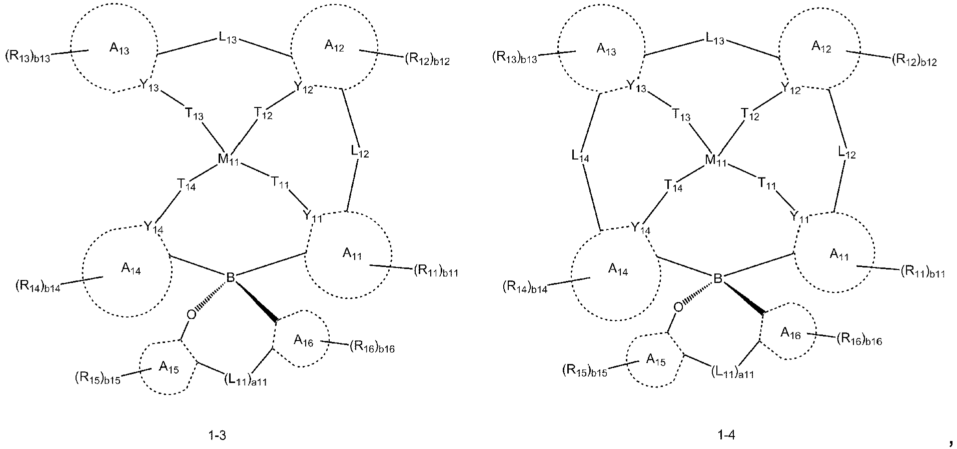 wherein, in Formulae 1-1 to 1-4,
M₁₁, A₁₁ to A₁₄, Y₁₁ to Y₁₄, T₁₁ to T₁₄, L₁₁ to L₁₄, a11 to a14, R₁₁ to R₁₄, and b11 to b14 are each independently the same as described in Formula 1,
A₁₅ and A₁₆ are each independently a C₅-C₆₀ carbocyclic group or a C₁-C₆₀ heterocyclic group,
R₁₅ and R₁₆ are each independently the same as described in connection with R₁₁ in Formula 1, and
b15 and b16 are each independently the same as described in connection with b11 in Formula 1.

17. An organometallic compound according to any one of claims 1 to 16, wherein:
the organometallic compound represented by Formula 1 is selected from Compounds 1 to 250:

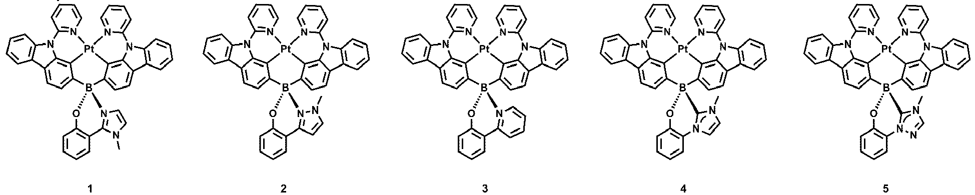

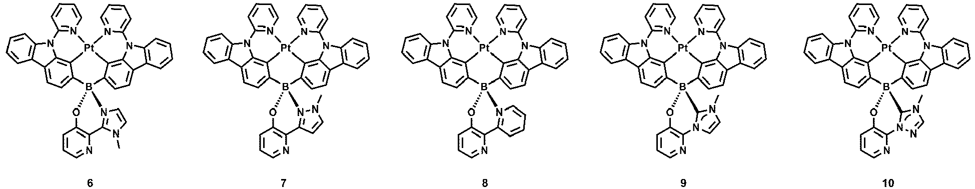

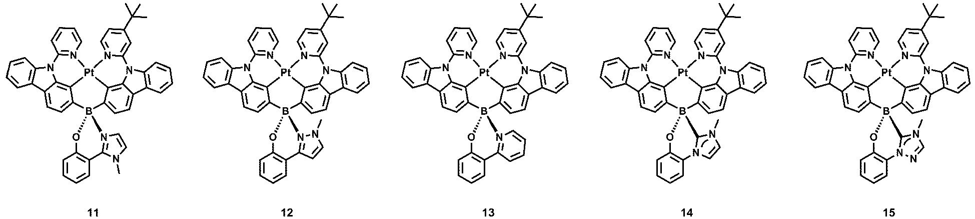

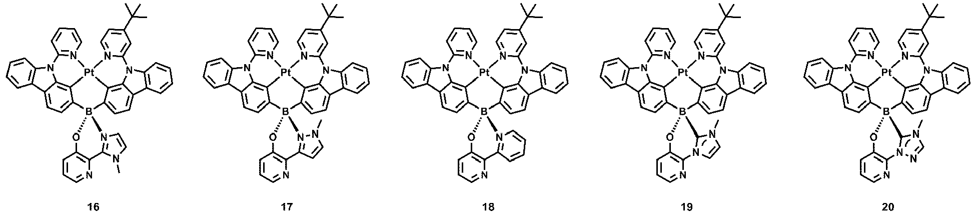

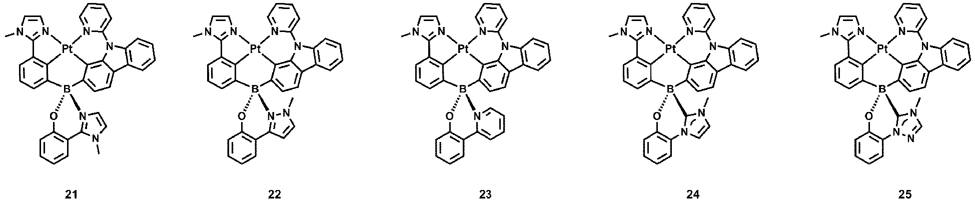

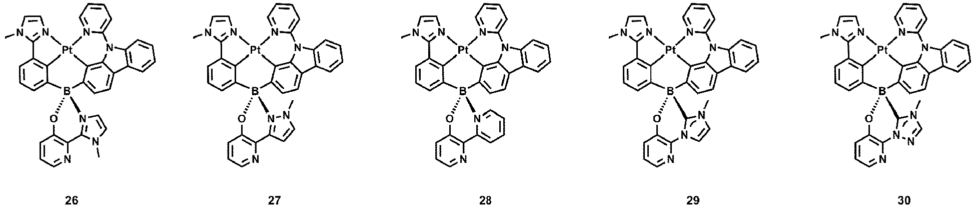

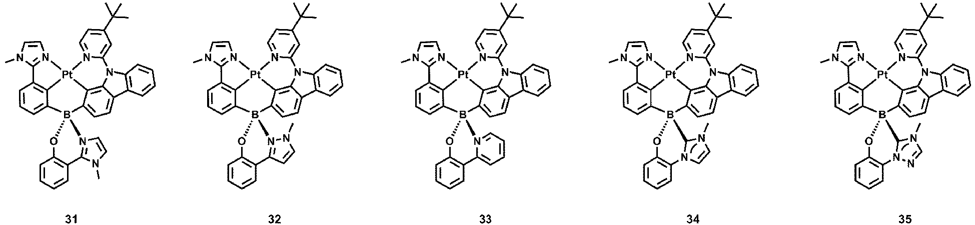

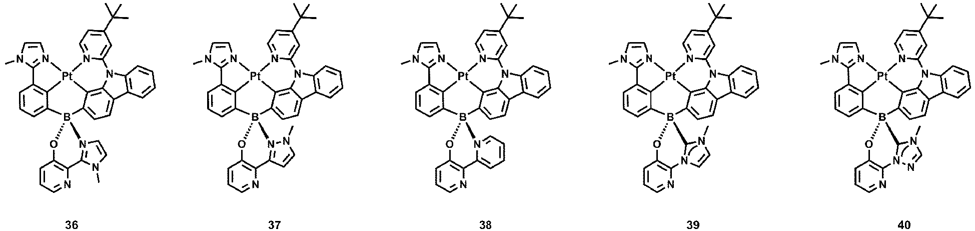

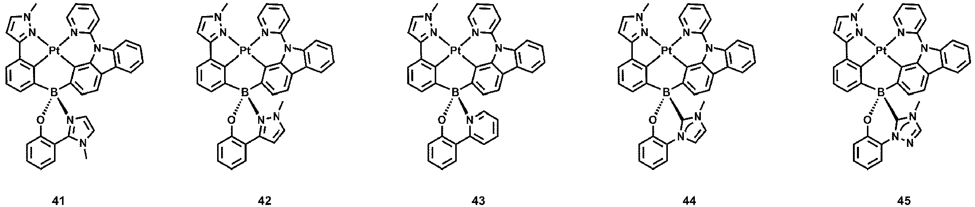

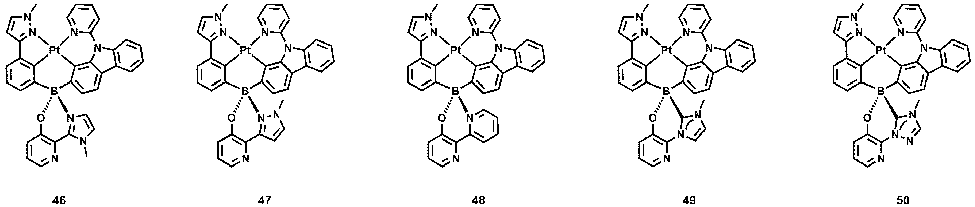

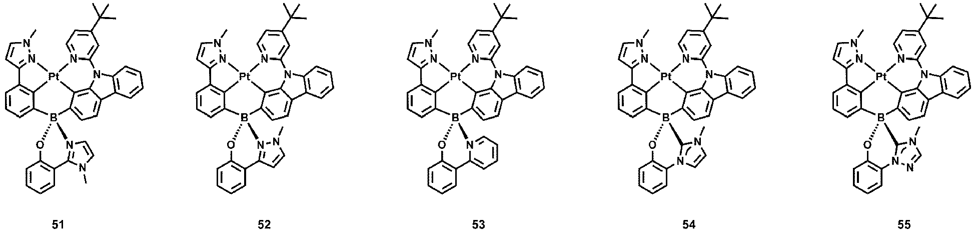

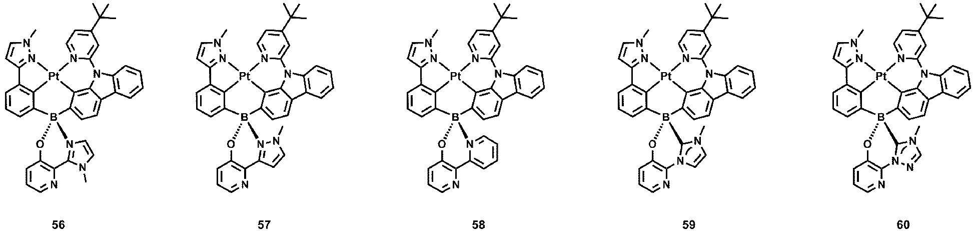

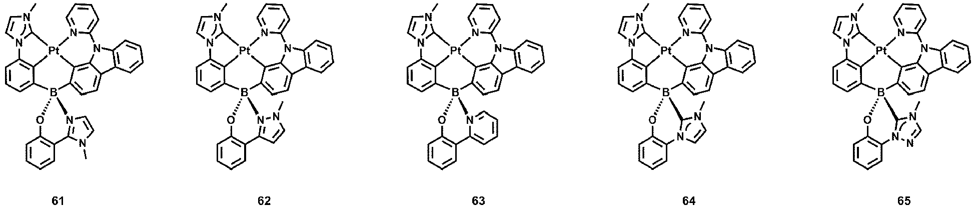

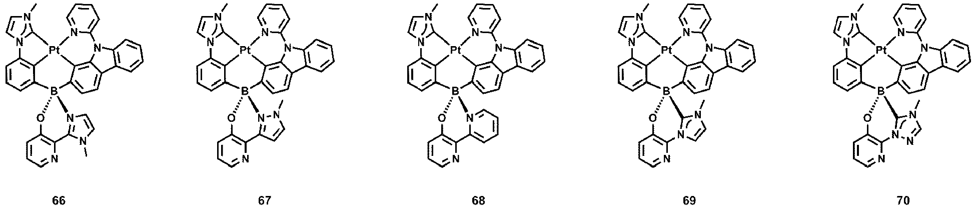

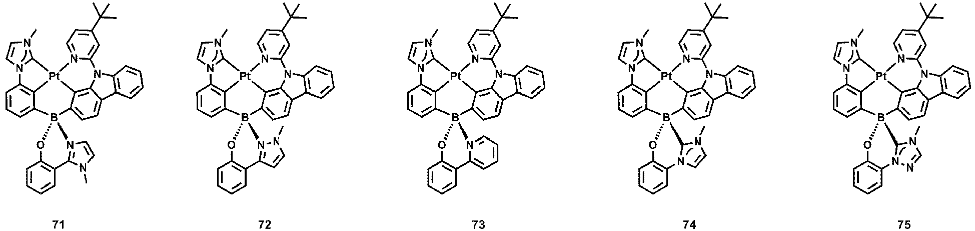

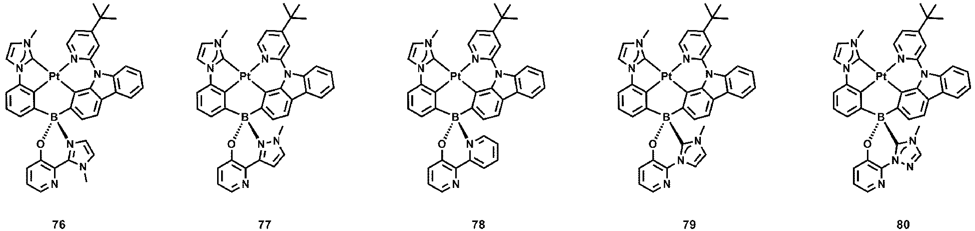

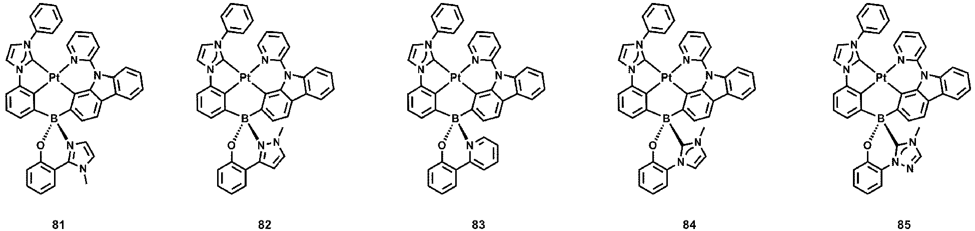

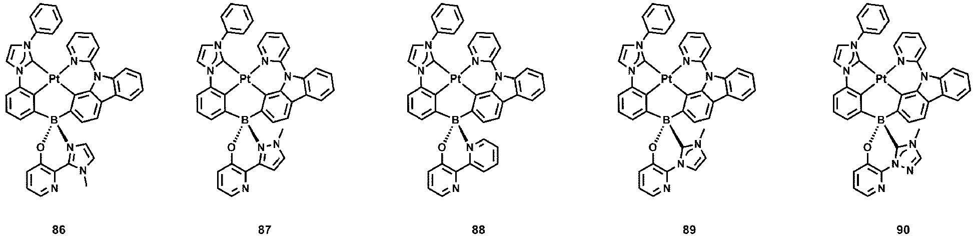

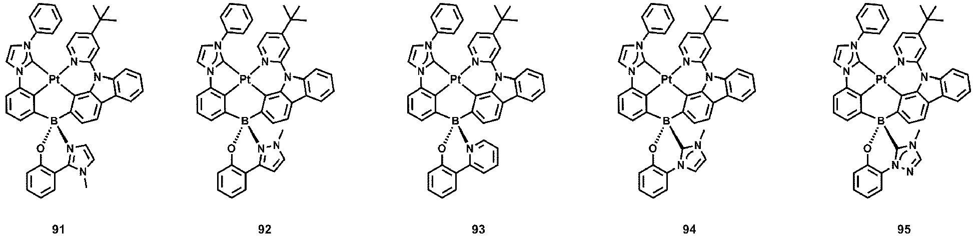

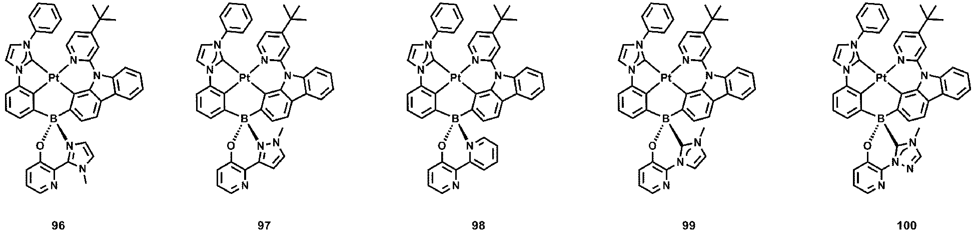

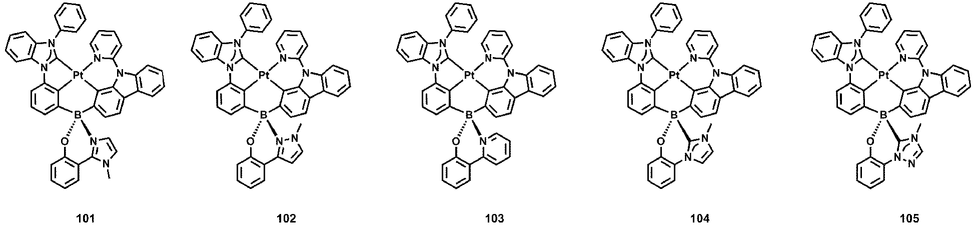

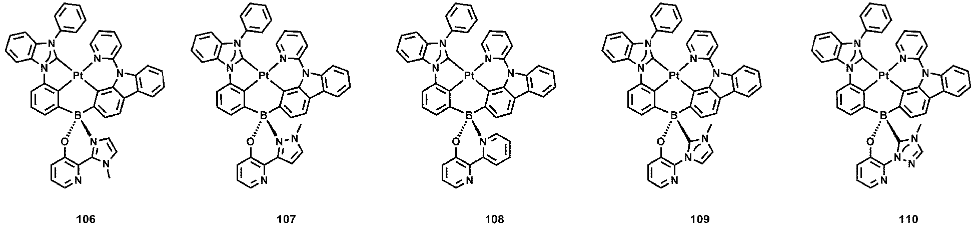

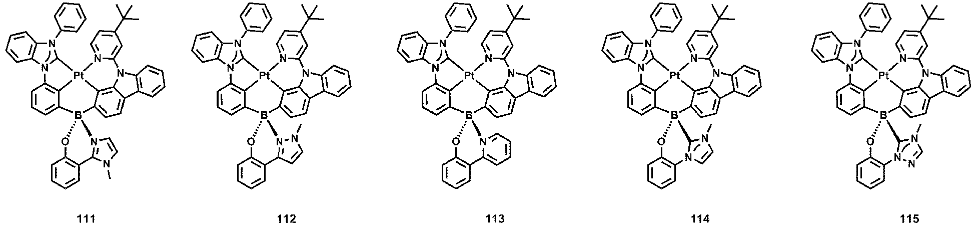

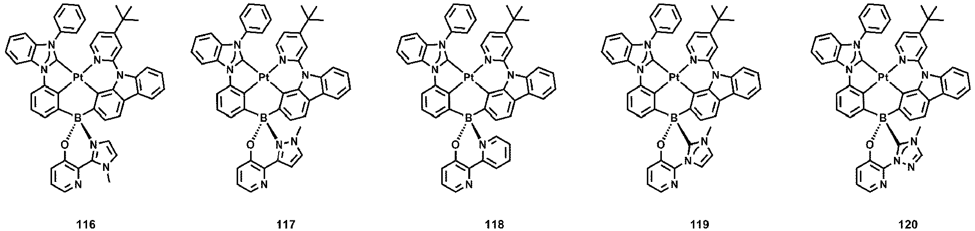

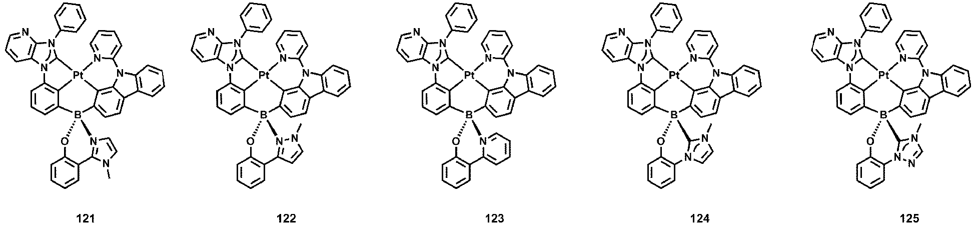

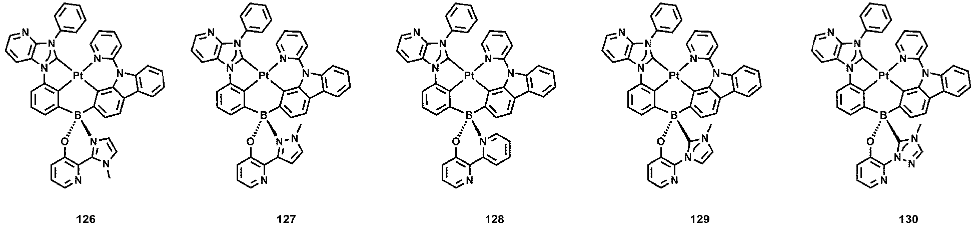

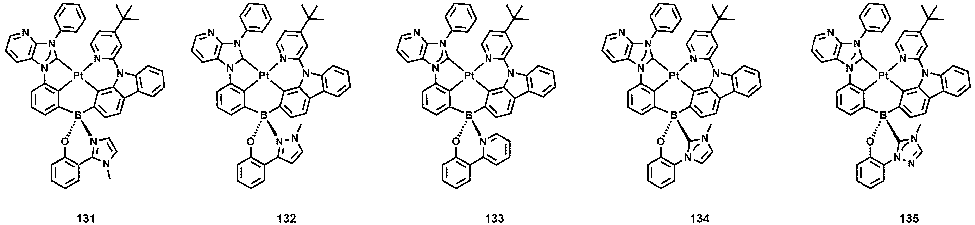

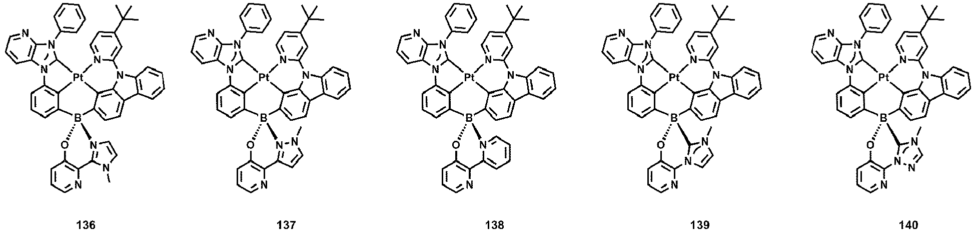

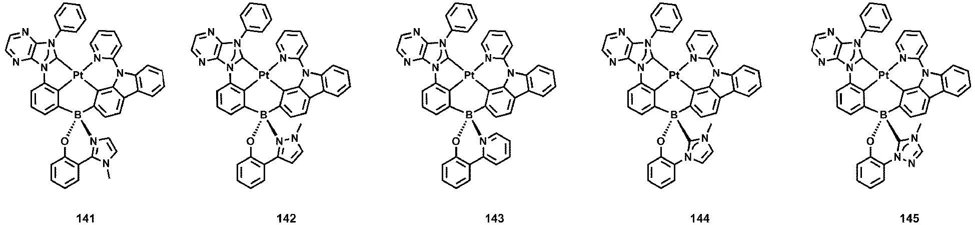

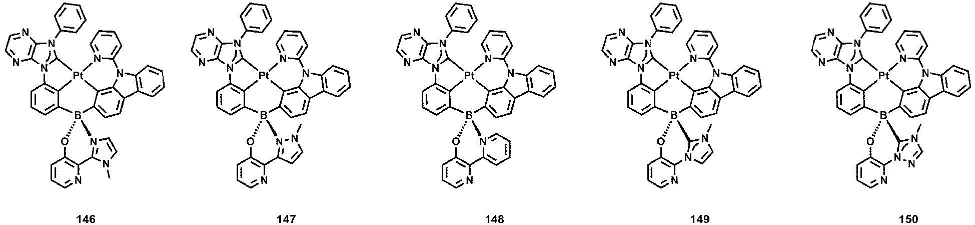

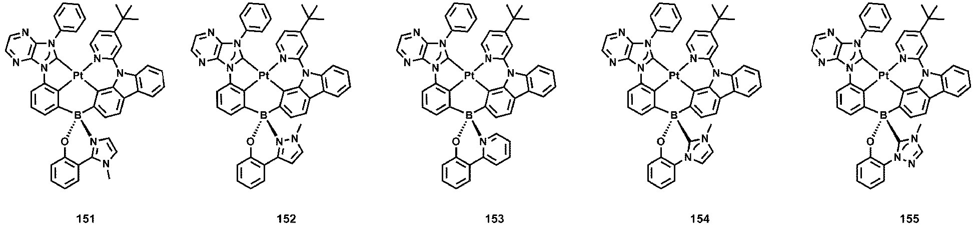

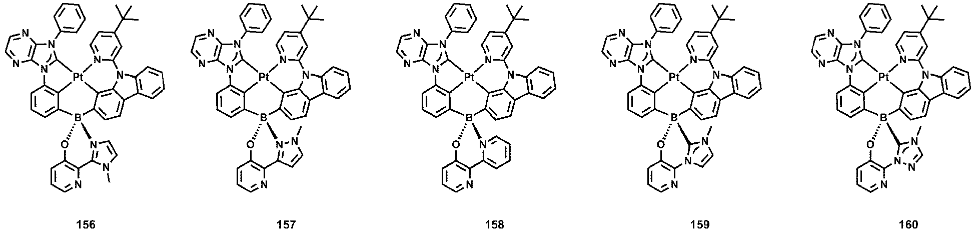

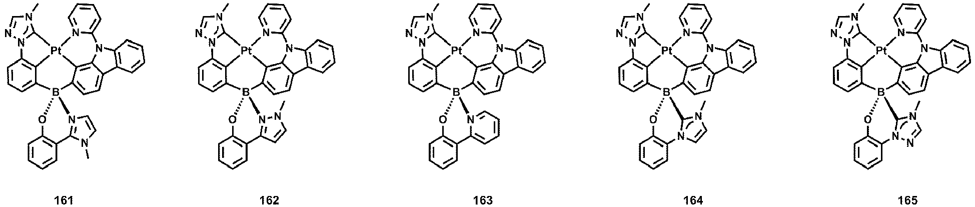

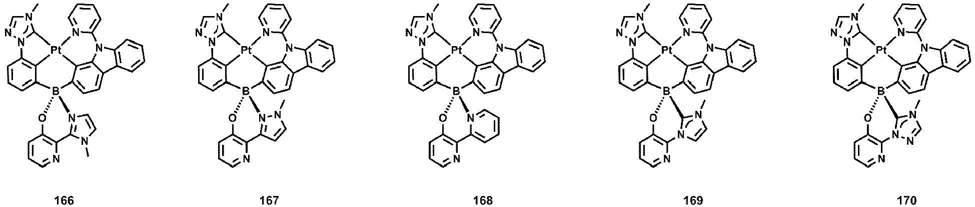

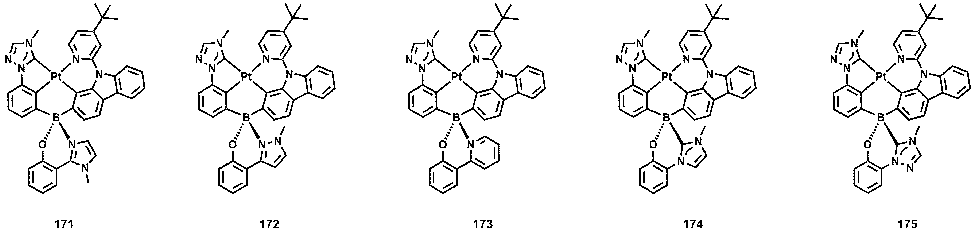

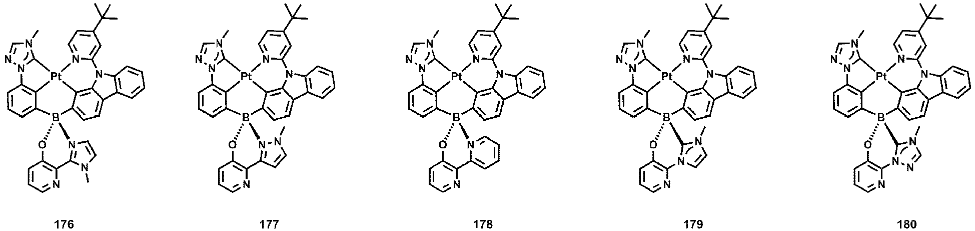

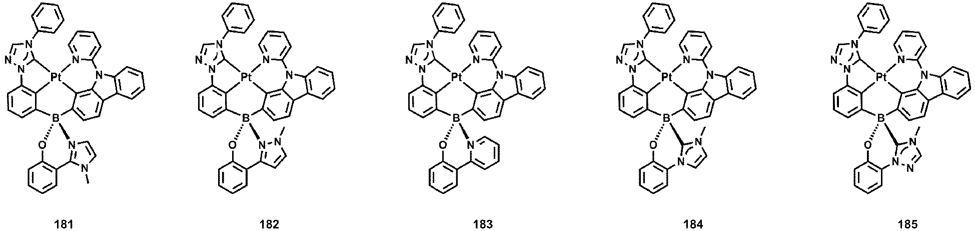

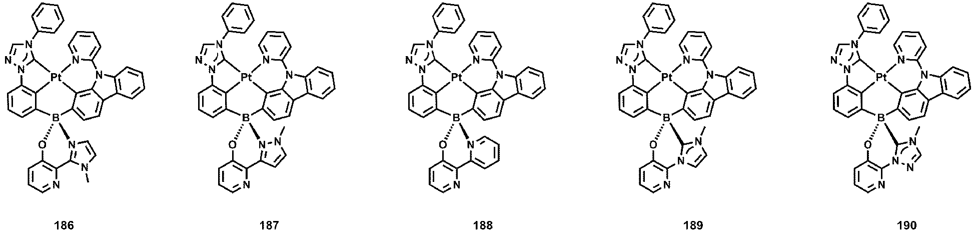

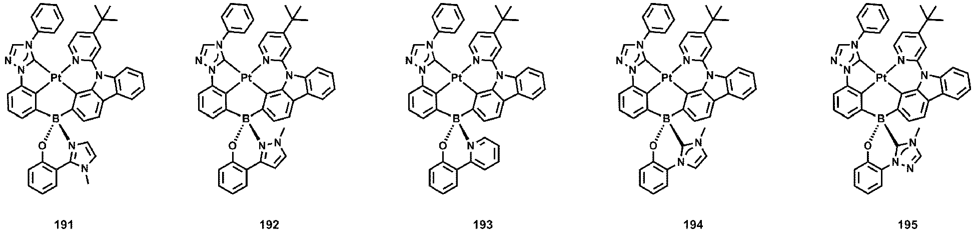

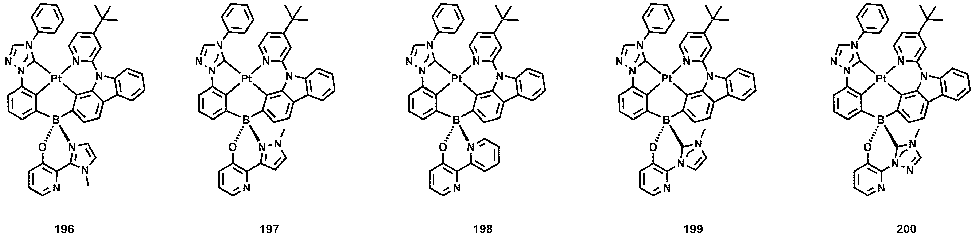

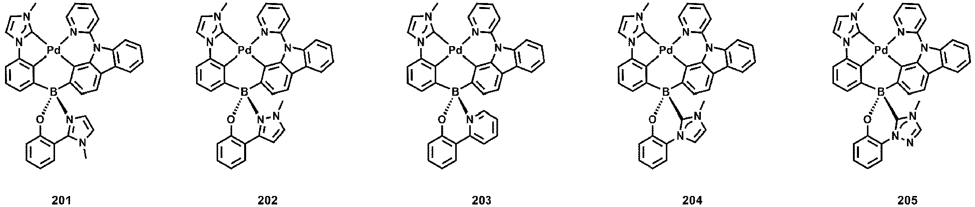

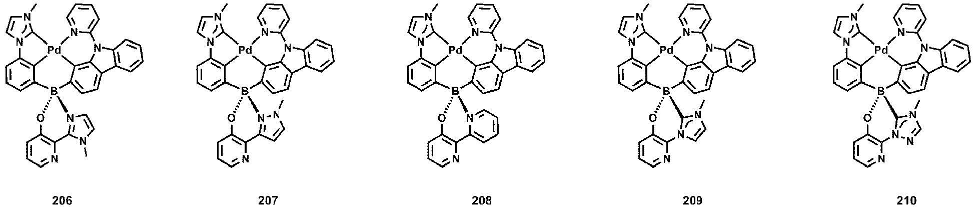

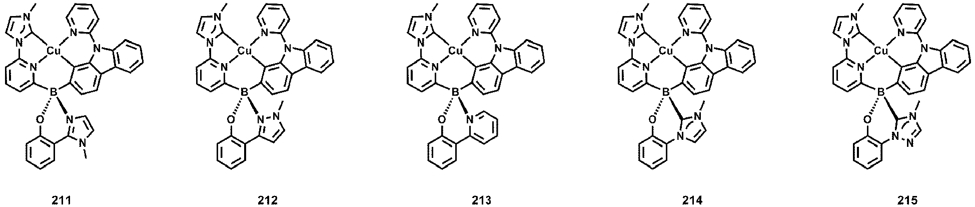

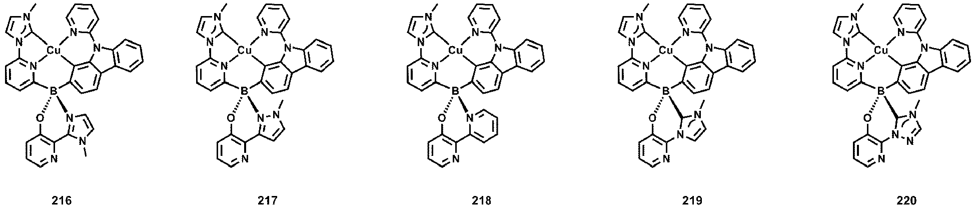

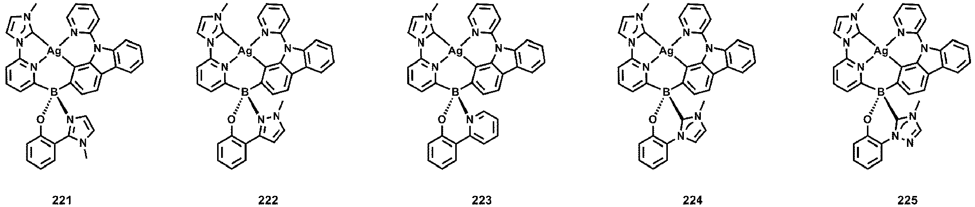

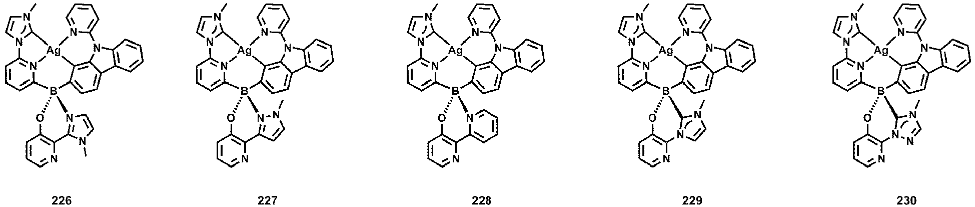

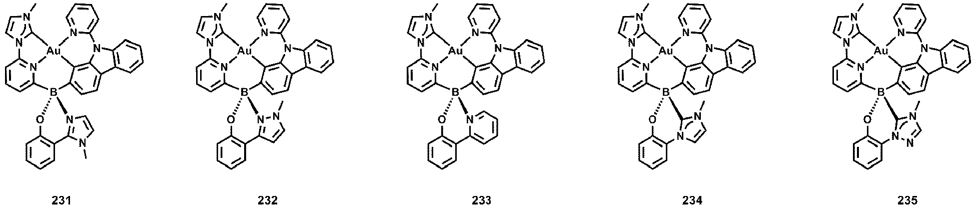

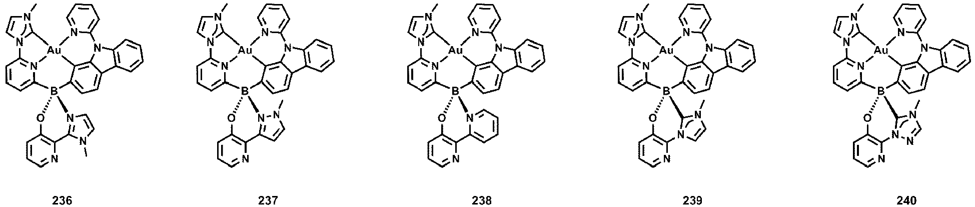

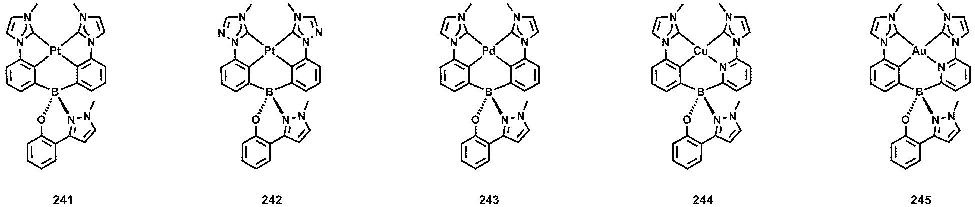

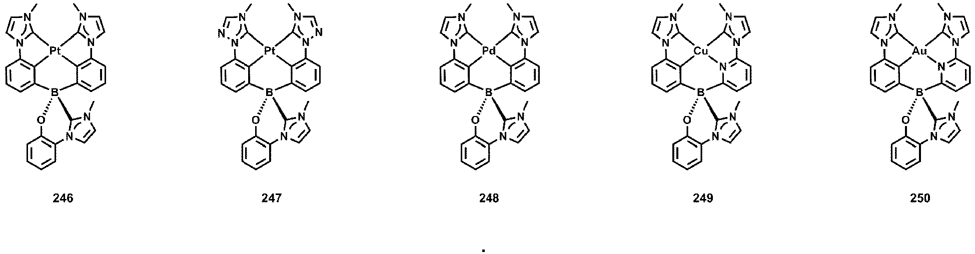

18. An organic light-emitting device comprising:
a first electrode;
a second electrode; and
an organic layer disposed between the first electrode and the second electrode,
wherein the organic layer comprises an emission layer and the organometallic compound according to any one of claims 1 to 17.

19. An organic light-emitting device according to claim 18, wherein:
the emission layer comprises the organometallic compound.

20. An organic light-emitting device according to claim 19, wherein:
the emission layer further comprises at least one of a phosphorescent dopant and a fluorescent dopant.

## Patentansprüche

1. Organometallische Verbindung, dargestellt durch Formel 1: 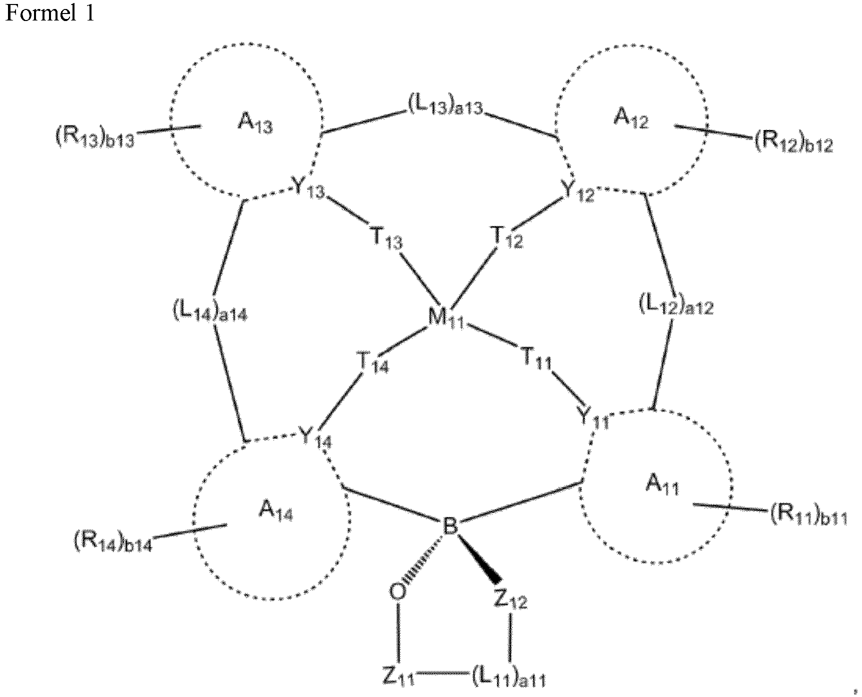 wobei, in Formel 1,
M₁₁ gewählt ist aus Platin (Pt), Palladium (Pd), Kupfer (Cu), Silber (Ag), Gold (Au), Rhodium (Rh), Iridium (Ir), Ruthenium (Ru), Osmium (Os), Titan (Ti), Zirkonium (Zr), Hafnium (Hf), Europium (Eu), Terbium (Tb) und Thulium (Tm),
A₁₁ bis A₁₄ jeweils unabhängig eine C₅-C₆₀ carbozyklische Gruppe oder eine C₁-C₆₀ heterozyklische Gruppe sind,
Y₁₁ bis Y₁₄ jeweils unabhängig N oder C sind,
Z₁₁ und Z₁₂ jeweils unabhängig gewählt sind aus N, C, O, S, einer Einfachbindung, einer substituierten oder unsubstituierten C₅-C₆₀ carbozyklischen Gruppe und einer substituierten oder unsubstituierten C₁-C₆₀ heterozyklischen Gruppe,
T₁₁ bis T₁₄ jeweils unabhängig gewählt sind aus einer Einfachbindung, O und S,
L₁₁ bis L₁₄ jeweils unabhängig gewählt sind aus einer Einfachbindung, *-O-*', *-S-*', *-C(R₁₇)(R₁₈)-*', *-C(R₁₇)=*', *=C(R₁₇)-*', *-C(R₁₇)=C(R₁₈)-*', *-C(=O)-*', *-C(=S)-*', *-C≡C-*', *-B(R₁₇)-*', *-N(R₁₇)-*', *-P(R₁₇)-*', *-Si(R₁₇)(R₁₈)-*', *-P(R₁₇)(R₁₈)-*' und * -Ge(R₁₇)(R₁₈)- * ',
a11 bis a14 jeweils unabhängig gewählt sind aus 0, 1, 2 und 3,
mindestens zwei von a12, a13 und a14 jeweils unabhängig gewählt sind aus 1, 2 und 3,
wenn a11 null ist, ist (L₁₁)ₐ₁₁ ein Einfachbindung ist, wenn a12 null ist, A₁₁ und A₁₂ nicht miteinander verbunden sind, wenn a13 null ist, A₁₂ und A₁₃ miteinander verbunden sind, und wenn a14 null ist, A₁₃ und A₁₄ nicht miteinander verbunden sind,
R₁₁ bis R₁₄, R₁₇ und R₁₈ jeweils unabhängig gewählt sind aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer substituierten oder unsubstituierten C₁-C₆₀ Alkylgruppe, einer substituierten oder unsubstituierten C₂-C₆₀ Alkenylgruppe, einer substituierten oder unsubstituierten C₂-C₆₀ Alkynylgruppe, einer substituierten oder unsubstituierten C₁-C₆₀ Alkoxygruppe, einer substituierten oder unsubstituierten C₃-C₁₀ Cycloalkylgruppe, einer substituierten oder unsubstituierten C₁-C₁₀ Heterocycloalkylgruppe, einer substituierten oder unsubstituierten C₃-C₁₀ Cycloalkenylgruppe, einer substituierten oder unsubstituierten C₁-C₁₀ Heterocycloalkenylgruppe, einer substituierten oder unsubstituierten C₆-C₆₀ Arylgruppe, einer substituierten oder unsubstituierten C₆-C₆₀ Aryloxygruppe, einer substituierten oder unsubstituierten C₆-C₆₀ Arylthiogruppe, einer substituierten oder unsubstituierten C₁-C₆₀ Heteroarylgruppe, einer substituierten oder unsubstituierten C₁-C₆₀ Heteroaryloxygruppe, einer substituierten oder unsubstituierten C₁-C₆₀ Heteroarylthiogruppe, einer substituierten oder unsubstituierten, monovalenten, nicht aromatischen, kondensierten polyzyklischen Gruppe, einer substituierten oder unsubstituierten, monovalenten, nicht aromatischen, kondensierten heteropolyzyklischen Gruppe, -Si(Q₁)(Q₂)(Q₃), -B(Q₁)(Q₂), -N(Q₁)(Q₂), - P(Q₁)(Q₂), -C(=O)(Q₁), -S(=O)(Q₁), -S(=O)₂(Q₁), -P(=O)(Q₁)(Q₂) und -P(=S)(Q₁)(Q₂),
R₁₇ und R₁₁, R₁₇ und R₁₂, R₁₇ und R₁₃, und/oder R₁₇ und R₁₄ optional verbunden sind, um eine substituierte oder unsubstituierte C₅-C₆₀ carbozyklische Gruppe oder eine substituierte oder unsubstituierte C₁-C₆₀ heterozyklische Gruppe zu bilden,
R₁₇ und R₁₈ optional verbunden sind, um eine substituierte oder unsubstituierte C₅-C₆₀ carbozyklische Gruppe, oder eine substituierte oder unsubstituierte C₁-C₆₀ heterozyklische Gruppe zu bilden,
b11 bis b14 jeweils unabhängig gewählt sind aus 1, 2, 3, 4, 5, 6, 7 und 8,
Q₁ bis Q₃ jeweils unabhängig gewählt sind aus Wasserstoff, Deuterium, -F, -Cl, - Br, -I, einer Hydroxylgruppe, einer Cyanogruppe, einer Nitrogruppe, einer Amidinogruppe, einer Hydrazingruppe, einer Hydrazongruppe, einer C₁-C₆₀ Alkylgruppe, einer C₂-C₆₀ Alkenylgruppe, einer C₂-C₆₀ Alkynylgruppe, einer C₁-C₆₀ Alkoxygruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer C₁-C₆₀ Heteroaryloxygruppe, einer C₁-C₆₀ Heteroarylthiogruppe, einer monovalenten, nicht aromatischen, kondensierten polyzyklischen Gruppe, einer monovalenten, nicht aromatischen, kondensierten heteropolyzyklischen Gruppe, einer C₁-C₆₀ Alkylgruppe, welche mit mindestens einem substituiert ist, gewählt aus Deuterium, -F und einer Cyanogruppe, einer C₆-C₆₀ Arylgruppe, welche mit mindestens einem substituiert ist, gewählt aus Deuterium, -F und einer Cyanogruppe, einer Biphenylgruppe und einer Terphenylgruppe,
wobei mindestens ein Substituent der substituierten C₅-C₆₀ carbozyklischen Gruppe, der substituierten C₁-C₆₀ heterozyklischen Gruppe, der substituierten C₁-C₆₀ Alkylgruppe, der substituierten C₂-C₆₀ Alkenylgruppe, der substituierten C₂-C₆₀ Alkynylgruppe, der substituierten C₁-C₆₀ Alkoxygruppe, der substituierten C₃-C₁₀ Cycloalkylgruppe, der substituierten C₁-C₁₀ Heterocycloalkylgruppe, der substituierten C₃-C₁₀ Cycloalkenylgruppe, der substituierten C₁-C₁₀ Heterocycloalkenylgruppe, der substituierten C₆-C₆₀ Arylgruppe, der substituierten C₆-C₆₀ Aryloxygruppe, der substituierten C₆-C₆₀ Arylthiogruppe, der substituierten C₁-C₆₀ Heteroarylgruppe, der substituierten C₁-C₆₀ Heteroaryloxygruppe, der substituierten C₁-C₆₀ Heteroarylthiogruppe, der substituierten monovalenten, nicht aromatischen, kondensierten polyzyklischen Gruppe, und der substituierten monovalenten, nicht aromatischen, kondensierten heteropolyzyklischen Gruppe gewählt ist aus:
Deuterium (-D), -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀ Alkylgruppe, einer C₂-C₆₀ Alkenylgruppe, einer C₂-C₆₀ Alkynylgruppe und einer C₁-C₆₀ Alkoxygruppe;
einer C₁-C₆₀ Alkylgruppe, einer C₂-C₆₀ Alkenylgruppe, einer C₂-C₆₀ Alkynylgruppe und einer C₁-C₆₀ Alkoxygruppe, jeweils substituiert mit mindestens einem, gewählt aus Deuterium, -F, Cl, -Br, -I, einer Hydroxylgruppe, einer Cyanogruppe, einer Nitrogruppe, einer Amidinogruppe, einer Hydrazingruppe, einer Hydrazongruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer C₁-C₆₀ Heteroaryloxygruppe, einer C₁-C₆₀ Heteroarylthiogruppe, einer monovalenten, nicht aromatischen, kondensiertem polyzyklischen Gruppe, einer monovalenten, nicht aromatischen, kondensierten, heteropolyzyklischen Gruppe, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁) und - P(=O)(Q₁₁)(Q₁₂);
einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer C₁-C₆₀ Heteroaryloxygruppe, einer C₁-C₆₀ Heteroarylthiogruppe, einer monovalenten, nicht aromatischen, kondensierten polyzyklischen Gruppe und einer monovalenten, nicht aromatischen, kondensierten heteropolyzyklischen Gruppe;
einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer C₁-C₆₀ Heteroaryloxygruppe, einer C₁-C₆₀ Heteroarylthiogruppe, einer monovalenten, nicht aromatischen, kondensiertem polyzyklischen Gruppe und einer monovalenten, nicht aromatischen, kondensiertem heteropolyzyklischen Gruppe, jeweils substituiert mit mindestens einem, gewählt aus Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀ Alkylgruppe, einer C₂-C₆₀ Alkenylgruppe, einer C₂-C₆₀ Alkynylgruppe, einer C₁-C₆₀ Alkoxygruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer C₁-C₆₀ Heteroaryloxygruppe, einer C₁-C₆₀ Heteroarylthiogruppe, einer monovalenten, nicht aromatischen, kondensiertem polyzyklischen Gruppe, einer monovalenten, nicht aromatischen, kondensierten heteropolyzyklischen Gruppe, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁) und - P(=O)(Q₂₁)(Q₂₂); und
Si(Q₃₁)(Q₃₂)(Q₃₃), -N(Q₃₁)(Q₃₂), -B(Q₃₁)(Q₃₂), -C(=O)(Q₃₁), -S(=O)2(Q₃₁) und - P(=O)(Q₃₁)(Q₃₂), und
Q₁₁ bis Q₁₃, Q₂₁ bis Q₂₃, und Q₃₁ bis Q₃₃ jeweils unabhängig gewählt sind aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀ Alkylgruppe, einer C₂-C₆₀ Alkenylgruppe, einer C₂-C₆₀ Alkynylgruppe, einer C₁-C₆₀ Alkoxygruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₁-C₆₀ Heteroarylgruppe, einer C₁-C₆₀ Heteroaryloxygruppe, einer C₁-C₆₀ Heteroarylthiogruppe, einer monovalenten, nicht aromatischen, kondensierten polyzyklischen Gruppe, einer monovalenten, nicht aromatischen, kondensierten heteropolyzyklischen Gruppe, einer C₁-C₆₀ Alkylgruppe, welche mit mindestens einem substituiert ist, gewählt aus Deuterium, -F und einer Cyanogruppe, einer C₆-C₆₀ Arylgruppe, welche mit mindestens einem substituiert ist, gewählt aus Deuterium, -F und einer Cyanogruppe, einer Biphenylgruppe und einer Terphenylgruppe; und
wobei * und *', jeweils eine Bindungsstelle an einem benachbarten Atom angeben.

2. Organometallische Verbindung nach Anspruch 1, bei welcher:
A₁₁ bis A₁₄ jeweils unabhängig gewählt sind aus einer Benzolgruppe, einer Naphthalingruppe, einer Anthracengruppe, einer Phenanthrengruppe, einer Triphenylengruppe, einer Pyrengruppe, einer Chrysengruppe, einer Cyclopentadiengruppe, einer 1,2,3,4-Tetrahydronaphthalingruppe, einer Furangruppe, einer Thiophengruppe, einer Silolgruppe, einer Indengruppe, einer Fluorengruppe, einer Indolgruppe, einer Carbazolgruppe, einer Benzofurangruppe, einer Dibenzofurangruppe, einer Benzothiophengruppe, einer Dibenzothiophengruppe, einer Benzosilolgruppe, einer Dibenzosilolgruppe, einer Indenopyridingruppe, einer Indolopyridingruppe, einer Benzofuropyridingruppe, einer Benzothienopyridingruppe, einer Benzosilolopyridingruppe, einer Indenopyrimidingruppe, einer Indolopyrimidingruppe, einer Benzofuropyrimidingruppe, einer Benzothienopyrimidingruppe, einer Benzosilolopyrimidingruppe, einer Dihydropyridingruppe, einer Pyridingruppe, einer Pyrimidingruppe, einer Pyrazingruppe, einer Pyridazingruppe, einer Triazingruppe, einer Quinolingruppe, einer Isoquinolingruppe, einer Quinoxalingruppe, einer Quinazolingruppe, einer Phenanthrolingruppe, einer Pyrrolgruppe, einer Pyrazolgruppe, einer Imidazolgruppe, einer 2,3-Dihydroimidazolgruppe, einer Triazolgruppe, einer 2,3-Dihydrotriazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer 2,3-Dihydrobenzimidazolgruppe, einer Imidazopyridingruppe, einer 2,3-Dihydroimidazopyridingruppe, einer Imidazopyrimidingruppe, einer 2,3-Dihydroimidazopyrimidingruppe, einer Imidazopyrazingruppe, einer 2,3-Dihydroimidazopyrazingruppe, einer Benzoxazolgruppe, einer Benzothiazolgruppe, einer Benzoxadiazolgruppe, einer Benzothiadiazolgruppe, einer 5,6,7,8-Tetrahydroisoquinolingruppe und einem 5,6,7,8-Tetrahydroquinolin.

3. Organometallische Verbindung nach Anspruch 1 oder 2, wobei:
A₁₁ bis A₁₄ jeweils unabhängig durch eine der Formeln 2-1 bis 2-43 dargestellt werden: 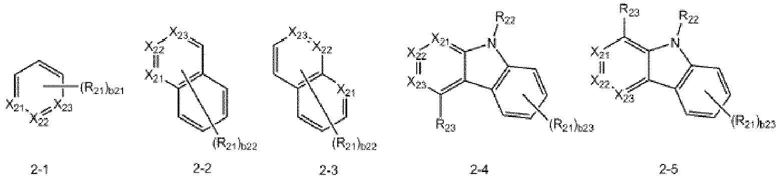 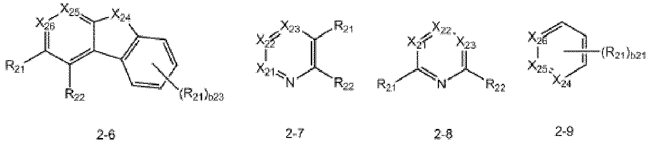 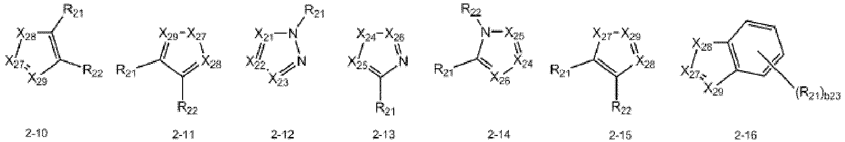 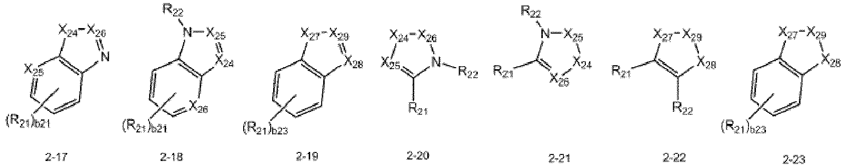 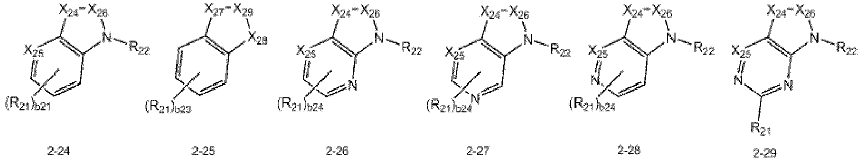 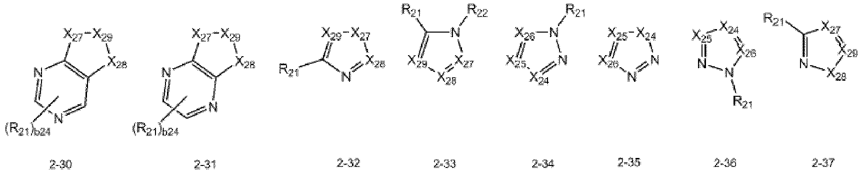 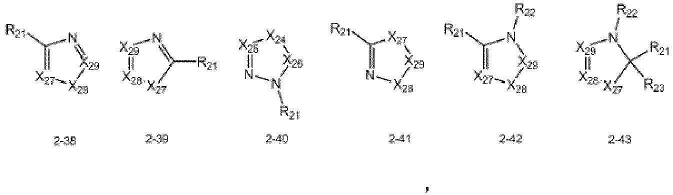 wobei in den Formeln 2-1 und 2-43,
X₂₁ bis X₂₃ jeweils unabhängig C(R₂₄) oder C-* sind, vorausgesetzt, dass mindestens zwei von X₂₁ bis X₂₃ jeweils C-* sind,
X₂₄ N-* ist, und X₂₅ und X₂₆ jeweils unabhängig C(R₂₄) oder C-* sind, vorausgesetzt, dass mindestens eines von X₂₅ bis X₂₆ C-* ist,
X₂₇ und X₂₈ jeweils unabhängig gewählt sind aus N, N(R₂₅) und N-*, und X₂₉ C(R₂₄) oder C-* ist, vorausgesetzt, dass i) mindestens eines von X₂₇ und X₂₈ N-* ist, und X₂₉ C-* is , oder ii) X₂₇ und X₂₈ jeweils N-* sind, und X₂₉ C(R₂₄) ist,
R₂₁ bis R₂₄ jeweils unabhängig dieselben sind wie in Verbindung mit R₁₁ in Formel 1 beschrieben,
b21 gewählt ist aus 1, 2 und 3,
b22 gewählt ist aus 1, 2, 3, 4 und 5,
b23 gewählt ist aus 1, 2, 3 und 4,
b24 1 oder 2 ist, und
wobei * eine Bindungsstelle an einem benachbarten Atom angibt.

4. Organometallische Verbindung nach einem der Ansprüche 1 bis 3, wobei:
Y₁₁, Y₁₂ und Y₁₃ jeweils C sind, und Y₁₄ N ist;
Y₁₁, Y₁₂ und Y₁₄ jeweils C sind, und Y₁₃ N ist;
Y₁₁, Y₁₃ und Y₁₄ jeweils C sind, und Y₁₂ N ist;
Y₁₂, Y₁₃ und Y₁₄ jeweils C sind, und Y₁₁ N ist;
Y₁₁ und Y₁₄ jeweils C sind, und Y₁₂ und Y₁₃ jeweils N sind;
Y₁₁ und Y₁₄ jeweils N sind, und Y₁₂ und Y₁₃ jeweils C sind;
Y₁₁ und Y₁₂ jeweils C sind, und Y₁₃ und Y₁₄ jeweils N sind;
Y₁₁ und Y₁₂ jeweils N sind, und Y₁₃ und Y₁₄ jeweils C sind;
Y₁₁ und Y₁₃ jeweils C sind, und Y₁₂ und Y₁₄ jeweils N sind; oder
Y₁₁ und Y₁₃ jeweils N sind, und Y₁₂ und Y₁₄ jeweils C sind.

5. Organometallische Verbindung nach einem der Ansprüche 1 bis 4, wobei:
Z₁₁ und Z₁₂ jeweils unabhängig gewählt sind aus:
N, C, O, S, einer Einfachbindung, einer Benzolgruppe, einer Naphthalingruppe, einer Anthracengruppe, einer Phenanthrengruppe, einer Triphenylengruppe, einer Pyrengruppe, einer Chrysengruppe, einer Cyclopentadiengruppe, einer 1,2,3,4-Tetrahydronaphthalingruppe, einer Furangruppe, einer Thiophengruppe, einer Silolgruppe, einer Indengruppe, einer Fluorengruppe, einer Indolgruppe, einer Carbazolgruppe, einer Benzofurangruppe, einer Dibenzofurangruppe, einer Benzothiophengruppe, einer Dibenzothiophengruppe, einer Benzosilolgruppe, einer Dibenzosilolgruppe, einer Indenopyridingruppe, einer Indolopyridingruppe, einer Benzofuropyridingruppe, einer Benzothienopyridingruppe, einer Benzosilolopyridingruppe, einer Indenopyrimidingruppe, einer Indolopyrimidingruppe, einer Benzofuropyrimidingruppe, einer Benzothienopyrimidingruppe, einer Benzosilolopyrimidingruppe, einer Dihydropyridingruppe, einer Pyridingruppe, einer Pyrimidingruppe, einer Pyrazingruppe, einer Pyridazingruppe, einer Triazingruppe, einer Quinolingruppe, einer Isoquinolingruppe, einer Quinoxalingruppe, einer Quinazolingruppe, einer Phenanthrolingruppe, einer Pyrrolgruppe, einer Pyrazolgruppe, einer Imidazolgruppe, einer 2,3-Dihydroimidazolgruppe, einer Triazolgruppe, einer 2,3-Dihydrotriazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer 2,3-Dihydrobenzimidazolgruppe, einer Imidazopyridingruppe, einer 2,3-Dihydroimidazopyridingruppe, einer Imidazopyrimidingruppe, einer 2,3-Dihydroimidazopyrimidingruppe, einer Imidazopyrazingruppe, einer 2,3-Dihydroimidazopyrazingruppe, einer Benzoxazolgruppe, einer Benzothiazolgruppe, einer Benzoxadiazolgruppe, einer Benzothiadiazolgruppe, einer 5,6,7,8-Tetrahydroisoquinolingruppe und einem 5,6,7,8-Tetrahydroquinolin;
einer Benzolgruppe, einer Naphthalingruppe, einer Anthracengruppe, einer Phenanthrengruppe, einer Triphenylengruppe, einer Pyrengruppe, einer Chrysengruppe, einer Cyclopentadiengruppe, einer 1,2,3,4-Tetrahydronaphthalingruppe, einer Furangruppe, einer Thiophengruppe, einer Silolgruppe, einer Indengruppe, einer Fluorengruppe, einer Indolgruppe, einer Carbazolgruppe, einer Benzofurangruppe, einer Dibenzofurangruppe, einer Benzothiophengruppe, einer Dibenzothiophengruppe, einer Benzosilolgruppe, einer Dibenzosilolgruppe, einer Inedenopyridingruppe, einer Indolopyridingruppe, einer Benzofuropyridingruppe, einer Benzothienopyridingruppe, einer Benzosilolopyridingruppe, einer Indenopyrimidingruppe, einer Indolopyrimidingruppe, einer Benzofuropyrimidingruppe, einer Benzothienopyrimidingruppe, einer Benzosilolopyrimidingruppe, einer Dihydropyridingruppe, einer Pyridingruppe, einer Pyrimidingruppe, einer Pyrazingruppe, einer Pyridazingruppe, einer Triazingruppe, einer Quinolingruppe, einer Isoquinolingruppe, einer Quinoxalingruppe, einer Quinazolingruppe, einer Phenanthrolingruppe, einer Pyrrolgruppe, einer Pyrazolgruppe, einer Imidazolgruppe, einer 2,3-Dihydroimidazolgruppe, einer Triazolgruppe, einer 2,3-Dihydrotriazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer 2,3-Dihydrobenzimidazolgruppe, einer Imidazopyridingruppe, einer 2,3-Dihydroimidazopyridingruppe, einer Imidazopyrimidingruppe, einer 2,3-Dihydroimidazopyrimidingruppe, einer Imidazopyrazingruppe, einer 2,3-Dihydroimidazopyrazingruppe, einer Benzoxazolgruppe, einer Benzothiazolgruppe, einer Benzoxadiazolgruppe, einer Benzothiadiazolgruppe, einer 5,6,7,8-Tetrahydroisoquinolingruppe und einem 5,6,7,8-Tetrahydroquinolin, jeweils substituiert mit mindestens einem, gewählt aus Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, -CD₃, -CD₂H, -CDH₂, -CF₃, -CF₂H, -CFH₂, einer C₁-C₆₀ Alkylgruppe, einer C₂-C₆₀ Alkenylgruppe, einer C₂-C₆₀ Alkynylgruppe und einer C₁-C₆₀ Alkoxygruppe; und
einer Benzolgruppe, einer Naphthalingruppe, einer Anthracengruppe, einer Phenanthrengruppe, einer Triphenylengruppe, einer Pyrengruppe, einer Chrysengruppe, einer Cyclopentadiengruppe, einer 1,2,3,4-Tetrahydronaphthalingruppe, einer Furangruppe, einer Thiophengruppe, einer Silolgruppe, einer Indengruppe, einer Fluorengruppe, einer Indolgruppe, einer Carbazolgruppe, einer Benzofurangruppe, einer Dibenzofurangruppe, einer Benzothiophengruppe, einer Dibenzothiophengruppe, einer Benzosilolgruppe, einer Dibenzosilolgruppe, einer Indenopyridingruppe, einer Indolopyridingruppe, einer Benzofuropyridingruppe, einer Benzothienopyridingruppe, einer Benzosilolopyrimidingruppe, einer Dihydropyridingruppe, einer Pyridingruppe, einer Pyrimidingruppe, einer Pyrazingruppe, einer Pyridazingruppe, einer Triazingruppe, einer Quinolingruppe, einer Isoquinolingruppe, einer Quinoxalingruppe, einer Quinazolingruppe, einer Phenanthrolingruppe, einer Pyrrolgruppe, einer Pyrazolgruppe, einer Imidazolgruppe, einer 2,3-Dihydroimidazolgruppe, einer Triazolgruppe, einer 2,3-Dihydrotriazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer 2,3-Dihydrobenzimidazolgruppe, einer Imidazopyridingruppe, einer 2,3-Dihydroimidazopyridingruppe, einer Imidazopyrimidingruppe, einer 2,3-Dihydroimidazopyrimidingruppe, einer Imidazopyrazingruppe, einer 2,3-Dihydroimidazopyrazingruppe, einer Benzoxazolgruppe, einer Benzothiazolgruppe, einer Benzoxadiazolgruppe, einer Benzothiadiazolgruppe, einer 5,6,7,8-Tetrahydroisoquinolingruppe und einem 5,6,7,8-Tetrahydroquinolin, jeweils substituiert mit mindestens einem, gewählt aus Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer monovalenten, nicht aromatischen, kondensierten polyzyklischen Gruppe und einer monovalenten, nicht aromatischen, kondensierten heteropolyzyklischen Gruppe, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁) und -P(=O)(Q₃₁)(Q₃₂), und
Q₃₁ bis Q₃₃ jeweils unabhängig gewählt sind aus Wasserstoff, Deuterium, -F, -Cl, - Br, -I, einer Hydroxylgruppe, einer Cyanogruppe, einer Nitrogruppe, einer Amidinogruppe, einer Hydrazingruppe, einer Hydrazongruppe, einer C₁-C₆₀ Alkylgruppe, einer C₂-C₆₀ Alkenylgruppe, einer C₂-C₆₀ Alkynylgruppe, einer C₁-C₆₀ Alkoxygruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₁-C₆₀ Heteroarylgruppe, einer monovalenten, nicht aromatischen, kondensierten polyzyklischen Gruppe, einer monovalenten, nicht aromatischen, kondensierten heteropolyzyklischen Gruppe, einer C₁-C₆₀ Alkylgruppe, welche mit mindestens einem substituiert ist, gewählt aus Deuterium, -F und einer Cyanogruppe, einer C₆-C₆₀ Arylgruppe, welche mit mindestens einem substituiert ist, gewählt aus Deuterium, -F und einer Cyanogruppe, einer Biphenylgruppe und einer Terphenylgruppe.

6. Organometallische Verbindung nach einem der Ansprüche 1 bis 5, wobei:
eine durch 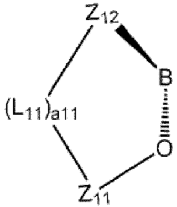 dargestellte Teilstruktur durch Formel 9 dargestellt ist: 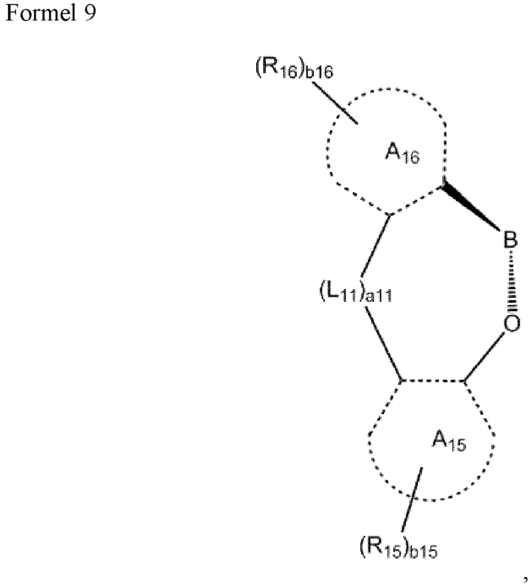 wobei, in Formel 9,
A₁₅ und A₁₆ jeweils unabhängig eine C₅-C₆₀ carbozyklische Gruppe oder eine C₁ C₆₀ heterozyklische Gruppe sind,
R₁₅ und R₆ jeweils unabhängig dieselben sind wie in Verbindung mit R₁₁ in Formel 1 beschrieben, und
b15 und b16 jeweils unabhängig dieselben sind wie in Verbindung mit b11 Formel 1 beschrieben.

7. Organometallische Verbindung nach Anspruch 6, wobei:
A₁₅ gewählt ist aus einer Benzolgruppe, einer Pyridingruppe, einer Pyrimidingruppe, einer Pyrazingruppe, einer Pyridazingruppe und einer Triazingruppe, und A₁₆ gewählt ist aus einer Pyrazolgruppe, einer Imidazolgruppe, einer 2,3-Dihydroimidazolgruppe, einer Triazolgruppe, einer 2,3-Dihydrotriazolgruppe, einer Oxazolgruppe, einer Isoxazolgruppe, einer Thiazolgruppe, einer Isothiazolgruppe, einer Oxadiazolgruppe und einer Thiadiazolgruppe;
A₁₅ gewählt ist aus einer Benzolgruppe, einer Pyridingruppe, einer Pyrimidingruppe, einer Pyrazingruppe, einer Pyridazingruppe und einer Triazingruppe, und A₁₆ gewählt ist aus einer Benzolgruppe, einer Pyridingruppe, einer Pyrimidingruppe, einer Pyrazingruppe, einer Pyridazingruppe und einer Triazingruppe;
A₁₅ gewählt ist aus einer Pyrazolgruppe, einer Imidazolgruppe, einer 2,3-Dihydroimidazolgruppe, einer Triazolgruppe, einer 2,3-Dihydrotriazolgruppe, einer Oxazolgruppe, einer Isoxazolgruppe, einer Thiazolgruppe, einer Isothiazolgruppe, einer Oxadiazolgruppe und einer Thiadiazolgruppe, und A₁₆ gewählt ist aus einer Benzolgruppe, einer Pyridingruppe, einer Pyrimidingruppe, einer Pyrazingruppe, einer Pyridazingruppe und einer Triazingruppe; oder
A₁₅ gewählt ist aus einer Pyrazolgruppe, einer Imidazolgruppe, einer 2,3-Dihydroimidazolgruppe, einer Triazolgruppe, einer 2,3-Dihydrotriazolgruppe, einer Oxazolgruppe, einer Isoxazolgruppe, einer Thiazolgruppe, einer Isothiazolgruppe, einer Oxadiazolgruppe und einer Thiadiazolgruppe und A₁₆ gewählt ist aus einer Pyrazolgruppe, einer Imidazolgruppe, einer 2,3-Dihydroimidazolgruppe, einer Triazolgruppe, einer 2,3-Dihydrotriazolgruppe, einer Oxazolgruppe, einer Isoxazolgruppe, einer Thiazolgruppe, einer Isothiazolgruppe, einer Oxadiazolgruppe und einer Thiadiazolgruppe.

8. Organometallische Verbindung nach einem der Ansprüche 1 bis 7, wobei:
eine durch 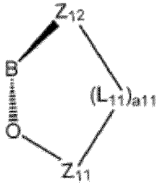 dargestellte Teilstruktur durch eine der Formeln 9-1 bis 9-112 dargestellt ist: 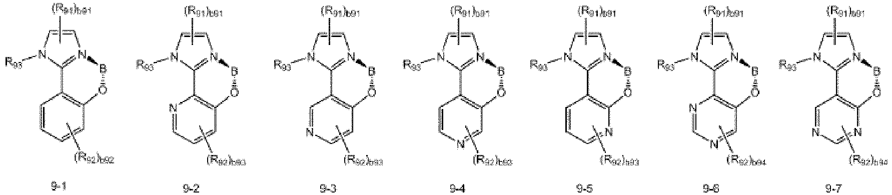 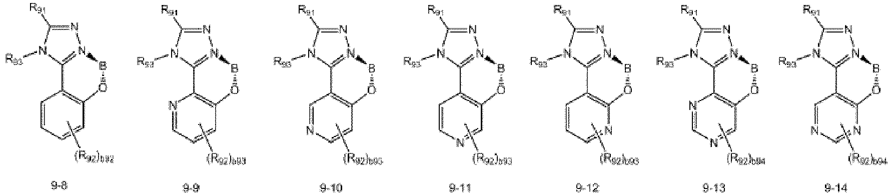 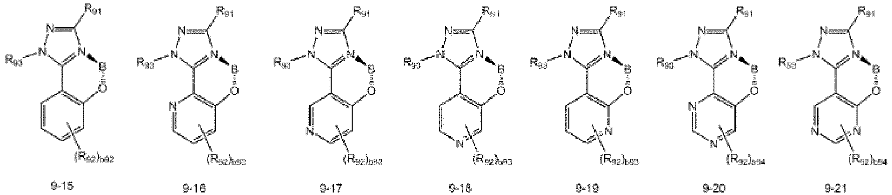 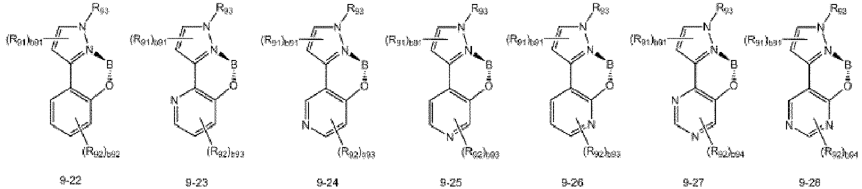 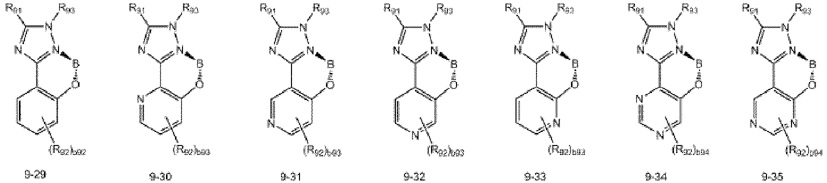 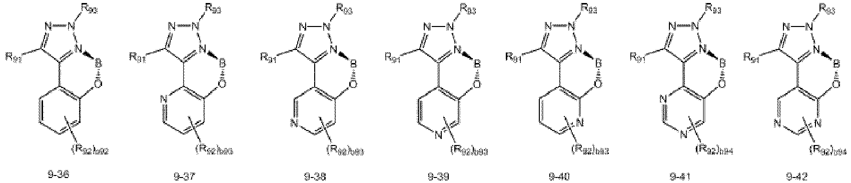 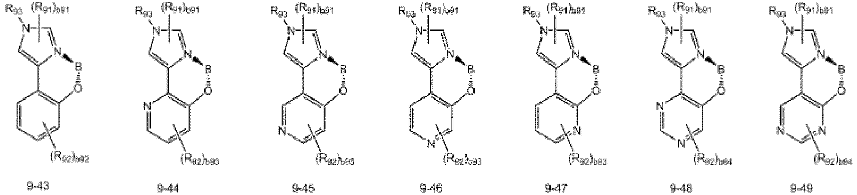 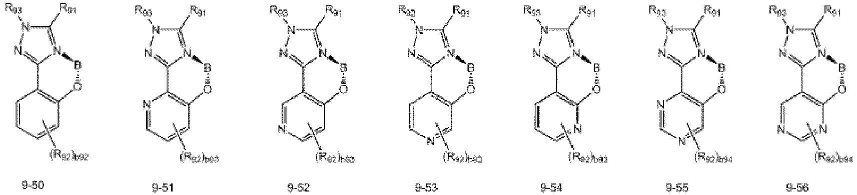 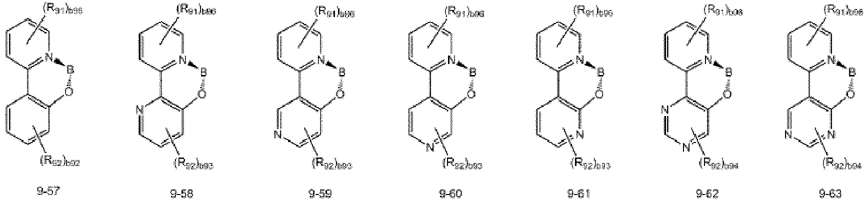 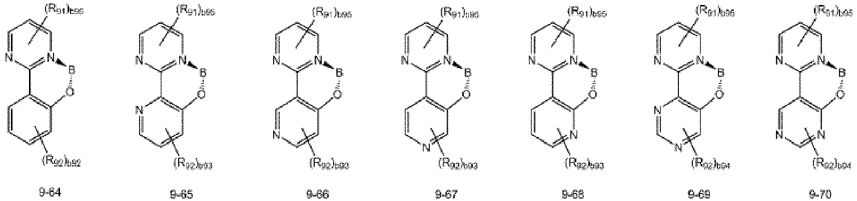 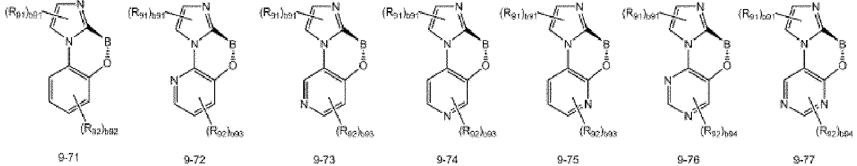 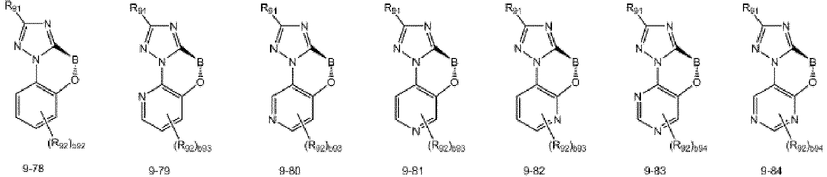 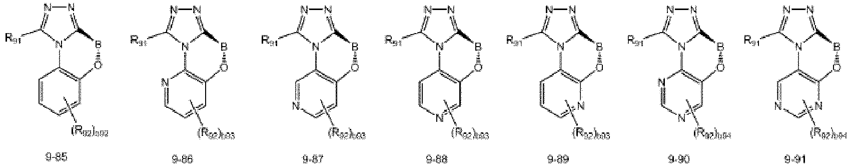 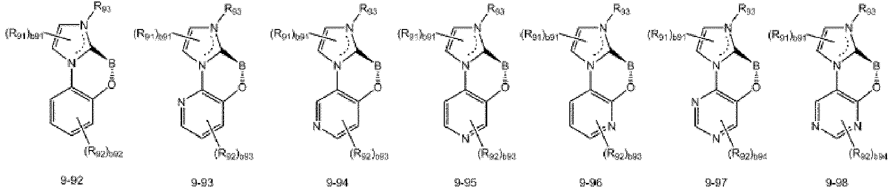 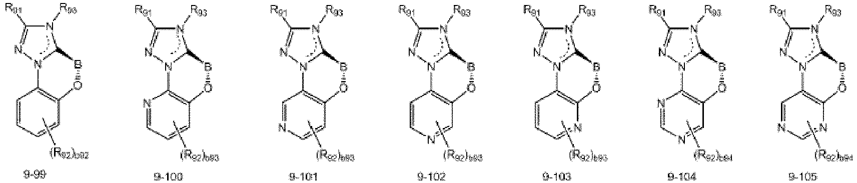 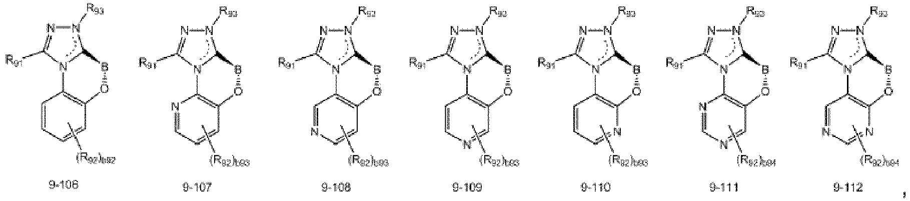 wobei in den Formeln 9-1 bis 9-112,
R₉₁ und R₉₃ jeweils unabhängig gewählt sind aus:
Wasserstoff, -F, einer Cyanogruppe, einer Nitrogruppe, einer Methylgruppe, einer Ethylgruppe, einer Propylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer iso-Hexylgruppe, einer sec-Hexylgruppe, einer tert-Hexylgruppe, einer n-Heptylgruppe, einer iso-Heptylgruppe, einer sec-Heptylgruppe, einer tert-Heptylgruppe, einer n-Octylgruppe, einer iso-Octylgruppe, einer sec-Octylgruppe, einer tert-Octylgruppe, einer n-Nonylgruppe, einer iso-Nonylgruppe, einer sec-Nonylgruppe, einer tert-Nonylgruppe, einer n-Decanylgruppe, einer iso-Decanylgruppe, einer sec-Decanylgruppe, einer tert-Decanylgruppe, einer Methoxygruppe, einer Ethoxygruppe, einer Propoxygruppe, einer Butoxygruppe, einer Pentoxygruppe, einer Phenylgruppe, einer Naphthylgruppe, einer Pyridinylgruppe, einer Pyrimidinylgruppe, einer Triazinylgruppe, einer Dibenzofuranylgruppe und einer Dibenzothiophenylgruppe; und
einer Methylgruppe, einer Ethylgruppe, einer Propylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer n-Hexylgruppe, einer iso-Hexylgruppe, einer sec-Hexylgruppe, einer tert-Hexylgruppe, einer n-Heptylgruppe, einer iso-Heptylgruppe, einer sec-Heptylgruppe, einer tert-Heptylgruppe, einer n-Octylgruppe, einer iso-Octylgruppe, einer sec-Octylgruppe, einer tert-Octylgruppe, einer n-Nonylgruppe, einer iso-Nonylgruppe, einer sec-Nonylgruppe, einer tert-Nonylgruppe, einer n-Decanylgruppe, einer iso-Decanylgruppe, einer sec-Decanylgruppe, einer tert-Decanylgruppe, einer Methoxygruppe, einer Ethoxygruppe, einer Propoxygruppe, einer Butoxygruppe, einer Pentoxygruppe, einer Phenylgruppe, einer Naphthylgruppe, einer Pyridinylgruppe, einer Pyrimidinylgruppe, einer Triazinylgruppe, einer Dibenzofuranylgruppe und einer Dibenzothiophenylgruppe, jeweils substituiert mit jeweils einem, gewählt aus -F, einer Cyanogruppe und einer Nitrogruppe,
b91 und b94 jeweils unabhängig 1 oder 2 sind,
b93 und b95 jeweils unabhängig gewählt sind aus 1, 2 und 3,
b92 and b96 jeweils unabhängig gewählt sind aus 1, 2, 3 und 4.

9. Organometallische Verbindung nach einem der Ansprüche 1 bis 8, wobei:
ein aus B, O, Z₁₁, Z₁₂, und (L₁₁)ₐₗₗ gebildeter Ring gewählt ist aus einem 5-gliedrigen Ring, einem 6-gliedrigen Ring, einem 7-gliedrigen Ring, einem 8-gliedrigen Ring und einem 9-gliedrigen Ring.

10. Organometallische Verbindung nach einem der Ansprüche 1 bis 9, wobei:
T₁₁ bis T₁₄ jeweils eine Einfachbindung sind;
T₁₁ O oder S ist, und T₁₂ bis T₁₄ jeweils eine Einfachbindung sind;
T₁₂ O oder S ist, und T₁₁, T₁₃ und T₁₄ jeweils eine Einfachbindung sind;
T₁₃ O oder S ist, und T₁₁, T₁₂ und T₁₄ jeweils eine Einfachbindung sind; oder
T₁₄ O oder S ist, und T₁₁, T₁₂ und T₁₃ jeweils eine Einfachbindung sind.

11. Organometallische Verbindung nach einem der Ansprüche 1 bis 10, wobei:
L₁₁ bis L₁₄ jeweils unabhängig gewählt sind aus einer Einfachbindung, *-O-*', *-S-*', *-C(R₁₅)(R₁₆)-*', *-C(R₁₅)=*', *=C(R₁₅)-*/, *-B(R₁₅)-*', *-N(R₁₅)-*', *-Si(R₁₅)(R₁₆)-*' und *-P(R₁₅)(R₁₆)-*'.

12. Organometallische Verbindung nach einem der Ansprüche 1 bis 11, wobei:
a11 0 oder 1 ist.

13. Organometallische Verbindung nach einem der Ansprüche 1 bis 12, wobei:
a12, a13 und a14 jeweils unabhängig gewählt sind aus 1, 2 und 3;
a12 0 ist und a13 und a14 jeweils unabhängig gewählt sind aus 1, 2 und 3;
a13 0 ist und a12 und a14 jeweils unabhängig gewählt sind aus 1, 2 und 3; oder
a14 0 ist und a12 und a13 jeweils unabhängig gewählt sind aus 1, 2 und 3.

14. Organometallische Verbindung nach einem der Ansprüche 1 bis 13, wobei:
R₁₁ bis R₁₄, R₁₇ und R₁₈ jeweils unabhängig gewählt sind aus:
Wasserstoff, Deuterium, -F, -Cl, -Br, -I, einer Cyanogruppe, einer C₁-C₂₀ Alkylgruppe und einer C₁-C₂₀ Alkoxygruppe;
einer C₁-C₂₀ Alkylgruppe und einer C₁-C₂₀ Alkoxygruppe, jeweils substituiert mit mindestens einem, gewählt aus Deuterium, -F, -Cl, -Br, -I, einer Cyanogruppe, einer Phenylgruppe und einer Biphenylgruppe;
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentacenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Quinolinylgruppe, einer Isoquinolinylgruppe, einer Benzoquinolinylgruppe, einer Isoquinolinylgruppe, einer Phthalazinylgruppe, einer Naphthyridinylgruppe, einer Quinoxalinylgruppe, einer Benzoquinoxalinylgruppe, einer Quinazolinylgruppe, einer Benzoquinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Benzothiazolylgruppe, einer Benzoisothiazolylgruppe, einer Benzoxazolylgruppe, einer Benzoisoxazolylgruppe, einer Triazolylgruppe, einer Tetrazolylgruppe, einer Thiadiazolylgruppe, einer Oxadiazolylgruppe, einer Triazinylgruppe, einer Carbazolylgruppe, einer Dibenzofuranylgruppe, einer Dibenzothiophenylgruppe, einer Dibenzosilolylgruppe, einer Benzocarbazolylgruppe, einer Naphthobenzofuranylgruppe, einer Naphthobenzothiophenylgruppe, einer Naphthobenzosilolylgruppe, einer Dibenzocarbazolylgruppe, einer Dinaphthofuranylgruppe, einer Dinaphthothiophenylgruppe, einer Dinaphthosilolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspirobifluorenylgruppe, einer Azacarbazolylgruppe, einer Azadibenzofuranylgruppe, einer Azadibenzothiophenylgruppe, einer Azadibenzosilolylgruppe, einer Indenopyrrolylgruppe, einer Indolopyrrolylgruppe, einer Indenocarbazolylgruppe und einer Indolocarbazolylgruppe;
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentacenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Quinolinylgruppe, einer Isoquinolinylgruppe, einer Benzoquinolinylgruppe, einer Isoquinolinylgruppe, einer Phthalazinylgruppe, einer Naphthyridinylgruppe, einer Quinoxalinylgruppe, einer Benzoquinoxalinylgruppe, einer Quinazolinylgruppe, einer Benzoquinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Benzothiazolylgruppe, einer Benzoisothiazolylgruppe, einer Benzoxazolylgruppe, einer Benzoisoxazolylgruppe, einer Triazolylgruppe, einer Tetrazolylgruppe, einer Thiadiazolylgruppe, einer Oxadiazolylgruppe, einer Triazinylgruppe, einer Carbazolylgruppe, einer Dibenzofuranylgruppe, einer Dibenzothiophenylgruppe, einer Dibenzosilolylgruppe, einer Benzocarbazolylgruppe, einer Naphthobenzofuranylgruppe, einer Naphthobenzothiophenylgruppe, einer Naphthobenzosilolylgruppe, einer Dibenzocarbazolylgruppe, einer Dinaphthofuranylgruppe, einer Dinaphthothiophenylgruppe, einer Dinaphthosilolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspirobifluorenylgruppe, einer Azacarbazolylgruppe, einer Azadibenzofuranylgruppe, einer Azadibenzothiophenylgruppe, einer Azadibenzosilolylgruppe, einer Indenopyrrolylgruppe, einer Indolopyrrolylgruppe, einer Indenocarbazolylgruppe, and einer Indolocarbazolylgruppe, jeweils substituiert mit mindestens einem, gewählt aus Deuterium, -F, -Cl, -Br, -I, einer Cyanogruppe, einer C₁-C₂₀ Alkylgruppe, einer C₁-C₂₀ Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentacenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Quinolinylgruppe, einer Isoquinolinylgruppe, einer Benzoquinolinylgruppe, einer Isoquinolinylgruppe, einer Phthalazinylgruppe, einer Naphthyridinylgruppe, einer Quinoxalinylgruppe, einer Benzoquinoxalinylgruppe, einer Quinazolinylgruppe, einer Benzoquinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Benzothiazolylgruppe, einer Benzoisothiazolylgruppe, einer Benzoxazolylgruppe, einer Benzoisoxazolylgruppe, einer Triazolylgruppe, einer Tetrazolylgruppe, einer Thiadiazolylgruppe, einer Oxadiazolylgruppe, einer Triazinylgruppe, einer Carbazolylgruppe, einer Dibenzofuranylgruppe, einer Dibenzothiophenylgruppe, einer Dibenzosilolylgruppe, einer Benzocarbazolylgruppe, einer Naphthobenzofuranylgruppe, einer Naphthobenzothiophenylgruppe, einer Naphthobenzosilolylgruppe, einer Dibenzocarbazolylgruppe, einer Dinaphthofuranylgruppe, einer Dinaphthothiophenylgruppe, einer Dinaphthosilolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspirobifluorenylgruppe, einer Azacarbazolylgruppe, einer Azadibenzofuranylgruppe, einer Azadibenzothiophenylgruppe, einer Azadibenzosilolylgruppe, einer Indenopyrrolylgruppe, einer Indolopyrrolylgruppe, einer Indenocarbazolylgruppe, einer Indolocarbazolylgruppe, - Si(Q₃₁)(Q₃₂)(Q₃₃), -N(Q₃₁)(Q₃₂), -B(Q₃₁)(Q₃₂), -C(=O)(Q₃₁), -S(=O)(Q₃₁), -S(=O)₂(Q₃₁), -P(=O)(Q₃₁)(Q₃₂) und
-Si(Q₁)(Q₂)(Q₃), -B(Q₁)(Q₂), -N(Q₁)(Q₂), -P(Q₁)(Q₂), -C(=O)(Q₁), -S(=O)(Q₁),-S(=O)₂(Q₁), -P(=O)(Q₁)(Q₂) und -P(=S)(Q₁)(Q₂), und
Q₁ bis Q₃ und Q₃₁ bis Q₃₃ jeweils unabhängig gewählt sind aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer C₁-C₆₀ Alkylgruppe, einer C₂-C₆₀ Alkenylgruppe, einer C₂-C₆₀ Alkynylgruppe, einer C₁-C₆₀ Alkoxygruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₁-C₆₀ Heteroarylgruppe, einer C₁-C₆₀ Heteroaryloxygruppe, einer C₁-C₆₀ Heteroarylthiogruppe, einer monovalenten, nicht aromatischen, kondensierten polyzyklischen Gruppe, einer monovalenten, nicht aromatischen, kondensierten heteropolyzyklischen Gruppe, einer C₁-C₆₀ Alkylgruppe, welche mit mindestens einem substituiert ist, gewählt aus Deuterium, -F und einer Cyanogruppe, einer C₆-C₆₀ Arylgruppe, welche mit mindestens einem substituiert ist, gewählt aus Deuterium, -F und einer Cyanogruppe, einer Biphenylgruppe und einer Terphenylgruppe.

15. Organometallische Verbindung nach einem der Ansprüche 1 bis 14, wobei:
R₁₁ bis R₁₄, R₁₇ und R₁₈ jeweils unabhängig gewählt sind aus:
Wasserstoff, Deuterium, -F, -Cl, -Br, -I, einer Cyanogruppe, einer Methylgruppe, einer Ethylgruppe, einer n-Propylgruppe, einer iso-Propylgruppe, einer n-Butylgruppe, einer iso-Butylgruppe, einer sec-Butylgruppe und einer tert-Butylgruppe;
einer Methylgruppe, einer Ethylgruppe, einer n-Propylgruppe, einer iso-Propylgruppe, einer n-Butylgruppe, einer iso-Butylgruppe, einer sec-Butylgruppe und einer tert-Butylgruppe, jeweils substituiert mit mindestens einem, gewält aus Deuterium, -F, -Cl, -Br, -I und einer Cyanogruppe; und
einer Phenylgruppe, einer Naphthylgruppe und einer Pyridinylgruppe.

16. Organometallische Verbindung nach einem der Ansprüche 1 bis 15, wobei:
die durch Formel 1 dargestellte organometallische Verbindung durch eine der Formeln 1-1 bis 1-4 dargestellt ist: 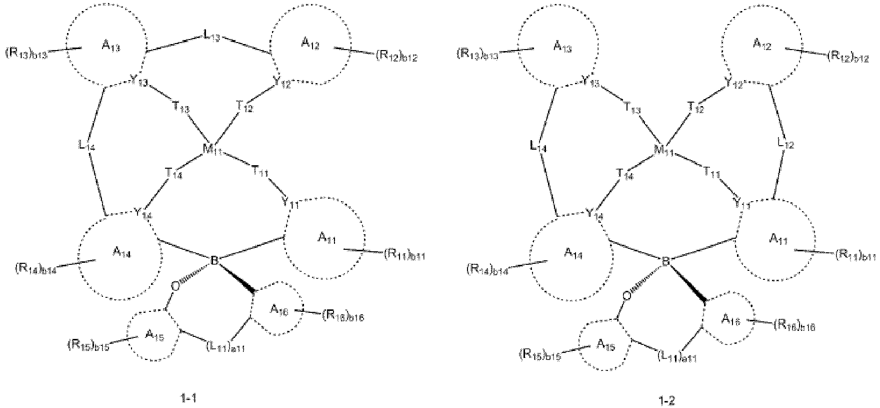 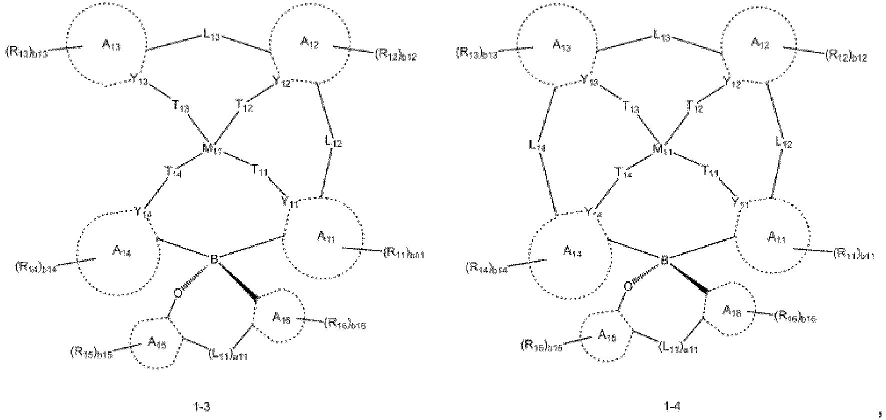 wobei in den Formeln 1-1 bis 1-4:
M₁₁, A₁₁ bis A₁₄, Y₁₁ bis Y₁₄, T₁₁ bis T₁₄, L₁₁ bis L₁₄, a11 bis a14, R₁₁ bis R₁₄ und b11 bis b14 jeweils unabhängig dieselben sind wie in Formel 1 beschrieben,
A₁₅ und A₁₆ jeweils unabhängig eine C₅-C₆₀ carbozyklische Gruppe oder eine C₁-C₆₀ heterozyklische Gruppe sind,
R₁₅ und R₁₆ jeweils unabhängig dieselben sind wie in Verbindung mit R₁₁ in Formel 1 beschrieben, und
b15 und b16 jeweils unabhängig dieselben sind wie in Verbindung mit b11 Formel 1 beschrieben.

17. Organometallische Verbindung nach einem der Ansprüche 1 bis 16, wobei:
die durch Formel 1 dargestellte organometallische Verbindung aus den Verbindungen 1 bis 250 gewählt ist:

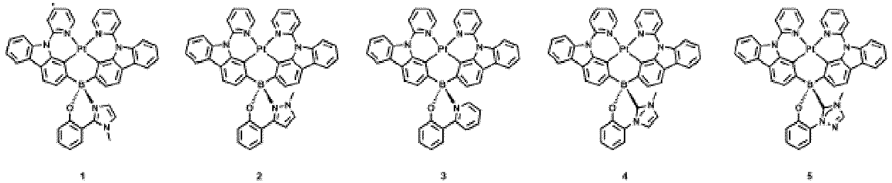

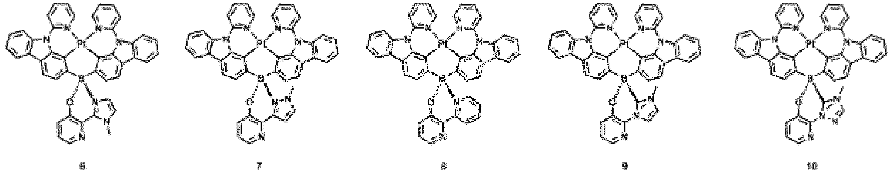

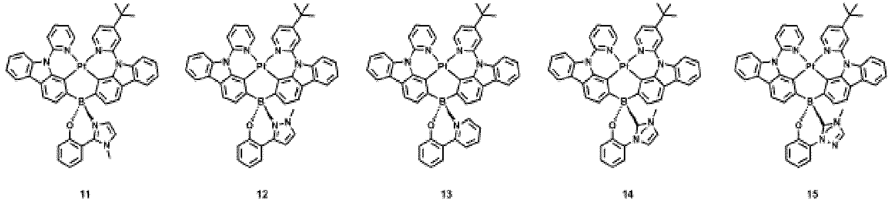

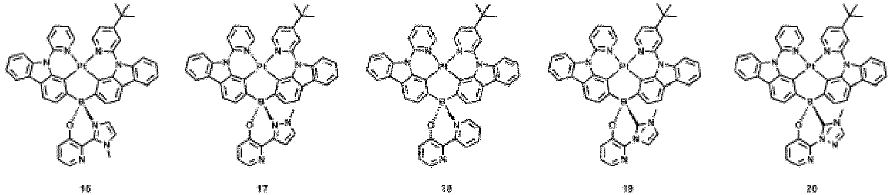

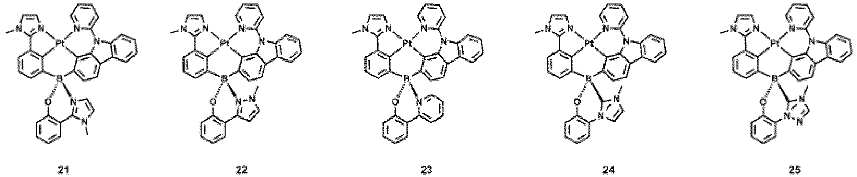

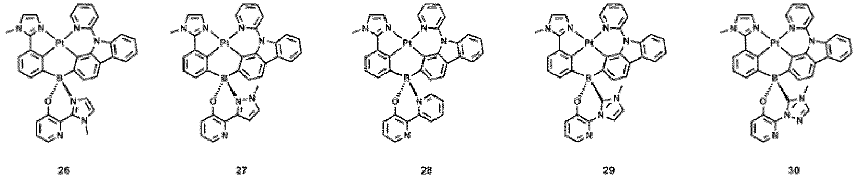

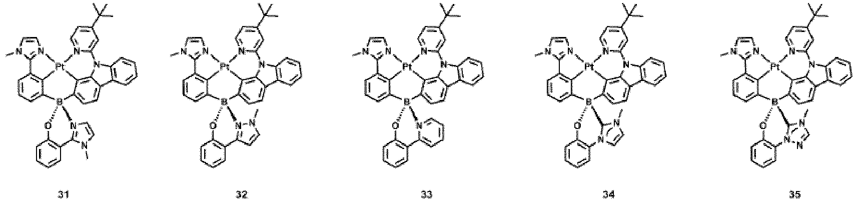

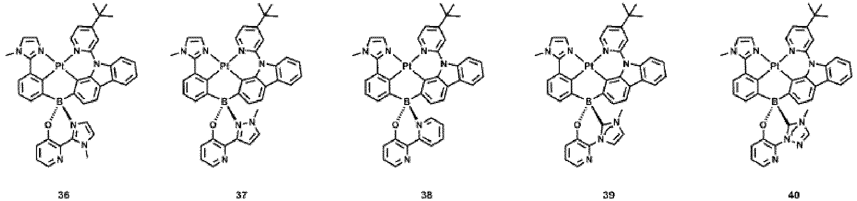

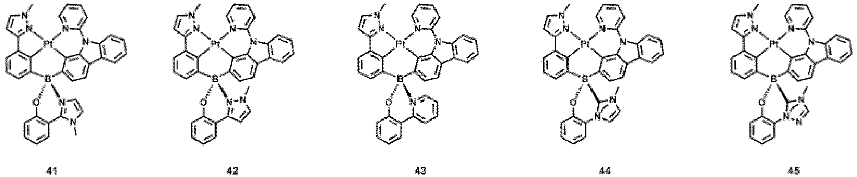

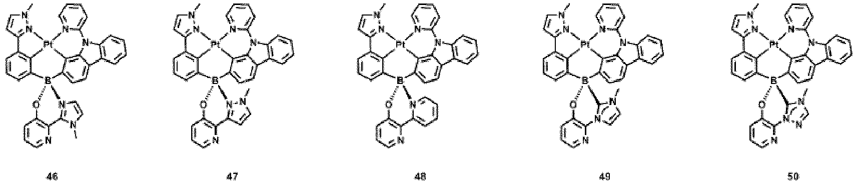

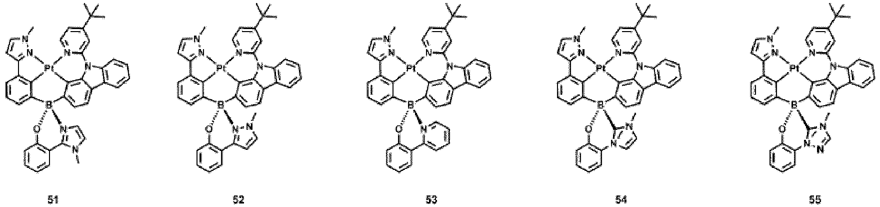

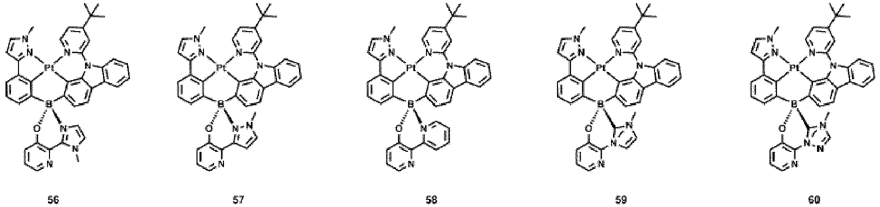

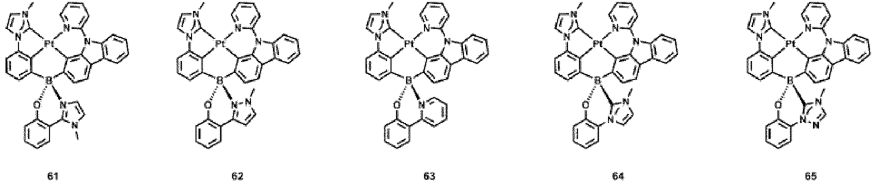

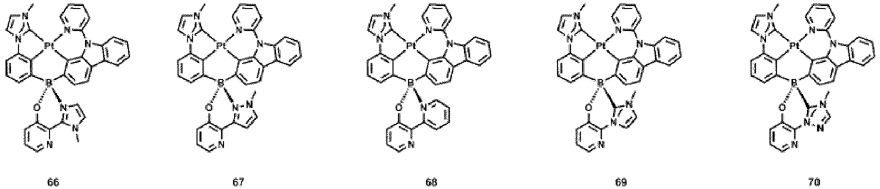

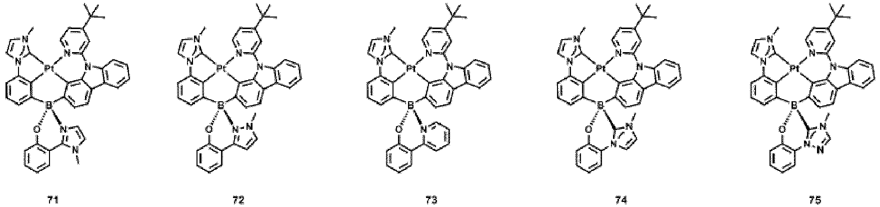

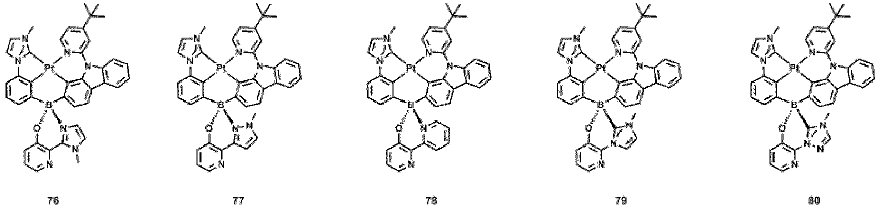

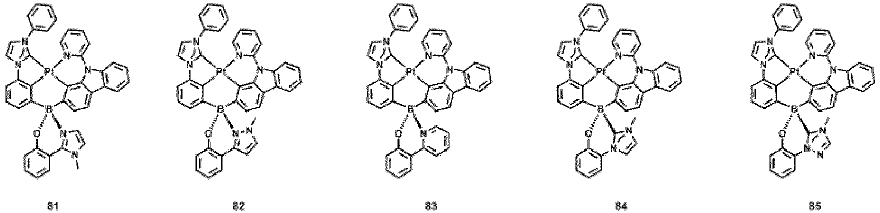

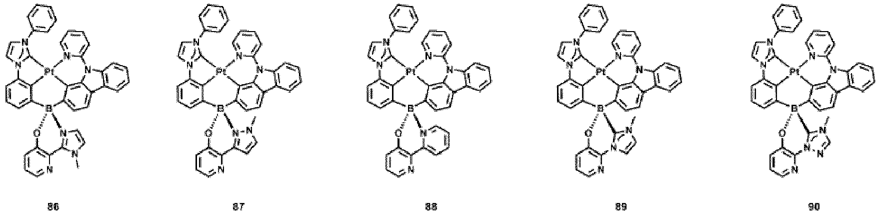

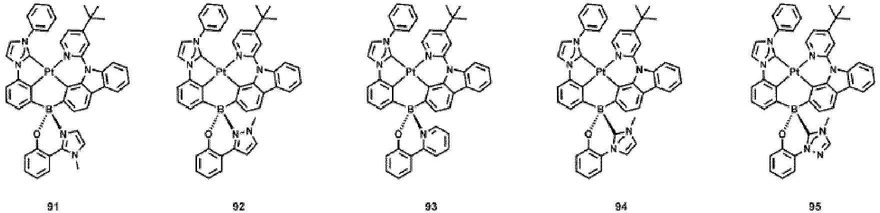

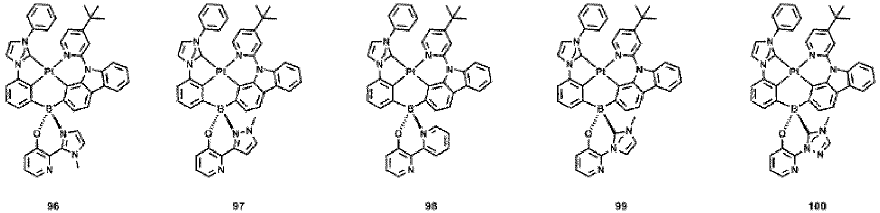

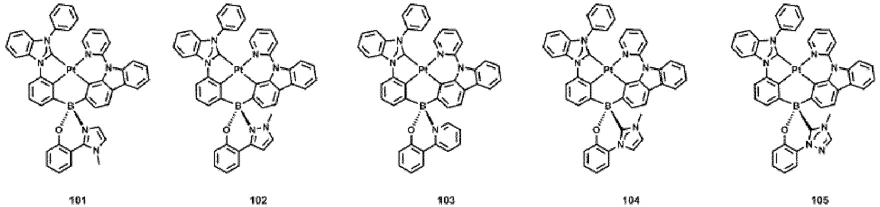

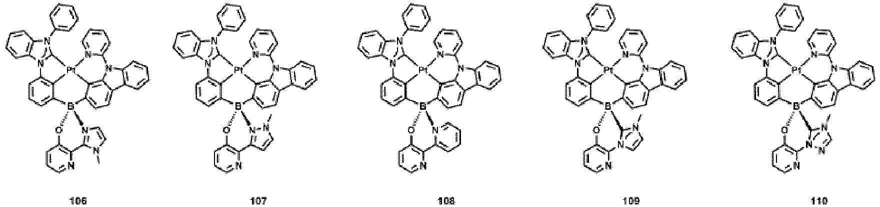

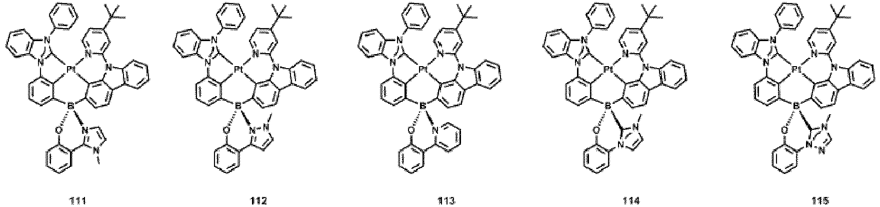

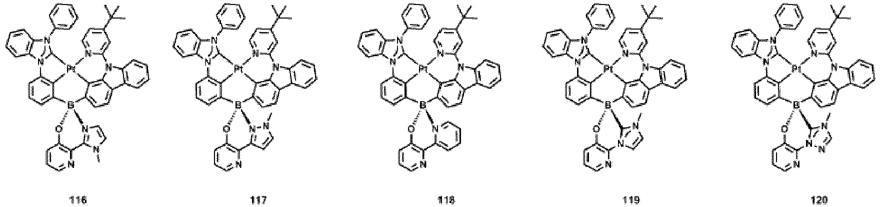

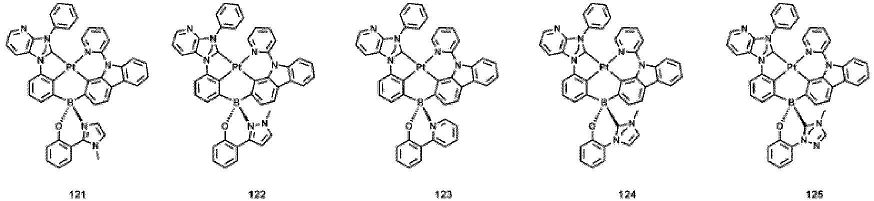

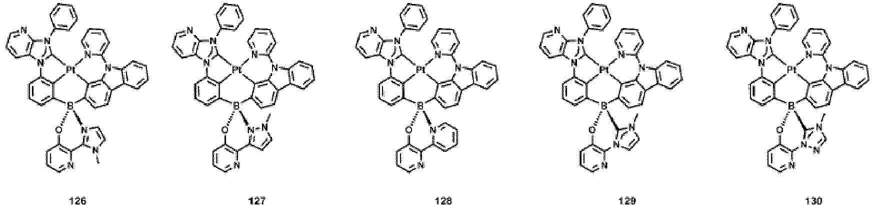

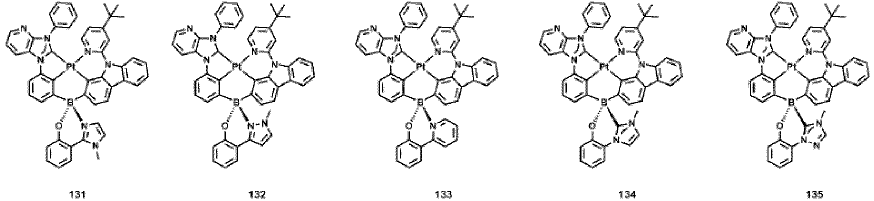

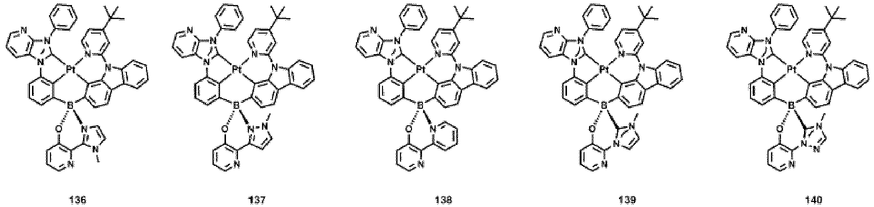

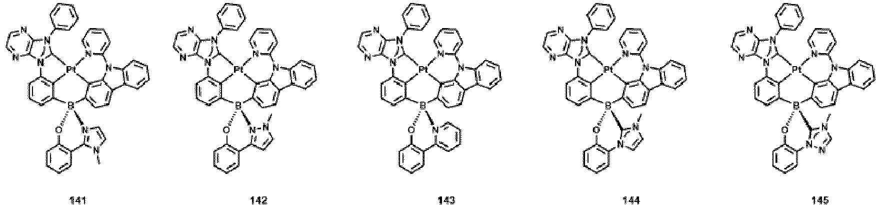

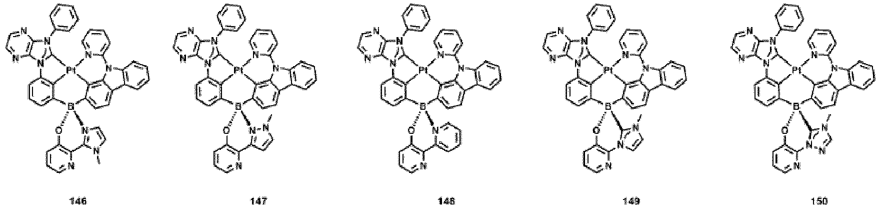

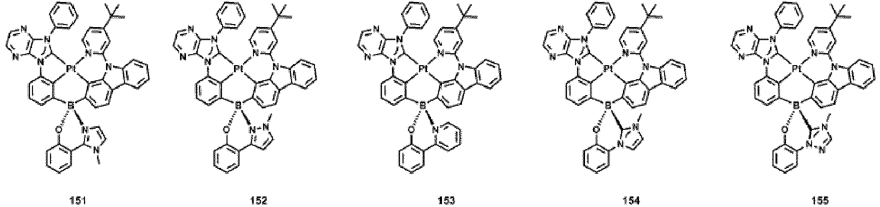

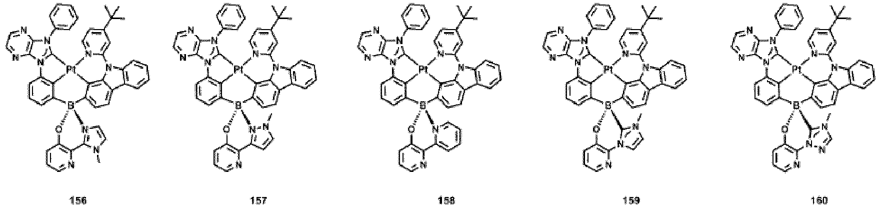

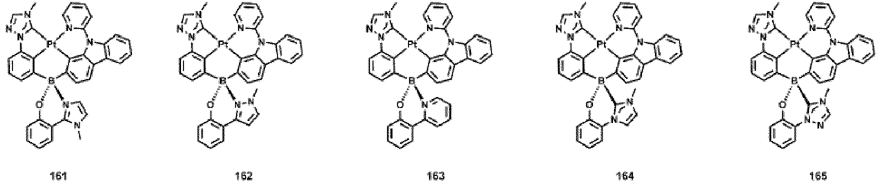

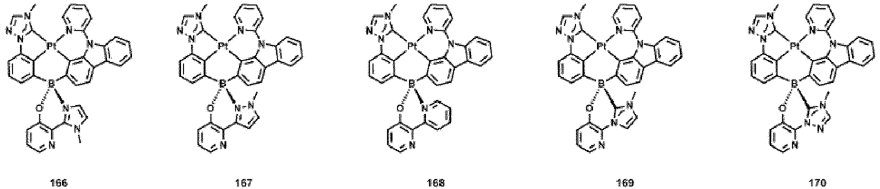

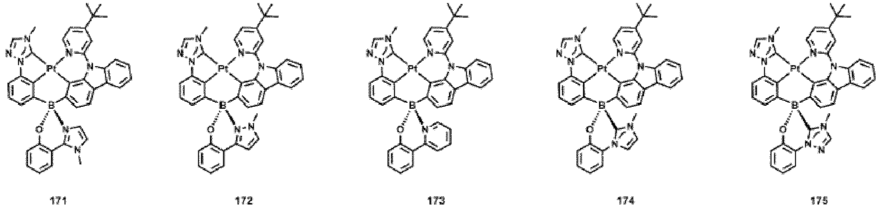

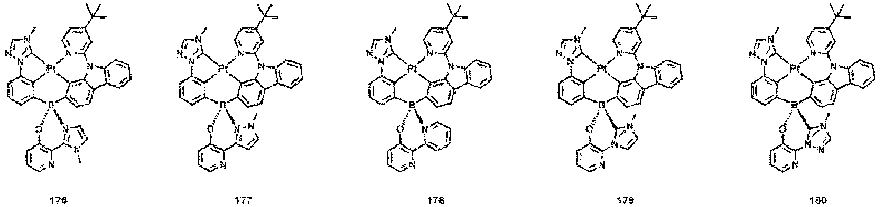

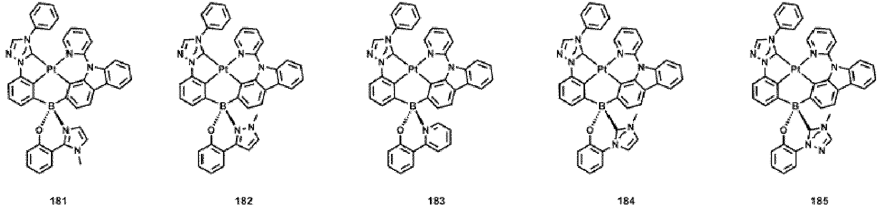

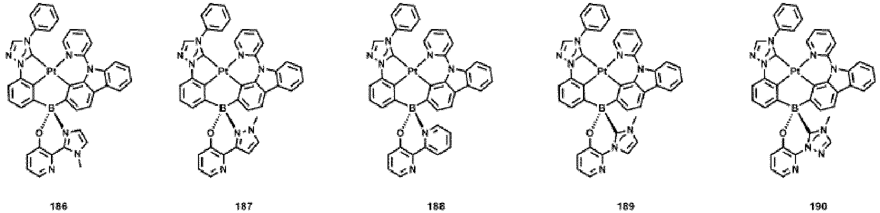

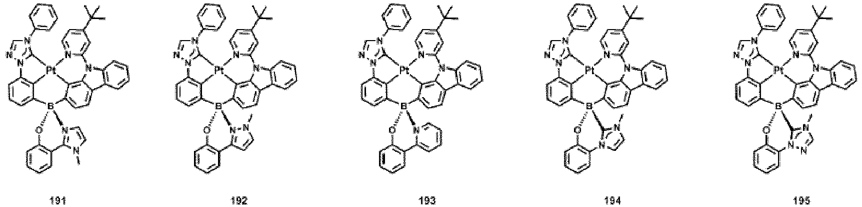

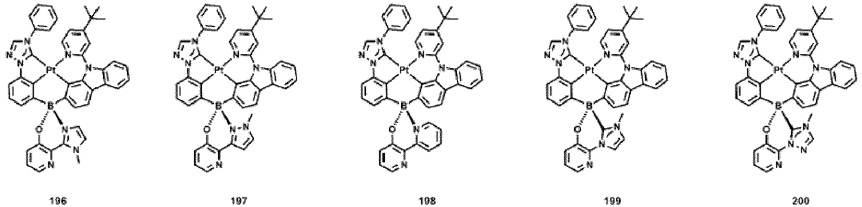

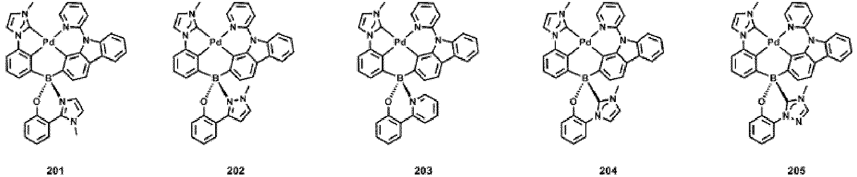

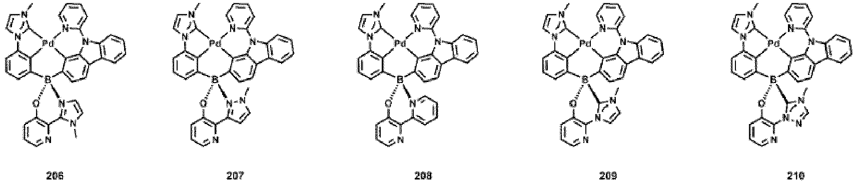

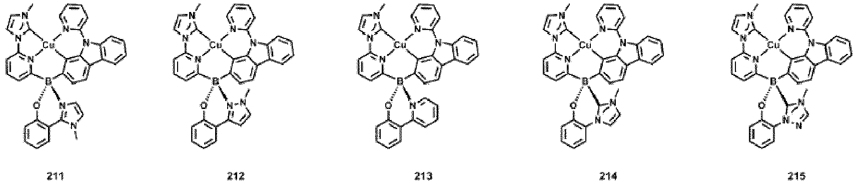

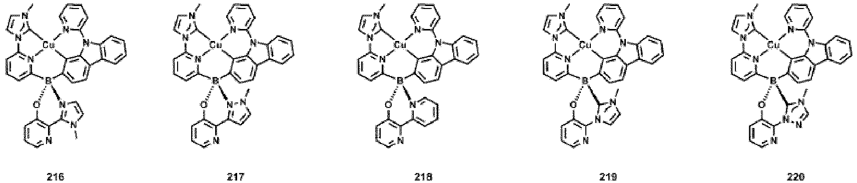

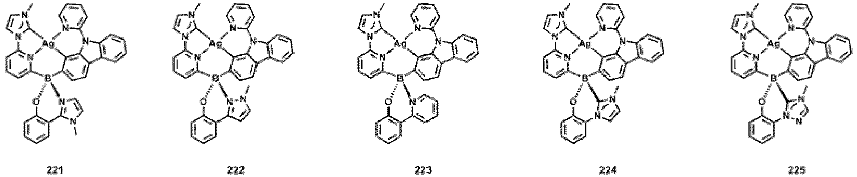

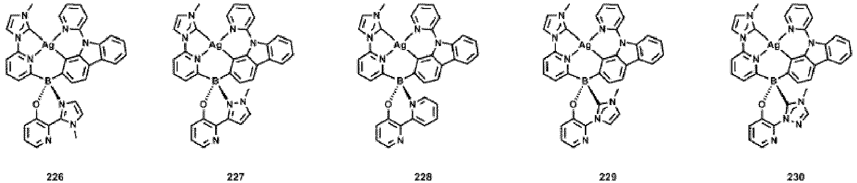

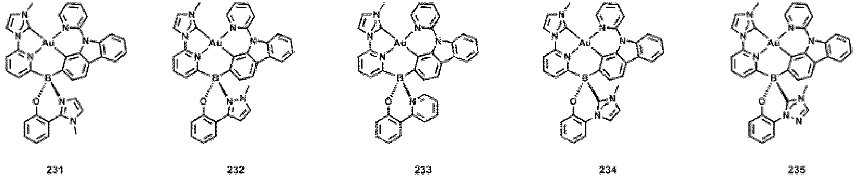

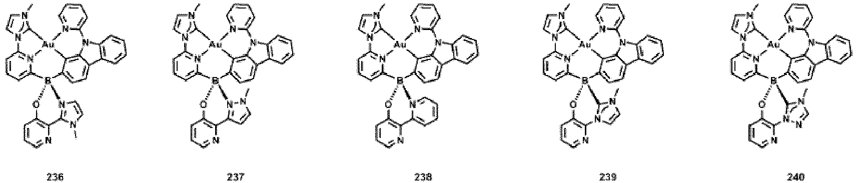

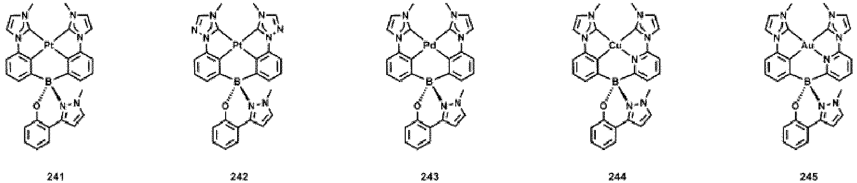

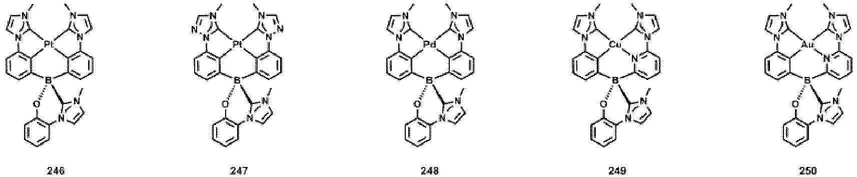

18. Organische lichtemittierende Vorrichtung, Folgendes beinhaltend:
eine erste Elektrode;
eine zweite Elektrode; und
eine zwischen der ersten Elektrode und der zweiten Elektrode angeordnete organische Schicht,
wobei die organische Schicht eine Emissionsschicht und die organometallische Verbindung nach einem der Ansprüche 1 bis 17 beinhaltet.

19. Organische lichtemittierende Vorrichtung nach Anspruch 18, wobei:
die Emissionsschicht die organometallische Verbindung beinhaltet.

20. Organische lichtemittierende Vorrichtung nach Anspruch 19, wobei:
die Emissionsschicht zudem mindestens eines von einem phosphoreszierenden Dotierungsmittel und einem fluoreszierenden Dotierungsmittel beinhaltet.

## Revendications

1. Composé organométallique représenté par la Formule 1: 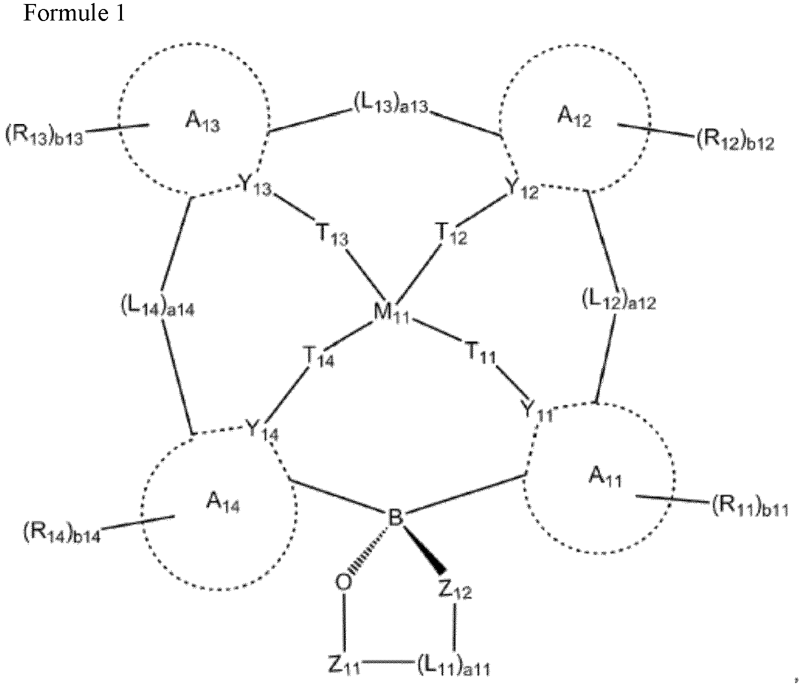 dans lequel, dans la Formule 1,
M₁₁ est choisi parmi: platine (Pt), palladium (Pd), cuivre (Cu), argent (Ag), or (Au), rhodium (Rh), iridium (Ir), ruthénium (Ru), osmium (Os), titane (Ti), zirconium (Zr), hafnium (Hf), europium (Eu), terbium (Tb) et thulium (Tm),
A₁₁ à A₁₄ sont chacun indépendamment un groupe C₅-C₆₀ carbocyclique ou un groupe C₁-C₆₀ hétérocyclique,
Y₁₁ à Y₁₄ sont chacun indépendamment N ou C,
Z₁₁ et Z₁₂ sont chacun indépendamment choisis parmi N, C, O, S, une liaison simple, un groupe C₅-C₆₀ carbocyclique substitué ou non substitué et un groupe C₁-C₆₀ hétérocyclique substitué ou non substitué,
T₁₁ à T₁₄ sont chacun indépendamment choisis parmi une liaison simple, O et S,
L₁₁ à L₁₄ sont chacun indépendamment choisis parmi une liaison simple, *-O-*', *-S-*_{'}, *-C(R₁₇)(R₁₈)-*', *-C(R₁₇)=*', *=C(R₁₇)-*', *-C(R₁₇)=C(R₁₈)-*', *-C(=O)-*', *-C(=S)-*', *-C≡C-*', *-B(R₁₇)-*', *-N(R₁₇)-*', *-P(R₁₇)-*', *-Si(R₁₇)(R₁₈)-*', *-P(R₁₇)(R₁₈)-*, et *-Ge(R₁₇)(R₁₈)-*',
a11 à a14 sont chacun indépendamment choisis parmi 0, 1, 2 et 3,
au moins deux de a12, a13 et a14 sont chacun indépendamment choisis parmi 1, 2 et 3,
lorsque a11 est zéro, (L₁₁)ₐ₁₁ est une liaison simple, lorsque a12 est zéro, A₁₁ et A₁₂ ne sont pas liés l'un à l'autre, lorsque a13 est zéro, A₁₂ et A₁₃ ne sont pas liés l'un à l'autre et lorsque a14 est zéro, A₁₃ et A₁₄ ne sont pas liés l'un à l'autre,
R₁₁ à R₁₄, R₁₇ et R₁₈ sont chacun indépendamment choisis parmi: hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle substitué ou non substitué, un groupe C₂-C₆₀ alcényle substitué ou non substitué, un groupe C₂-C₆₀ alcynyle substitué ou non substitué, un groupe C₁-C₆₀ alcoxy substitué ou non substitué, un groupe C₃-C₁₀ cycloalkyle substitué ou non substitué, un groupe C₁-C₁₀ hétérocycloalkyle substitué ou non substitué, un groupe C₃-C₁₀ cycloalcényle substitué ou non substitué, un groupe C₁-C₁₀ hétérocycloalcényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe C₁-C₆₀ hétéroaryloxy substitué ou non substitué, un groupe C₁-C₆₀ hétéroarylthio substitué ou non substitué, un groupe polycyclique condensé non aromatique monovalent substitué ou non substitué, un groupe hétéropolycyclique condensé non aromatique monovalent substitué ou non substitué, - Si(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂) et -P(=S)(Q₁)(Q₂),
R₁₇ et R₁₁, R₁₇ et R₁₂, R₁₇ et R₁₃ et/ou R₁₇ et R₁₄ sont optionnellement liés pour former un groupe C₅-C₆₀ carbocyclique substitué ou non substitué ou un groupe C₁-C₆₀ hétérocyclique substitué ou non substitué,
R₁₇ et R₁₈ sont optionnellement liés pour former un groupe C₅-C₆₀ carbocyclique substitué ou non substitué ou un groupe C₁-C₆₀ hétérocyclique substitué ou non substitué,
b11 à b14 sont chacun indépendamment choisis parmi 1, 2, 3, 4, 5, 6, 7 et 8,
Q₁ à Q₃ sont chacun indépendamment choisis parmi: hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle, un groupe C₁-C₆₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C₁-C₆₀ hétéroaryloxy, un groupe C₁-C₆₀ hétéroarylthio, un groupe polycyclique condensé non aromatique monovalent, un groupe hétéropolycyclique condensé non aromatique monovalent, un groupe C₁-C₆₀ alkyle substitué avec au moins un choisi parmi: deutérium, -F et un groupe cyano, un groupe C₆-C₆₀ aryle substitué avec au moins un choisi parmi: deutérium, -F et un groupe cyano, un groupe biphényle et un groupe terphényle,
dans lequel au moins un substituant du groupe C₅-C₆₀ carbocyclique substitué, du groupe C₁-C₆₀ hétérocyclique substitué, du groupe C₁-C₆₀ alkyle substitué, du groupe C₂-C₆₀ alcényle substitué, du groupe C₂-C₆₀ alcynyle substitué, du groupe C₁-C₆₀ alcoxy substitué, du groupe C₃-C₁₀ cycloalkyle substitué, du groupe C₁-C₁₀ hétérocycloalkyle substitué, du groupe C₃-C₁₀ cycloalcényle substitué, du groupe C₁-C₁₀ hétérocycloalcényle substitué, du groupe C₆-C₆₀ aryle substitué, du groupe C₆-C₆₀ aryloxy substitué, du groupe C₆-C₆₀ arylthio substitué, du groupe C₁-C₆₀ hétéroaryle substitué, du groupe C₁-C₆₀ hétéroaryloxy substitué, du groupe C₁-C₆₀ hétéroarylthio substitué, du groupe polycyclique condensé non aromatique monovalent substitué et du groupe hétéropolycyclique condensé non aromatique monovalent substitué est choisi parmi:
deutérium (-D), -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle et un groupe C₁-C₆₀ alcoxy;
un groupe C₁-C₆₀ alkyle, un groupe C₂-C₆₀ alcényle, un groupe C₂-C₆₀ alcynyle et un groupe C₁-C₆₀ alcoxy, chacun étant substitué avec au moins un choisi parmi: deutérium, -F, -Cl, -Br, -I, un groupe hydroxyle, un groupe cyano, un groupe nitro, un groupe amidino, un groupe hydrazino, un groupe hydrazono, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C₁-C₆₀ hétéroaryloxy, un groupe C₁-C₆₀ hétéroarylthio, un groupe polycyclique condensé non aromatique monovalent, un groupe hétéropolycyclique condensé non aromatique monovalent, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁) et -P(=O)(Q₁₁)(Q₁₂);
un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C₁-C₆₀ hétéroaryloxy, un groupe C₁-C₆₀ hétéroarylthio, un groupe polycyclique condensé non aromatique monovalent et un groupe hétéropolycyclique condensé non aromatique monovalent;
un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C₁-C₆₀ hétéroaryloxy, un groupe C₁-C₆₀ hétéroarylthio, un groupe polycyclique condensé non aromatique monovalent et un groupe hétéropolycyclique condensé non aromatique monovalent, chacun étant substitué avec au moins un choisi parmi: deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle, un groupe C₁-C₆₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C₁-C₆₀ hétéroaryloxy, un groupe C₁-C₆₀ hétéroarylthio, un groupe polycyclique condensé non aromatique monovalent, un groupe hétéropolycyclique condensé non aromatique monovalent, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁) et -P(=O)(Q₂₁)(Q₂₂); et
Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et - P(=O)(Q₃₁)(Q₃₂), et
Q₁₁ à Q₁₃, Q₂₁ à Q₂₃ et Q₃₁ à Q₃₃ sont chacun indépendamment choisis parmi: hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle, un groupe C₁-C₆₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₁-C₆₀ hétéroaryle, un groupe C₁-C₆₀ hétéroaryloxy, un groupe C₁-C₆₀ hétéroarylthio, un groupe polycyclique condensé non aromatique monovalent, un groupe hétéropolycyclique condensé non aromatique monovalent, un groupe C₁-C₆₀ alkyle substitué avec au moins un choisi parmi: deutérium, -F et un groupe cyano, un groupe C₆-C₆₀ aryle substitué avec au moins un choisi parmi: deutérium, -F et un groupe cyano, un groupe biphényle et un groupe terphényle; et
* et *', indiquant chacun un site de liaison à un atome voisin.

2. Composé organométallique selon la revendication 1, dans lequel:
A₁₁ à A₁₄ sont chacun indépendamment choisis parmi un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe indénopyridine, un groupe indolopyridine, un groupe benzofuropyridine, un groupe benzothiénopyridine, un groupe benzosilolopyridine, un groupe indénopyrimidine, un groupe indolopyrimidine, un groupe benzofuropyrimidine, un groupe benzothiénopyrimidine, un groupe benzosilolopyrimidine, un groupe dihydropyridine, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe 2,3-dihydroimidazole, un groupe triazole, un groupe 2,3-dihydrotriazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe 2,3-dihydrobenzimidazole, un groupe imidazopyridine, un groupe 2,3-dihydroimidazopyridine, un groupe imidazopyrimidine, un groupe 2,3-dihydroimidazopyrimidine, un groupe imidazopyrazine, un groupe 2,3-dihydroimidazopyrazine, un groupe benzoxazole, un groupe benzothiazole, un groupe benzoxadiazole, un groupe benzothiadiazole, un groupe 5,6,7,8-tétrahydroisoquinoléine et un groupe 5,6,7,8-tétrahydroquinoléine.

3. Composé organométallique selon la revendication 1 ou la revendication 2, dans lequel:
A₁₁ à A₁₄ sont chacun indépendamment représentés par l'une des Formules 2-1 à 2-43: 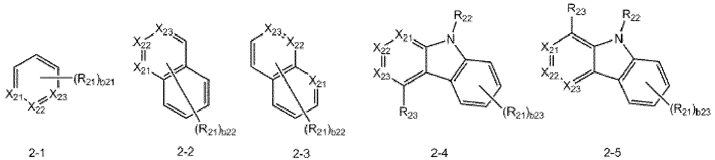 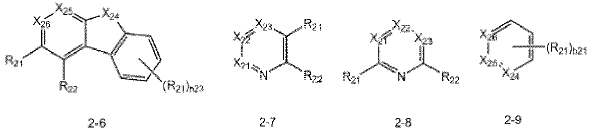 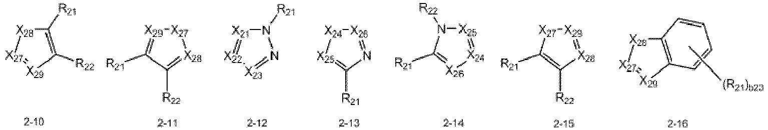 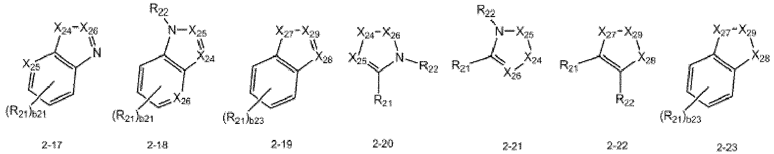 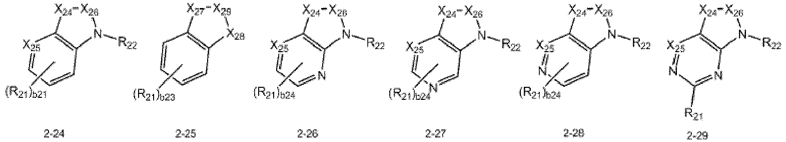 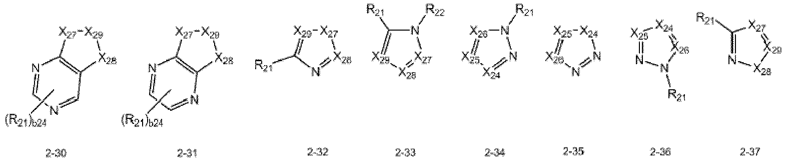 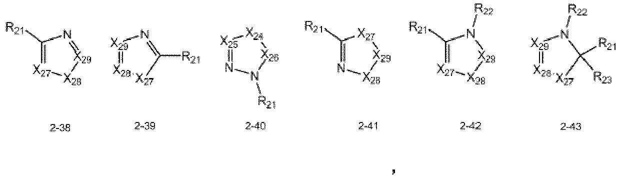 dans lequel, dans les Formules 2-1 à 2-43,
X₂₁ à X₂₃ sont chacun indépendamment C(R₂₄) ou C-*, à condition que au moins deux de X₂₁ à X₂₃ soient chacun C-*,
X₂₄ est N-*, et X₂₅ et X₂₆ sont chacun indépendamment C(R₂₄) ou C-*, à condition que au moins un de X₂₅ et X₂₆ soit C-*,
X₂₇ et X₂₈ sont chacun indépendamment choisis parmi N, N(R₂₅) et N-*, et X₂₉ est C(R₂₄) ou C-*, à condition que i) au moins un de X₂₇ et X₂₈ soit N-*, et X₂₉ soit C-*, ou ii) X₂₇ et X₂₈ soient chacun N-*, et X₂₉ soit C(R₂₄),
R₂₁ à R₂₄ sont chacun indépendamment les mêmes que ce qui est décrit conjointement à R₁₁ dans la Formule 1,
b21 est choisi parmi 1, 2 et 3,
b22 est choisi parmi 1, 2, 3, 4 et 5,
b23 est choisi parmi 1, 2, 3 et 4,
b24 est 1 ou 2, et
* indique un site de liaison à un atome voisin.

4. Composé organométallique selon l'une quelconque des revendications 1 à 3, dans lequel:
Y₁₁, Y₁₂ et Y₁₃ sont chacun C, et Y₁₄ est N;
Y₁₁, Y₁₂ et Y₁₄ sont chacun C, et Y₁₃ est N;
Y₁₁, Y₁₃ et Y₁₄ sont chacun C, et Y₁₂ est N;
Y₁₂, Y₁₃ et Y₁₄ sont chacun C, et Y₁₁ est N;
Y₁₁ et Y₁₄ sont chacun C, et Y₁₂ et Y₁₃ sont chacun N;
Y₁₁ et Y₁₄ sont chacun N, et Y₁₂ et Y₁₃ sont chacun C;
Y₁₁ et Y₁₂ sont chacun C, et Y₁₃ et Y₁₄ sont chacun N;
Y₁₁ et Y₁₂ sont chacun N, et Y₁₃ et Y₁₄ sont chacun C;
Y₁₁ et Y₁₃ sont chacun C, et Y₁₂ et Y₁₄ sont chacun N; ou
Y₁₁ et Y₁₃ sont chacun N, et Y₁₂ et Y₁₄ sont chacun C.

5. Composé organométallique selon l'une quelconque des revendications 1 à 4, dans lequel:
Z₁₁ et Z₁₂ sont chacun indépendamment choisis parmi:
N, C, O, S, une liaison simple, un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe indénopyridine, un groupe indolopyridine, un groupe benzofuropyridine, un groupe benzothiénopyridine, un groupe benzosilolopyridine, un groupe indénopyrimidine, un groupe indolopyrimidine, un groupe benzofuropyrimidine, un groupe benzothiénopyrimidine, un groupe benzosilolopyrimidine, un groupe dihydropyridine, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe 2,3-dihydroimidazole, un groupe triazole, un groupe 2,3-dihydrotriazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe 2,3-dihydrobenzimidazole, un groupe imidazopyridine, un groupe 2,3-dihydroimidazopyridine, un groupe imidazopyrimidine, un groupe 2,3-dihydroimidazopyrimidine, un groupe imidazopyrazine, un groupe 2,3-dihydroimidazopyrazine, un groupe benzoxazole, un groupe benzothiazole, un groupe benzoxadiazole, un groupe benzothiadiazole, un groupe 5,6,7,8-tétrahydroisoquinoléine et un groupe 5,6,7,8-tétrahydroquinoléine;
un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe indénopyridine, un groupe indolopyridine, un groupe benzofuropyridine, un groupe benzothiénopyridine, un groupe benzosilolopyridine, un groupe indénopyrimidine, un groupe indolopyrimidine, un groupe benzofuropyrimidine, un groupe benzothiénopyrimidine, un groupe benzosilolopyrimidine, un groupe dihydropyridine, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe 2,3-dihydroimidazole, un groupe triazole, un groupe 2,3-dihydrotriazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe 2,3-dihydrobenzimidazole, un groupe imidazopyridine, un groupe 2,3-dihydroimidazopyridine, un groupe imidazopyrimidine, un groupe 2,3-dihydroimidazopyrimidine, un groupe imidazopyrazine, un groupe 2,3-dihydroimidazopyrazine, un groupe benzoxazole, un groupe benzothiazole, un groupe benzoxadiazole, un groupe benzothiadiazole, un groupe 5,6,7,8-tétrahydroisoquinoléine et un groupe 5,6,7,8-tétrahydroquinoléine, chacun étant substitué avec au moins un choisi parmi: deutérium, -F, -Cl, -Br, -I, un groupe hydroxyle, un groupe cyano, un groupe nitro, un groupe amidino, un groupe hydrazino, un groupe hydrazono, -CD₃, -CD₂H, -CDH₂, - CF₃, -CF₂H, -CFH₂, un groupe C₁-C₆₀ alkyle, un groupe C₂-C₆₀ alcényle, un groupe C₂-C₆₀ alcynyle et un groupe C₁-C₆₀ alcoxy; et
un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe indénopyridine, un groupe indolopyridine, un groupe benzofuropyridine, un groupe benzothiénopyridine, un groupe benzosilolopyridine, un groupe indénopyrimidine, un groupe indolopyrimidine, un groupe benzofuropyrimidine, un groupe benzothiénopyrimidine, un groupe benzosilolopyrimidine, un groupe dihydropyridine, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe 2,3-dihydroimidazole, un groupe triazole, un groupe 2,3-dihydrotriazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe 2,3-dihydrobenzimidazole, un groupe imidazopyridine, un groupe 2,3-dihydroimidazopyridine, un groupe imidazopyrimidine, un groupe 2,3-dihydroimidazopyrimidine, un groupe imidazopyrazine, un groupe 2,3-dihydroimidazopyrazine, un groupe benzoxazole, un groupe benzothiazole, un groupe benzoxadiazole, un groupe benzothiadiazole, un groupe 5,6,7,8-tétrahydroisoquinoléine et un groupe 5,6,7,8-tétrahydroquinoléine, chacun étant substitué avec au moins un choisi parmi: deutérium, -F, -Cl, -Br, -I, un groupe hydroxyle, un groupe cyano, un groupe nitro, un groupe amidino, un groupe hydrazino, un groupe hydrazono, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe polycyclique condensé non aromatique monovalent, et un groupe hétéropolycyclique condensé non aromatique monovalent, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) et -P(=O)(Q₃₁)(Q₃₂), et
Q₃₁ à Q₃₃ sont chacun indépendamment choisis parmi: hydrogène, deutérium, -F, - Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle, un groupe C₁-C₆₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₁-C₆₀ hétéroaryle, un groupe polycyclique condensé non aromatique monovalent, un groupe hétéropolycyclique condensé non aromatique monovalent, un groupe C₁-C₆₀ alkyle substitué avec au moins un choisi parmi: deutérium, -F et un groupe cyano, un groupe C₆-C₆₀ aryle substitué avec au moins un choisi parmi: deutérium, -F et un groupe cyano, un groupe biphényle et un groupe terphényle.

6. Composé organométallique selon l'une quelconque des revendications 1 à 5, dans lequel:
une sous-structure représentée par 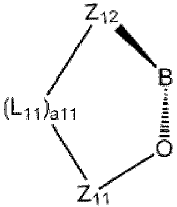 est représentée par la Formule 9: 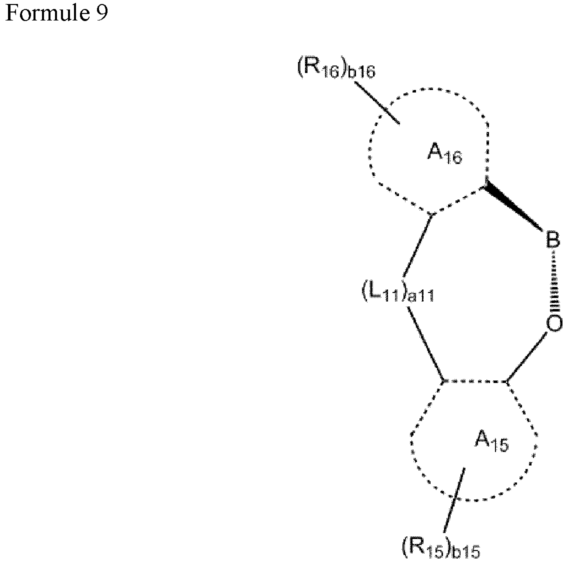 dans lequel, dans la Formule 9,
A₁₅ et A₁₆ sont chacun indépendamment un groupe C₅-C₆₀ carbocyclique ou un groupe C₁-C₆₀ hétérocyclique,
R₁₅ et R₁₆ sont chacun indépendamment les mêmes que ce qui est décrit conjointement à R₁₁ dans la Formule 1, et
b15 et b16 sont chacun indépendamment les mêmes que ce qui est décrit conjointement à b11 dans la Formule 1.

7. Composé organométallique selon la revendication 6, dans lequel:
A₁₅ est choisi parmi un groupe benzène, un groupe pyridine, un groupe pyrimidine, un groupe pyrazine, un groupe pyridazine et un groupe triazine, et A₁₆ est choisi parmi un groupe pyrazole, un groupe imidazole, un groupe 2,3-dihydroimidazole, un groupe triazole, un groupe 2,3-dihydrotriazole, un groupe oxazole, un groupe isoxazole, un groupe thiazole, un groupe isothiazole, un groupe oxadiazole et un groupe thiadiazole;
A₁₅ est choisi parmi un groupe benzène, un groupe pyridine, un groupe pyrimidine, un groupe pyrazine, un groupe pyridazine et un groupe triazine, et A₁₆ est choisi parmi un groupe benzène, un groupe pyridine, un groupe pyrimidine, un groupe pyrazine, un groupe pyridazine et un groupe triazine;
A₁₅ est choisi parmi un groupe pyrazole, un groupe imidazole, un groupe 2,3-dihydroimidazole, un groupe triazole, un groupe 2,3-dihydrotriazole, un groupe oxazole, un groupe isoxazole, un groupe thiazole, un groupe isothiazole, un groupe oxadiazole et un groupe thiadiazole, et A₁₆ est choisi parmi un groupe benzène, un groupe pyridine, un groupe pyrimidine, un groupe pyrazine, un groupe pyridazine et un groupe triazine; ou
A₁₅ est choisi parmi un groupe pyrazole, un groupe imidazole, un groupe 2,3-dihydroimidazole, un groupe triazole, un groupe 2,3-dihydrotriazole, un groupe oxazole, un groupe isoxazole, un groupe thiazole, un groupe isothiazole, un groupe oxadiazole et un groupe thiadiazole, et A₁₆ est choisi parmi un groupe pyrazole, un groupe imidazole, un groupe 2,3-dihydroimidazole, un groupe triazole, un groupe 2,3-dihydrotriazole, un groupe oxazole, un groupe isoxazole, un groupe thiazole, un groupe isothiazole, un groupe oxadiazole et un groupe thiadiazole.

8. Composé organométallique selon l'une quelconque des revendications 1 à 7, dans lequel:
une sous-structure représentée par 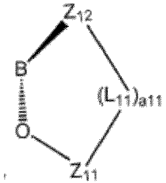 est représentée par l'une des Formules 9-1 à 9-112: 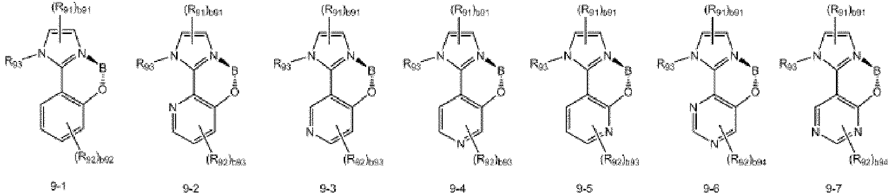 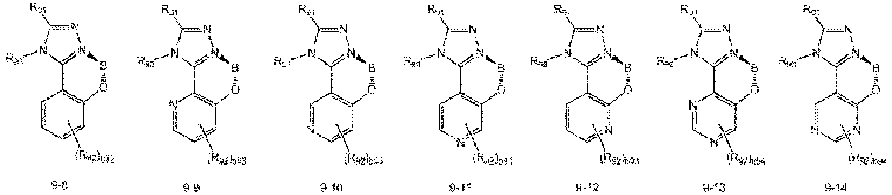 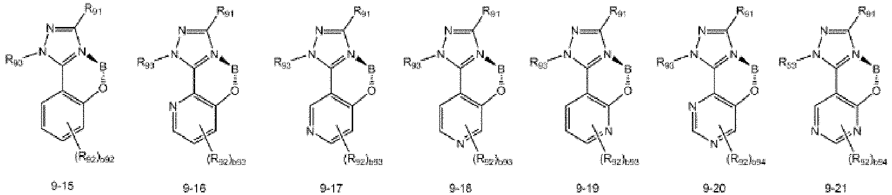 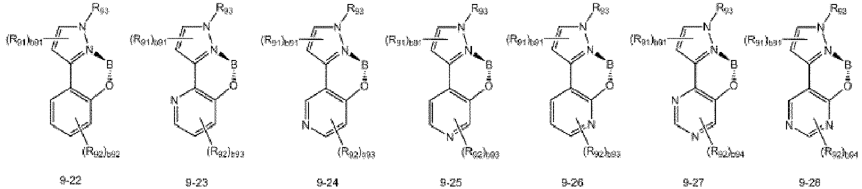 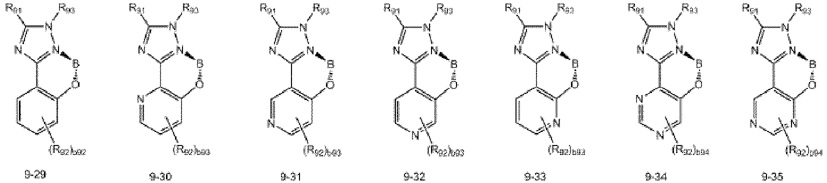 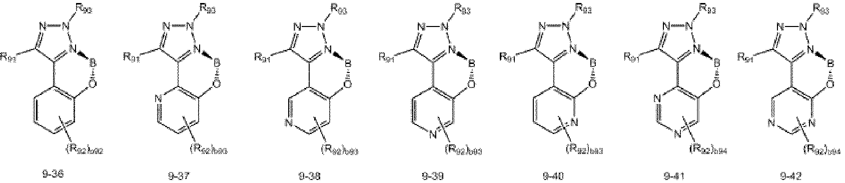 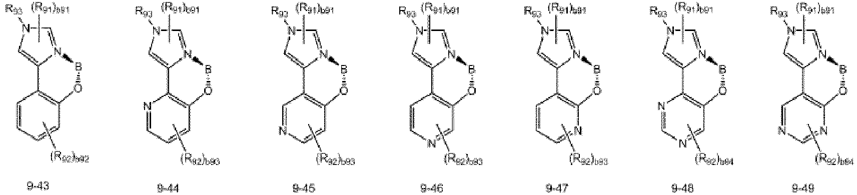 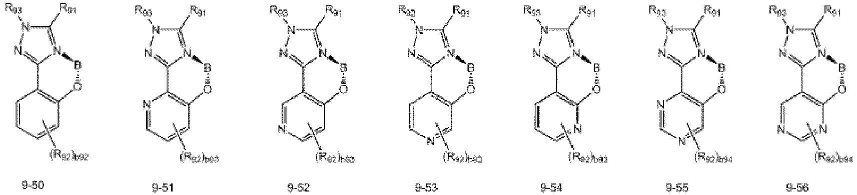 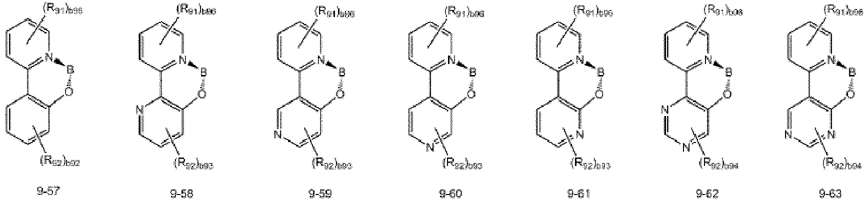 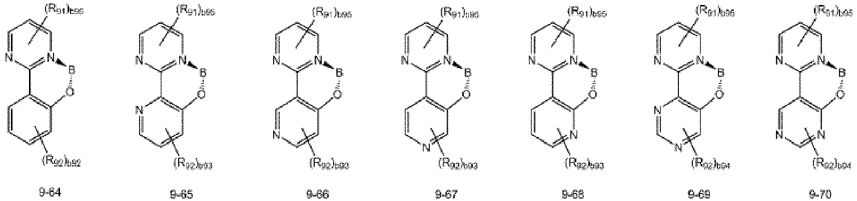 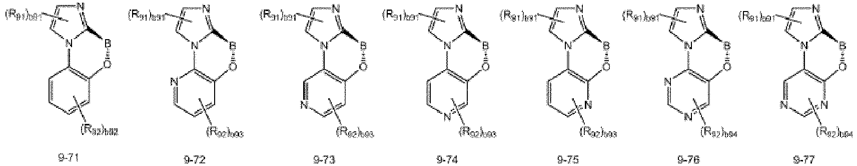 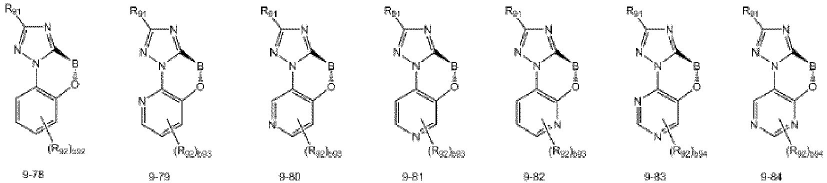 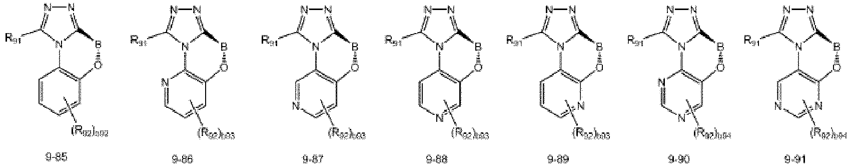 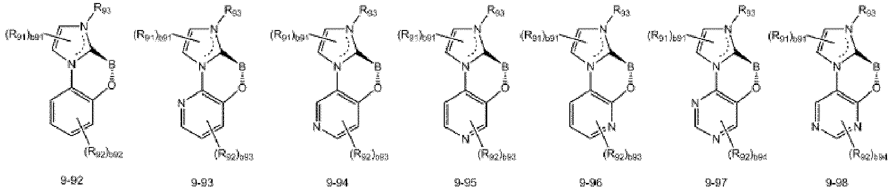 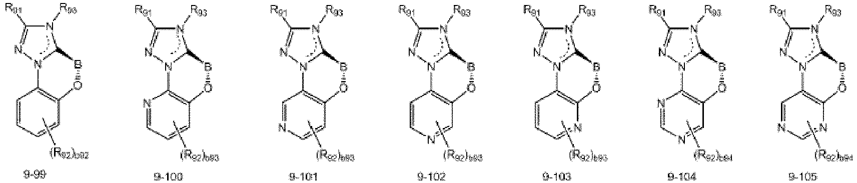 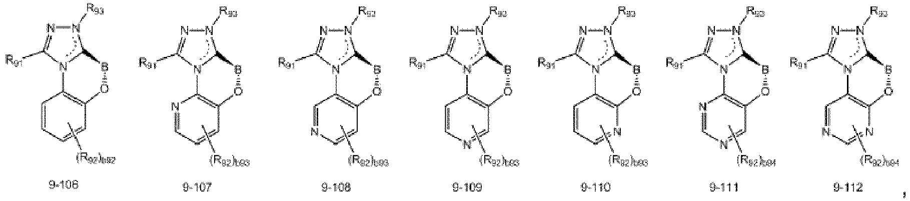 dans lequel, dans les Formules 9-1 à 9-112,
R₉₁ à R₉₃ sont chacun indépendamment choisis parmi:
hydrogène, -F, un groupe cyano, un groupe nitro, un groupe méthyle, un groupe éthyle, un groupe propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décanyle, un groupe iso-décanyle, un groupe sec-décanyle, un groupe tert-décanyle, un groupe méthoxy, un groupe éthoxy, un groupe propoxy, un groupe butoxy, un groupe pentoxy, un groupe phényle, un groupe naphtyle, un groupe pyridinyle, un groupe pyrimidinyle, un groupe triazinyle, un groupe dibenzofuranyle et un groupe dibenzothiophényle; et
un groupe méthyle, un groupe éthyle, un groupe propyle, un groupe n-butyle, un groupe iso-butyle, un groupe sec-butyle, un groupe tert-butyle, un groupe n-pentyle, un groupe iso-pentyle, un groupe sec-pentyle, un groupe tert-pentyle, un groupe n-hexyle, un groupe iso-hexyle, un groupe sec-hexyle, un groupe tert-hexyle, un groupe n-heptyle, un groupe iso-heptyle, un groupe sec-heptyle, un groupe tert-heptyle, un groupe n-octyle, un groupe iso-octyle, un groupe sec-octyle, un groupe tert-octyle, un groupe n-nonyle, un groupe iso-nonyle, un groupe sec-nonyle, un groupe tert-nonyle, un groupe n-décanyle, un groupe iso-décanyle, un groupe sec-décanyle, un groupe tert-décanyle, un groupe méthoxy, un groupe éthoxy, un groupe propoxy, un groupe butoxy, un groupe pentoxy, un groupe phényle, un groupe naphtyle, un groupe pyridinyle, un groupe pyrimidinyle, un groupe triazinyle, un groupe dibenzofuranyle et un groupe dibenzothiophényle, chacun étant substitué avec au moins un choisi parmi -F, un groupe cyano et un groupe nitro,
b91 et b94 sont chacun indépendamment 1 ou 2,
b93 et b95 sont chacun indépendamment choisis parmi 1, 2 et 3,
b92 et b96 sont chacun indépendamment choisis parmi 1, 2, 3 et 4.

9. Composé organométallique selon l'une quelconque des revendications 1 à 8, dans lequel:
un cycle formé par B, O, Z₁₁, Z₁₂ et (L₁₁)ₐ₁₁ est choisi parmi un cycle à 5 membres, un cycle à 6 membres, un cycle à 7 membres, un cycle à 8 membres et un cycle à 9 membres.

10. Composé organométallique selon l'une quelconque des revendications 1 à 9, dans lequel:
T₁₁ à T₁₄ sont chacun une liaison simple;
T₁₁ est O ou S, et T₁₂ à T₁₄ sont chacun une liaison simple;
T₁₂ est O ou S, et T₁₁, T₁₃ et T₁₄ sont chacun une liaison simple;
T₁₃ est O ou S, et T₁₁, T₁₂ et T₁₄ sont chacun une liaison simple; ou
T₁₄ est O ou S, et T₁₁, T₁₂ et T₁₃ sont chacun une liaison simple.

11. Composé organométallique selon l'une quelconque des revendications 1 à 10, dans lequel:
L₁₁ à L₁₄ sont chacun indépendamment choisis parmi une liaison simple, *-O-*', *-S-*_{'}, *-C(R₁₅)(R₁₆)-*', *-C(R₁₅)=*', *=C(R₁₅)-*', *-B(R₁₅)-*', *-N(R₁₅)-*', *-Si(R₁₅)(R₁₆)-*' et *-P(R₁₅)(R₁₆)-*'.

12. Composé organométallique selon l'une quelconque des revendications 1 à 11, dans lequel:
a11 est 0 ou 1.

13. Composé organométallique selon l'une quelconque des revendications 1 à 12, dans lequel:
a12, a13 et a14 sont chacun indépendamment choisis parmi 1, 2 et 3;
a12 est 0, et a13 et a14 sont chacun indépendamment choisis parmi 1, 2 et 3;
a13 est 0, et a12 et a14 sont chacun indépendamment choisis parmi 1, 2 et 3; ou
a14 est 0, et a12 et a13 sont chacun indépendamment choisis parmi 1, 2 et 3.

14. Composé organométallique selon l'une quelconque des revendications 1 à 13, dans lequel:
R₁₁ à R₁₄, R₁₇ et R₁₈ sont chacun indépendamment choisis parmi:
hydrogène, deutérium, -F, -Cl, -Br, -I, un groupe cyano, un groupe C₁-C₂₀ alkyle et un groupe C₁-C₂₀ alcoxy;
un groupe C₁-C₂₀ alkyle et un groupe C₁-C₂₀ alcoxy, chacun étant substitué avec au moins un choisi parmi: deutérium, -F, -Cl, -Br, -I, un groupe cyano, un groupe phényle et un groupe biphényle;
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentacényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinoléinyle, un groupe isoquinoléinyle, un groupe benzoquinoléinyle, un isoquinoléinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe benzothiazolyle, un groupe benzoisothiazolyle, un groupe benzoxazolyle, un groupe benzoisoxazolyle, un groupe triazolyle, un groupe tétrazolyle, un groupe thiadiazolyle, un groupe oxadiazolyle, un groupe triazinyle, un groupe carbazolyle, un groupe dibenzofuranyle, un groupe dibenzothiophényle, un groupe dibenzosilolyle, un groupe benzocarbazolyle, un groupe naphtobenzofuranyle, un groupe naphtobenzothiophényle, un groupe naphtobenzosilolyle, un groupe dibenzocarbazolyle, un groupe dinaphtofuranyle, un groupe dinaphtothiophényle, un groupe dinaphtosilolyle, un groupe imidazopyridinyle, un groupe imidazopyrimidinyle, un groupe oxazolopyridinyle, un groupe thiazolopyridinyle, un groupe benzonaphtyridinyle, un groupe azafluorényle, un groupe azaspiro-bifluorényle, un groupe azacarbazolyle, un groupe azadibenzofuranyle, un groupe azadibenzothiophényle, un groupe azadibenzosilolyle, un groupe indénopyrrolyle, un groupe indolopyrrolyle, un groupe indénocarbazolyle et un groupe indolocarbazolyle;
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentacényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinoléinyle, un groupe isoquinoléinyle, un groupe benzoquinoléinyle, un isoquinoléinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe benzothiazolyle, un groupe benzoisothiazolyle, un groupe benzoxazolyle, un groupe benzoisoxazolyle, un groupe triazolyle, un groupe tétrazolyle, un groupe thiadiazolyle, un groupe oxadiazolyle, un groupe triazinyle, un groupe carbazolyle, un groupe dibenzofuranyle, un groupe dibenzothiophényle, un groupe dibenzosilolyle, un groupe benzocarbazolyle, un groupe naphtobenzofuranyle, un groupe naphtobenzothiophényle, un groupe naphtobenzosilolyle, un groupe dibenzocarbazolyle, un groupe dinaphtofuranyle, un groupe dinaphtothiophényle, un groupe dinaphtosilolyle, un groupe imidazopyridinyle, un groupe imidazopyrimidinyle, un groupe oxazolopyridinyle, un groupe thiazolopyridinyle, un groupe benzonaphtyridinyle, un groupe azafluorényle, un groupe azaspiro-bifluorényle, un groupe azacarbazolyle, un groupe azadibenzofuranyle, un groupe azadibenzothiophényle, un groupe azadibenzosilolyle, un groupe indénopyrrolyle, un groupe indolopyrrolyle, un groupe indénocarbazolyle et un groupe indolocarbazolyle, chacun étant substitué avec au moins un choisi parmi: deutérium, -F, -Cl, -Br, -I, un groupe cyano, un groupe C₁-C₂₀ alkyle, un groupe C₁-C₂₀ alcoxy, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentacényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinoléinyle, un groupe isoquinoléinyle, un groupe benzoquinoléinyle, un isoquinoléinyle, un groupe phtalazinyle, un groupe naphtyridinyle, un groupe quinoxalinyle, un groupe benzoquinoxalinyle, un groupe quinazolinyle, un groupe benzoquinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe benzothiazolyle, un groupe benzoisothiazolyle, un groupe benzoxazolyle, un groupe benzoisoxazolyle, un groupe triazolyle, un groupe tétrazolyle, un groupe thiadiazolyle, un groupe oxadiazolyle, un groupe triazinyle, un groupe carbazolyle, un groupe dibenzofuranyle, un groupe dibenzothiophényle, un groupe dibenzosilolyle, un groupe benzocarbazolyle, un groupe naphtobenzofuranyle, un groupe naphtobenzothiophényle, un groupe naphtobenzosilolyle, un groupe dibenzocarbazolyle, un groupe dinaphtofuranyle, un groupe dinaphtothiophényle, un groupe dinaphtosilolyle, un groupe imidazopyridinyle, un groupe imidazopyrimidinyle, un groupe oxazolopyridinyle, un groupe thiazolopyridinyle, un groupe benzonaphtyridinyle, un groupe azafluorényle, un groupe azaspiro-bifluorényle, un groupe azacarbazolyle, un groupe azadibenzofuranyle, un groupe azadibenzothiophényle, un groupe azadibenzosilolyle, un groupe indénopyrrolyle, un groupe indolopyrrolyle, un groupe indénocarbazolyle, un groupe indolocarbazolyle, -Si(Q₃₁)(Q₃₂)(Q₃₃), -N(Q₃₁)(Q₃₂), - B(Q₃₁)(Q₃₂), -C(=O)(Q₃₁), -S(=O)(Q₃₁), -S(=O)₂(Q₃₁), -P(=O)(Q₃₁)(Q₃₂) et - P(=S)(Q₃₁)(Q₃₂); et
- Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂) et -P(=S)(Q₁)(Q₂), et
Q₁ à Q₃ et Q₃₁ à Q₃₃ sont chacun indépendamment choisis parmi: hydrogène, deutérium, -F, -Cl, -Br, -I, un groupe hydroxyle, un groupe cyano, un groupe nitro, un groupe amidino, un groupe hydrazino, un groupe hydrazono, un groupe C₁-C₆₀ alkyle, un groupe C₂-C₆₀ alcényle, un groupe C₂-C₆₀ alcynyle, un groupe C₁-C₆₀ alcoxy, un groupe C₃-C₁₀ cycloalkyle, un groupe C₁-C₁₀ hétérocycloalkyle, un groupe C₃-C₁₀ cycloalcényle, un groupe C₁-C₁₀ hétérocycloalcényle, un groupe C₆-C₆₀ aryle, un groupe C₆-C₆₀ aryloxy, un groupe C₆-C₆₀ arylthio, un groupe C₁-C₆₀ hétéroaryle, un groupe C₁-C₆₀ hétéroaryloxy, un groupe C₁-C₆₀ hétéroarylthio, un groupe polycyclique condensé non aromatique monovalent, un groupe hétéropolycyclique condensé non aromatique monovalent, un groupe C₁-C₆₀ alkyle substitué avec au moins un choisi parmi: deutérium, -F et un groupe cyano, un groupe C₆-C₆₀ aryle substitué avec au moins un choisi parmi: deutérium, -F et un groupe cyano, un groupe biphényle et un groupe terphényle.

15. Composé organométallique selon l'une quelconque des revendications 1 à 14, dans lequel:
R₁₁ à R₁₄, R₁₇ et R₁₈ sont chacun indépendamment choisis parmi:
hydrogène, deutérium, -F, -Cl, -Br, -I, un groupe cyano, un groupe méthyle, un groupe éthyle, un groupe n-propyle, un groupe iso-propyle, un groupe n-butyle, un groupe iso-butyle, un groupe sec-butyle et un groupe tert-butyle;
un groupe méthyle, un groupe éthyle, un groupe n-propyle, un groupe iso-propyle, un groupe n-butyle, un groupe iso-butyle, un groupe sec-butyle et un groupe tert-butyle, chacun étant substitué avec au moins un choisi parmi: deutérium, -F, -Cl, -Br, -I et un groupe cyano; et
un groupe phényle, un groupe naphtyle et un groupe pyridinyle.

16. Composé organométallique selon l'une quelconque des revendications 1 à 15, dans lequel le composé organométallique représenté par la Formule 1 est représenté par l'une des Formules 1-1 à 1-4: 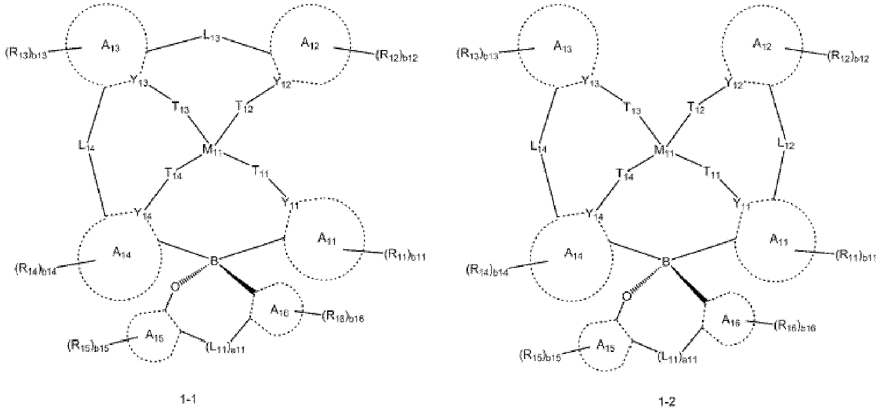 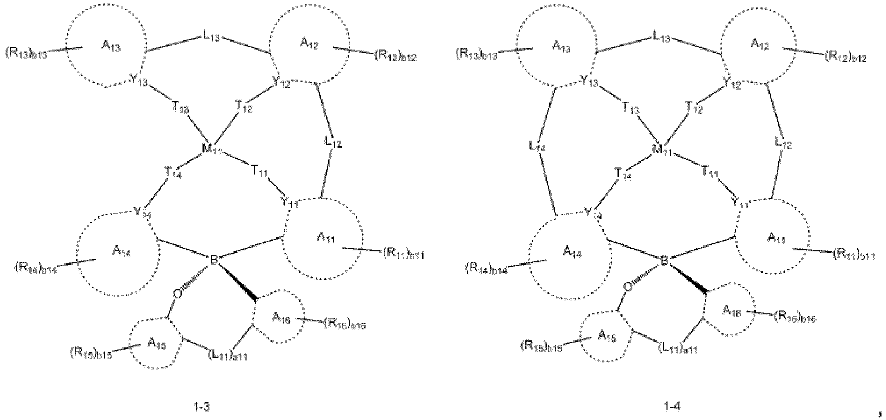 dans lequel, dans les Formules 1-1 à 1-4,
M₁₁, A₁₁ à A₁₄, Y₁₁ à Y₁₄, T₁₁ à T₁₄, L₁₁ à L₁₄, a11 à a14, R₁₁ à R₁₄ et b₁₁ à b14 sont chacun indépendamment les mêmes que ce qui est décrit dans la Formule 1,
A₁₅ et A₁₆ sont chacun indépendamment un groupe C₅-C₆₀ carbocyclique ou un groupe C₁-C₆₀ hétérocyclique,
R₁₅ et R₁₆ sont chacun indépendamment les mêmes que ce qui est décrit conjointement à R₁₁ dans la Formule 1, et
b15 et b16 sont chacun indépendamment les mêmes que ce qui est décrit conjointement à b11 dans la Formule 1.

17. Composé organométallique selon l'une quelconque des revendications 1 à 16, dans lequel le composé organométallique représenté par la Formule 1 est choisi parmi les Composés 1 à 250:

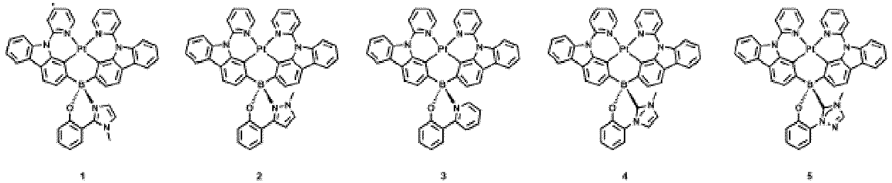

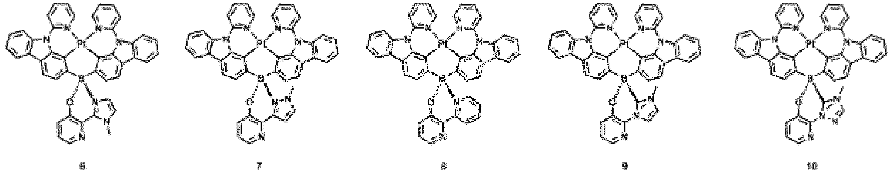

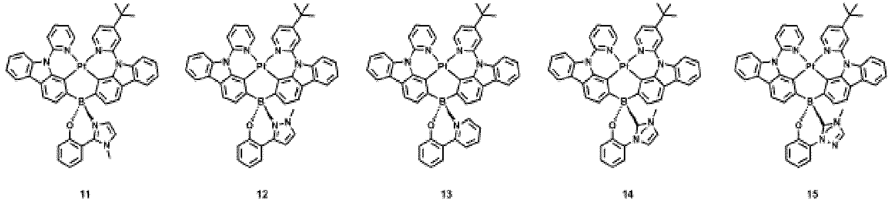

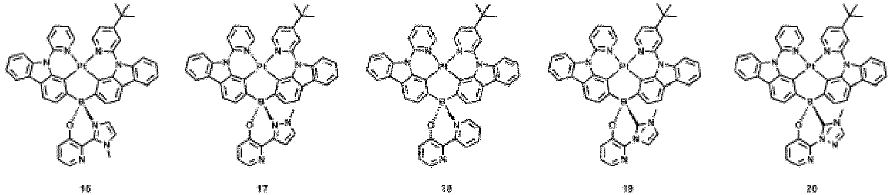

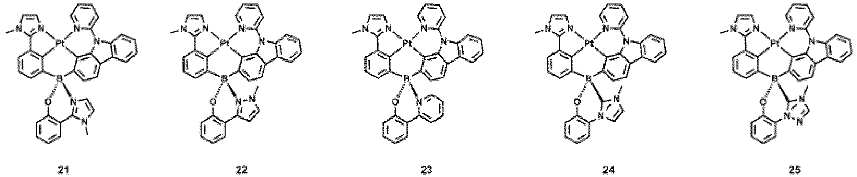

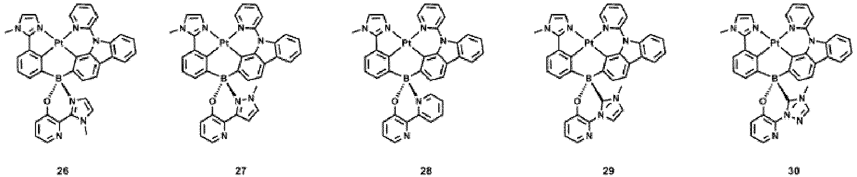

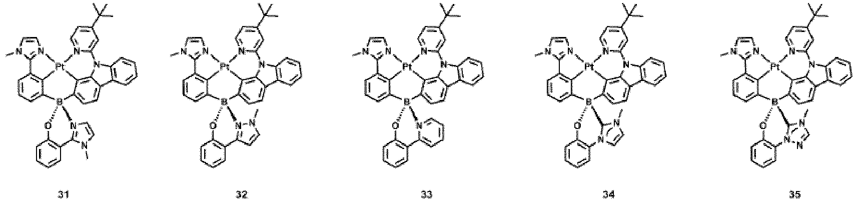

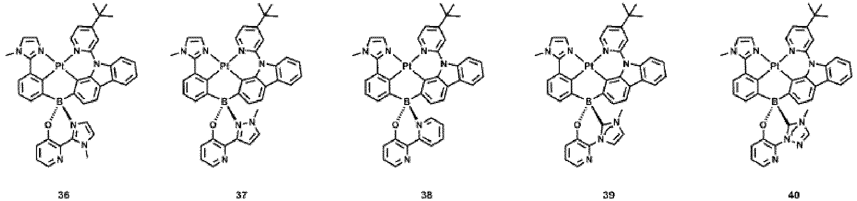

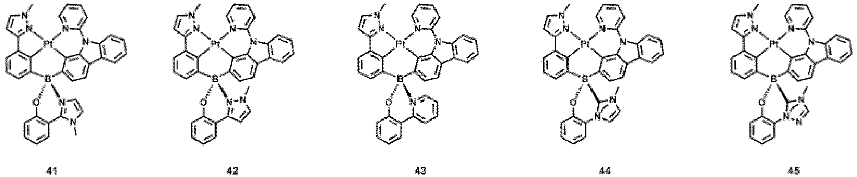

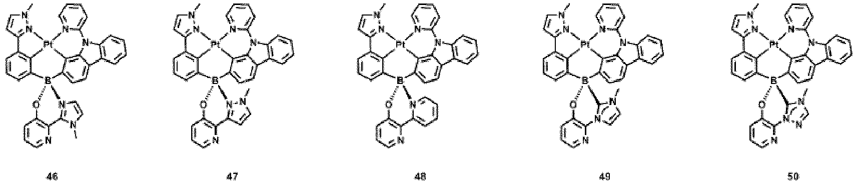

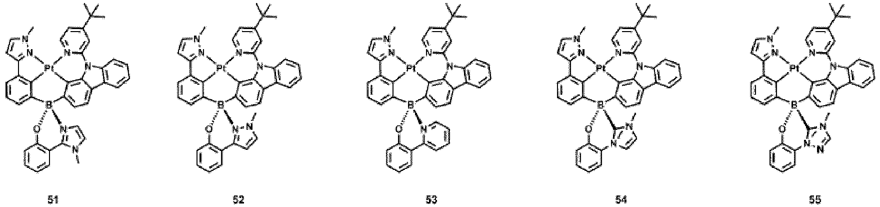

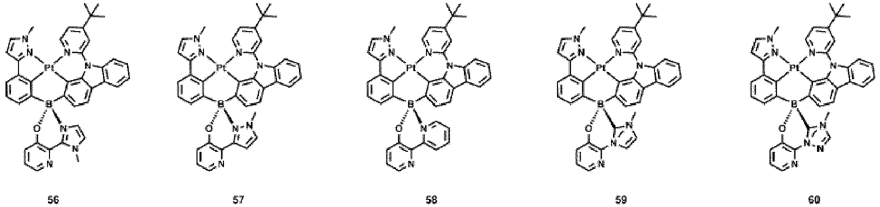

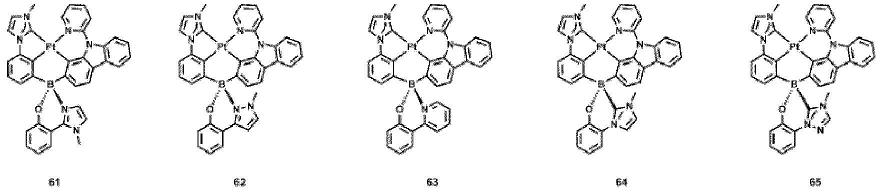

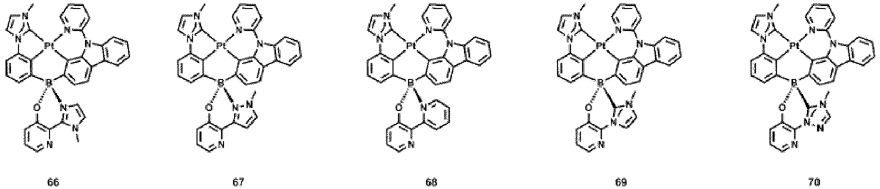

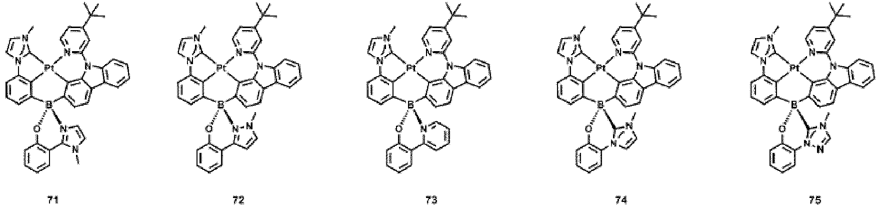

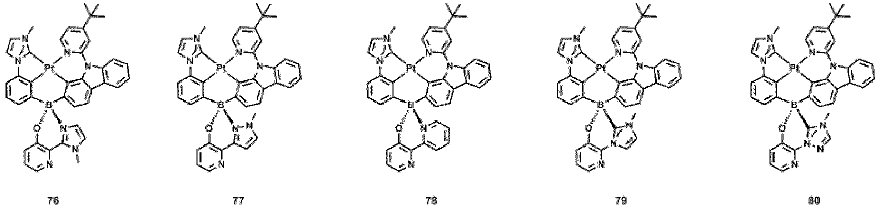

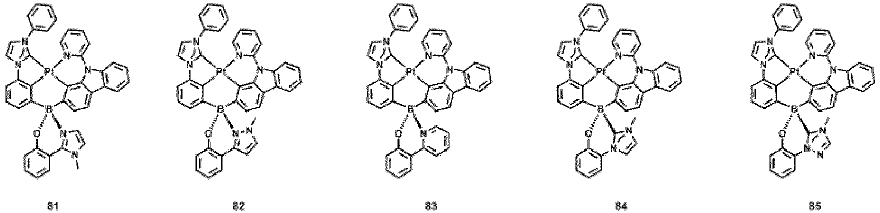

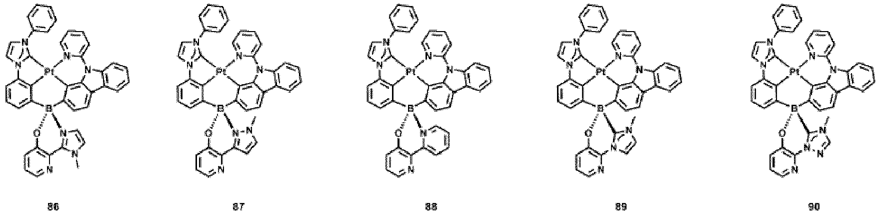

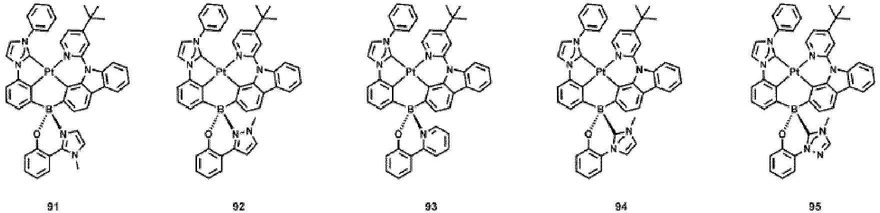

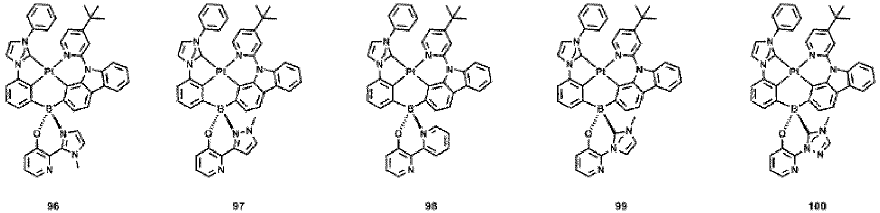

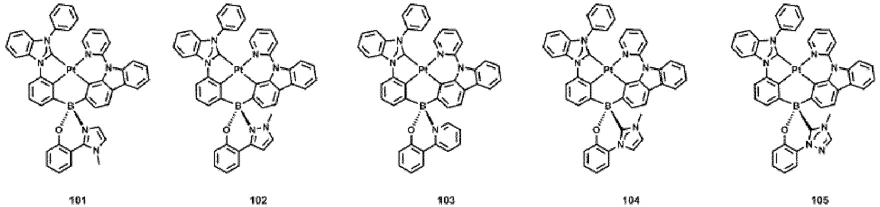

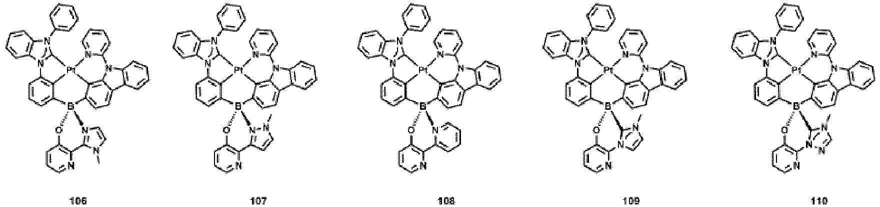

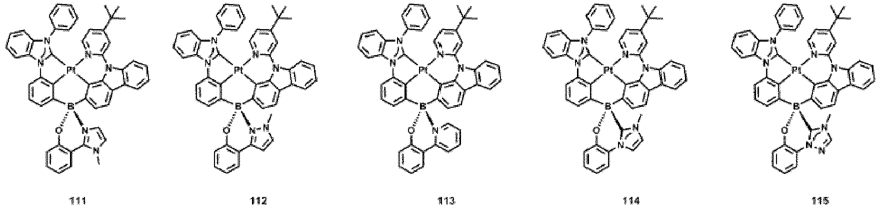

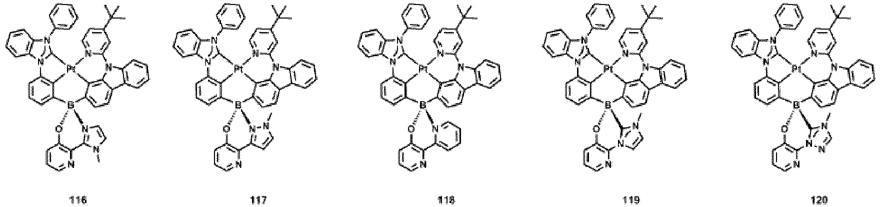

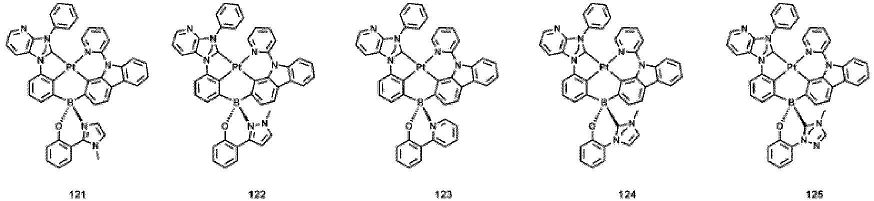

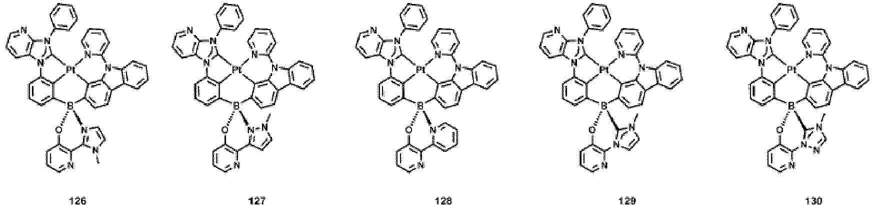

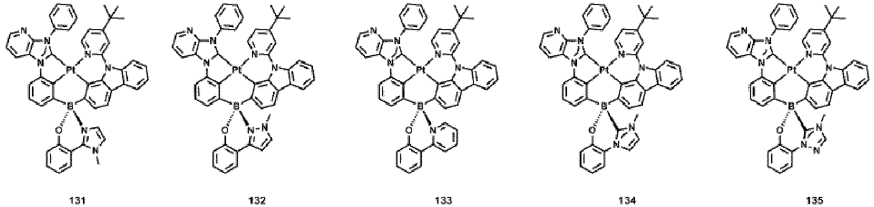

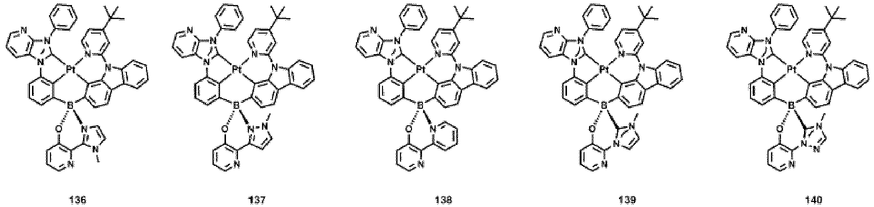

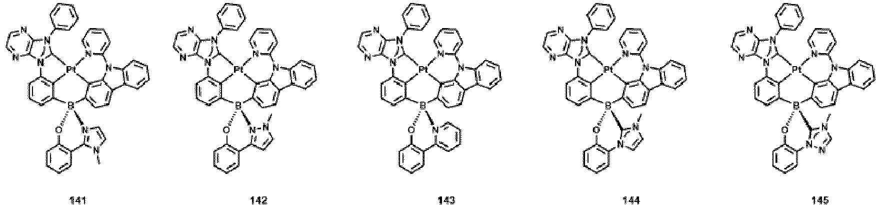

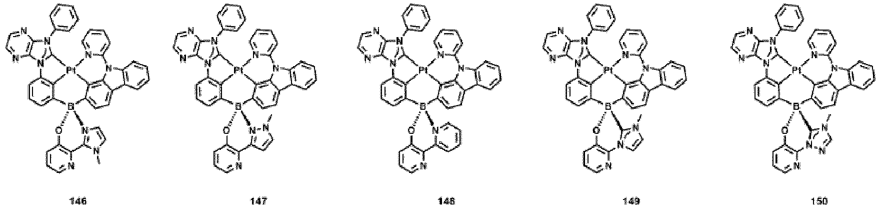

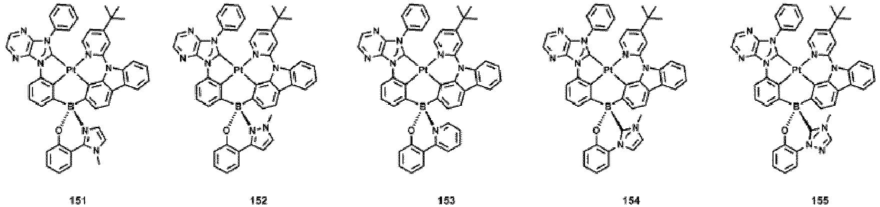

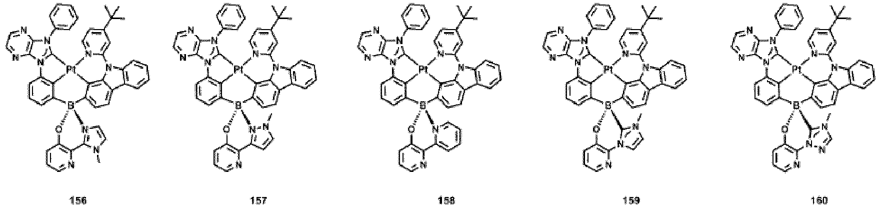

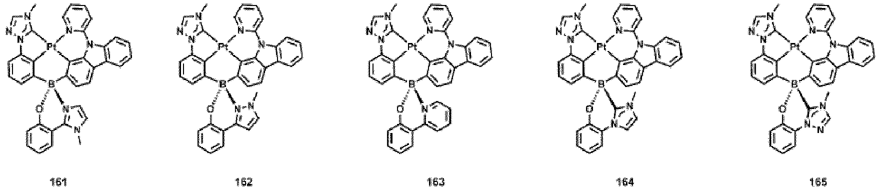

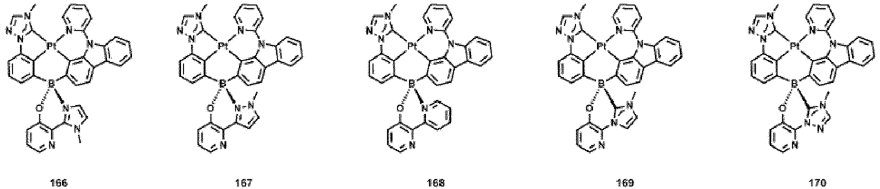

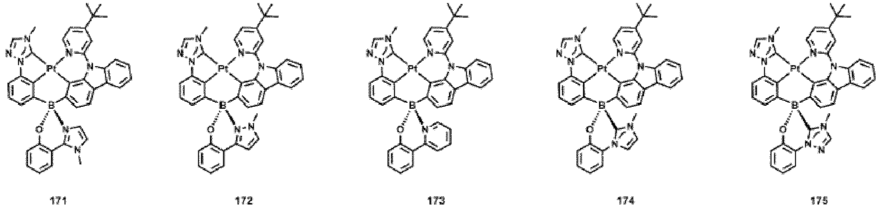

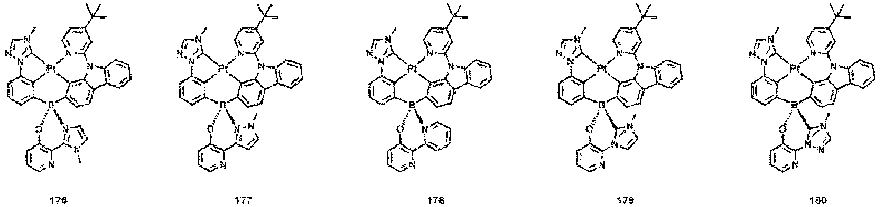

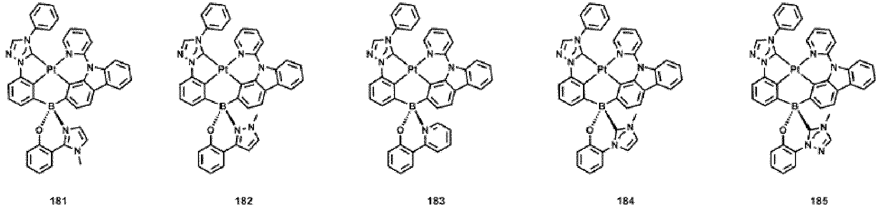

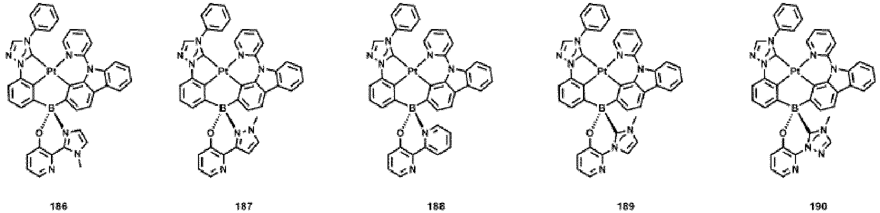

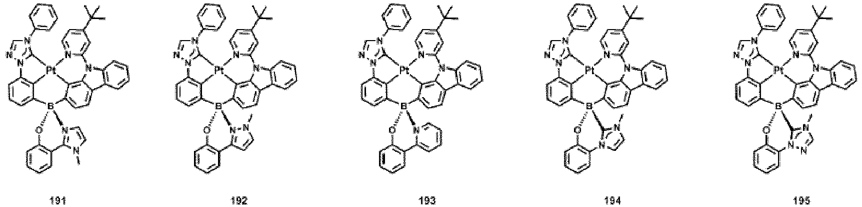

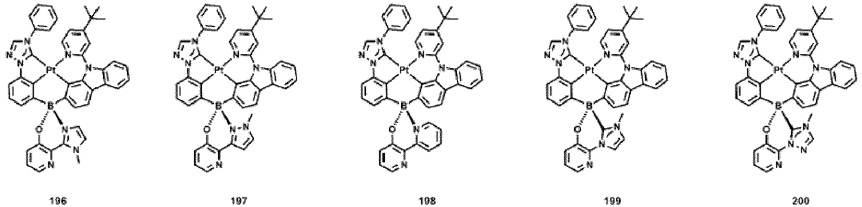

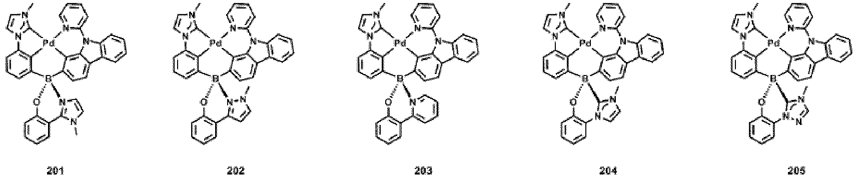

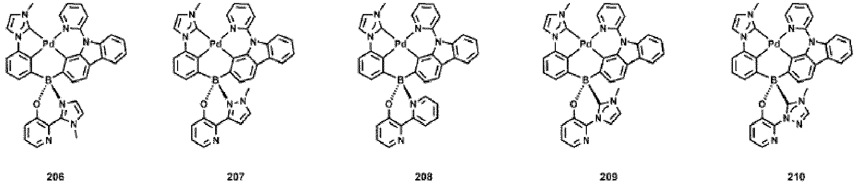

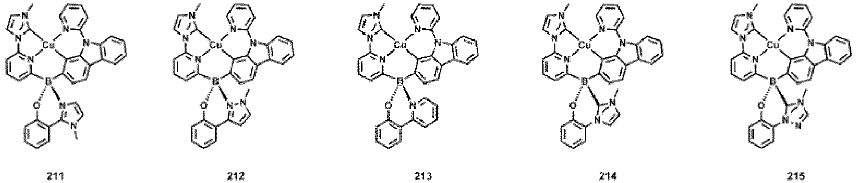

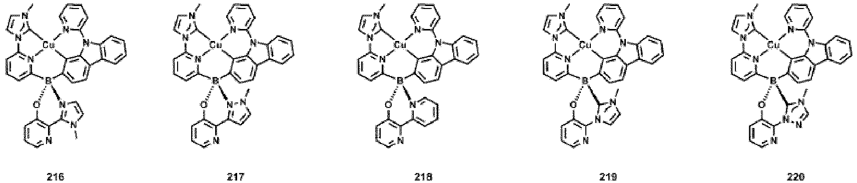

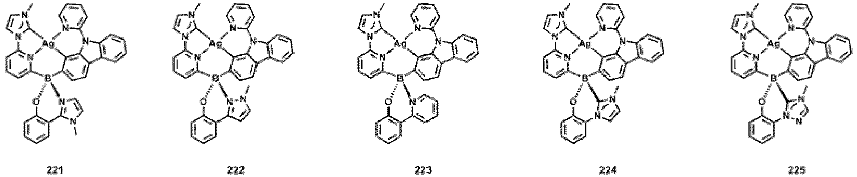

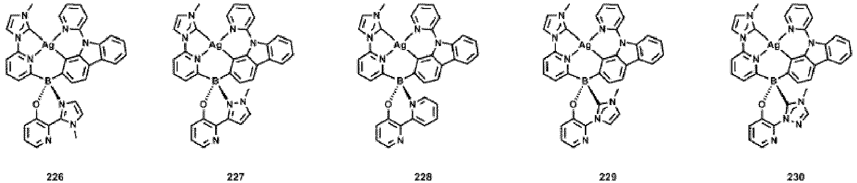

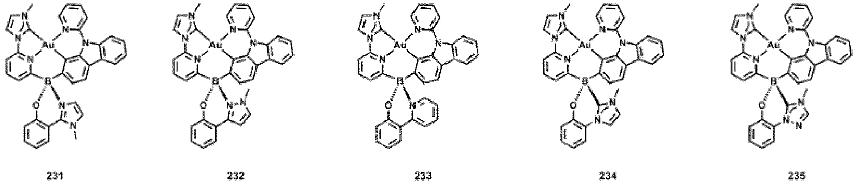

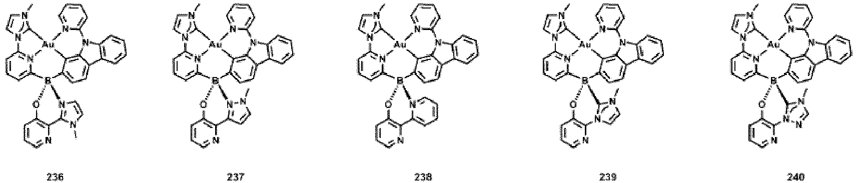

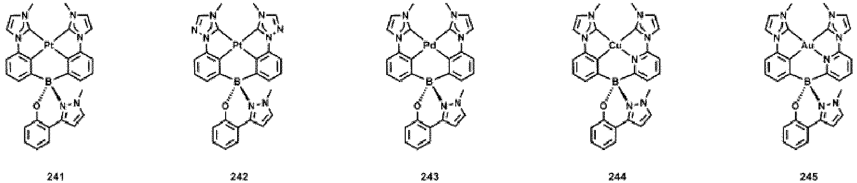

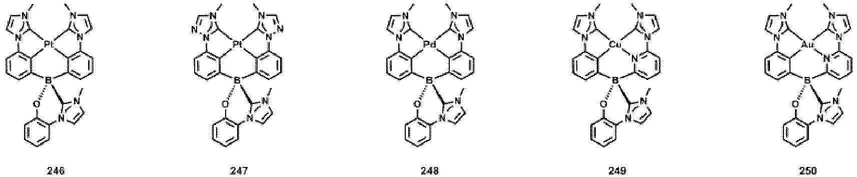

18. Dispositif électroluminescent organique comprenant:
une première électrode;
une deuxième électrode; et
une couche organique placée entre la première électrode et la deuxième électrode,
dans lequel la couche organique comprend une couche d'émission et le composé organométallique selon l'une quelconque des revendications 1 à 17.

19. Dispositif électroluminescent organique selon la revendication 18, dans lequel:
la couche d'émission comprend le composé organométallique.

20. Dispositif électroluminescent organique selon la revendication 19, dans lequel:
la couche d'émission comprend en outre au moins un parmi un dopant phosphorescent et un dopant fluorescent.
